# EUROPEAN PATENT SPECIFICATION

(11) **EP 4 101 908 B1**
(45) Date of publication and mention of the grant of the patent: **24.07.2024**
(21) Application number: 22178099.2
(22) Date of filing: 09.06.2022
(51) Int. Cl.: C09K 11/06, C07B 59/00, C07F 15/00, H10K 85/30, H10K 50/11

(54) **COMPOSITION, LAYER INCLUDING THE COMPOSITION, LIGHT-EMITTING DEVICE INCLUDING THE COMPOSITION, AND ELECTRONIC APPARATUS INCLUDING THE LIGHT-EMITTING DEVICE**
ZUSAMMENSETZUNG, SCHICHT MIT DER ZUSAMMENSETZUNG, LICHTEMITTIERENDE VORRICHTUNG MIT DER ZUSAMMENSETZUNG UND ELEKTRONISCHES GERÄT MIT DER LICHTEMITTIERENDEN VORRICHTUNG
COMPOSITION, COUCHE INCLUANT LA COMPOSITION, DISPOSITIF ÉLECTROLUMINESCENT INCLUANT LA COMPOSITION ET APPAREIL ÉLECTRONIQUE INCLUANT LE DISPOSITIF ÉLECTROLUMINESCENT

(30) Priority: 11.06.2021 KR 20210076312
(43) Date of publication of application: 14.12.2022
(73) Proprietor: Samsung Electronics Co., Ltd., Gyeonggi-do, 16677 (KR)
(72) Inventor: LEE, Kum Hee, 16678 Suwon-si (KR); KANG, Byungjoon, 16678 Suwon-si (KR); KWAK, Seungyeon, 16678 Suwon-si (KR); SIM, Myungsun, 16678 Suwon-si (KR); LEE, Banglin, 16678 Suwon-si (KR); LEE, Sunghun, 16678 Suwon-si (KR); YI, Jeoungin, 16678 Suwon-si (KR); CHOI, Byoungki, 16678 Suwon-si (KR)
(74) Representative: Elkington and Fife LLP

(56) References cited:
- WO-A1-2013/161739
- US-A1- 2008 203 360
- US-A1- 2018 342 680

## Description

### FIELD OF THE INVENTION

Provided are a composition, a layer including the composition, a light-emitting device including the composition, and an electronic apparatus including the light-emitting device.

### BACKGROUND OF THE INVENTION

From among light-emitting devices, organic light-emitting devices (OLEDs) are self-emissive devices, which have improved characteristics in terms of viewing angles, response time, luminance, driving voltage, and response speed, and produce full-color images.

In an example, an organic light-emitting device includes an anode, a cathode, and an organic layer located between the anode and the cathode, wherein the organic layer includes an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state to thereby generate light.

US 2018/0342680 A1 discloses a composition formed of a mixture of two compounds having similar thermal evaporation properties.

WO 2013/161739 A1 discloses an organic electroluminescence element, and an illumination device and display device containing the element.

US 2008/0203360 A1 discloses an electroluminescent material, a process for preparing the same, and a display device containing the same.

### SUMMARY OF THE INVENTION

Provided are a composition capable of providing excellent luminescence efficiency and lifespan characteristics and the like, a layer including the composition, a light-emitting device including the composition, and an electronic apparatus including the light-emitting device.

Additional aspects will be set forth in part in the description, which follows and, in part, will be apparent from the description, or may be learned by practice of the presented embodiments as described herein.

According to an aspect of the invention, provided is a composition according to claim 1.

According to another aspect, provided is a layer including the composition described herein.

According to another aspect, provided is a light-emitting device including a first electrode, a second electrode, and an organic layer located between the first electrode and the second electrode, wherein the organic layer includes an emission layer, and wherein the organic layer includes the composition described herein.

In one or more embodiments, the emission layer of the light-emitting device may include the composition described herein.

According to another aspect, provided is an electronic apparatus including the light-emitting device described herein.

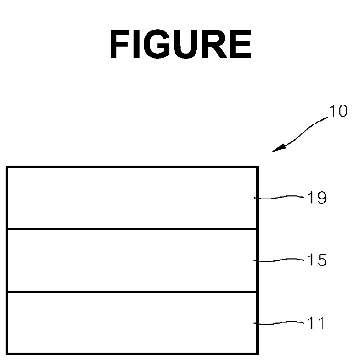

### BRIEF DESCRIPTION OF THE DRAWING

The above and other aspects, features, and advantages of certain embodiments will be more apparent from the following description taken in conjunction with the accompanying drawings, in which
The FIGURE shows a schematic cross-sectional view of a light-emitting device according to aspects of one or more embodiments.

### DETAILED DESCRIPTION OF THE EMBODIMENTS

Reference will now be made in detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

A composition according to the invention includes a first compound represented by Formula 1 and a second compound represented by Formula 2:

Formula 1 Ir(L₁₁)ₙ₁₁(L₁₂)ₙ₁₂(L₁₃)ₙ₁₃

Formula 2 Ir(L₂₁)ₙ₂₁(L₂₂)ₙ₂₂(L₂₃)ₙ₂₃

wherein each of Formulae 1 and 2 includes one iridium (Ir).

Each of the first compound and the second compound may be electrically neutral.

L₁₁, L₁₂, and L₁₃ in Formula 1 are different from one another.

In Formula 1, n11 and n12 are each independently 1 or 2, and n13 is 0 or 1. The sum of n11, n12, and n13 is 3.

In one or more embodiments, in Formula 1, i) n11 may be 1, n12 may be 2, and n13 may be 0; or ii) n11 may be 2, n12 may be 1, and n13 may be 0.

L₂₁, L₂₂, and L₂₃ in Formula 2 are different from one another.

In Formula 2, n21 and n22 re each independently 1 or 2, and n23 is 0 or 1. The sum of n21, n22, and n23 is 3.

In one or more embodiments, in Formula 2, i) n21 may be 1, n22 may be 2, and n23 may be 0; or ii) n21 may be 2, n22 may be 1, and n23 may be 0.

Each of the first compound and the second compound is a heteroleptic complex.

In one or more embodiments, n13 in Formula 1 may be 0, and n23 in Formula 2 may be 0.

In Formulae 1 and 2,
L₁₁ is a ligand represented by Formula 1-1,
L₁₂ is a ligand represented by Formula 1-2,
L₁₃ is a ligand represented by Formula 1-1 or a ligand represented by Formula 1-2,
L₂₁ is a ligand represented by Formula 2-1,
L₂₂ is a ligand represented by Formula 2-2, and
L₂₃ is a ligand represented by Formula 2-1 or a ligand represented by Formula 2-2: 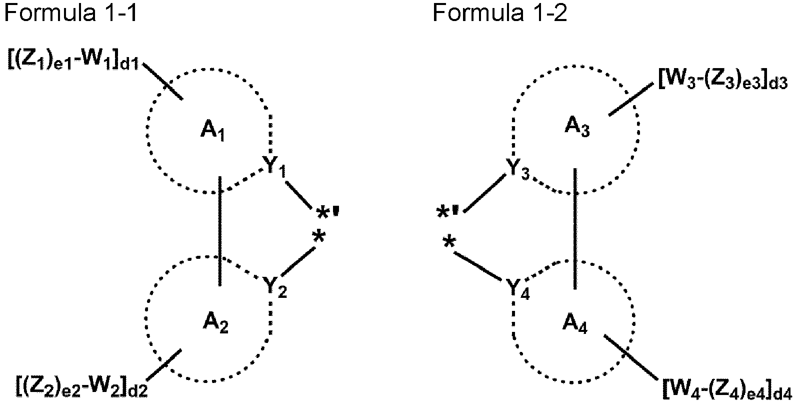 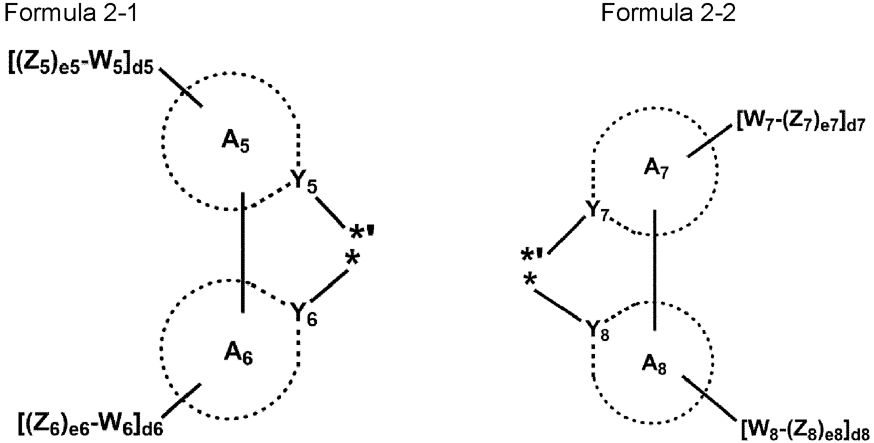 wherein Y₁, Y₃, Y₅, and Y₇ are N, and Y₂, Y₄, Y₆, and Y₈ are C.

In one or more embodiments, i) Y₁ and Y₂ may each be C, ii) Y₃ and Y₄ may each be C, iii) Y₅ and Y₆ may each be C, or iv) Y₇ and Y₈ may each be C.

In Formulae 1, 2, 1-1, 1-2, 2-1, and 2-2, i) a bond between Y₁ and iridium, a bond between Y₃ and iridium, a bond between Y₅ and iridium, and a bond between Y₇ and iridium may each be a coordinate bond, and ii) a bond between Y₂ and iridium, a bond between Y₄ and iridium, a bond between Y₆ and iridium, and a bond between Y₈ and iridium may each be a covalent bond. Thus, each of the first compound and the second compound may be electrically neutral.

In Formulae 1-1, 1-2, 2-1, and 2-2, i) ring A₁, ring A₃, ring A₅, and ring A₇ are each a C₁-C₃₀ heterocyclic group, ii) ring A₂, ring A₄, ring A₆, and ring A₈ are each independently a C₅-C₃₀ carbocyclic group or a C₁-C₃₀ heterocyclic group, iii) Y₁, Y₃, Y₅, and Y₇ are each N, and iv) Y₂, Y₄, Y₆, and Y₈ are each C.

In one or more embodiments, in Formulae 1-1, 1-2, 2-1, and 2-2, ring A₁, ring A₃, ring A₅, and ring A₇ may each independently be i) ring T1, ii) a condensed ring in which two or more ring T1 are condensed with each other, or iii) a condensed ring in which at least one ring T1 and at least one ring T2 are condensed with each other,
ring T1 may be a pyridine group, a pyrimidine group, a pyrazine group, a pyridazine group, a triazine group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
ring T2 may be a cyclopentane group, a cyclopentene group, a furan group, a thiophene group, a pyrrole group, a silole group, a borole group, a phosphole group, a germole group, a selenophene group, an adamantane group, a norbornane group, a norbornene group, a cyclohexane group, a cyclohexene group, or a benzene group.

In one or more embodiments, in Formulae 1-1, 1-2, 2-1, and 2-2, ring A₂, ring A₄, ring A₆, and ring A₈ may each be i) a first ring, ii) a second ring, iii) a condensed ring in which two or more first rings are condensed with each other, iv) a condensed ring in which two or more second rings are condensed with each other, or v) a condensed ring in which at least one first ring and at least one second ring are condensed with each other,
the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

In one or more embodiments, in Formulae 1-1, 1-2, 2-1, and 2-2, ring A₁, ring A₃, ring A₅, and ring A₇ may each independently be an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an iso-oxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidino pyrrole group, a pyrimidino pyrazole group, a pyrimidino imidazole group, a pyrimidino oxazole group, a pyrimidino isoxazole group, a pyrimidino thiazole group, a pyrimidino isothiazole group, a pyrimidino oxadiazole group, a pyrimidinothiadiazole group, a naphthopyrrole group, a naphthopyrazole group, a naphthoimidazole group, a naphthooxazole group, a naphthoisoxazole group, a naphthothiazole group, a naphthoisothiazole group, a naphthooxadiazole group, a naphthothiadiazole group, a phenanthrenopyrrole group, a phenanthrenopyrazole group, a phenanthrenoimidazole group, a phenanthrenooxazole group, a phenanthrenoisoxazole group, a phenanthrenothiazole group, a phenanthrenoisothiazole group, a phenanthrenooxadiazole group, a phenanthrenothiadiazole group, a 5,6,7,8-tetrahydroisoquinoline group, a 5,6,7,8-tetrahydroquinoline group, a pyridine group condensed with a cyclohexane group, or a pyridine group condensed with a norbornane group.

In one or more embodiments, in Formulae 1-1, 1-2, 2-1, and 2-2, ring A₂, ring A₄, ring A₆, and ring A₈ may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an iso-oxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a naphthopyrrole group, a naphthopyrazole group, a naphthoimidazole group, a naphthooxazole group, a naphthoisoxazole group, a naphthothiazole group, a naphthoisothiazole group, a naphthooxadiazole group, a naphthothiadiazole group, a phenanthrenopyrrole group, a phenanthrenopyrazole group, a phenanthrenoimidazole group, a phenanthrenooxazole group, a phenanthrenoisoxazole group, a phenanthrenothiazole group, a phenanthrenoisothiazole group, a phenanthrenooxadiazole group, a phenanthrenothiadiazole group, a 5,6,7,8-tetrahydroisoquinoline group, a 5,6,7,8-tetrahydroquinoline group, an adamantane group, a norbornane group, a norbornene group, a benzene group condensed with a cyclohexane group, a benzene group condensed with a norbornane group, a pyridine group condensed with a cyclohexane group, or a pyridine group condensed with a norbornane group.

Ring A₁ and ring A₃ in Formulae 1-1 and 1-2 are different from each other.

In one or more embodiments, a Y₁-containing monocyclic group in ring A₁, a Y₂-containing monocyclic group in ring A₂, and a Y₄-containing monocyclic group in ring A₄ may each be a 6-membered ring. In other words, ring A₁, ring A₂, and ring A₄ may each comprise a 6-membered ring. For example, ring A₁ and ring A₂ may each be a 6-membered ring, and ring A₄ may comprise a 6-membered ring.

In one or more embodiments, a Y₃-containing monocyclic group in ring A₃ may be a 6-membered ring. In other words, ring A₃ may comprise a 6-membered ring.

A Y₃-containing monocyclic group in ring A₃ is a 5-membered ring. In other words, ring A₃ comprises a 5-membered ring.

In one or more embodiments, a Y₁-containing monocyclic group in ring A₁ may be a 6-membered ring, and a Y₃-containing monocyclic group in ring A₃ may be a 5-membered ring. In other words, ring A₁ may comprise a 6-membered ring and ring A₃ may comprise a 5-membered ring. For example, ring A₁ may be a 6-membered ring and ring A₃ may comprise a 5-membered ring.

Ring A₅ and ring A₇ in Formulae 2-1 and 2-2 may be identical to each other.

In one or more embodiments, a Y₅-containing monocyclic group in ring A₅, a Y₆-containing monocyclic group in ring A₆, and a Y₈-containing monocyclic group in ring A₈ may each be a 6-membered ring. In other words, ring A₅, ring A₆, and ring A₈ may each comprise a 6-membered ring. For example, ring A₅ and ring A₆ may each be a 6-membered ring, and ring A₈ may comprise a 6-membered ring.

In one or more embodiments, a Y₇-containing monocyclic group in ring A₇ may be a 6-membered ring. In other words, ring A₇ may comprise a 6-membered ring. For example, ring A₇ may be a 6-membered ring.

In one or more embodiments, a Y₇-containing monocyclic group in ring A₇ may be a 5-membered ring. In other words, ring A₇ may comprise a 5-membered ring. For example, ring A₇ may be a 5-membered ring.

In one or more embodiments, a Y₅-containing monocyclic group in ring A₅ and a Y₇-containing monocyclic group in ring A₇ may each be a 6-membered ring.

In one or more embodiments, ring A₁, ring A₃, ring A₅, and ring A₇ in Formulae 1-1, 1-2, 2-1, and 2-2 may each independently be i) an A group, ii) a polycyclic group in which two or more A groups are condensed with each other, or iii) a polycyclic group in which at least one A group and at least one B group are condensed with each other,
the A group may be a pyridine group, a pyrimidine group, a pyridazine group, a pyrazine group, or a triazine group, and
the B group may be a cyclohexane group, a cyclohexene group, a norbornane group, a benzene group, a furan group, a thiophene group, a selenophene group, a pyrrole group, a cyclopentadiene group, or a silole group.

In one or more embodiments, in Formulae 1-2 and 2-2, ring A₃ and ring A₇ may each independently be i) a C group, ii) a polycyclic group in which two or more C groups are condensed with each other, or iii) a polycyclic group in which at least one C group and at least one D group are condensed with each other,
the C group may be a pyrrole group, a pyrazole group, an imidazole group, a triazole group, an oxazole group, an isoxazole group, a thiazole group, or an isothiazole group, and
the D group may be a cyclohexane group, a cyclohexene group, a norbornane group, a benzene group, a furan group, a thiophene group, a selenophene group, a cyclopentadiene group, a silole group, a pyridine group, a pyrimidine group, a pyridazine group, a pyrazine group, or a triazine group.

In one or more embodiments, ring A₁ and ring A₅ in Formulae 1-1 and 2-1 may each independently be:
a pyridine group, a pyrimidine group, a pyridazine group, or a pyrazine group; or
a pyridine group, a pyrimidine group, a pyridazine group, or a pyrazine group, each condensed with at least one of a cyclohexane group, a norbornane group, a benzene group, or a combination thereof.

In one or more embodiments, ring A₃ and ring A₇ in Formulae 1-2 and 2-2 may each independently be:
a pyridine group, a pyrimidine group, a pyridazine group, or a pyrazine group;
a pyridine group, a pyrimidine group, a pyridazine group, or a pyrazine group, each condensed with at least one of a cyclohexane group, a norbornane group, a benzene group, or a combination thereof; or
an imidazole group, a benzimidazole group, a naphthoimidazole group, a phenanthrenoimidazole group, a pyridinooimidazole group, an oxazole group, a benzoxazole group, a naphthooxazole group, a phenanthrenooxazole group, a pyridinoooxazole group, a thiazole group, a benzothiazole group, a naphthothiazole group, a phenanthrenothiazole group, or a pyridinoothiazole group.

In one or more embodiments, ring A₂ and ring A₄ in Formulae 1-1 and 1-2 may be different from each other.

In one or more embodiments, ring A₆ and ring A₈ in Formulae 2-1 and 2-2 may be different from each other.

In one or more embodiments, ring A₂, ring A₄, ring A₆, and ring A₈ in Formulae 1-1, 1-2, 2-1, and 2-2 may each independently be i) an E group, ii) a polycyclic group in which two or more E groups are condensed with each other, or iii) a polycyclic group in which at least one E group and at least one F group are condensed with each other,
the E group may be a benzene group, a pyridine group, a pyrimidine group, a pyridazine group, a pyrazine group, or a triazine group, and
the F group may be a furan group, a thiophene group, a selenophene group, a pyrrole group, a cyclopentadiene group, a silole group, a pyrazole group, an imidazole group, an oxazole group, a thiazole group, an isoxazole group, or an isothiazole group.

In one or more embodiments, ring A₂ in Formula 1-1 may be a polycyclic group in which two or more E groups and at least one F group are condensed with each other.

In one or more embodiments, ring A₄ in Formula 1-2 may be a polycyclic group in which two or more E groups and at least one F group are condensed with each other.

In one or more embodiments, ring A₆ in Formula 2-1 may be a polycyclic group in which two or more E groups and at least one F group are condensed with each other.

In one or more embodiments, ring A₈ in Formula 2-2 may be a polycyclic group in which two or more E groups and at least one F group are condensed with each other.

In one or more embodiments, ring A₂ and ring A₆ in Formulae 1-1 and 2-1 may each independently be:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with at least one of a cyclohexane group, a norbornane group, a benzene group, or a combination thereof.

In one or more embodiments, ring A₄ and ring A₈ in Formulae 1-2 and 2-2 may each independently be:
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, an azadibenzosilole group or a phenanthrobenzofuran group; or
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or an azadibenzosilole group, each condensed with at least one of a benzene group, a pyridine group, a pyrimidine group, a pyridazine group, a pyrazine group, a cyclohexane group, a norbornane group, a furan group, a thiophene group, a selenophene group, a pyrrole group, a cyclopentadiene group, a silole group, a pyrazole group, an imidazole group, an oxazole group, a thiazole group, an isoxazole group, an isothiazole group, or a combination thereof.

W₁ to W₈ in Formulae 1-1, 1-2, 2-1, and 2-2 are each independently a single bond, a C₁-C₂₀ alkylene group that is unsubstituted or substituted with at least one R₁₀ₐ, a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

For example, W₁ to W₈ in Formulae 1-1, 1-2, 2-1, and 2-2 may each independently be:
a single bond; or
a C₁-C₂₀ alkylene group, a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an iso-oxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each unsubstituted or substituted with at least one R₁₀ₐ.

In one or more embodiments, W₁ to W₈ in Formulae 1-1, 1-2, 2-1, and 2-2 may each independently be:
a single bond; or
a benzene group, a naphthalene group, a pyridine group, a fluorene group, a carbazole group, a dibenzofuran group, or a dibenzothiophene group, each unsubstituted or substituted with at least one R₁₀ₐ.

In one or more embodiments, W₁ to W₈ in Formulae 1-1, 1-2, 2-1, and 2-2 may each independently be:
a single bond; or
a C₁-C₂₀ alkylene group, a benzene group, a naphthalene group, a dibenzofuran group, or a dibenzothiophene group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

Z₁ to Z₈ in Formulae 1-1, 1-2, 2-1, and 2-2 are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉). Q₁ to Q₉ are respectively as described herein.

In one or more embodiments, Z₁ to Z₈ in Formulae 1-1, 1-2, 2-1, and 2-2 may each independently be:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, a C₁-C₂₀ alkenyl group, a C₁-C₂₀ alkoxy group, or a C₁-C₂₀ alkylthio group;
a C₁-C₂₀ alkyl group, a C₁-C₂₀ alkenyl group, a C₁-C₂₀ alkoxy group, or a C₁-C₂₀ alkylthio group, each substituted with at least one of deuterium, -F, - Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a fluorinated C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a phenyl group, a (C₁-C₂₀ alkyl)phenyl group, a deuterated phenyl group, a fluorinated phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-N(Q₁)(Q₂), -Si(Q₃)(Q₄)(Q₅), -Ge(Q₃)(Q₄)(Q₅), -B(Q₆)(Q₇), - P(=O)(Q₈)(Q₉), or -P(Q₈)(Q₉),
wherein Q₁ to Q₉ may each independently be:
   deuterium, -F, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, - CD₂CD₃, -CD₂CD₂H, -CD₂CDH₂, -CF₃, -CF₂H, -CFH₂, -CH₂CF₃, -CH₂CF₂H, - CH₂CFH₂, -CHFCH₃, -CHFCF₂H, -CHFCFH₂, -CHFCF₃, -CF₂CF₃, -CF₂CF₂H, or -CF₂CFH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a C₁-C₁₀ alkyl group, a phenyl group, or a combination thereof.

In one or more embodiments, Z₁ to Z₈ in Formulae 1-1, 1-2, 2-1, and 2-2 may each independently be:
hydrogen, deuterium, -F, or a cyano group;
a C₁-C₂₀ alkyl group that is unsubstituted or substituted with at least one of deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C_{1O} heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or a combination thereof;
a C₃-C₁₀ cycloalkyl group, a C₁-C₁₀ a heterocycloalkyl group, a phenyl group, a biphenyl group, a naphthyl group, a pyridinyl group, a fluorenyl group, a carbazolyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₁-C₂₀ alkylthio group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or a combination thereof; or
-Si(Q₃)(Q₄)(Q₅) or -Ge(Q₃)(Q₄)(Q₅).

In one or more embodiments, in Formula 1-1,
e1 and d1 may each not be 0, and
one or more Z₁(s) may each independently be:
   a C₁-C₂₀ alkyl group that is unsubstituted or substituted with at least one of deuterium, -F, a phenyl group, or a combination thereof;
   -Si(Q₃)(Q₄)(Q₅); or
   -Ge(Q₃)(Q₄)(Q₅).

Q₃ to Q₅ are respectively as described herein.

In one or more embodiments, in Formula 2-1,
e5 and d5 may each not be 0, and
one or more Z₅(s) may each independently be:
a C₁-C₂₀ alkyl group that is unsubstituted or substituted with at least one of deuterium, -F, a phenyl group, or a combination thereof;
   - Si(Q₃)(Q₄)(Q₅); or
   - Ge(Q₃)(Q₄)(Q₅).

Q₃ to Q₅ are respectively as described herein.

In one or more embodiments, Q₃ to Q₅ may each independently be:
a C₁-C₆₀ alkyl group unsubstituted or substituted with at least one of deuterium, a C₁-C₆₀ alkyl group, a C₆-C₆₀ aryl group, or a combination thereof; or
a C₆-C₆₀ aryl group unsubstituted or substituted with at least one of deuterium, a C₁-C₆₀ alkyl group, a C₆-C₆₀ aryl group, or a combination thereof.

In one or more embodiments, Q₃ to Q₅ may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₁₀ alkyl group, a phenyl group, or a combination thereof.

In one or more embodiments, Q₃ to Q₅ may be identical to each other (i.e., the same).

In one or more embodiments, two or more of Q₃ to Q₅ may be different from each other.

In one or more embodiments, Z₁ to Z₈ in Formulae 1-1, 1-2, 2-1, and 2-2 may each independently be: hydrogen, deuterium, -F, -CH₃, -CD₃, -CD₂H, -CDH₂, -CF₃, - CF₂H, -CFH₂, a C₁-C₁₀ alkenyl group, a C₁-C₁₀ alkoxy group, a C₁-C₁₀ alkylthio group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with-F, a group represented by one of Formulae 9-201 to 9-227, a group represented by one of Formulae 9-201 to 9-227 in which at least one hydrogen is substituted with deuterium, a group represented by one of Formulae 9-201 to 9-227 in which at least one hydrogen is substituted with -F, a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with-F, a group represented by one of Formulae 10-201 to 10-350, a group represented by one of Formulae 10-201 to 10-350 in which at least one hydrogen is substituted with deuterium, a group represented by one of Formulae 10-201 to 10-350 in which at least one hydrogen is substituted with -F, -Si(Q₃)(Q₄)(Q₅), or -Ge(Q₃)(Q₄)(Q₅), wherein Q₃ to Q₅ are respectively as described herein:

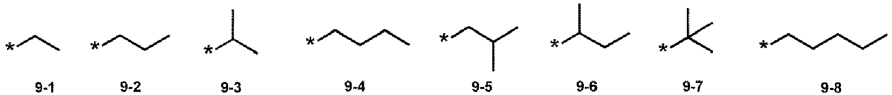

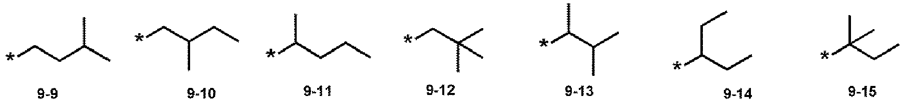

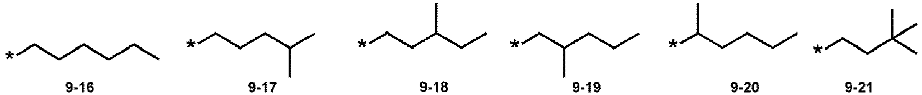

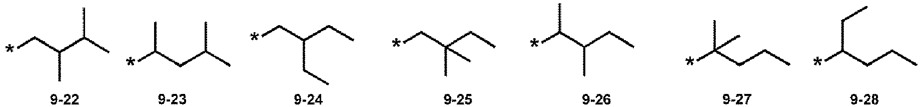

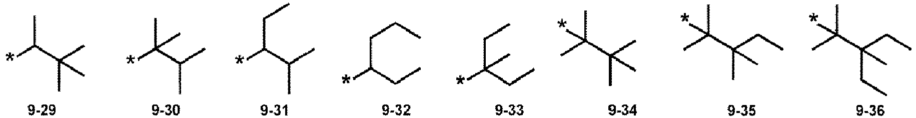

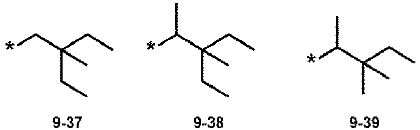

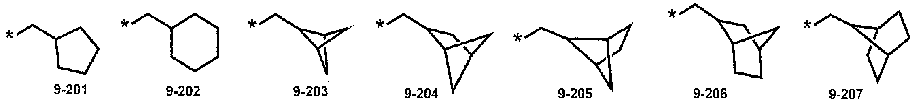

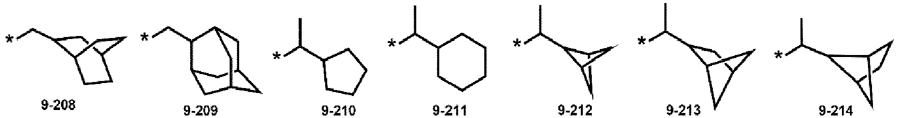

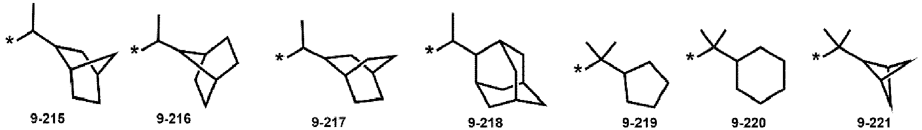

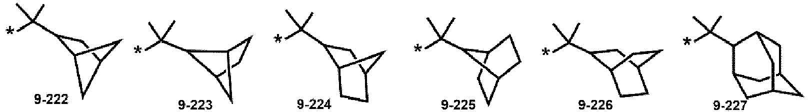

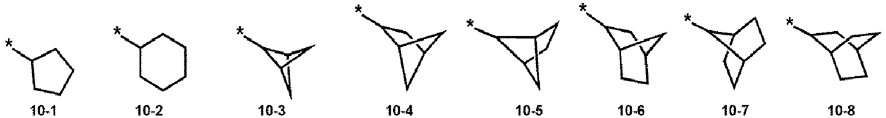

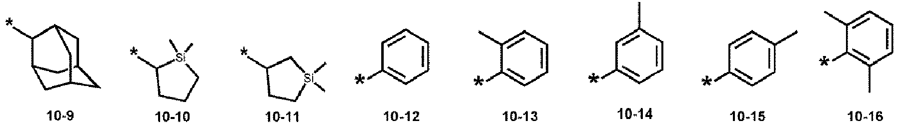

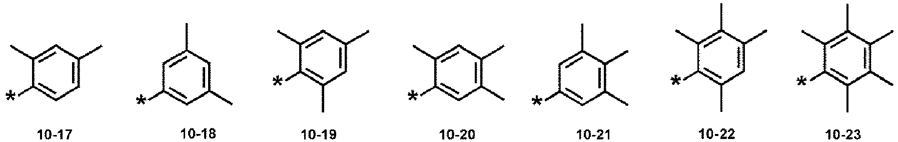

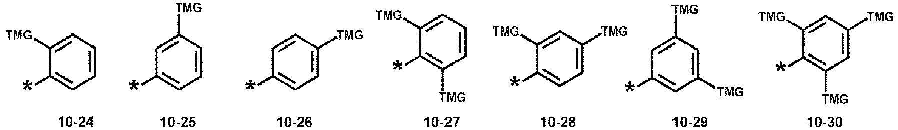

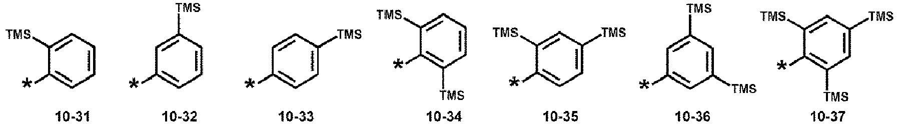

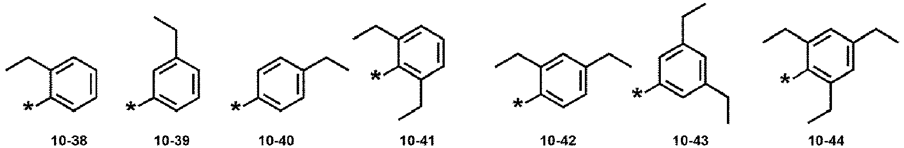

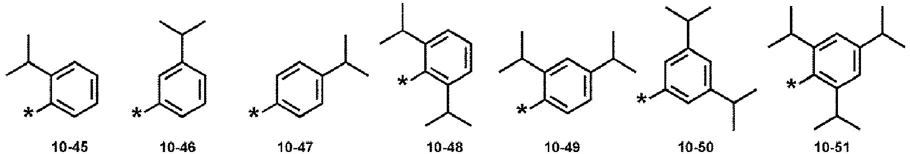

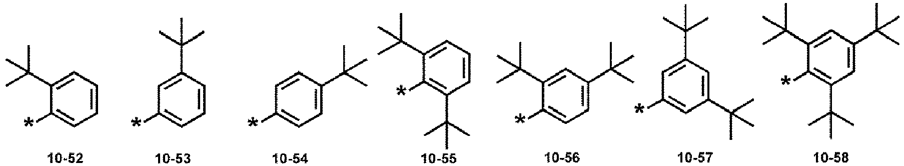

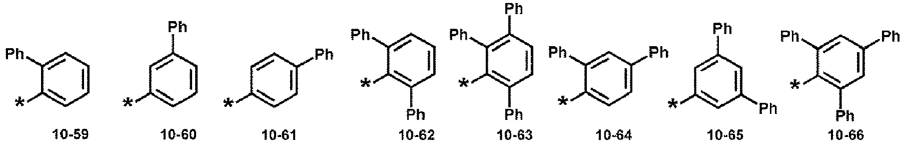

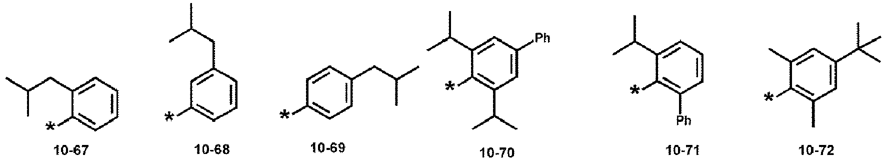

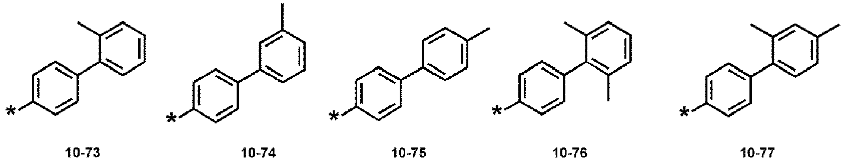

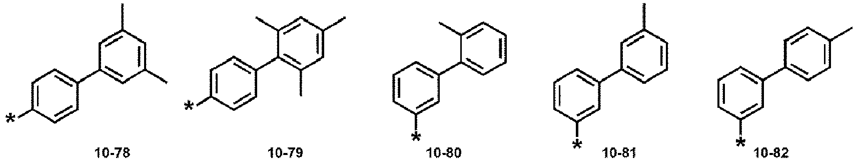

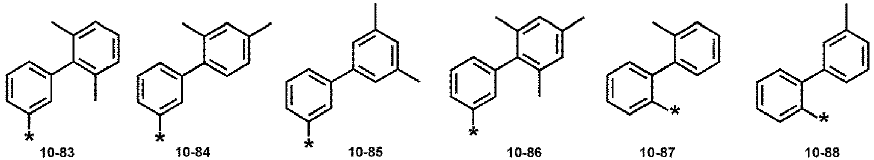

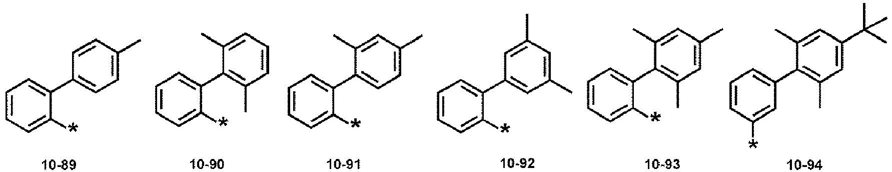

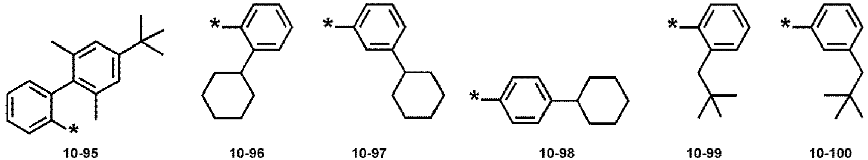

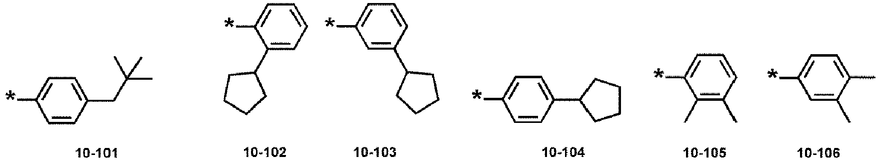

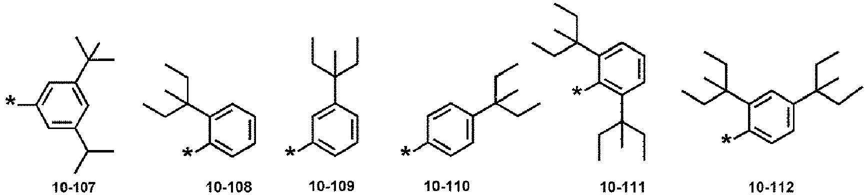

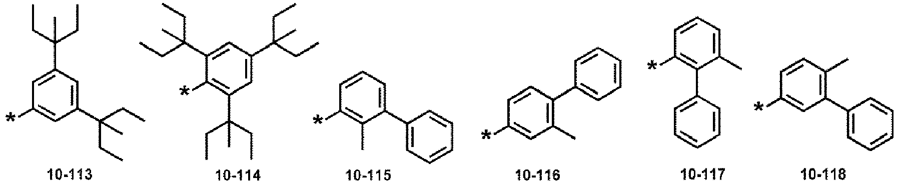

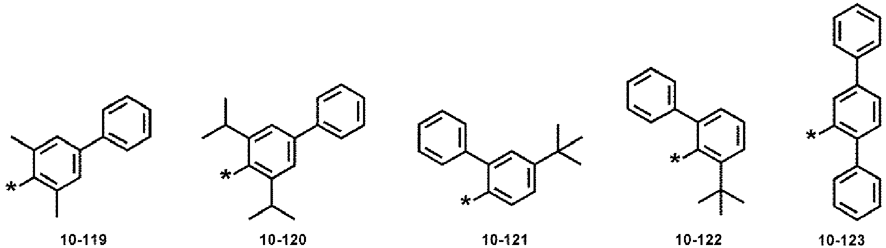

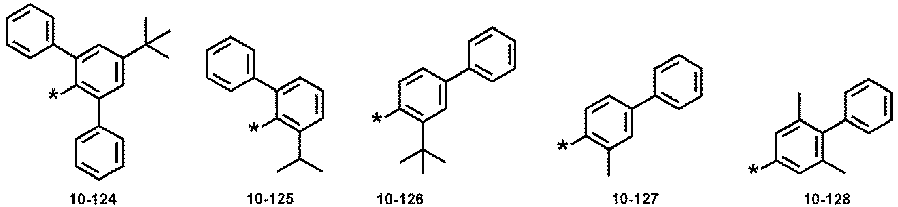

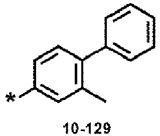

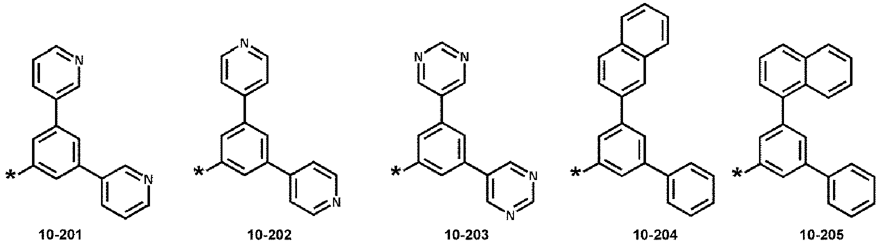

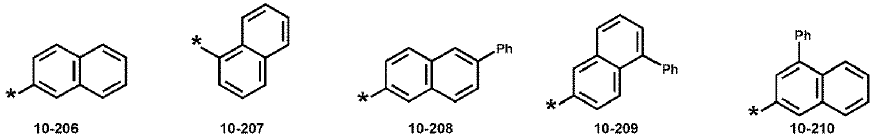

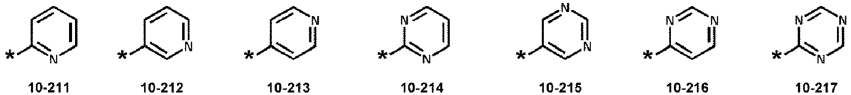

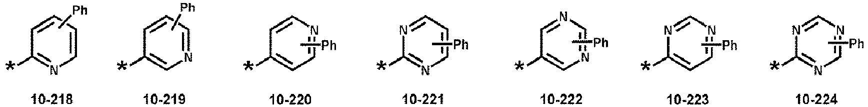

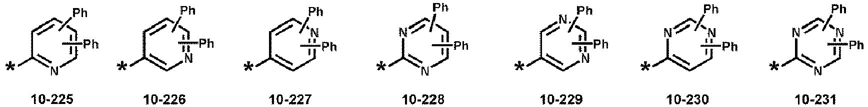

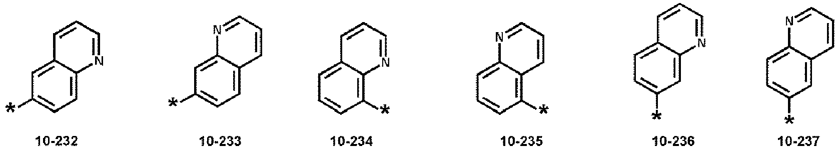

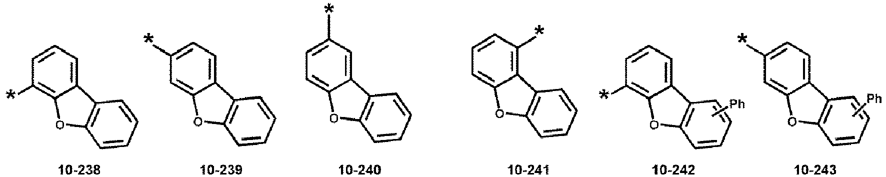

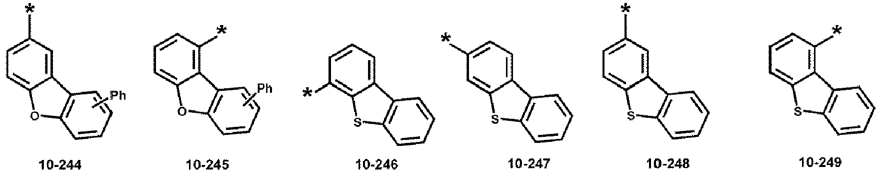

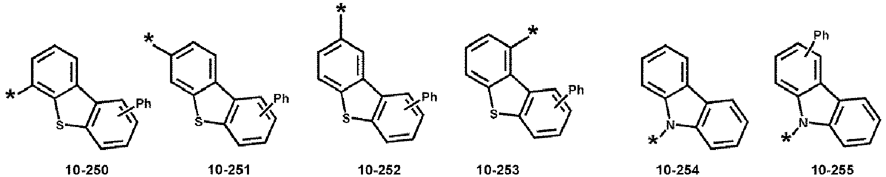

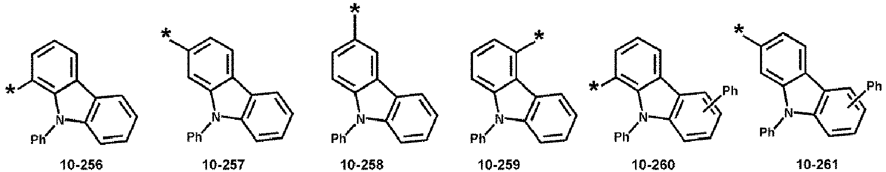

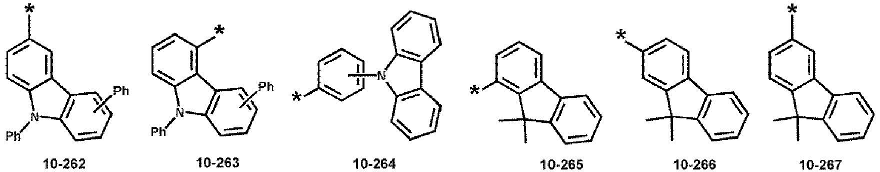

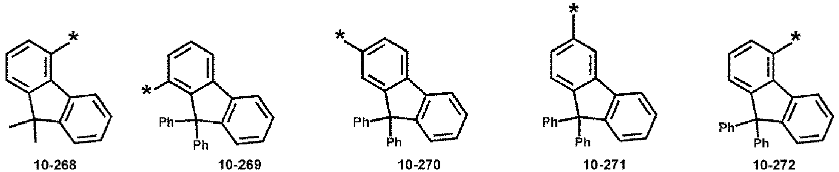

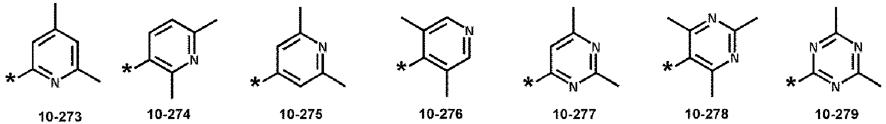

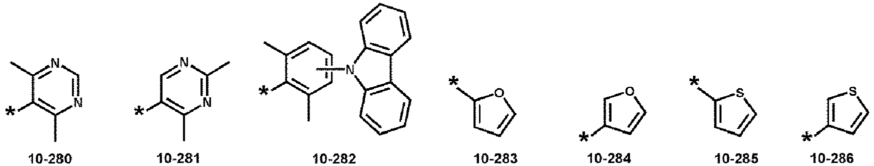

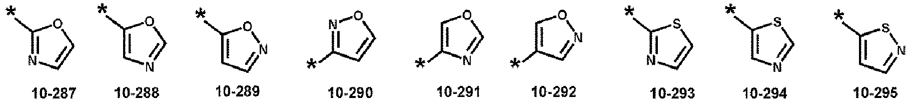

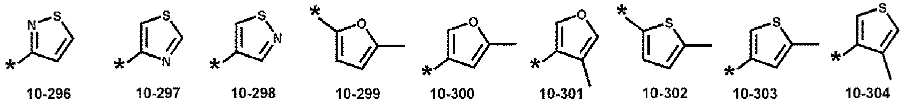

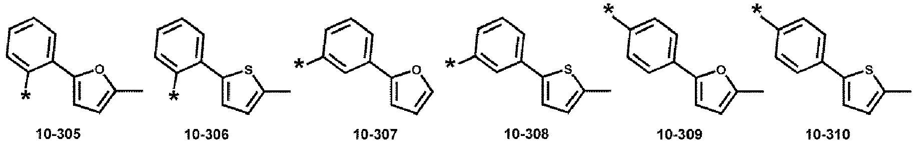

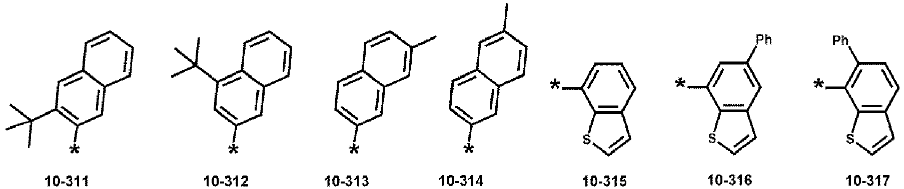

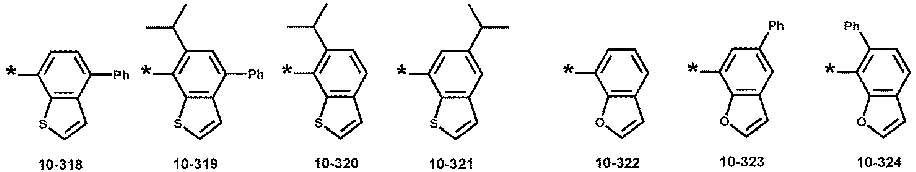

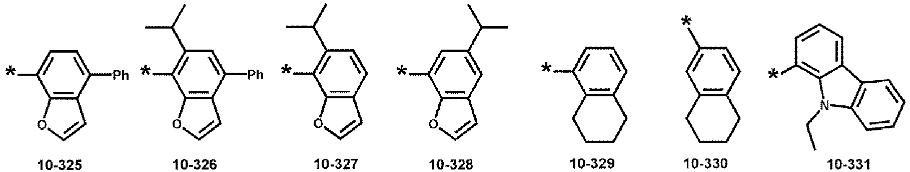

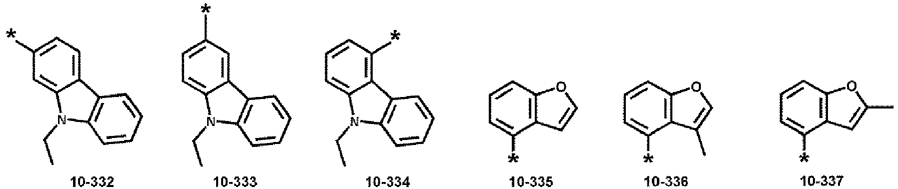

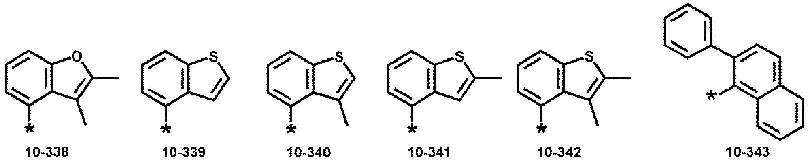

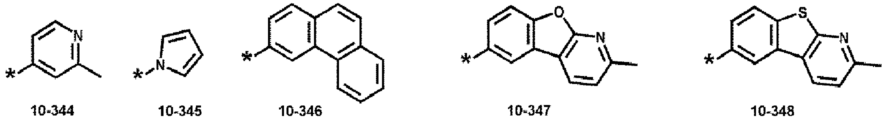

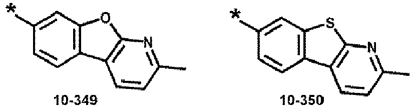

In Formulae 9-1 to 9-39, 9-201 to 9-227, 10-1 to 10-129, and 10-201 to 10-350, * indicates a binding site to a neighboring atom, Ph is a phenyl group, TMS is a trimethylsilyl group, and TMG is a trimethylgermyl group.

The "group represented by one of Formulae 9-1 to 9-39 in which at least one hydrogen is substituted with deuterium" and the "group represented by one of Formulae 9-201 to 9-227 in which at least one hydrogen is substituted with deuterium" may be, for example, a group represented by one of Formulae 9-501 to 9-514 and 9-601 to 9-636: 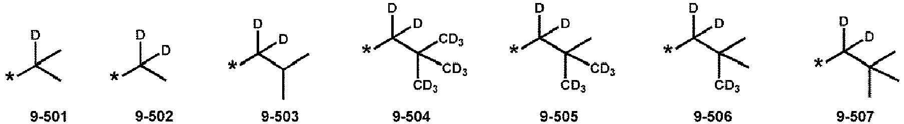 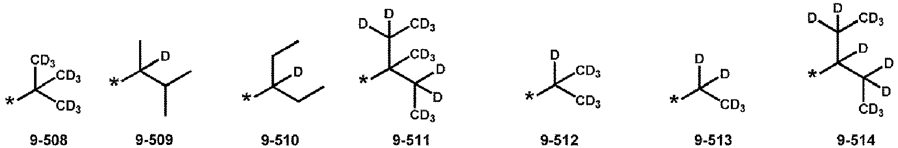 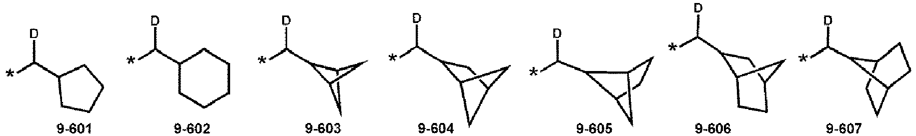 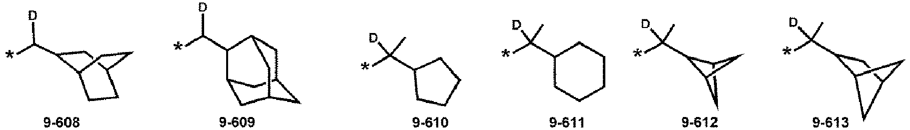 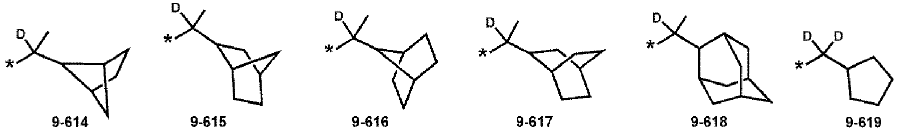 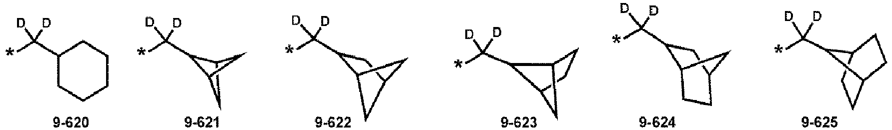 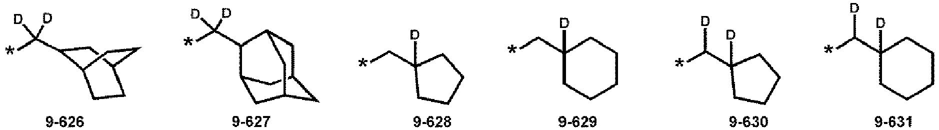 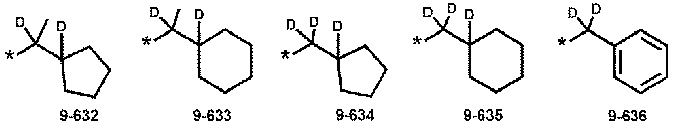 wherein * indicates a binding site to a neighboring atom

The "group represented by one of Formulae 9-1 to 9-39 in which at least one hydrogen is substituted with -F" and the "group represented by one of Formulae 9-201 to 9-227 in which at least one hydrogen is substituted with -F" may be, for example, a group represented by one of Formulae 9-701 to 9-710: 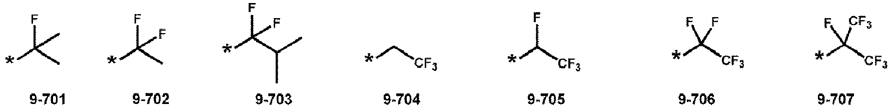 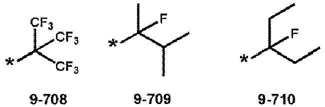 wherein * indicates a binding site to a neighboring atom

The "group represented by one of Formulae 10-1 to 10-129 in which at least one hydrogen is substituted with deuterium" and the "group represented by one of Formulae 10-201 to 10-350 in which at least one hydrogen is substituted with deuterium" may be, for example, a group represented by one of Formulae 10-501 to 10-553: 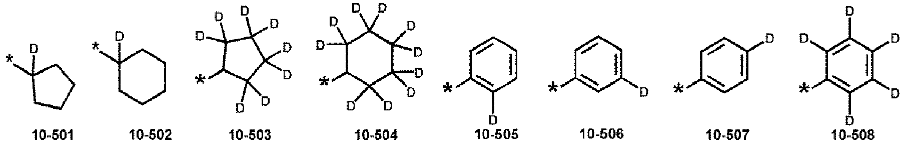 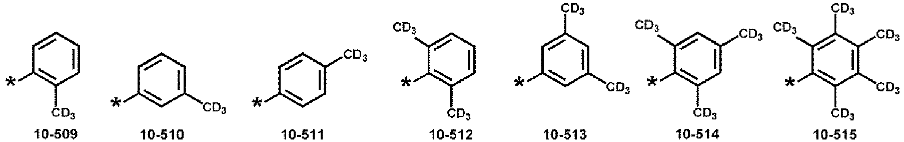 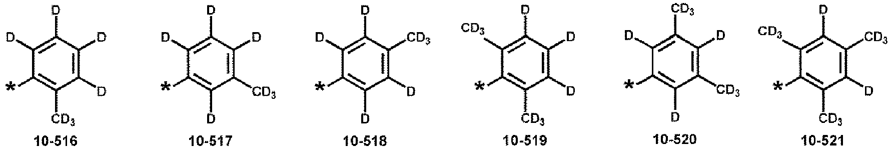 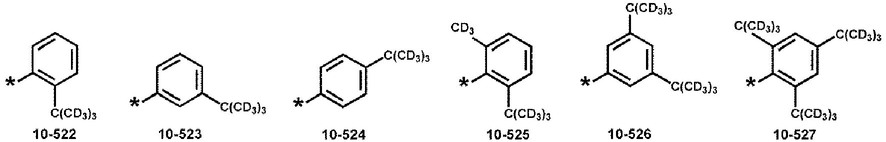 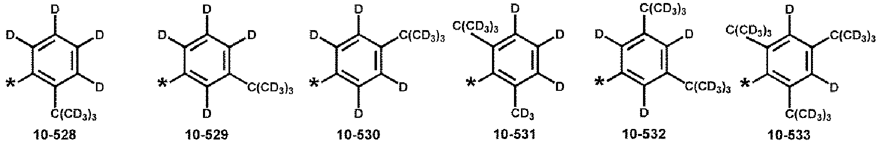 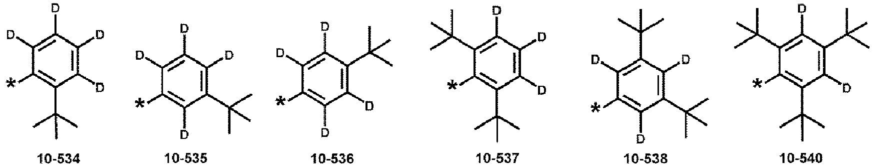 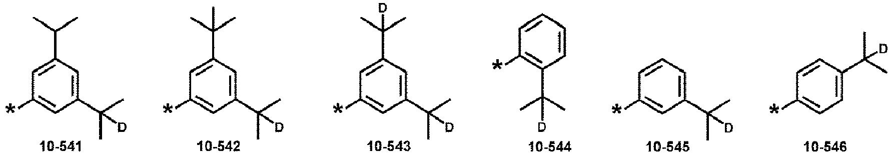 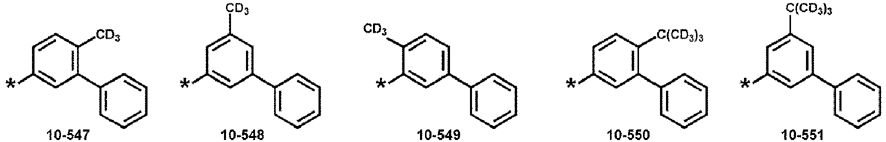 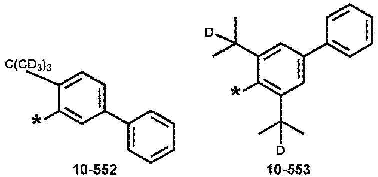 wherein * indicates a binding site to a neighboring atom

The "group represented by one of Formulae 10-1 to 10-129 in which at least one hydrogen is substituted with -F" and the "group represented by one of Formulae 10-201 to 10-350 in which at least one hydrogen is substituted with -F" may be, for example, a group represented by one of Formulae 10-601 to 10-617: 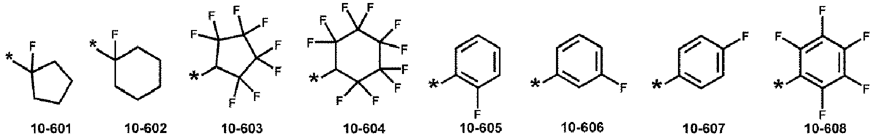 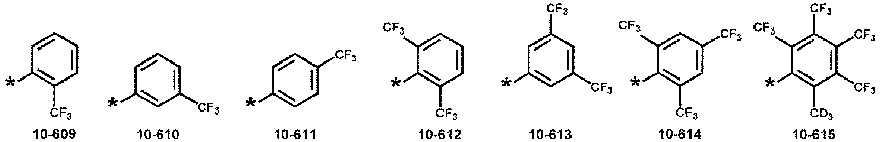 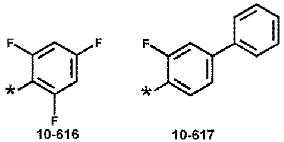 wherein * indicates a binding site to a neighboring atom.

e1 to e8 and d1 to d8 in Formulae 1-1, 1-2, 2-1, and 2-2 indicate numbers of Z₁ to Zsgroup(s), a group represented by *-[W₁-(Z₁)ₑ₁], a group represented by *-[W₂-(Z₂)ₑ₂], a group represented by *-[W₃-(Z₃)ₑ₃], a group represented by *-[W₄-(Z₄)ₑ₄], a group represented by *-[W₅-(Z₅)ₑ₅], a group represented by *-[W₆-(Z₆)ₑ₆], a group represented by *-[W₇-(Z₇)ₑ₇], and a group represented by *-[W₈-(Z₈)ₑ₈], respectively, and are each independently an integer from 0 to 20. When e1 is 2 or more, two or more of Z₁(s) may be identical to or different from each other, when e2 is 2 or more, two or more of Z₂(s) may be identical to or different from each other, when e3 is 2 or more, two or more of Z₃(s) may be identical to or different from each other, when e4 is 2 or more, two or more of Z₄(s) may be identical to or different from each other, when e5 is 2 or more, two or more of Z₅(s) may be identical to or different from each other, when e6 is 2 or more, two or more of Z₆(s) may be identical to or different from each other, when e7 is 2 or more, two or more of Z₇(s) may be identical to or different from each other, when e8 is 2 or more, two or more of Z₈(s) may be identical to or different from each other, when d1 is 2 or more, two or more of groups represented by *-[W₁-(Z₁)ₑ₁] may be identical to or different from each other, when d2 is 2 or more, two or more of groups represented by *-[W₂-(Z₂)ₑ₂] may be identical to or different from each other, when d3 is 2 or more, two or more of groups represented by *-[W₃-(Z₃)ₑ₃] may be identical to or different from each other, when d4 is 2 or more, two or more of groups represented by *-[W₄-(Z₄)ₑ₁] may be identical to or different from each other, when d5 is 2 or more, two or more of groups represented by *-[W₅-(Z₅)ₑ₅] may be identical to or different from each other, when d6 is 2 or more, two or more of groups represented by *-[W₆-(Z₆)ₑ₆] may be identical to or different from each other, when d7 is 2 or more, two or more of groups represented by *-[W₇-(Z₇)ₑ₇] may be identical to or different from each other, and when d8 is 2 or more, two or more of groups represented by *-[W₈-(Z₈)ₑ₈] may be identical to or different from each other. In one or more embodiments, e1 to e8 and d1 to d8 in Formulae 1-1, 1-2, 2-1, and 2-2 may each independently be 0, 1, 2, or 3.

* and *' herein each indicate a binding site to a neighboring atom, unless otherwise stated.

In Formulae 1-1, 1-2, 2-1, and 2-2, one or more of i) two or more of a plurality of Z₁(s), ii) two or more of a plurality of Z₂(s), iii) two or more of a plurality of Z₃(s), iv) two or more of a plurality of Z₄(s), v) two or more of a plurality of Z₅(s), vi) two or more of a plurality of Z₆(s), vii) two or more of a plurality of Z₇(s), and viii) two or more of a plurality of Z₈(s) are respectively optionally bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ.

R₁₀ₐ is as described in connection with Z₁ herein.

* and *' in Formulae 1-1, 1-2, 2-1, and 2-2 each indicate a binding site to iridium in Formulae 1 and 2.

In one or more embodiments, a group represented by 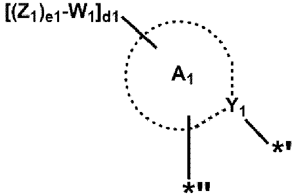 in Formula 1-1 may be a group represented by one of Formulae A1-1 to A1-3. In one or more embodiments, a group represented by 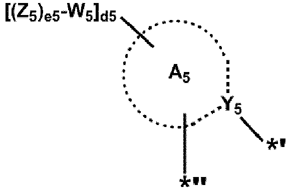 in Formula 2-1 may be a group represented by one of Formulae A5-1 to A5-3:

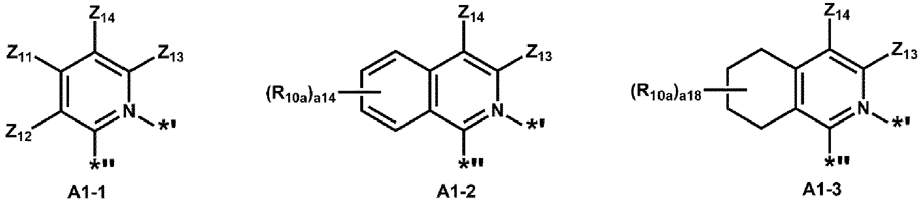

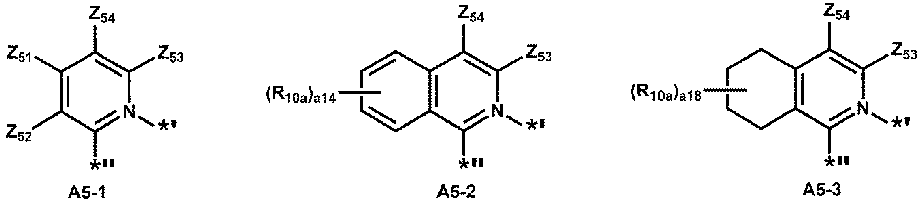

In Formulae A1-1 to A1-3 and A5-1 to A5-3,
Z₁₁ to Z₁₄ are respectively as described in connection with Z₁ herein,
Z₅₁ to Z₅₄ are respectively as described in connection with Z₅ herein,
R₁₀ₐ is as described herein,
a14 may be an integer from 0 to 4,
a18 may be an integer from 0 to 8,
*' indicates a binding site to iridium in Formulae 1 or 2, and
*" indicates a binding site to ring A₂ or ring A₆.

In one or more embodiments, at least one of Z₁₁, Z₁₂, and Z₁₄ (for example, Z₁₄) in Formulae A1-1 to A1-3 and at least one of Z₅₁, Z₅₂, and Z₅₄ (for example, Z₅₄) in Formulae A5-1 to A5-3 may each independently be:
a C₁-C₂₀ alkyl group that is unsubstituted or substituted with at least one of deuterium, -F, a phenyl group, or a combination thereof;
-Si(Q₃)(Q₄)(Q₅); or
-Ge(Q₃)(Q₄)(Q₅).

In one or more embodiments,
Y₃ in Formula 1-2 and Y₇ in Formula 2-2 may each be N, and
a group represented by 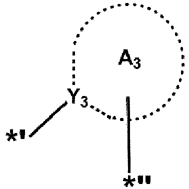 in Formula 1-2, and
a group represented by 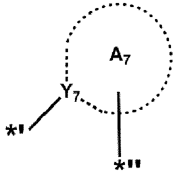 in Formula 2-2 may each independently be a group represented by one of Formulae NR1 to NR48: 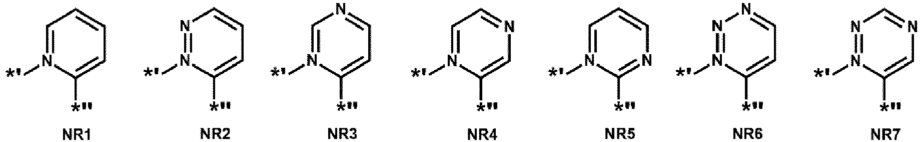 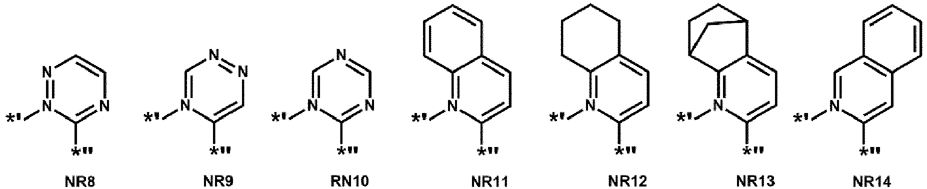 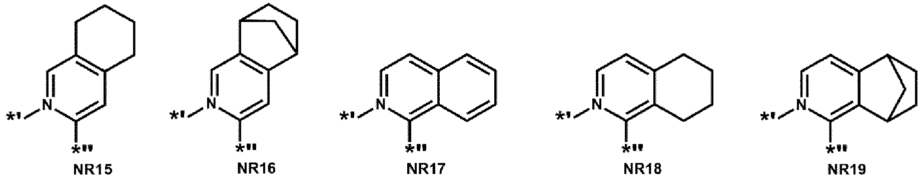 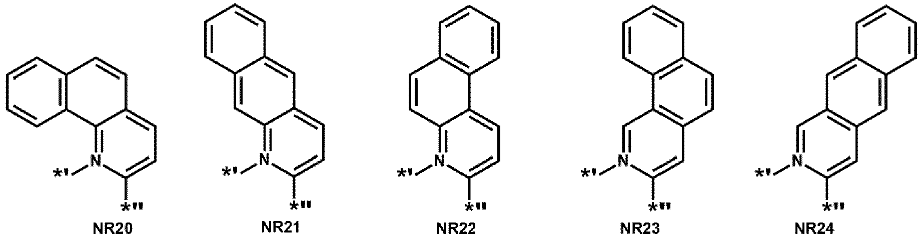 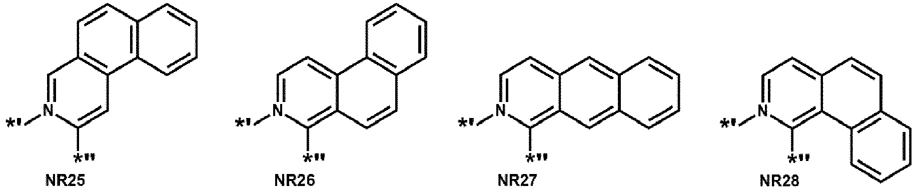 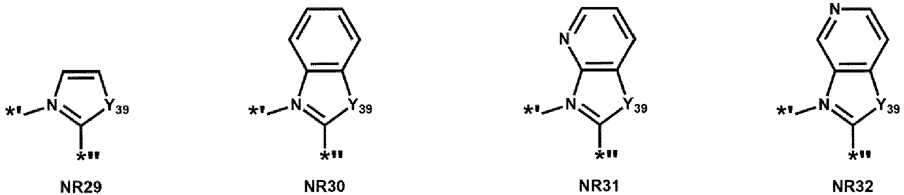 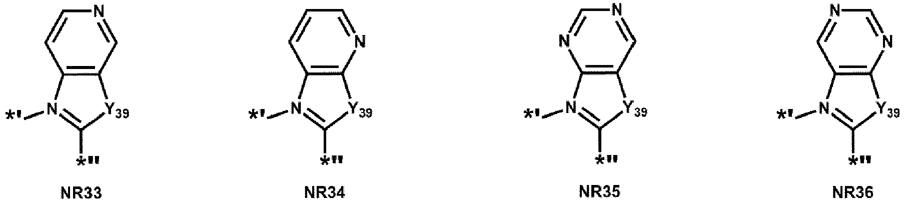 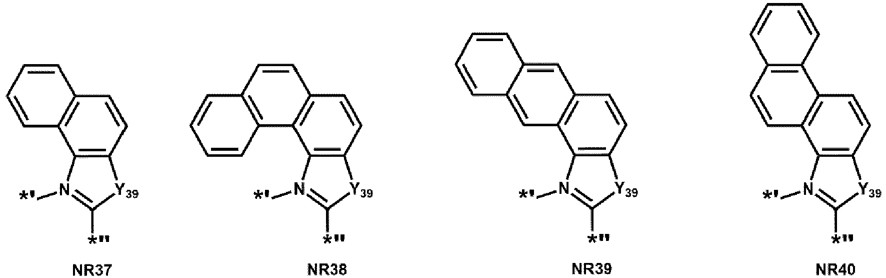 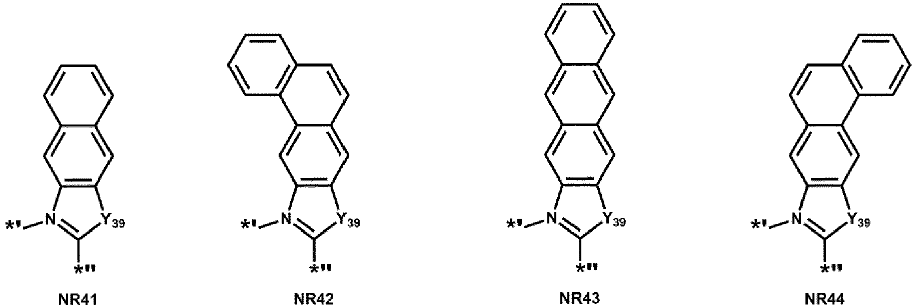 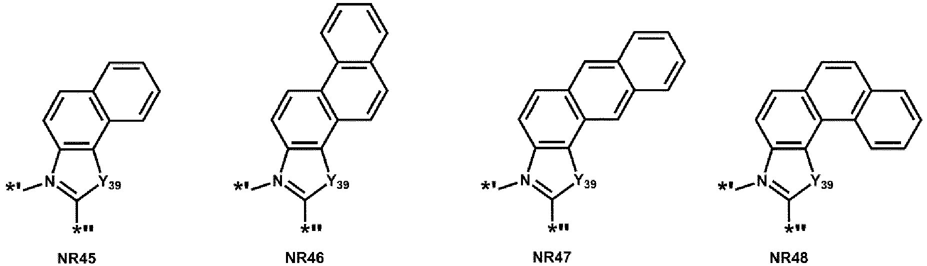
wherein, in Formulae NR1 to NR48,
Y₃₉ may be O, S, Se, N-[W₃-(Z₃)ₑ₃], N-[W₇-(Z₇)ₑ₇], C(Z₃₉ₐ)(Z_{39b}), C(Z₇₉ₐ)(Z_{79b}), Si(Z₃₉ₐ)(Z_{39b}), or Si(Z₇₉ₐ)(Z_{79b}),
W₃, W₇, Z₃, Z₇, e3, and e7 are respectively as described herein, Z₃₉ₐ and Z_{39b} are respectively as described in connection with Z₃ herein, and Z₇₉ₐ and Z_{79b} are each as described in connection with Z₇ herein,
*' indicates a binding site to iridium in Formula 1 or 2, and
*" indicates a binding site to ring A₄ or ring A₈.

In one or more embodiments, a group represented by 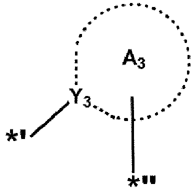 in Formula 1-2 may be a group represented by one of Formulae NR30 to NR48.

In one or more embodiments,
Y₂ in Formula 1-1, Y₄ in Formula 1-2, Y₆ in Formula 2-1, and Y₈ in Formula 2-2 may each be C, and
a group represented by 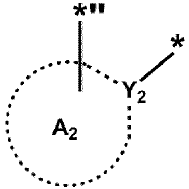 in Formula 1-1,
a group represented by 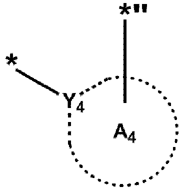 in Formula 1-2,
a group represented by 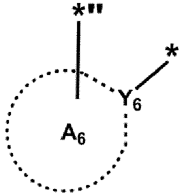 in Formula 2-1, and
a group represented by 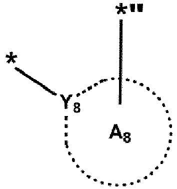 in Formula 2-2 may each independently be a group represented by one of Formulae CR1 to CR29: 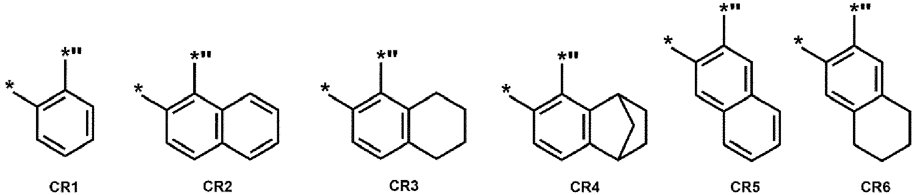 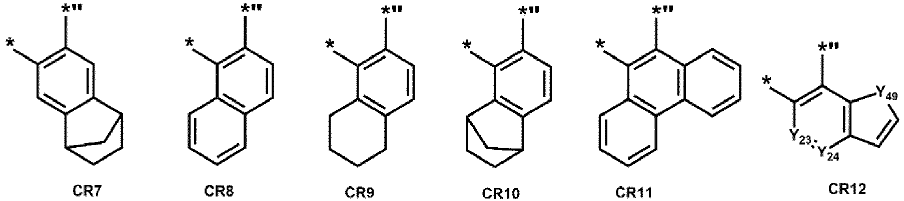 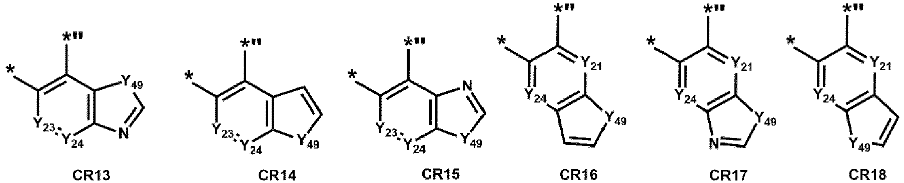 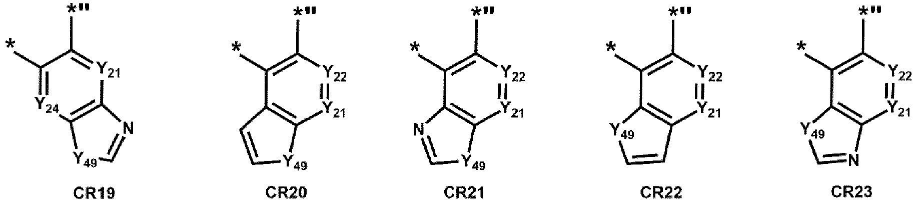 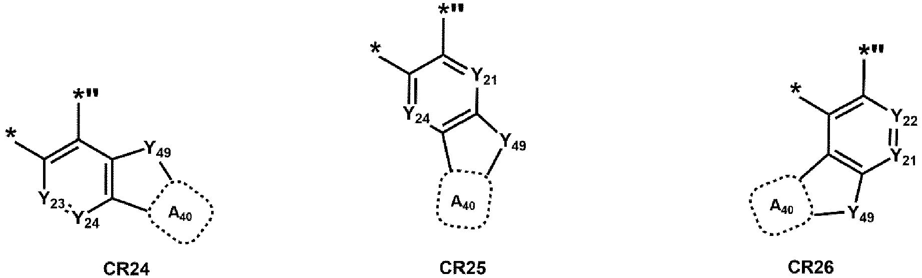 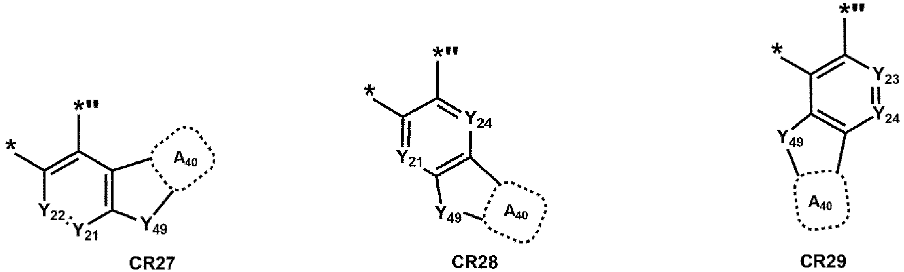
wherein, in Formulae CR1 to CR29,
Y₄₉ may be O, S, Se, N-[W₂-(Z₂)ₑ₂], N-[W₄-(Z₄)ₑ₄], N-[W₆-(Z₆)ₑ₆], N-[W₈-(Z₈)ₑ₈], C(Z₂₉ₐ)(Z_{29b}), C(Z₄₉ₐ)(Z_{49b}), C(Z₆₉ₐ)(Z_{69b}), C(Z₈₉ₐ)(Z_{89b}), Si(Z₂₉ₐ)(Z_{29b}), Si(Z₄₉ₐ)(Z_{49b}), Si(Z₆₉ₐ)(Z_{69b}), or Si(Z₈₉ₐ)(Z_{89b}),
W₂, W₄, W₆, W₈, Z₂, Z₄, Z₆, Z₈, e2, e4, e6, and e8 are respectively as described herein, Z₂₉ₐ and Z_{29b} are respectively as described in connection with Z₂ herein, Z₄₉ₐ and Z_{49b} are respectively as described in connection with Z₄ herein, Z₆₉ₐ and Z_{69b} are respectively as described in connection with Z₆ herein, and Z₈₉ₐ and Z_{89b} are respectively as described in connection with Z₈ herein,
Y₂₁ to Y₂₄ may each independently be N or C,
ring A₄₀ may be a C₅-C₃₀ carbocyclic group or a C₁-C₃₀ heterocyclic group (for example, a benzene group, a naphthalene group, a phenanthrene group, a pyridine group, a pyrimidine group, a pyrazine group, a pyridazine group, a quinoline group, an isoquinoline group, a benzoquinoline group, a benzoisoquinoline group, a quinoxaline group, a benzoquinoxaline group, a quinazoline group, or benzoquinazoline group),
* indicates a binding site to iridium in Formulae 1 and 2, and
*" indicates a binding site to ring A₁, ring A₃, ring A₅, and ring A₇.

In one or more embodiments, a group represented by 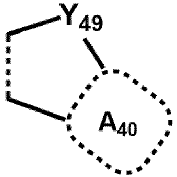 in Formulae CR24 to CR29 may be a group represented by one of Formulae CR(1) to CR(13): 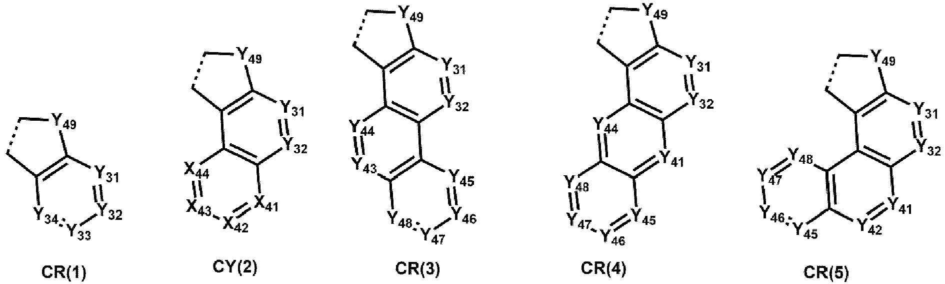 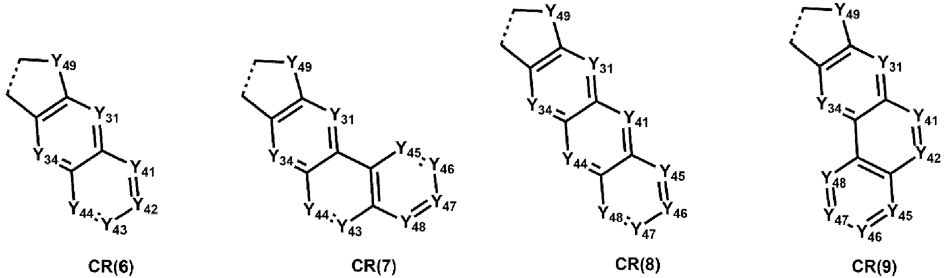 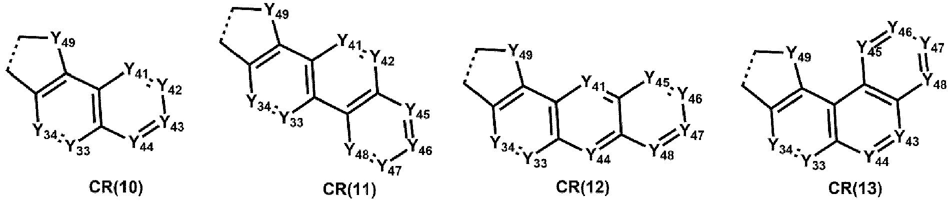 wherein, in Formulae CR(1) to CR(13),
Y₄₉ is as described herein, and
Y₃₁ to Y₃₄ and Y₄₁ to Y₄₈ may each independently be C or N.

In one or more embodiments, the first compound may include at least one deuterium.

In one or more embodiments, the second compound may include at least one deuterium.

The first compound may emit a first light including a first spectrum, and λP(1) may be an emission peak wavelength (in nanometers, nm) of the first spectrum.

The second compound may emit a second light including a second spectrum, and λP(2) may be an emission peak wavelength (nm) of the second spectrum.

The λP(1) and the λP(2) may be evaluated from a photoluminescence (PL) spectra measured for a first film and a second film, respectively.

As used herein, the "first film" is a film including the first compound, and the "second film" is a film including the second compound. The first film and the second film may be manufactured using various methods such as any method, for example, a vacuum deposition method, a coating and heating method. The first film and the second film may further include other compounds, for example, a host described herein, in addition to the first compound and the second compound.

In one or more embodiments, each of the λP(1) and the λP(2) may be 480 nm to 580 nm, or about 510 nm to about 570 nm.

In one or more embodiments, an absolute value of a difference between the λP(1) and the λP(2) may be 0 nm to 30 nm, 0 nm to about 20 nm, or 0 nm to about 10 nm.

In one or more embodiments, the first light and the second light may each be green light.

In one or more embodiments, the first light may be green light, and the second light may be yellow-green light.

In one or more embodiments, the first light and the second light may each be yellow-green light.

In one or more embodiments, the first light may be yellow-green light, and the second light may be yellow light.

In one or more embodiments, the first light and the second light may each be yellow light.

In one or more embodiments, L₁₁ and L₁₃ in Formula 1, L₂₁ and L₂₃ in Formula 2, a ligand represented by Formula 1-1, and a ligand represented by Formula 2-1 may each independently be represented by one of Formulae A1 to A380:

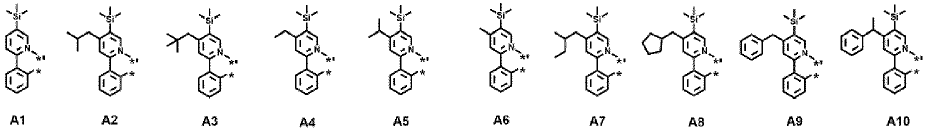

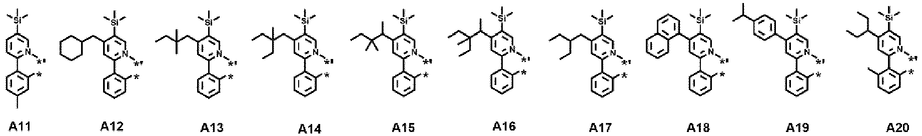

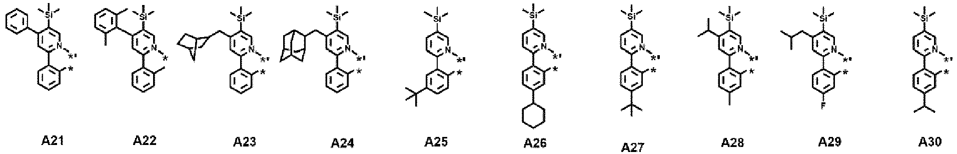

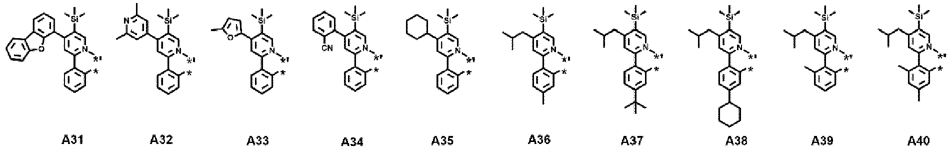

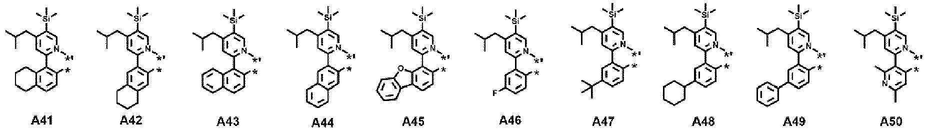

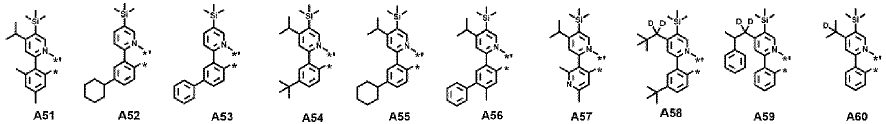

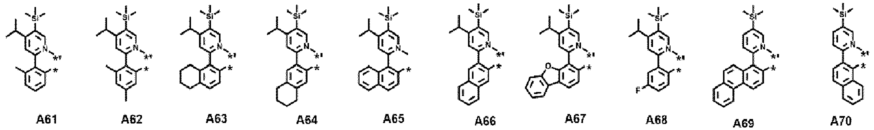

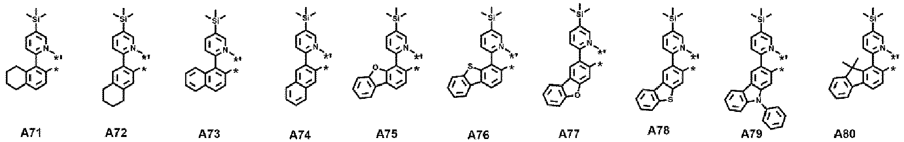

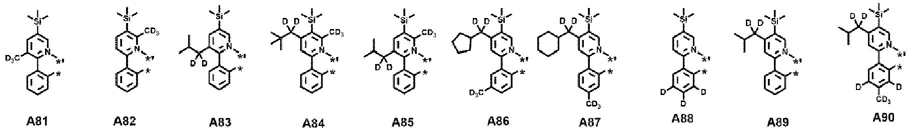

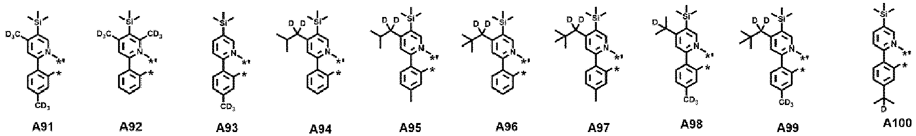

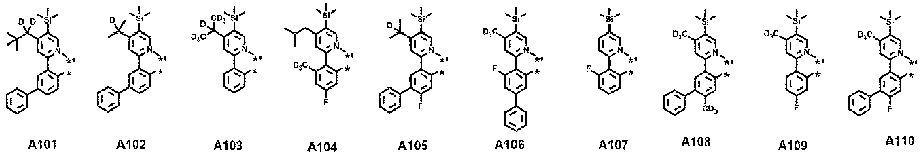

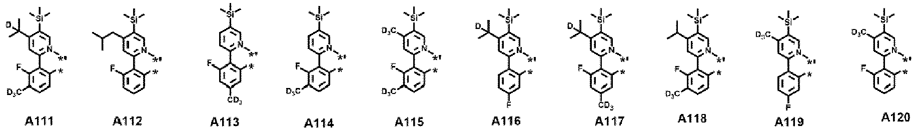

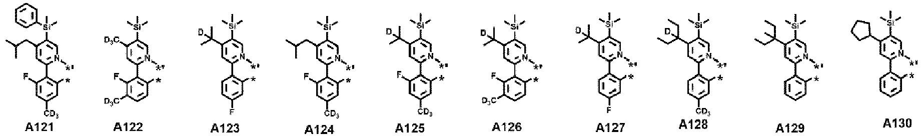

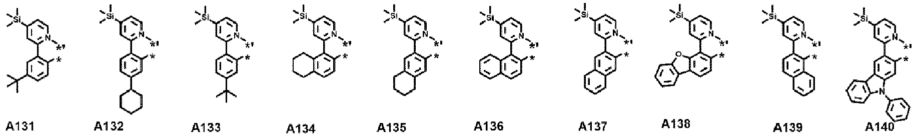

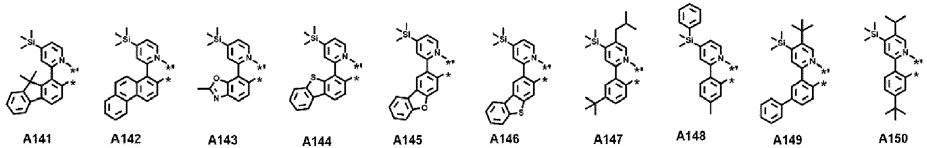

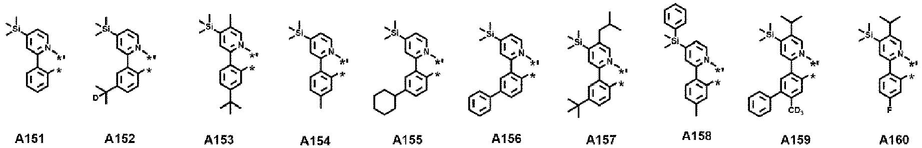

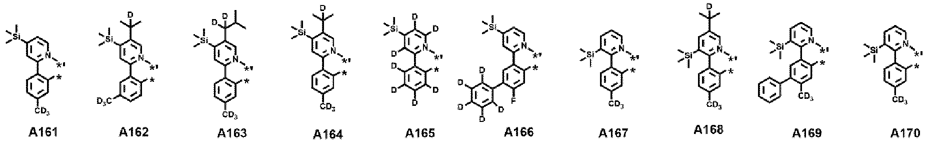

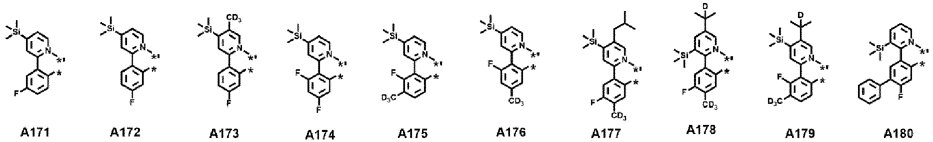

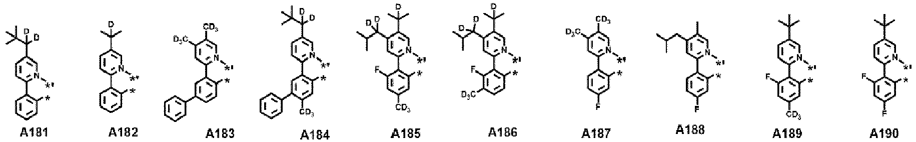

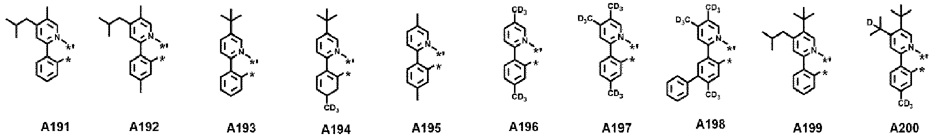

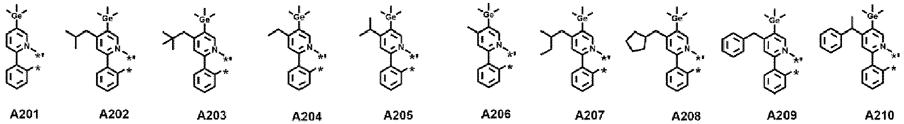

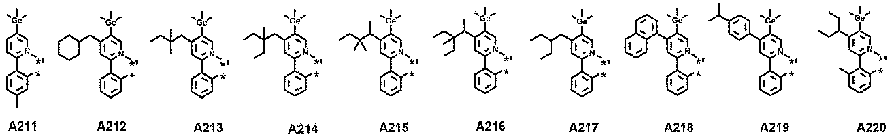

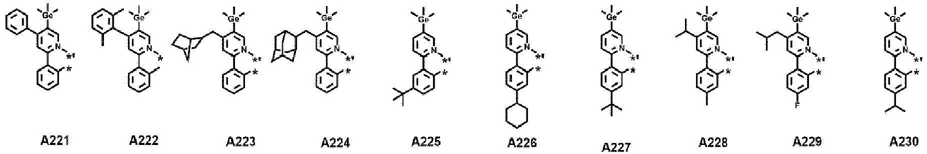

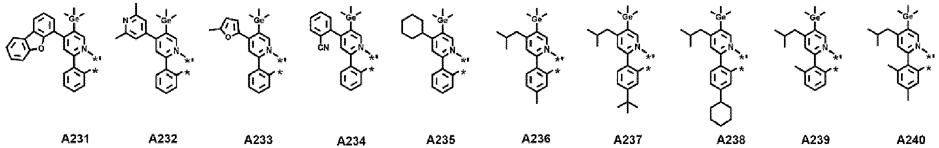

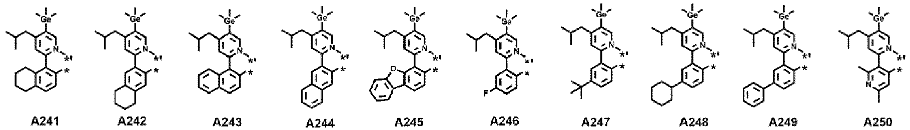

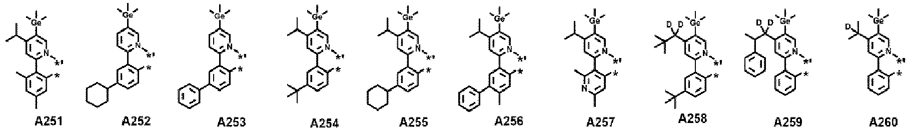

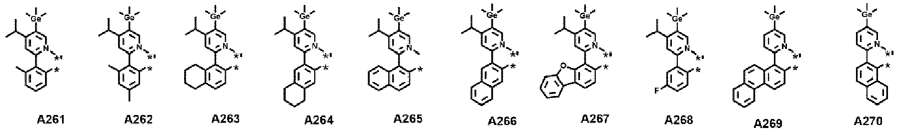

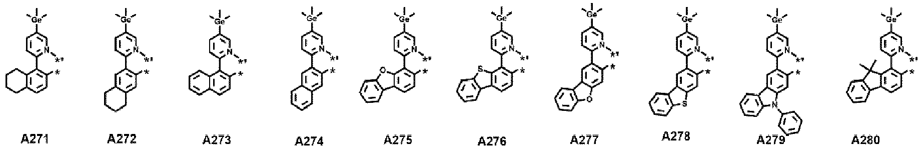

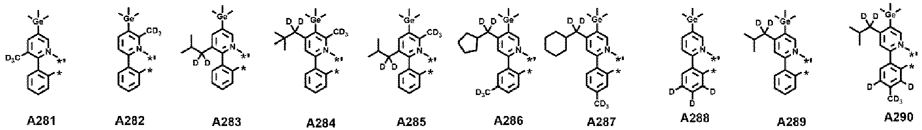

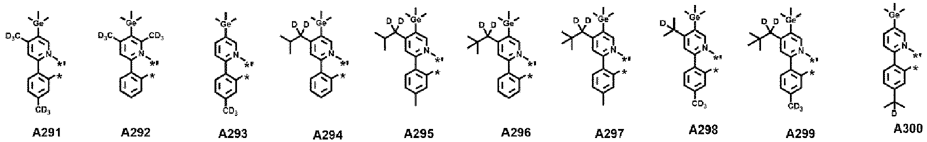

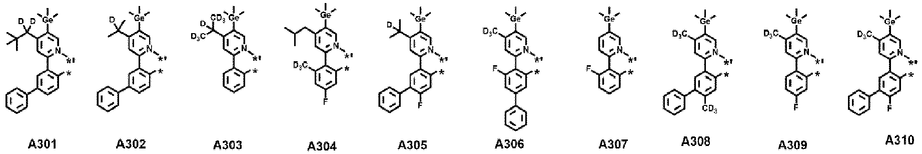

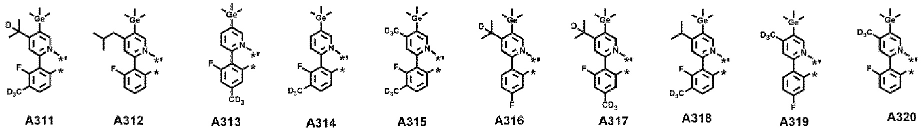

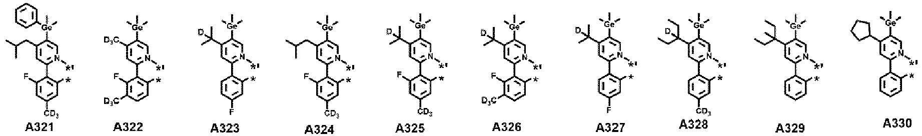

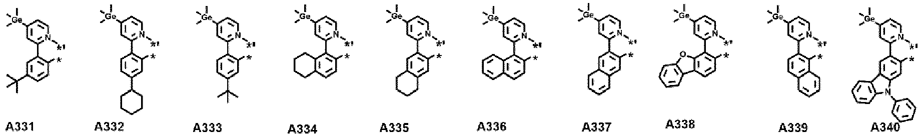

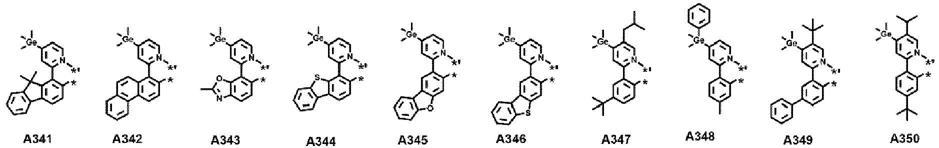

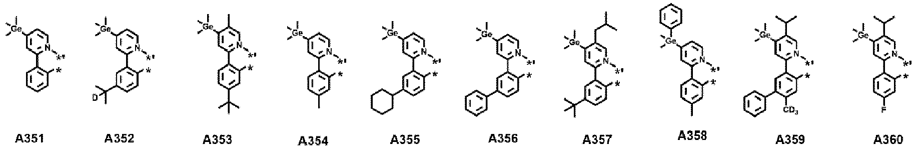

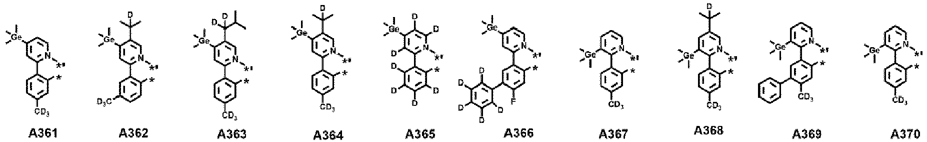

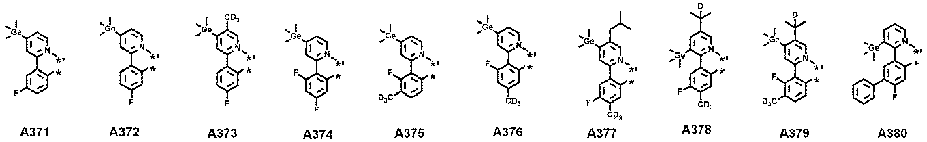

In one or more embodiments, L₁₂ and L₁₃ in Formula 1, L₂₂ and L₂₃ in Formula 2, a ligand represented by Formula 1-2, and a ligand represented by Formula 2-2 may each independently be represented by one of B1 to B1542: 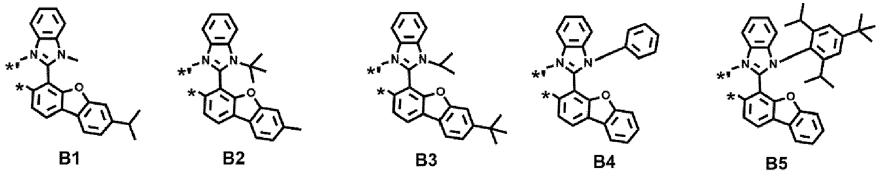 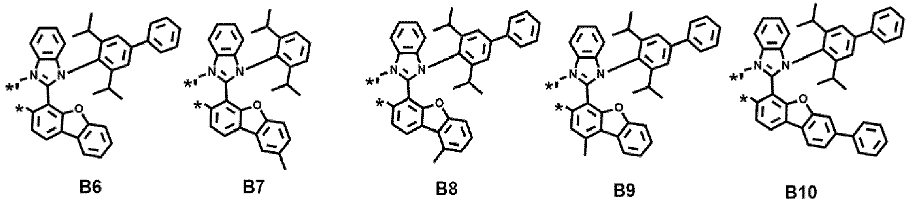 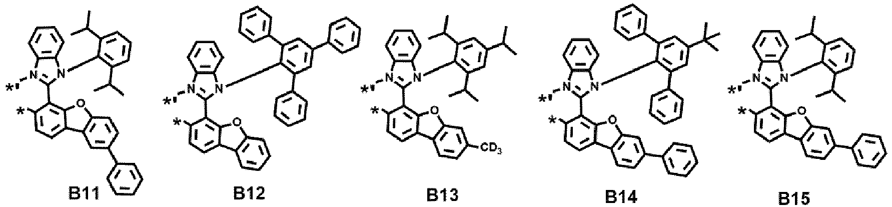 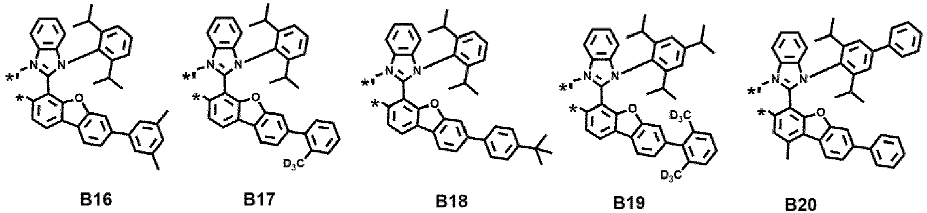 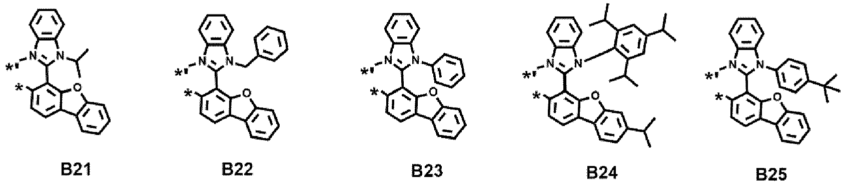 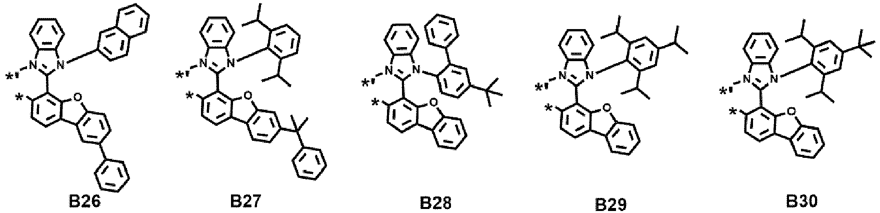 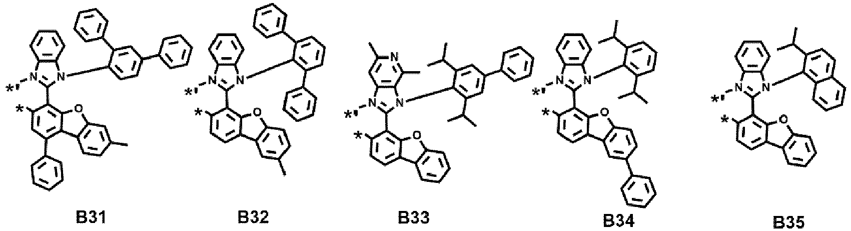 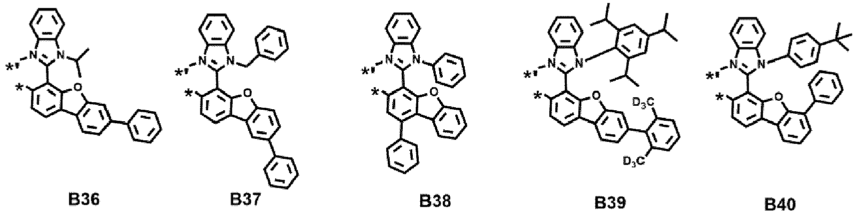 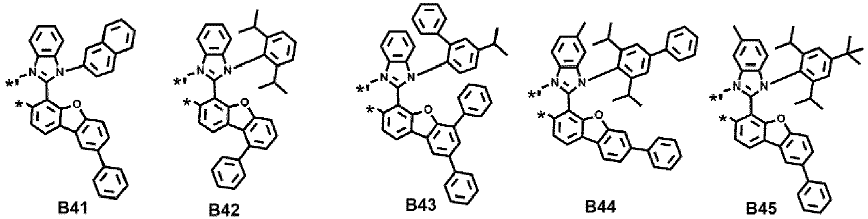 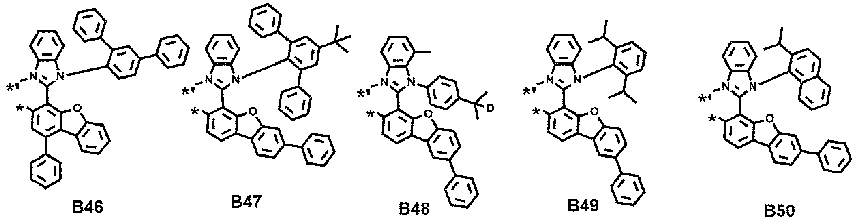 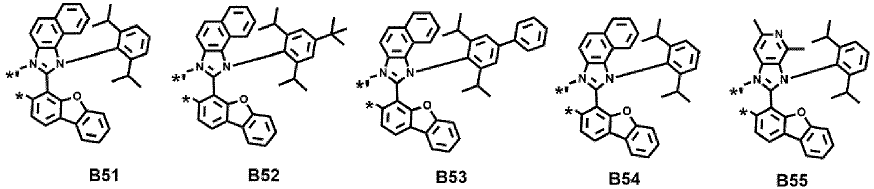 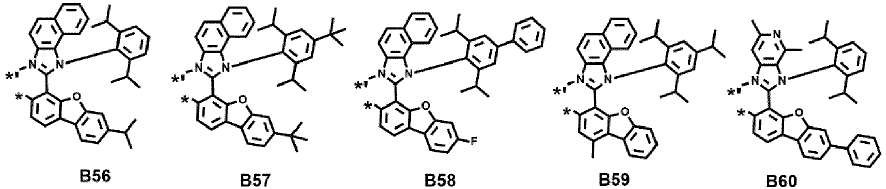 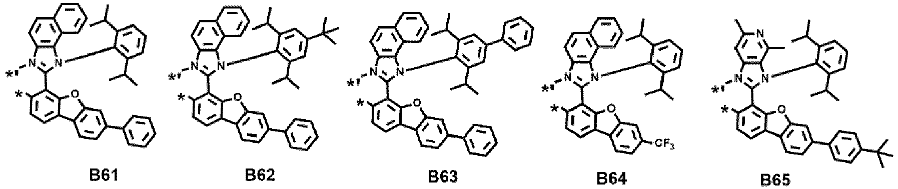 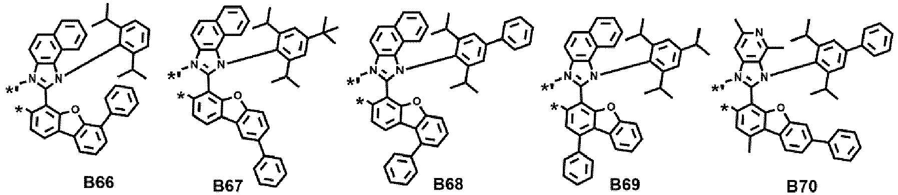 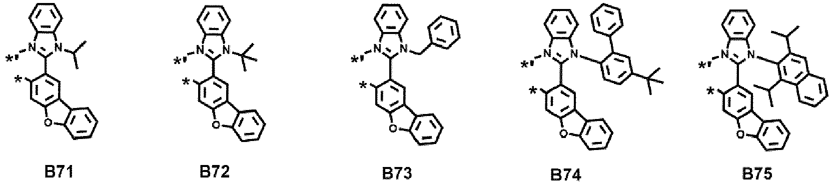 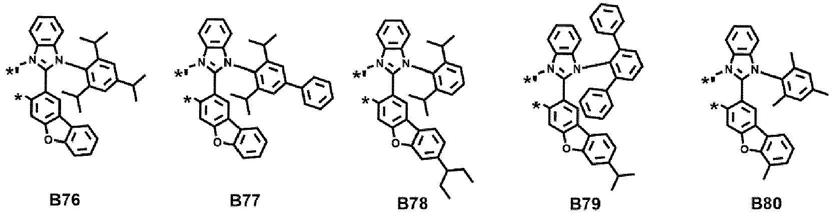 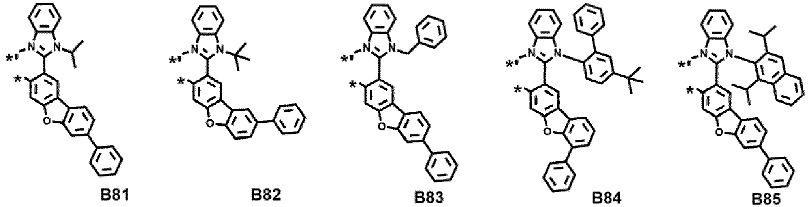 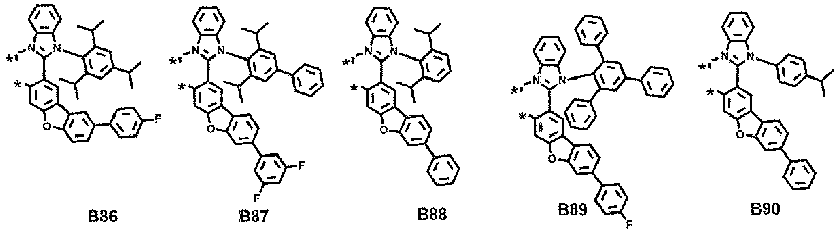 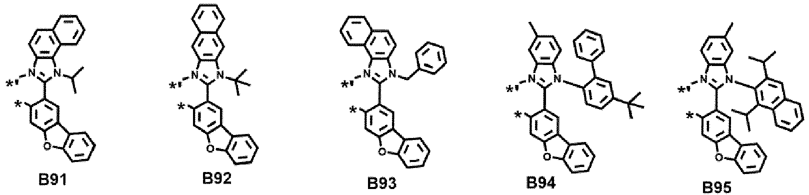 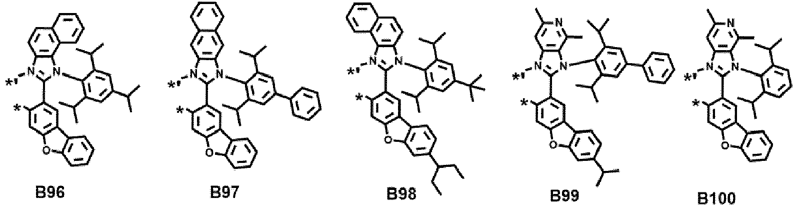 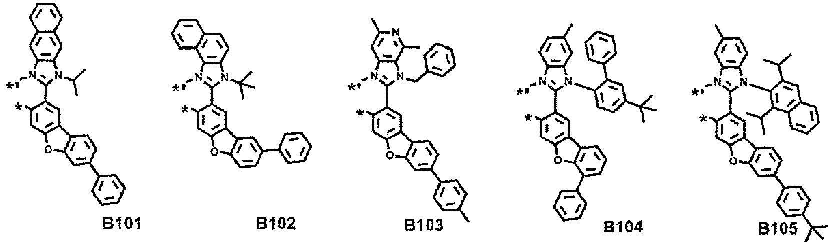 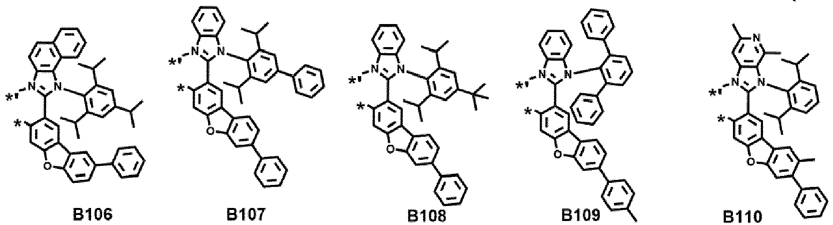 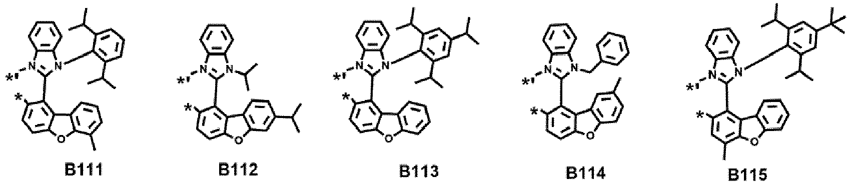 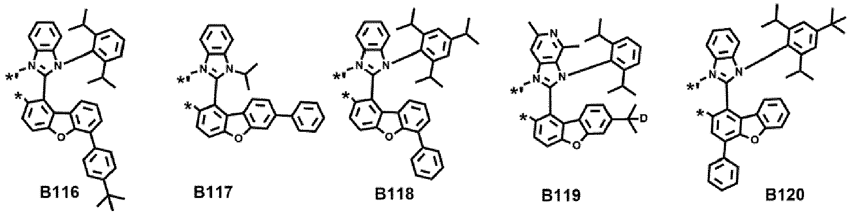 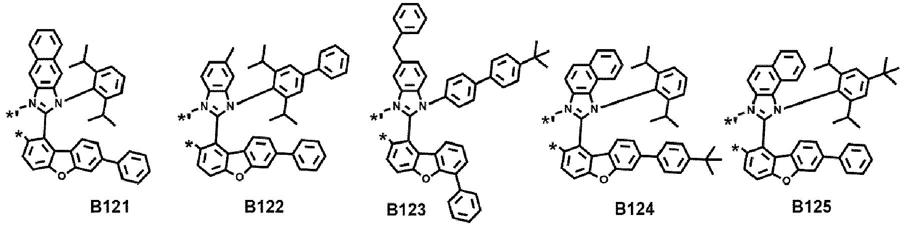 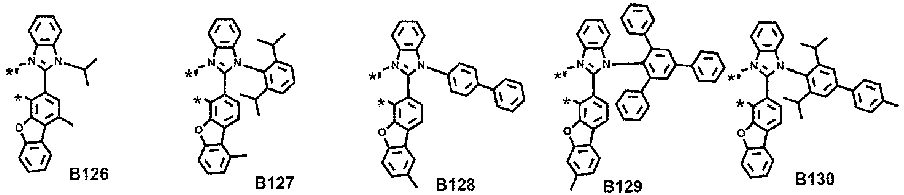 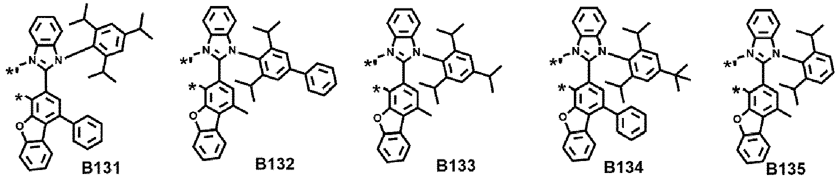 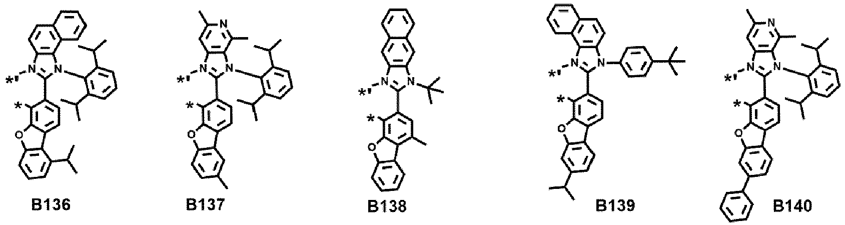 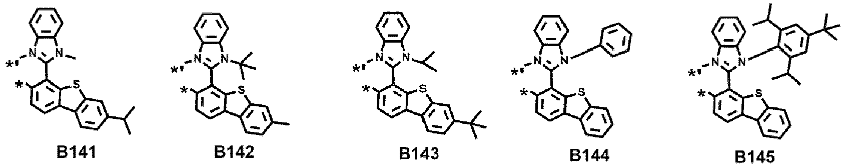 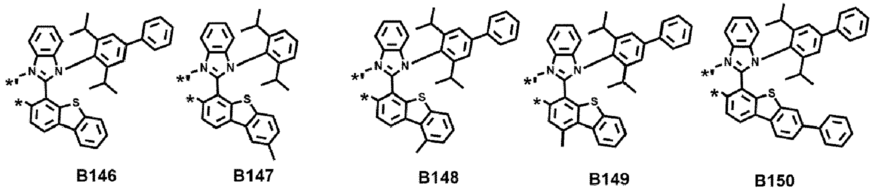 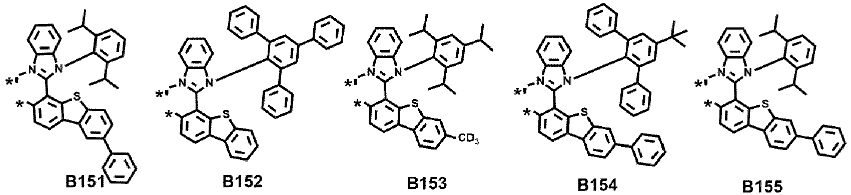 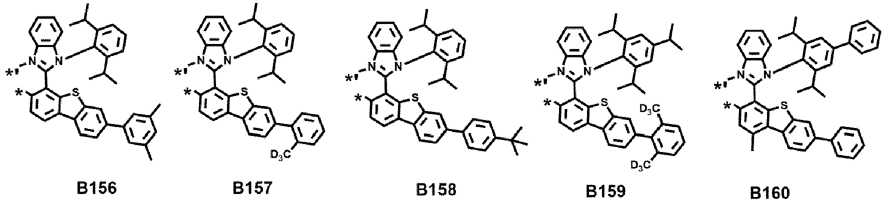 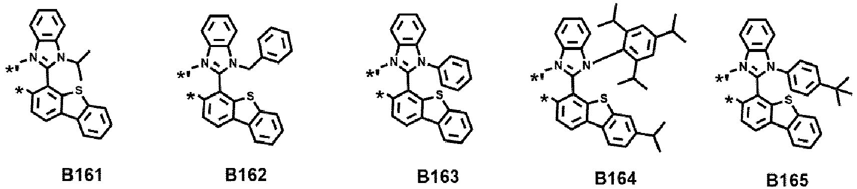 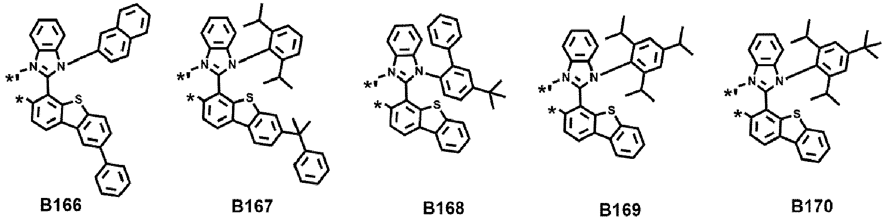 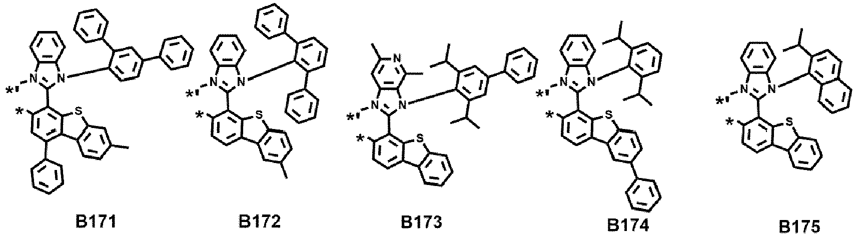 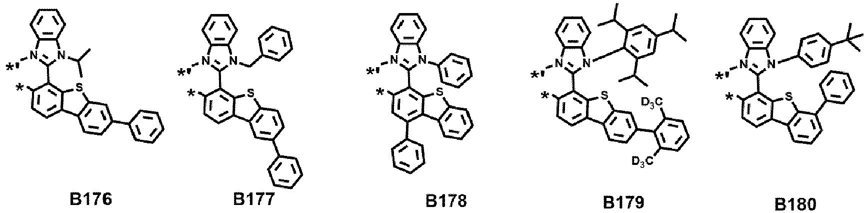 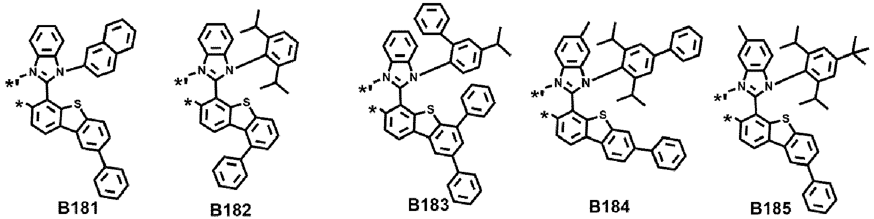 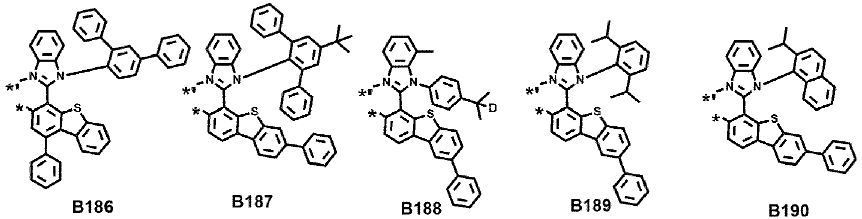 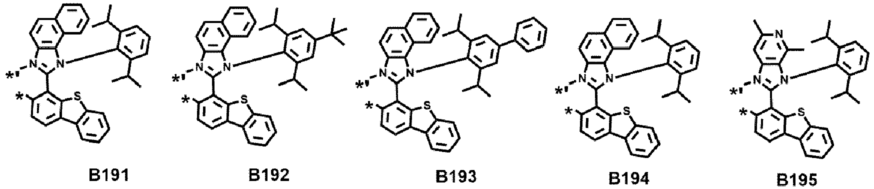 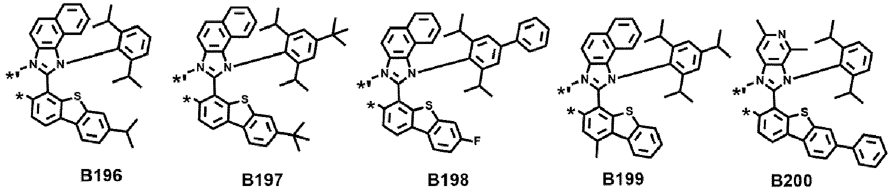 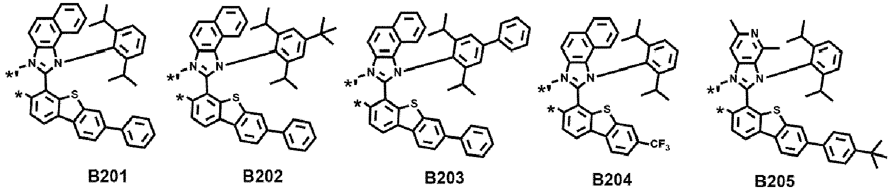 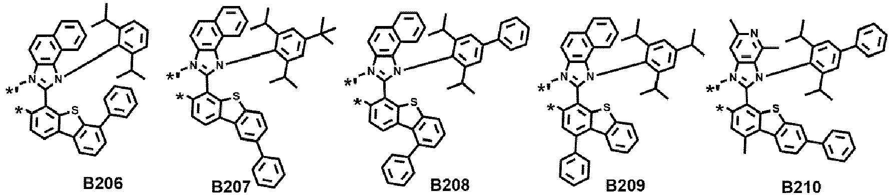 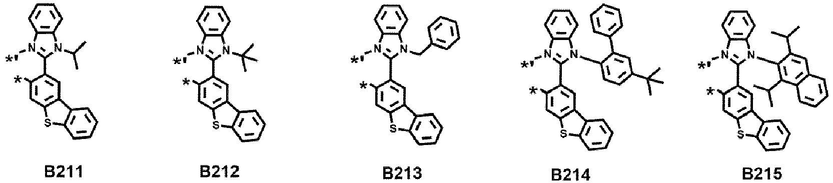 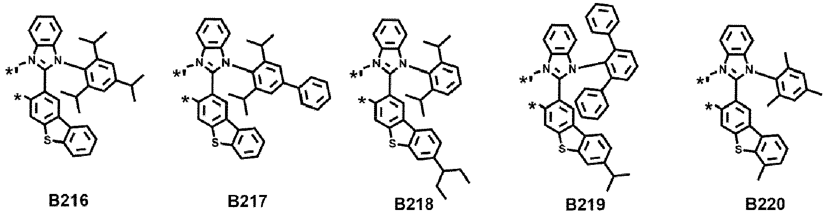 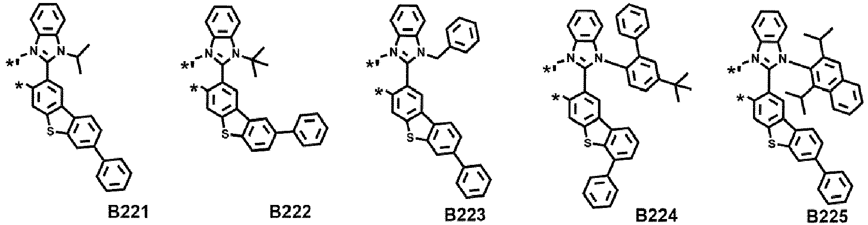 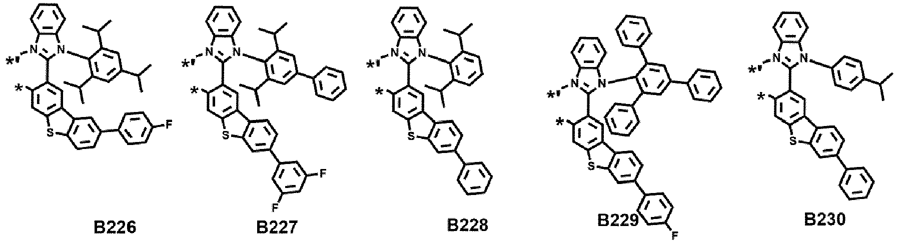 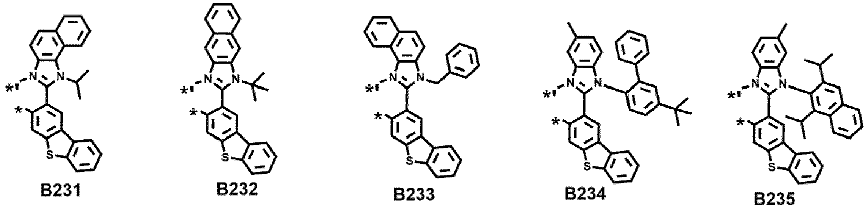 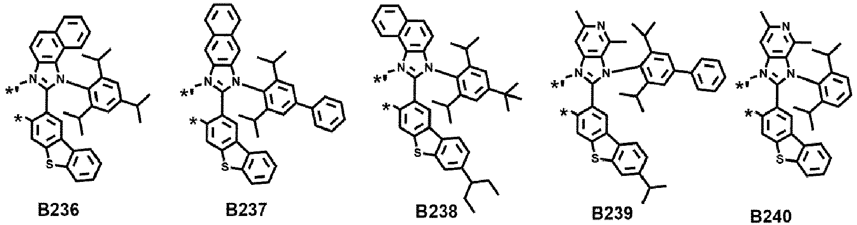 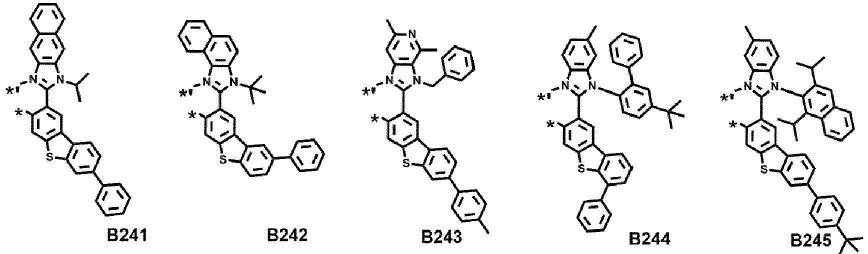 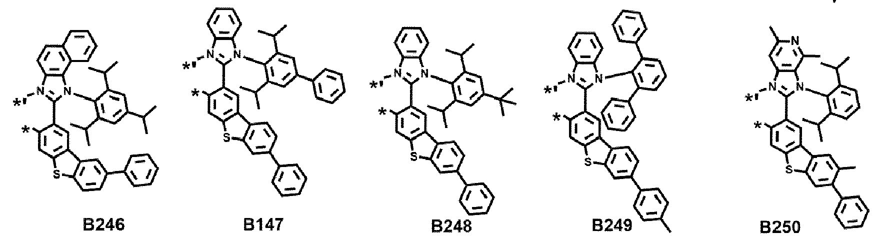 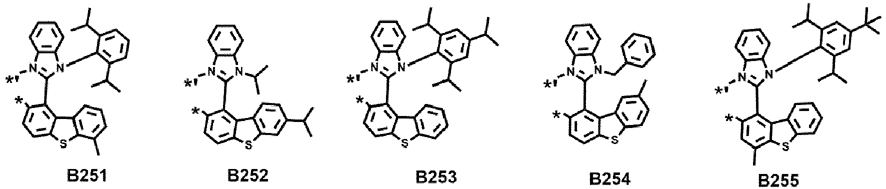 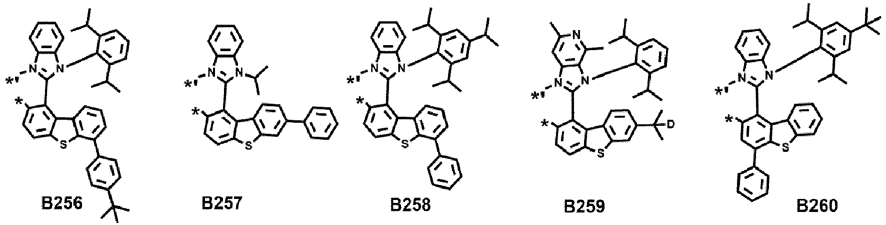 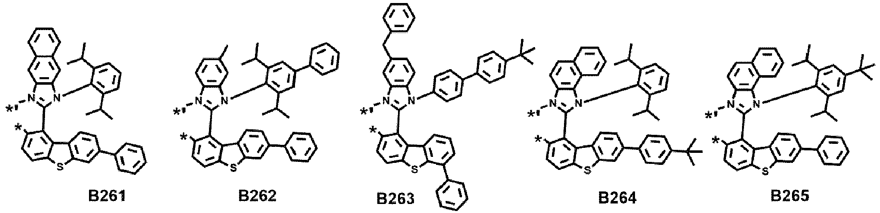 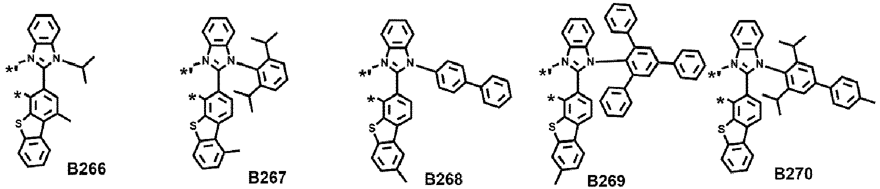 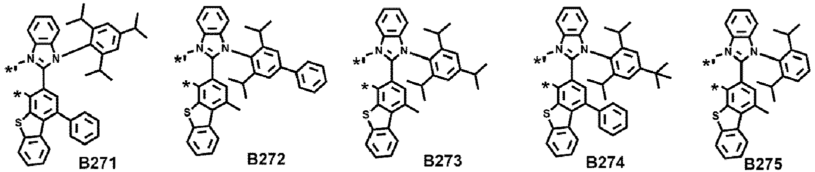 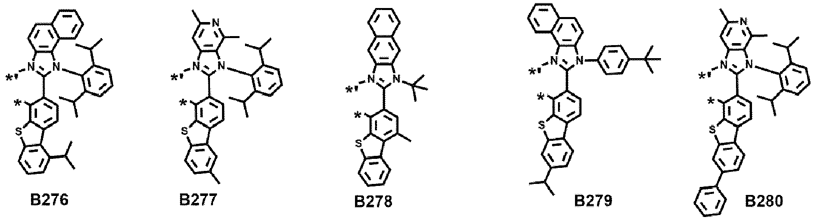 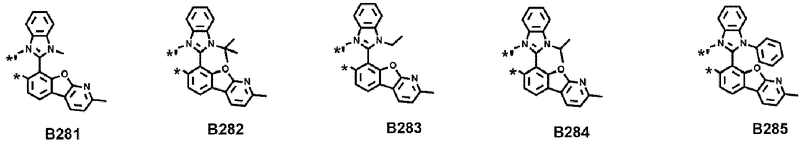 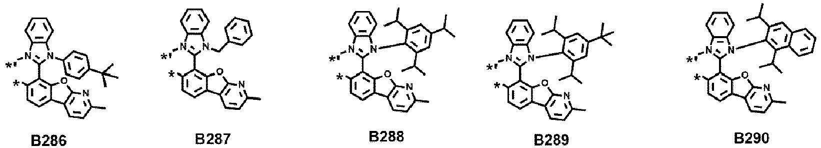 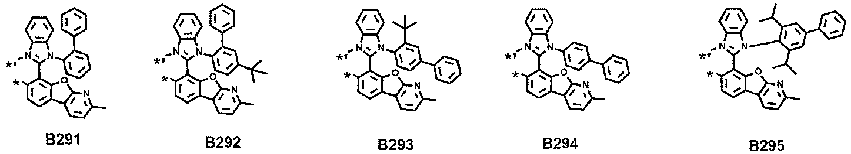 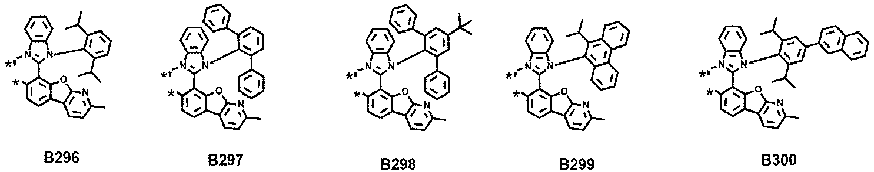 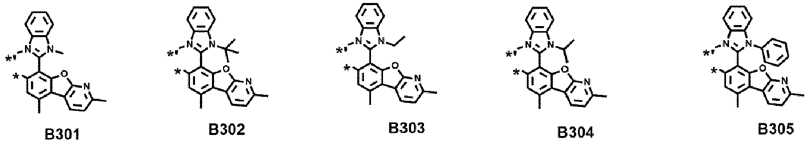 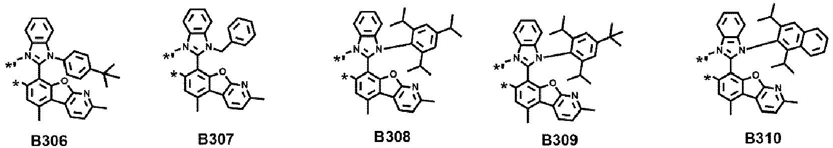 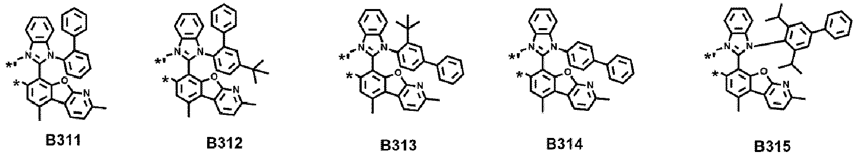 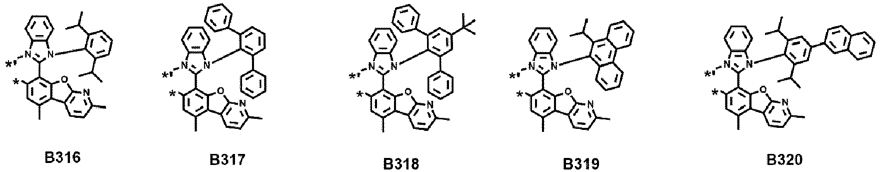 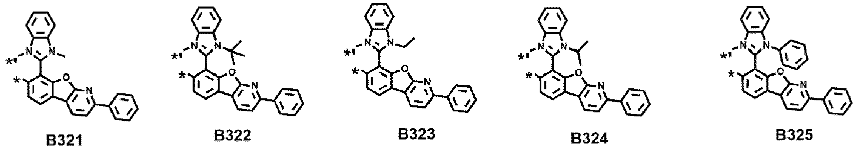 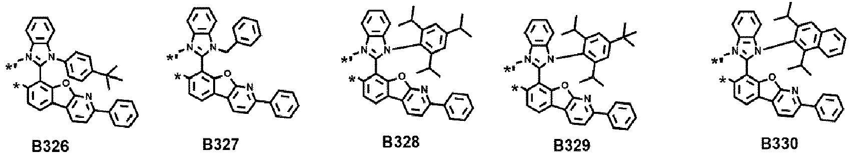 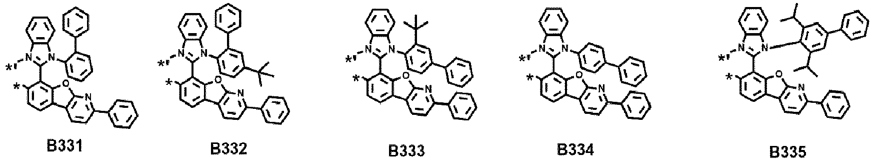 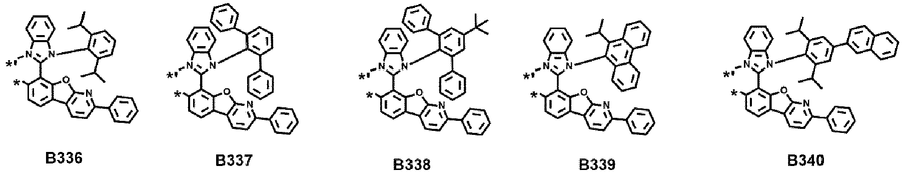 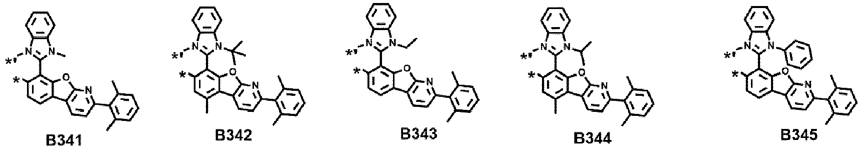 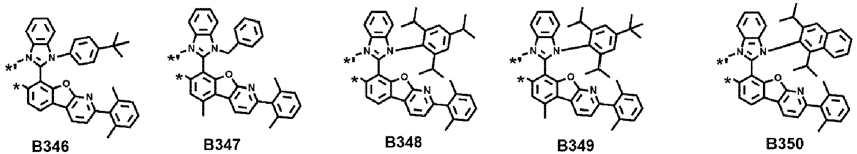 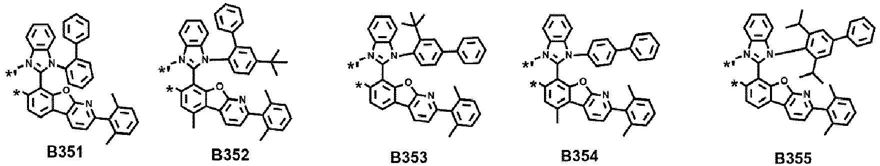 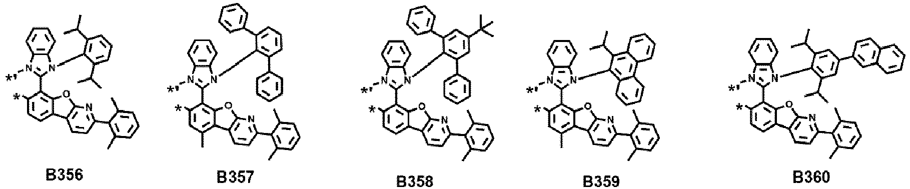 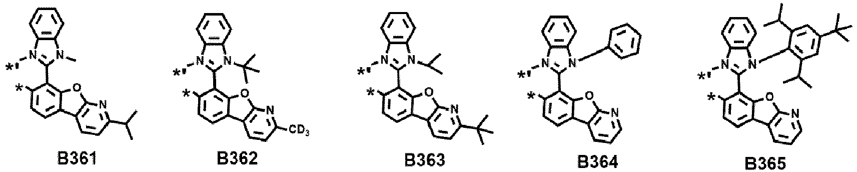 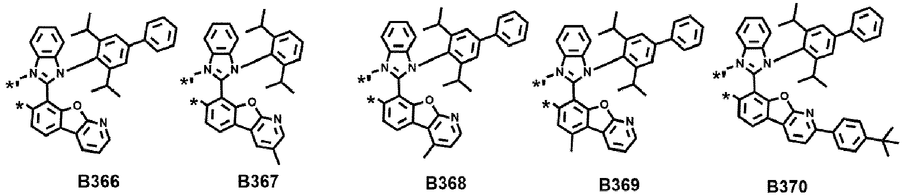 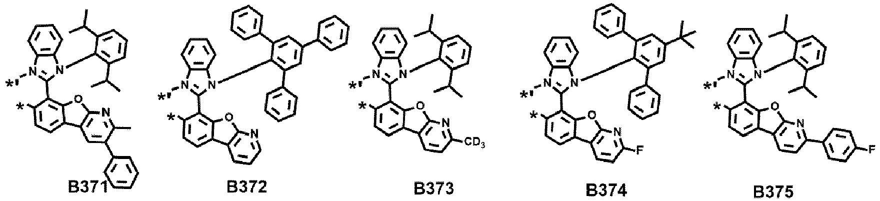 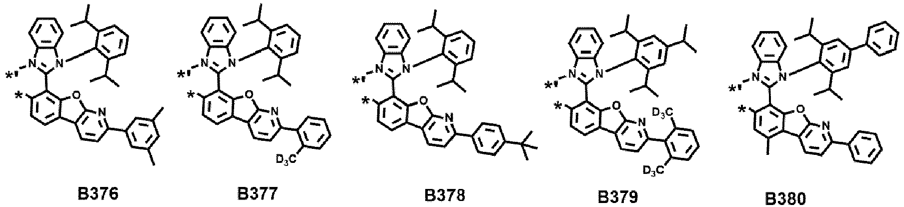 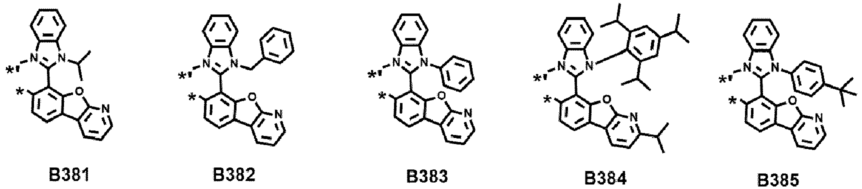 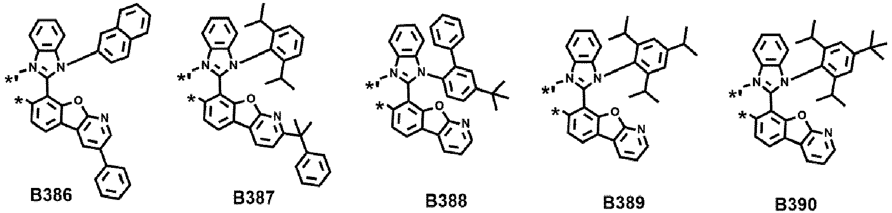 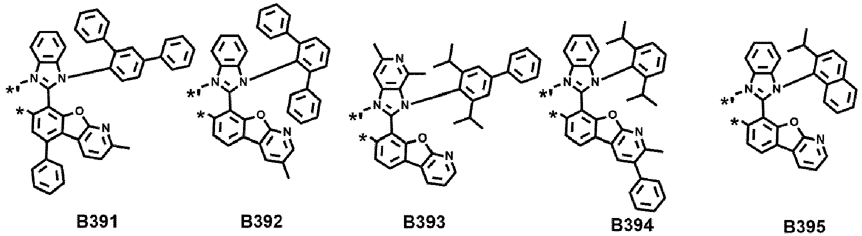 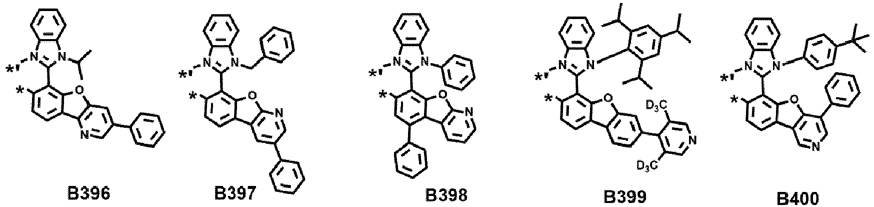 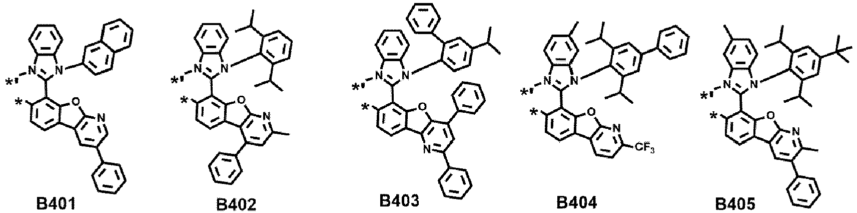 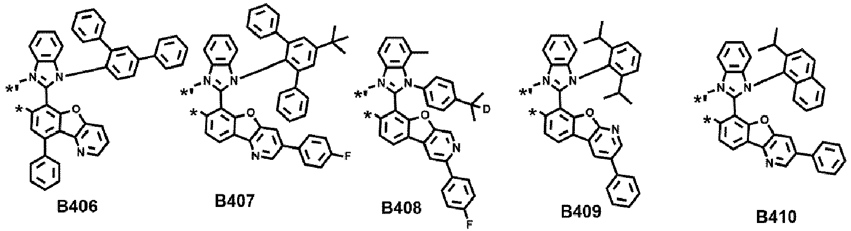 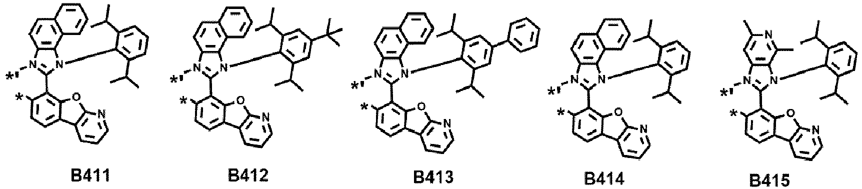 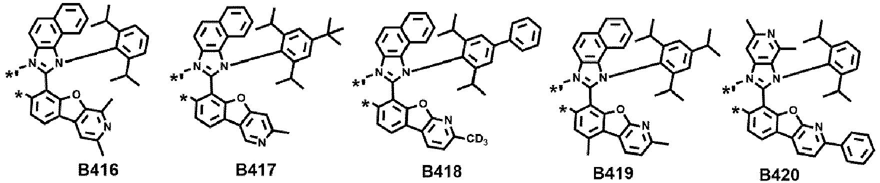 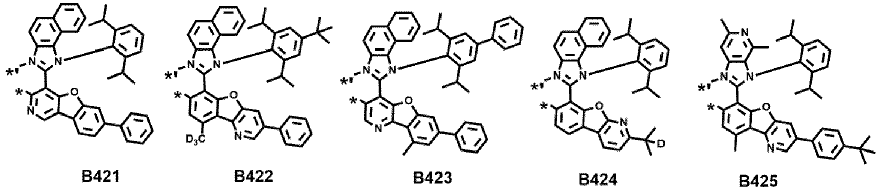 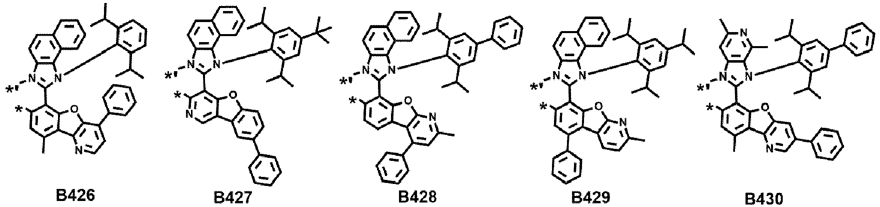 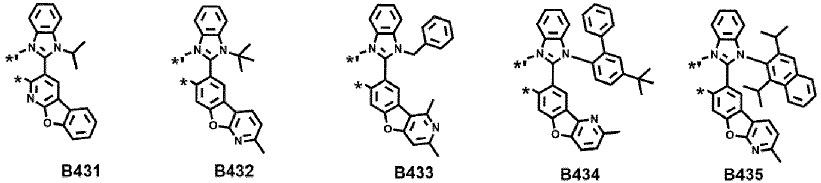 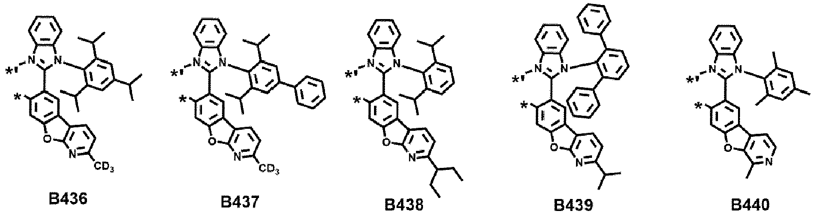 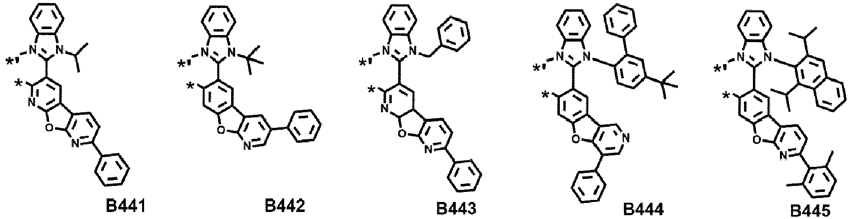 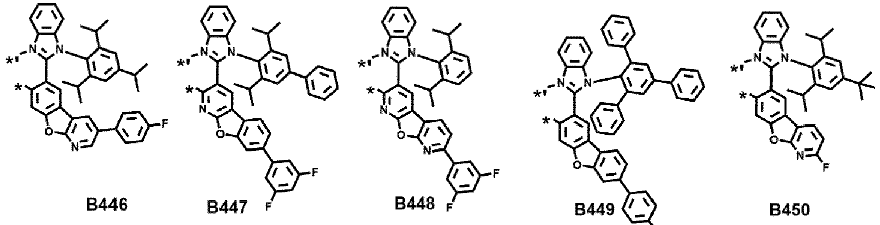 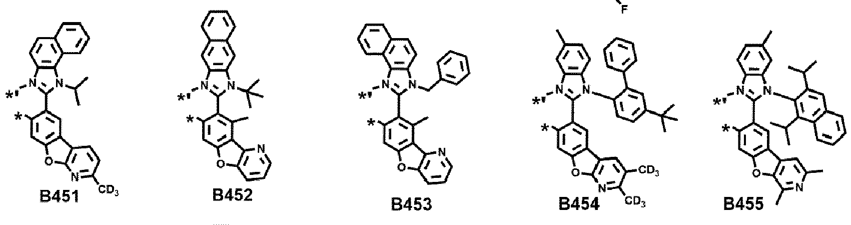 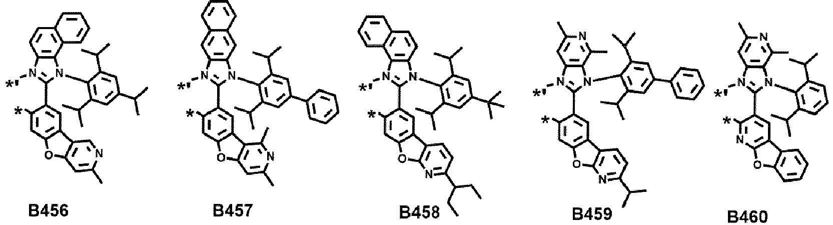 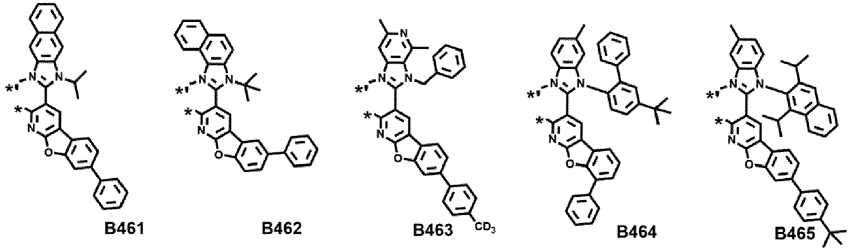 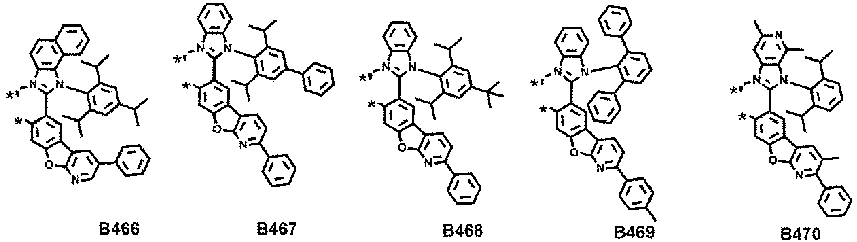 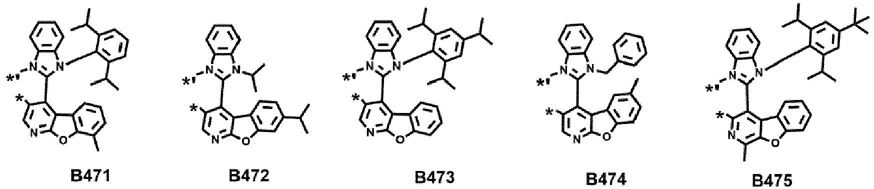 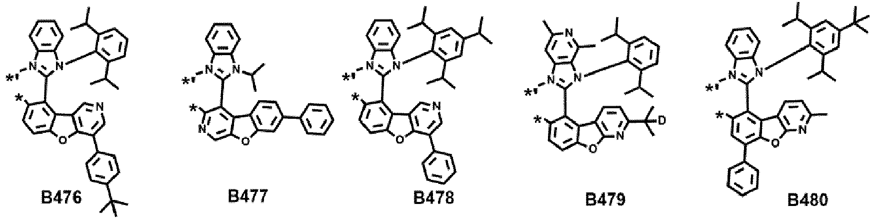 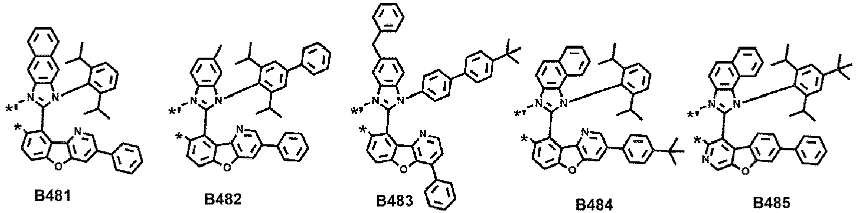 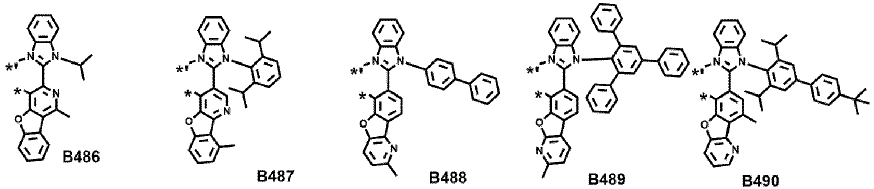 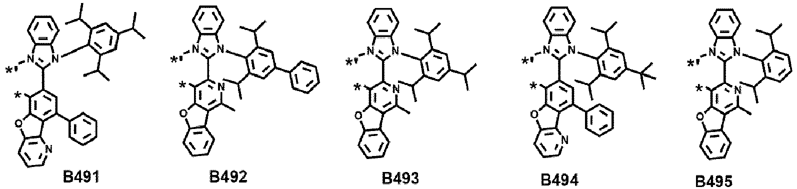 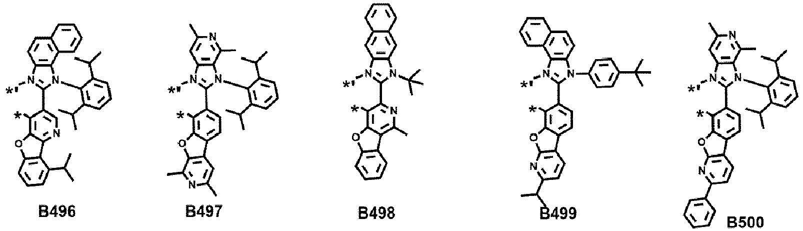 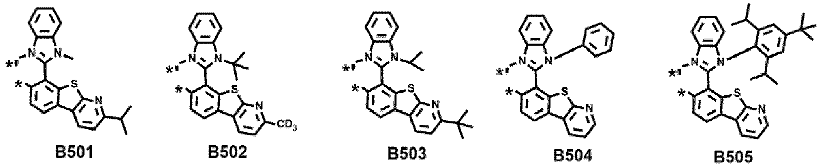 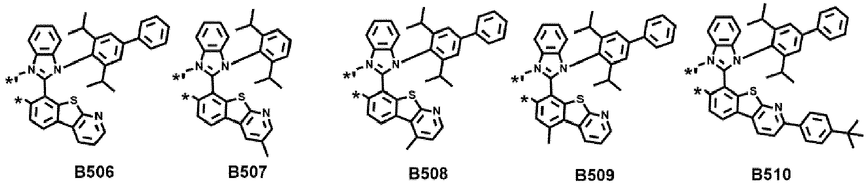 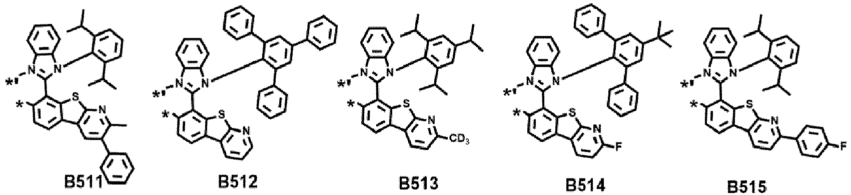 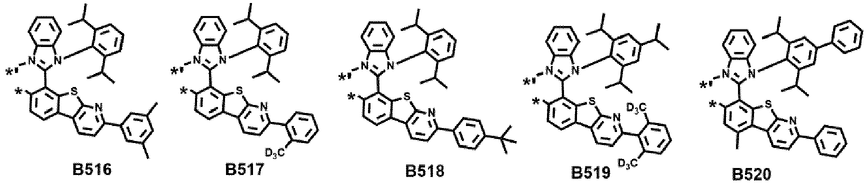 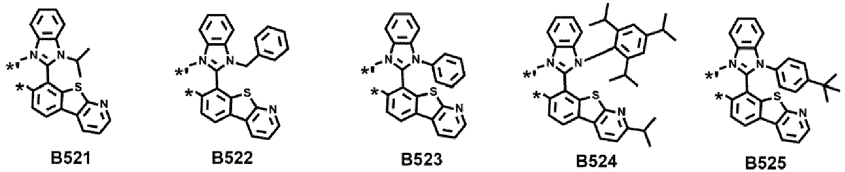 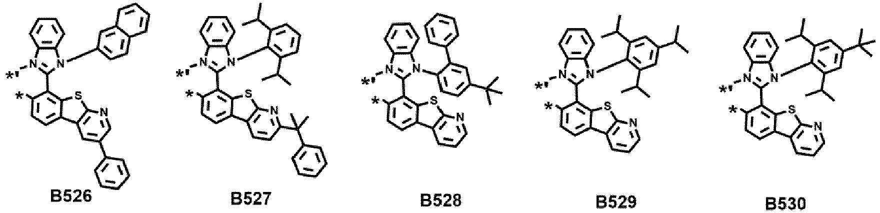 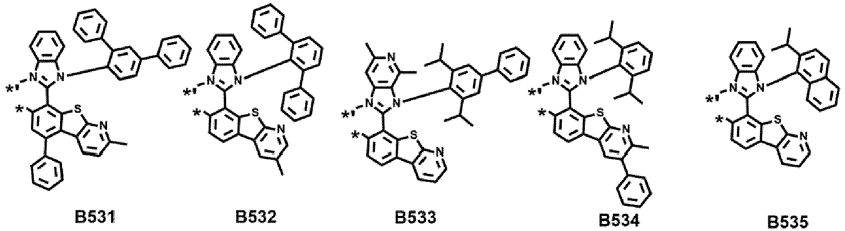 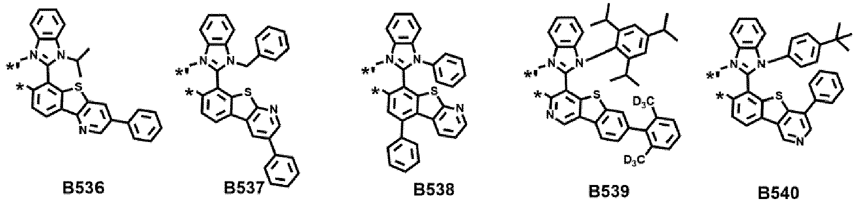 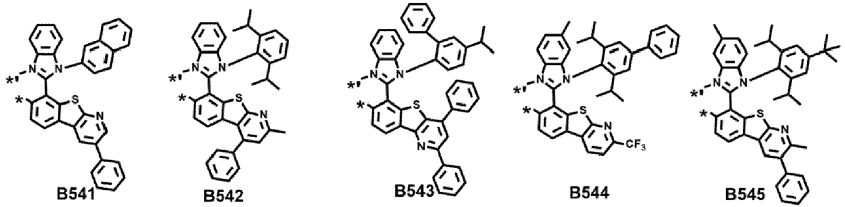 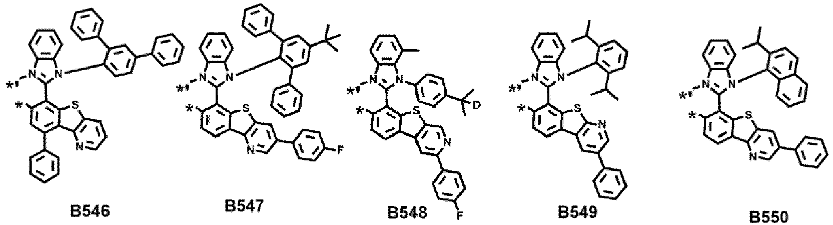 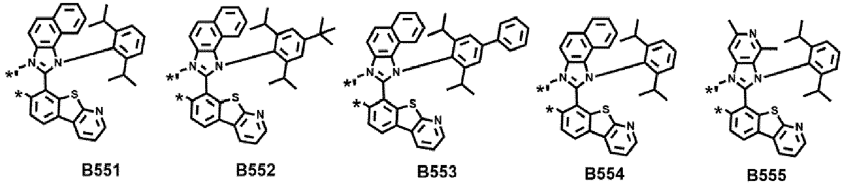 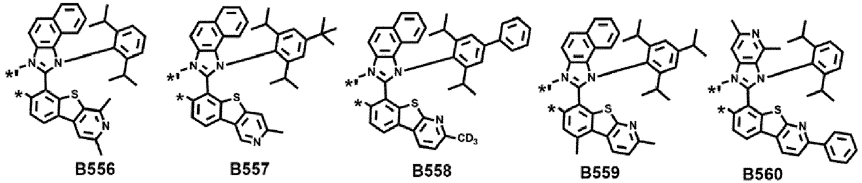 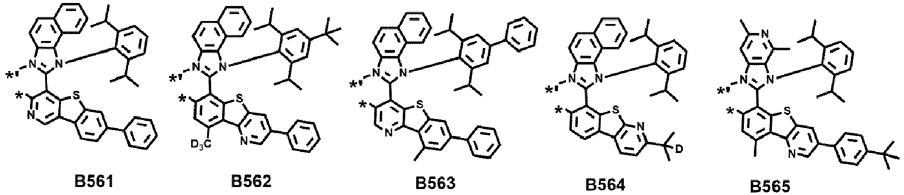 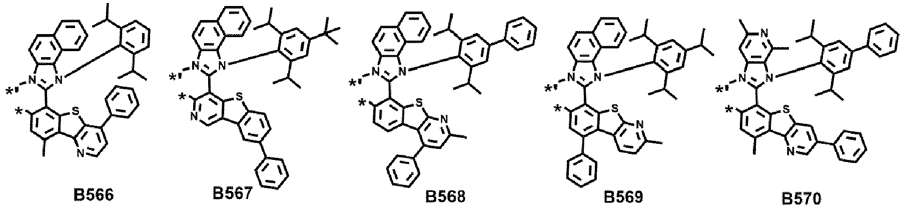 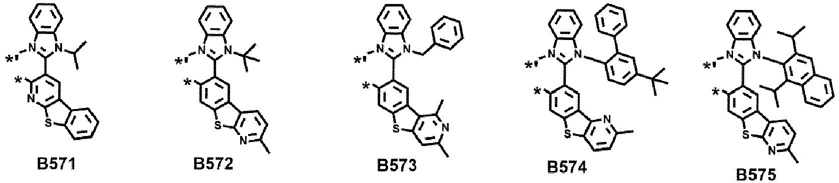 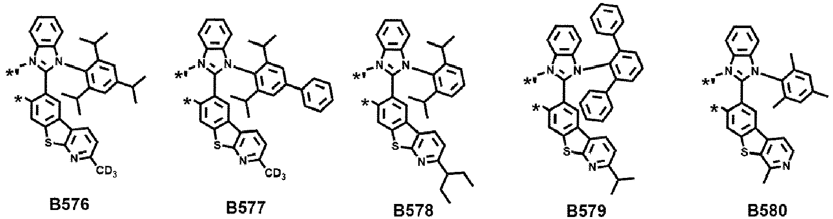 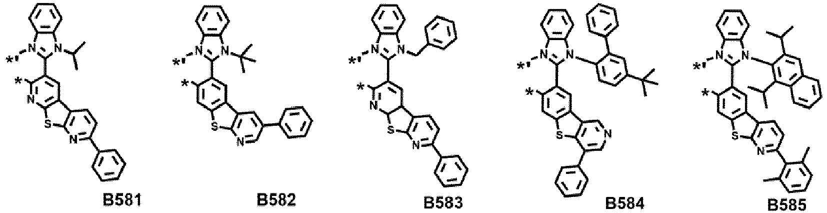 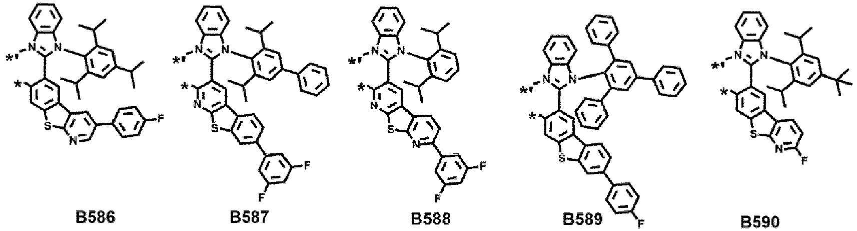 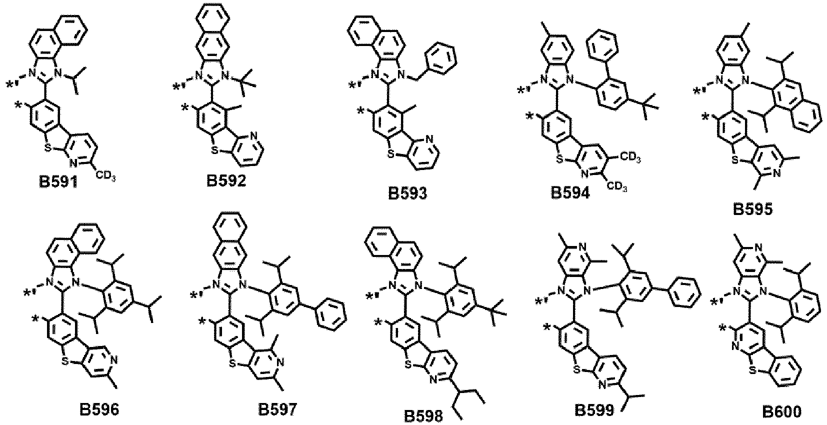 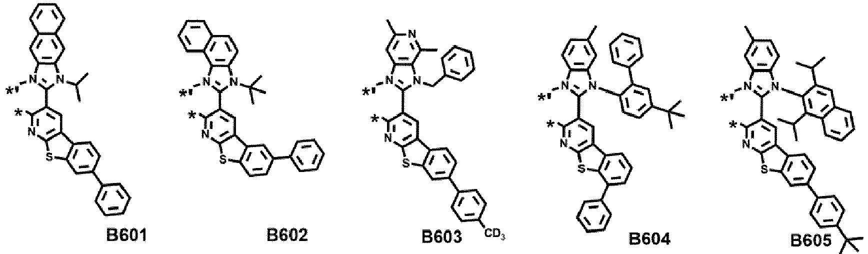 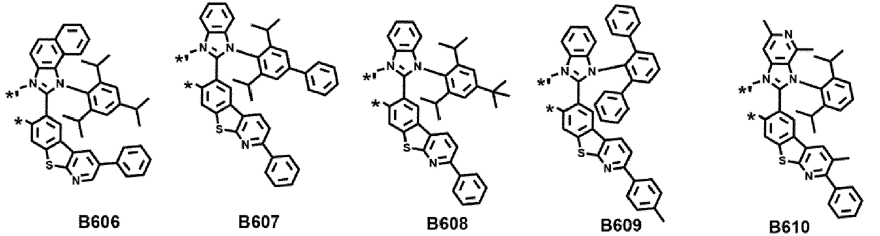 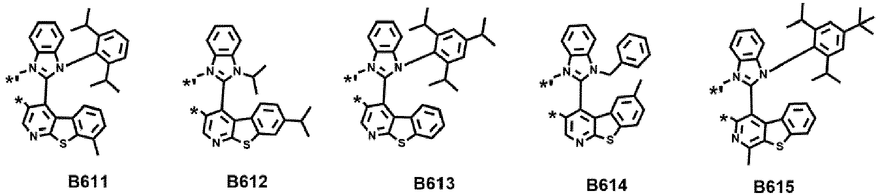 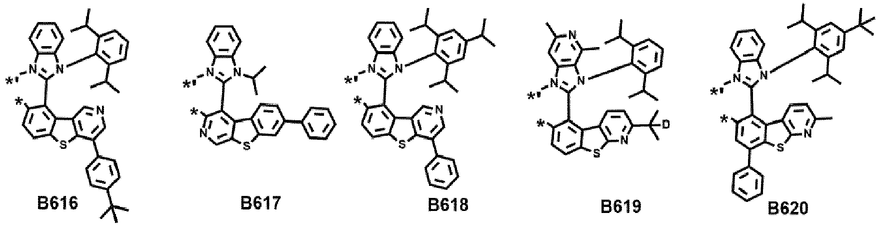 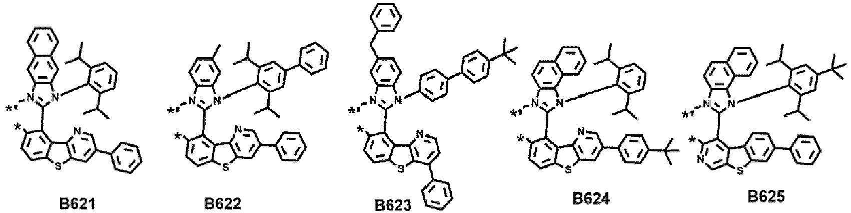 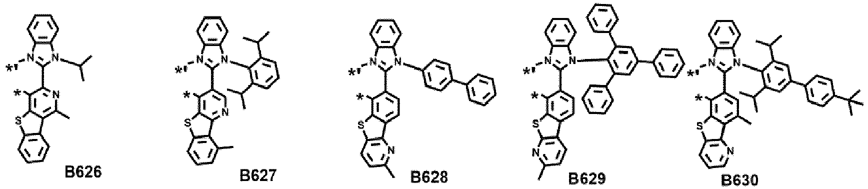 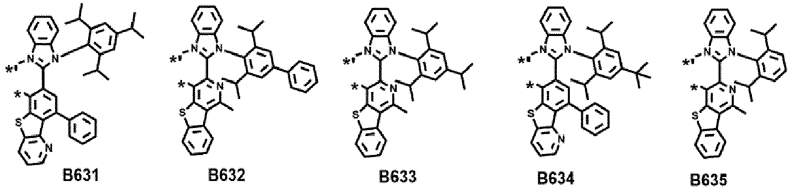 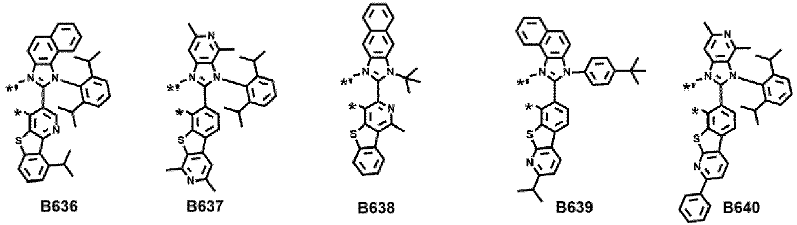 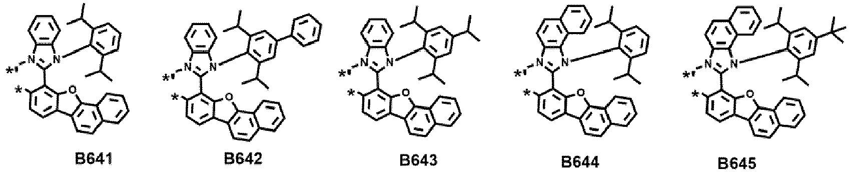 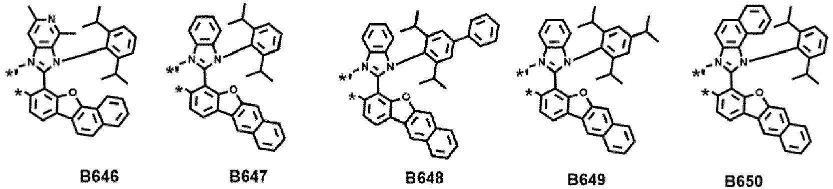 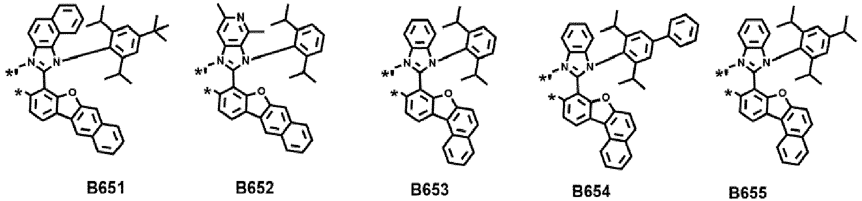 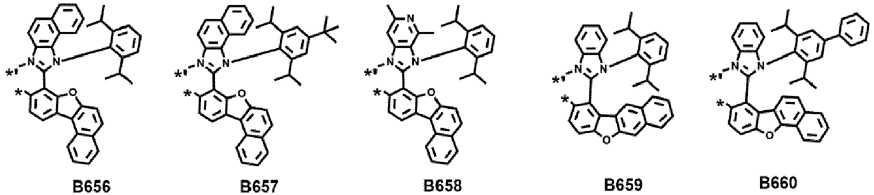 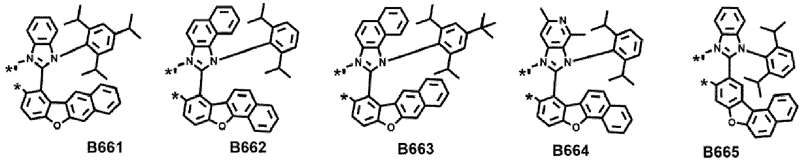 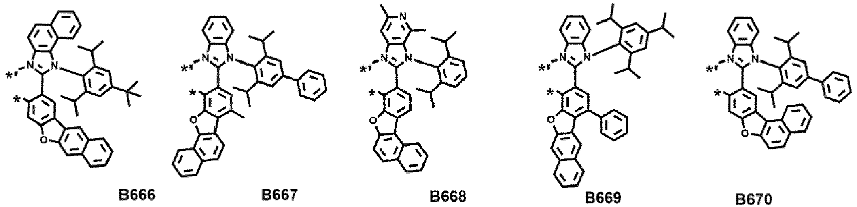 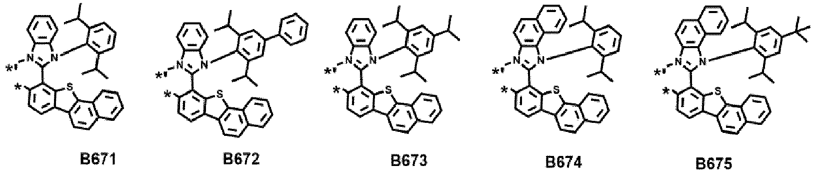 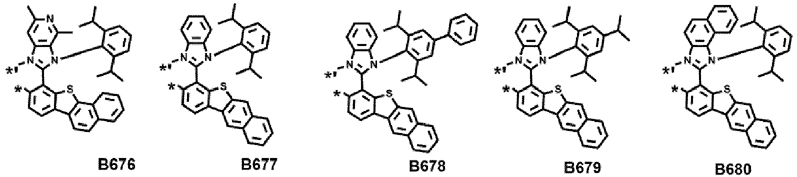 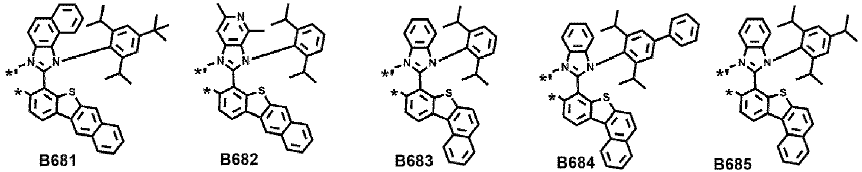 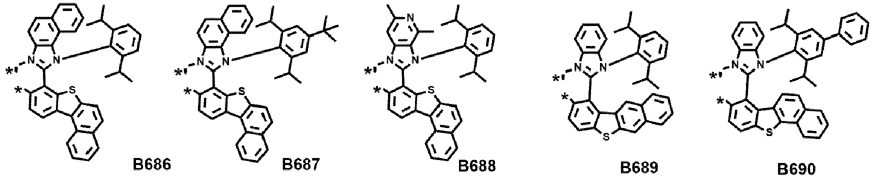 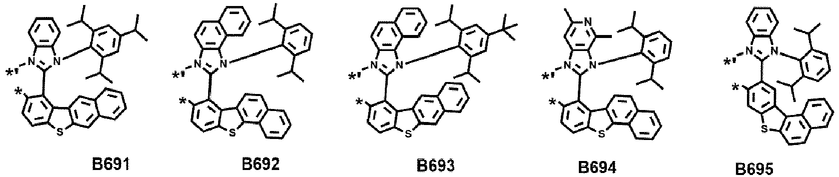 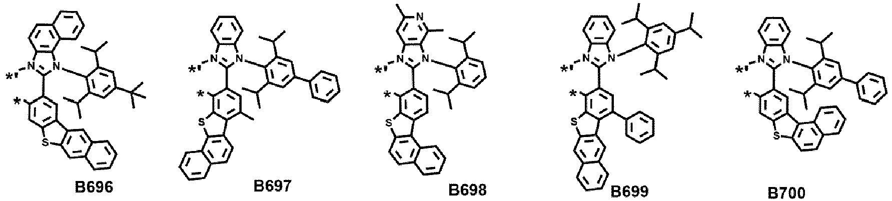 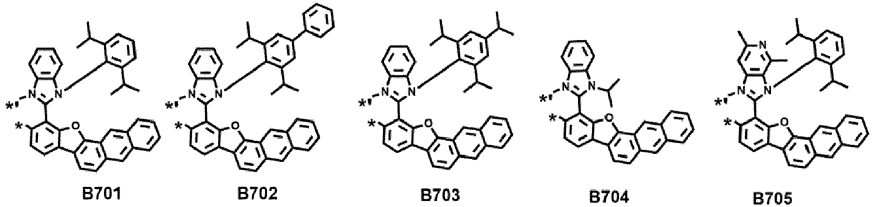 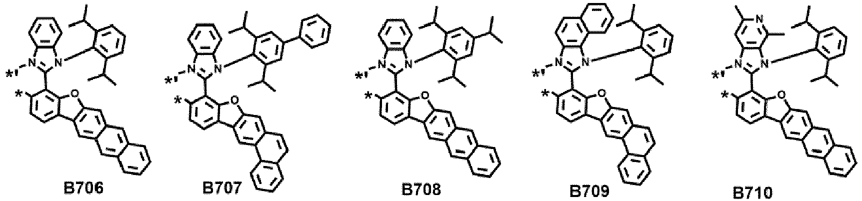 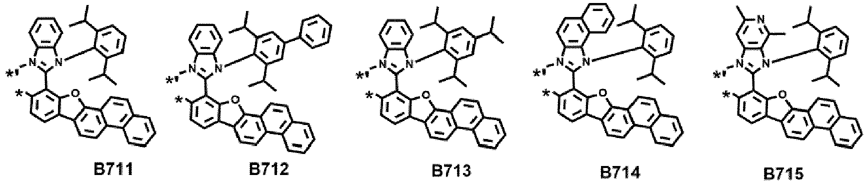 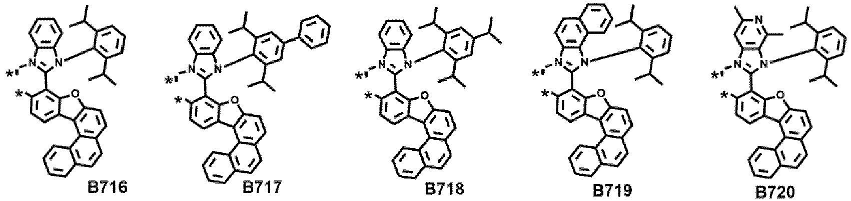 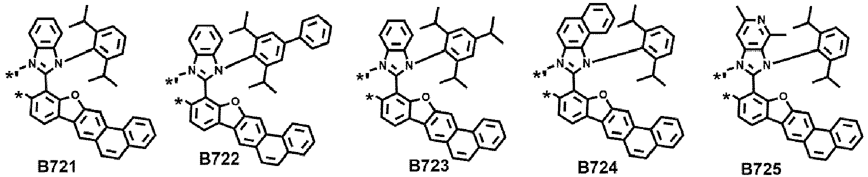 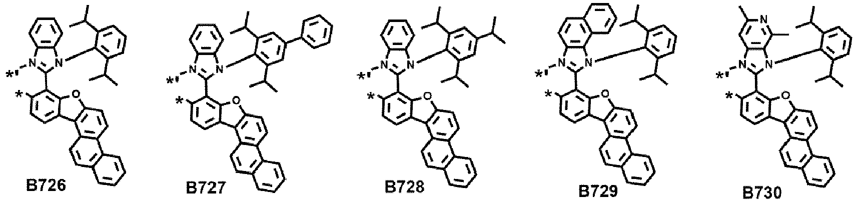 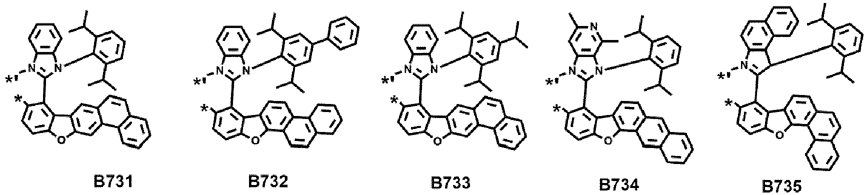 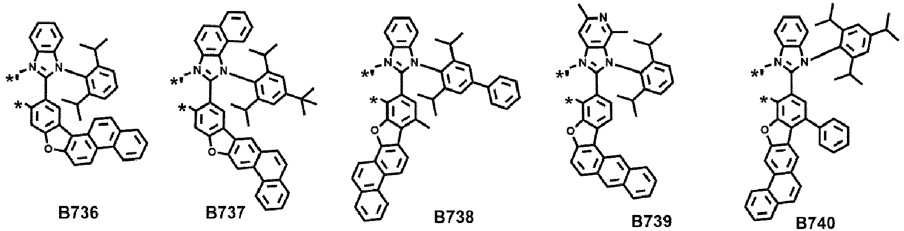 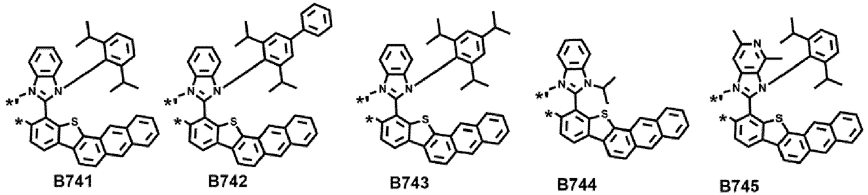 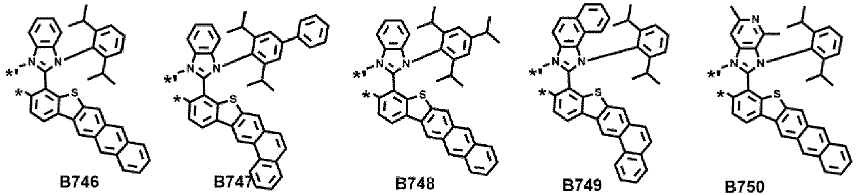 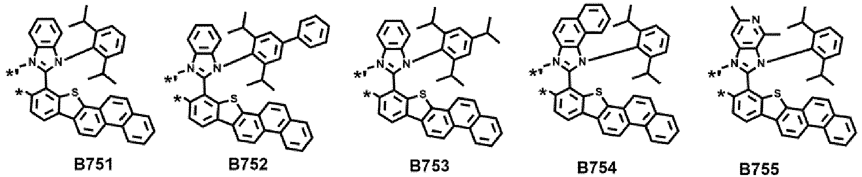 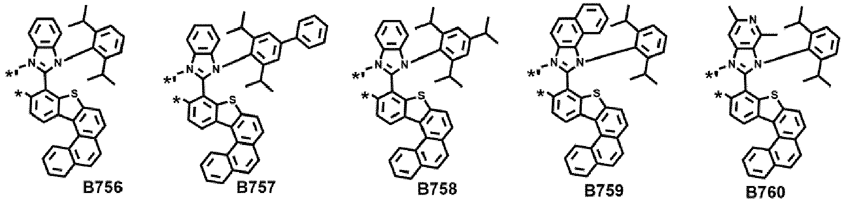 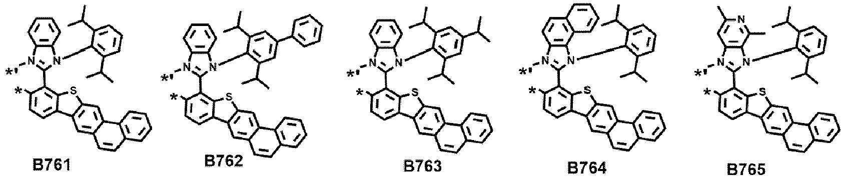 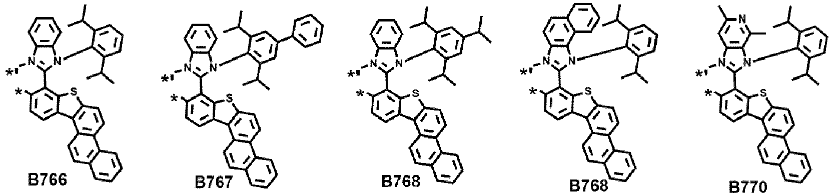 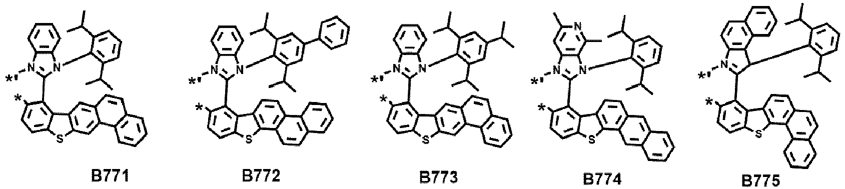 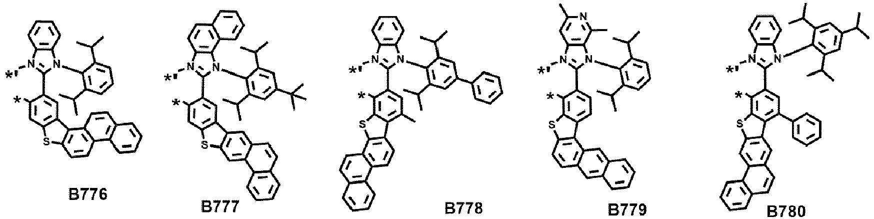 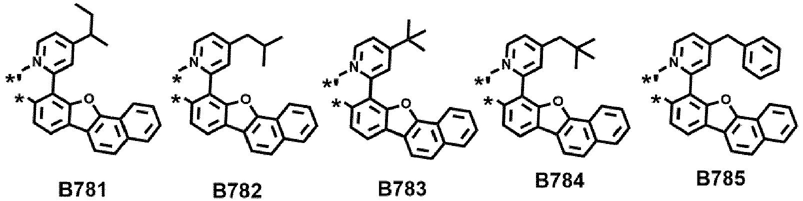 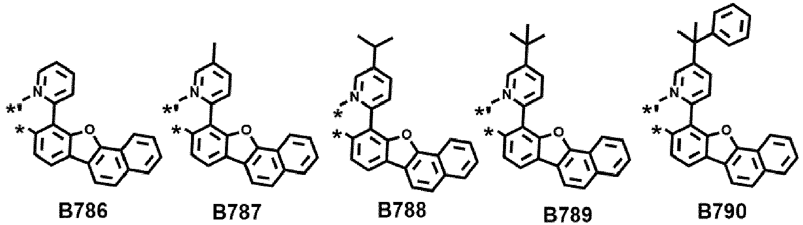 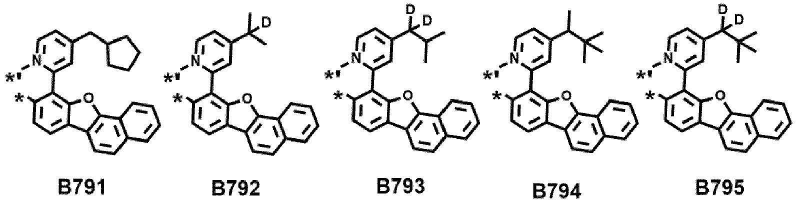 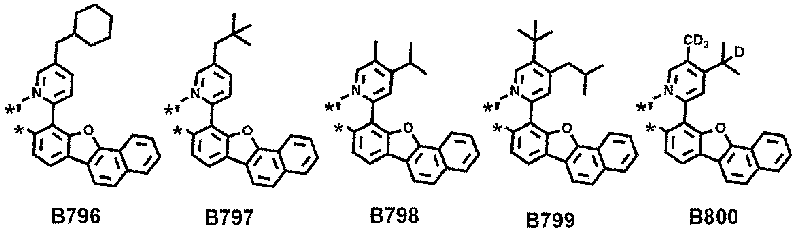 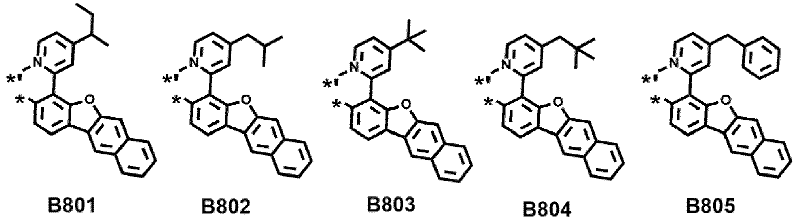 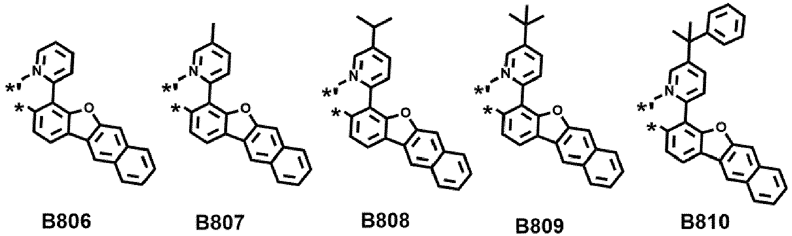 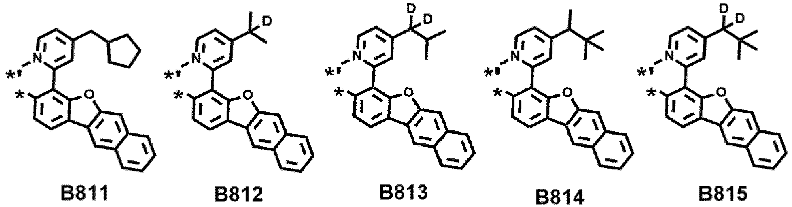 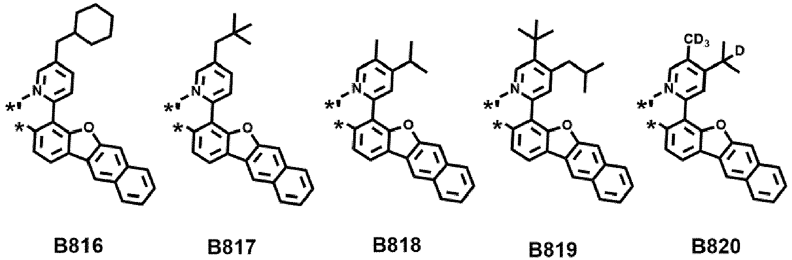 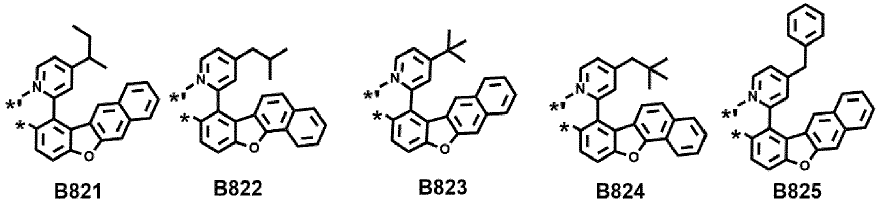 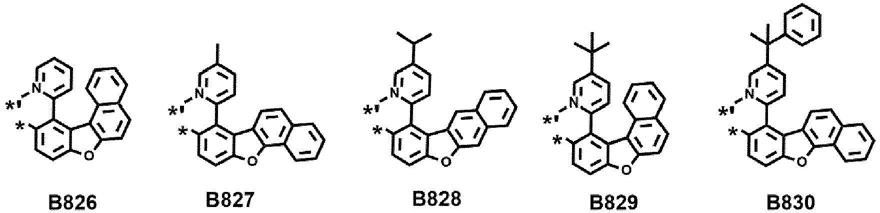 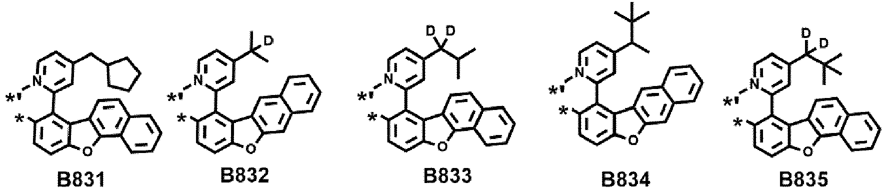 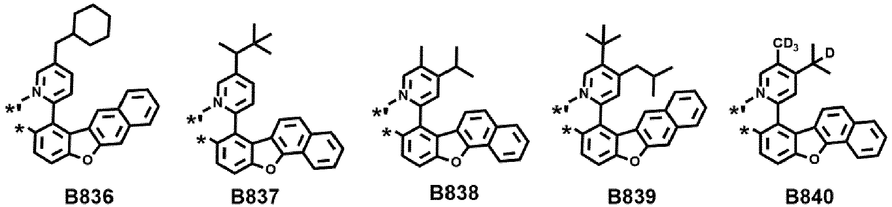 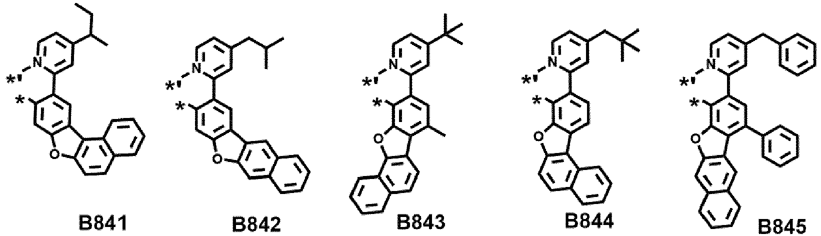 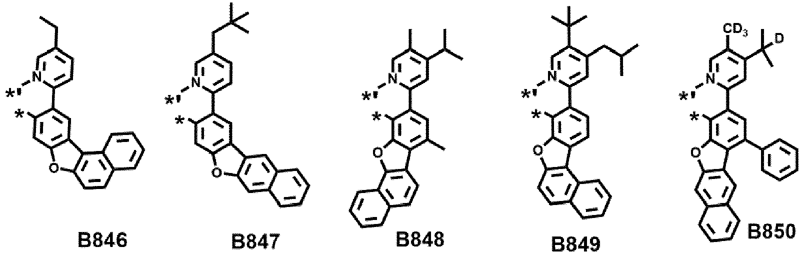 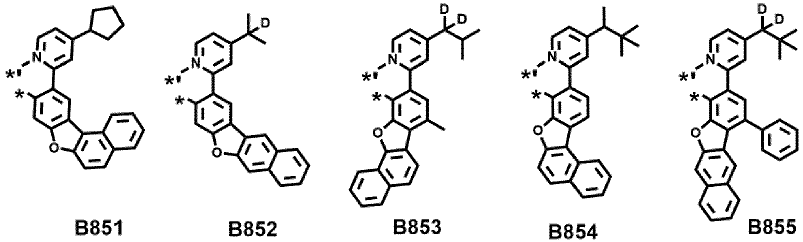 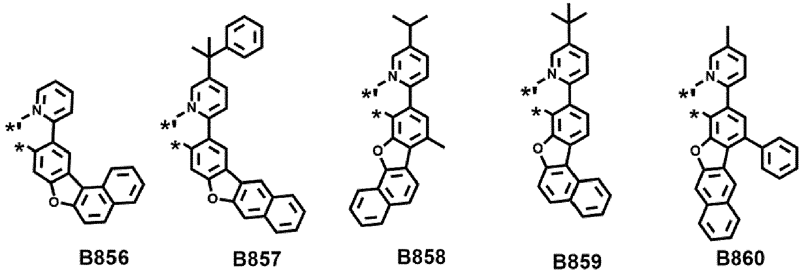 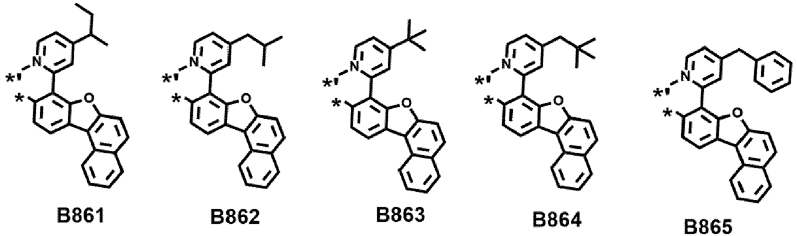 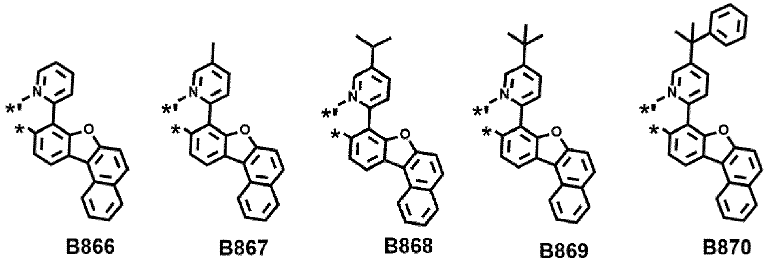 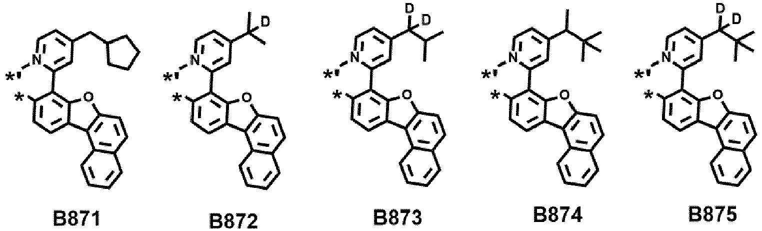 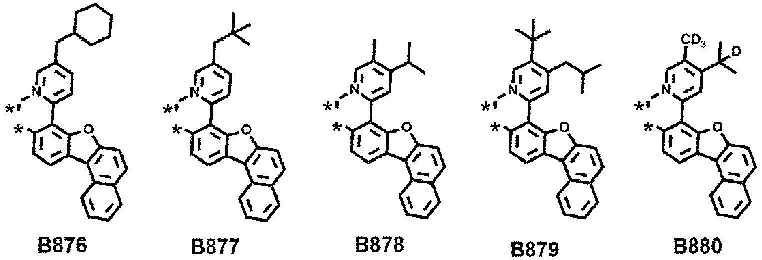 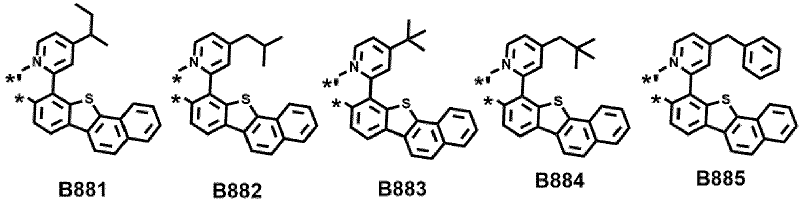 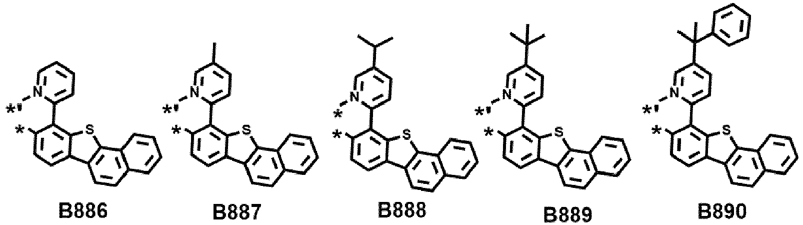 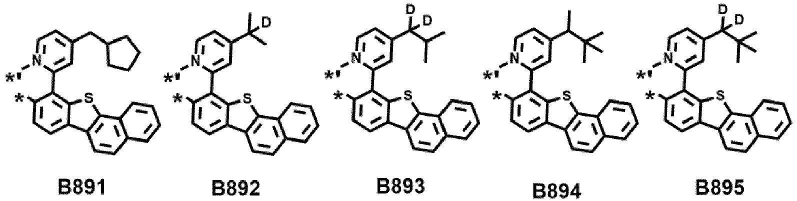 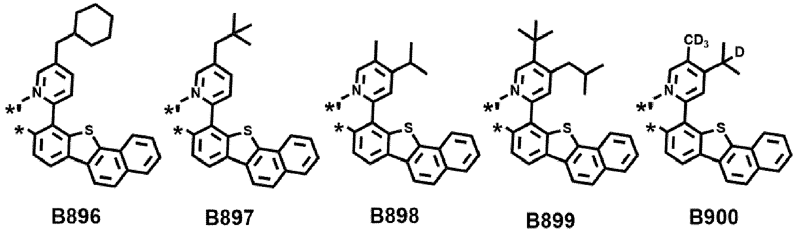 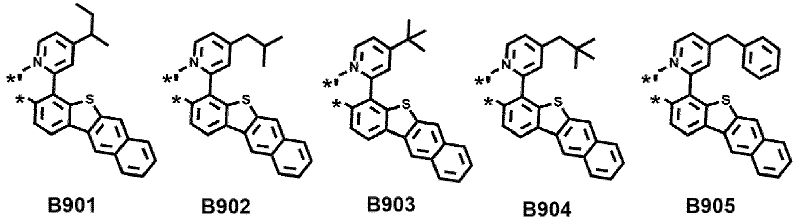 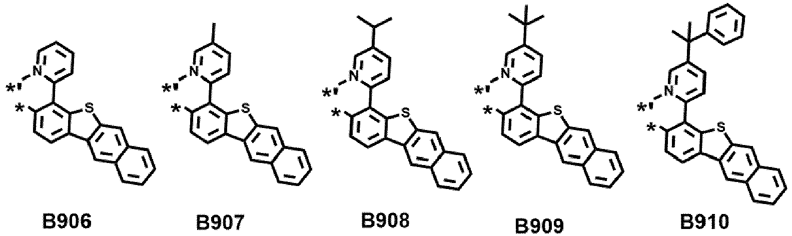 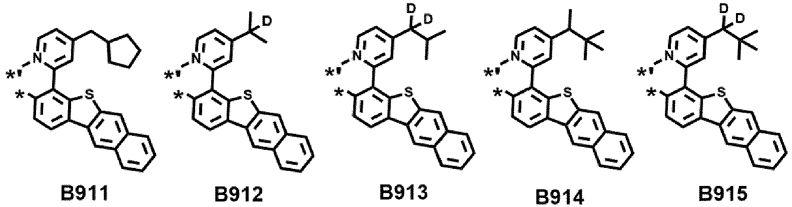 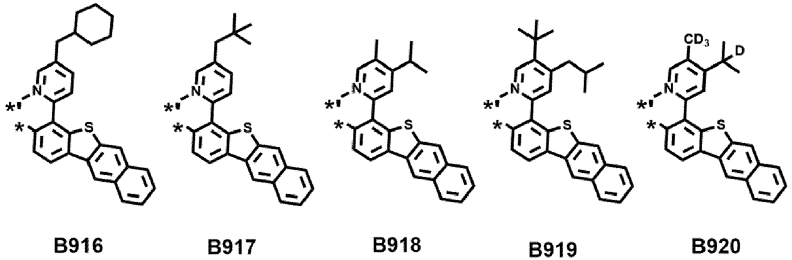 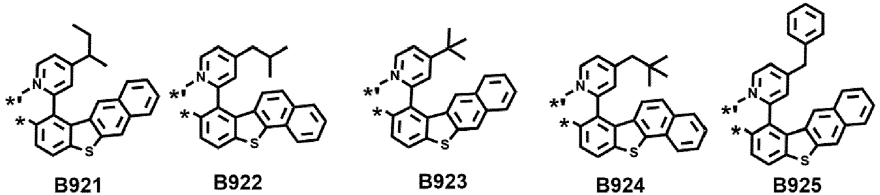 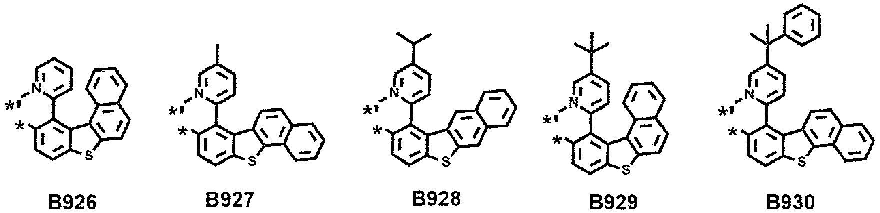 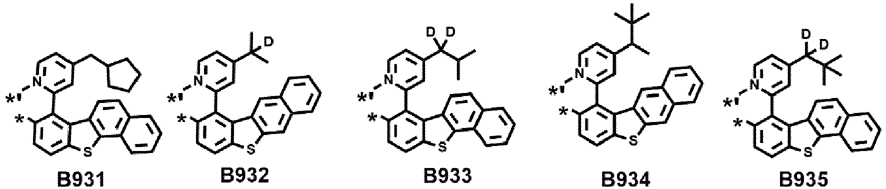 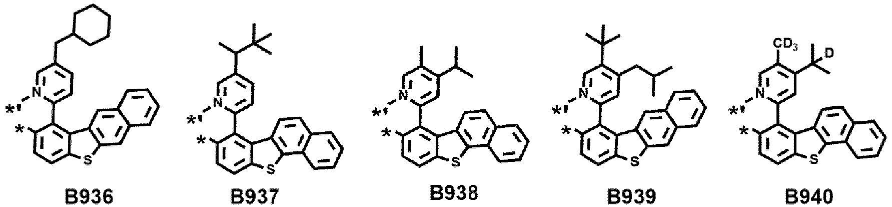 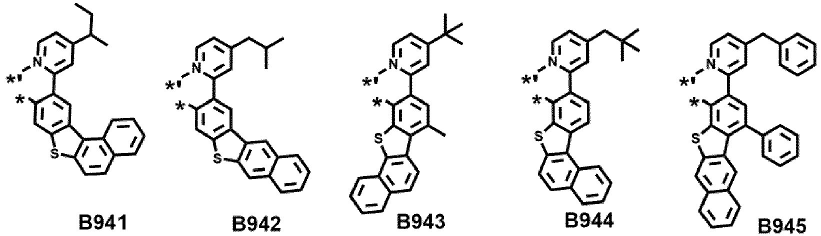 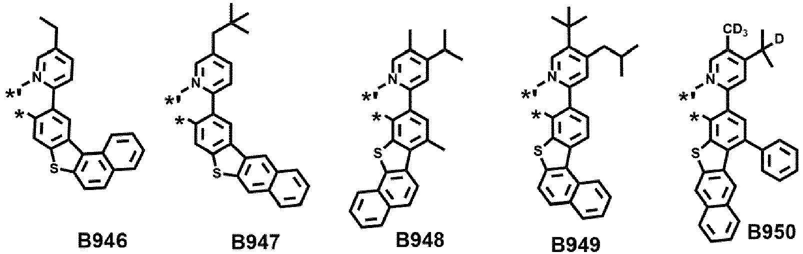 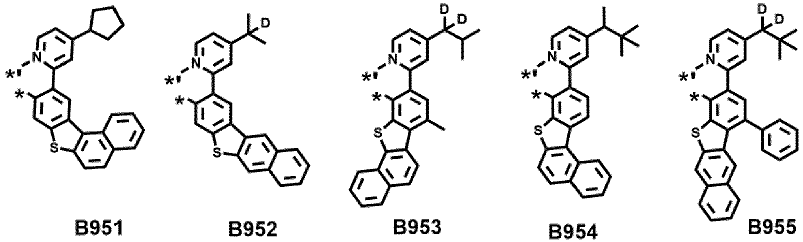 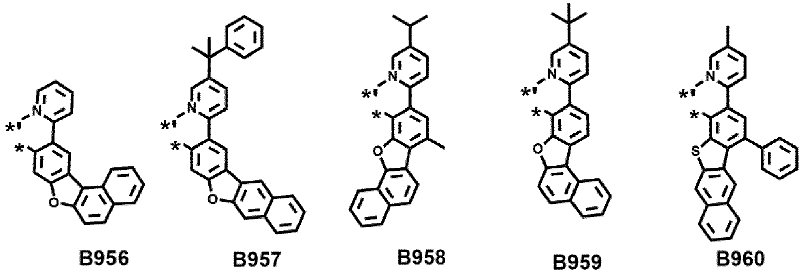 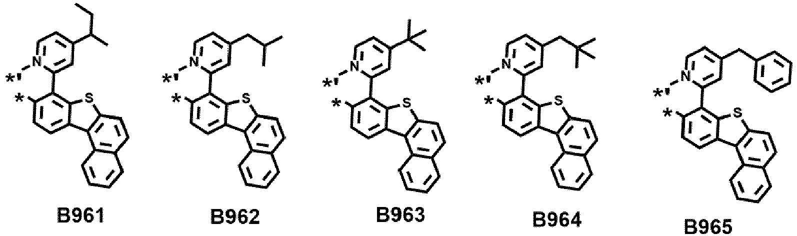 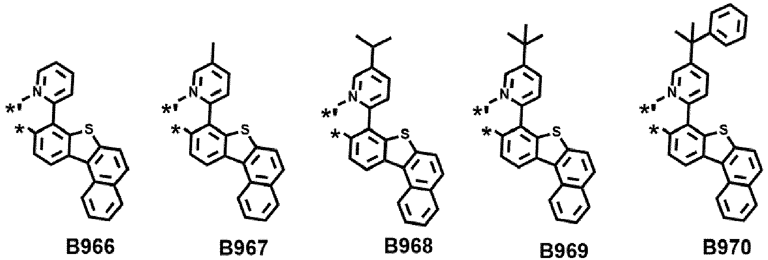 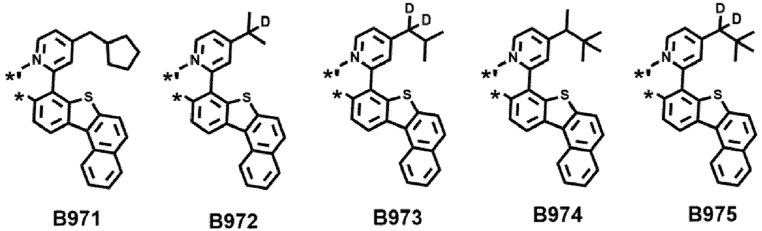 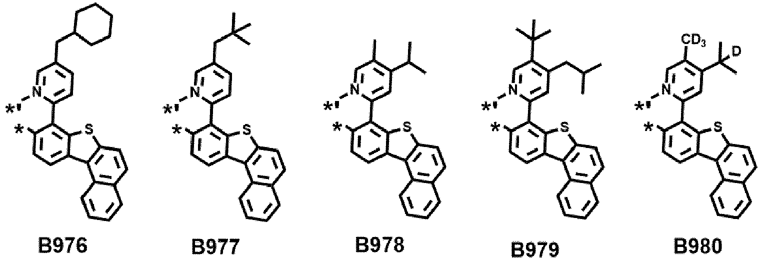 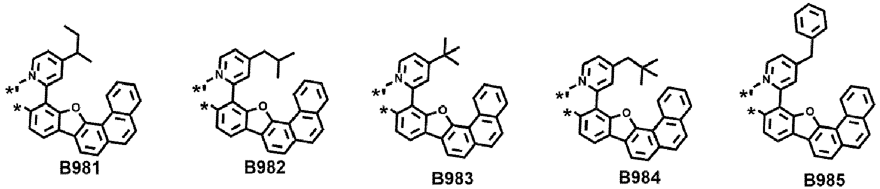 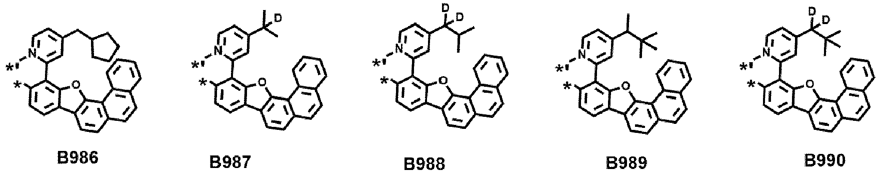 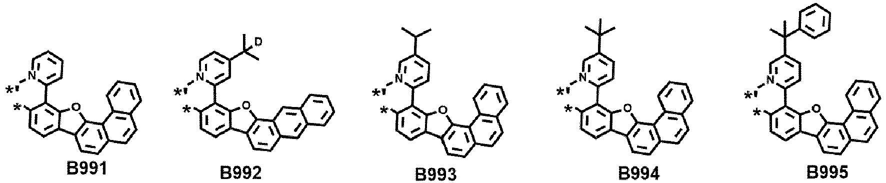 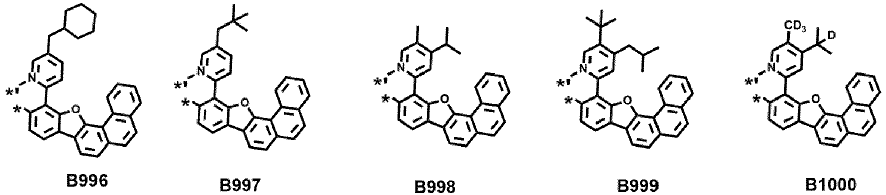 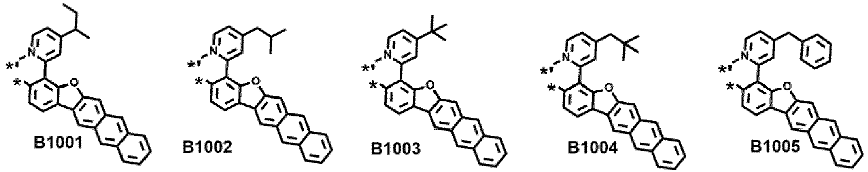 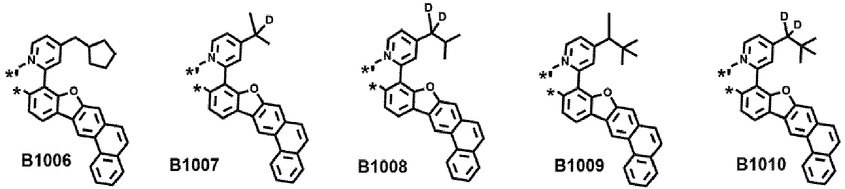 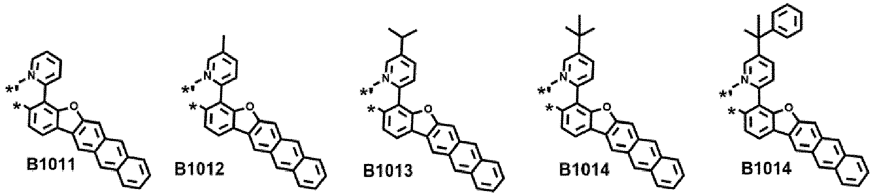 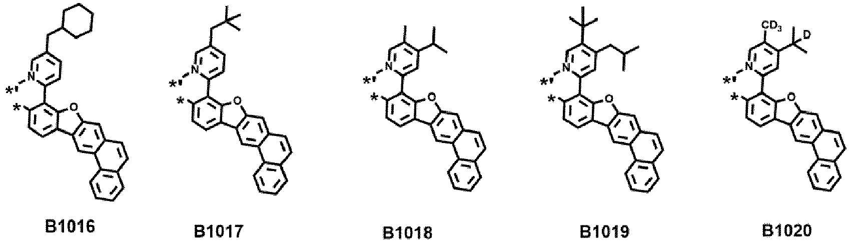 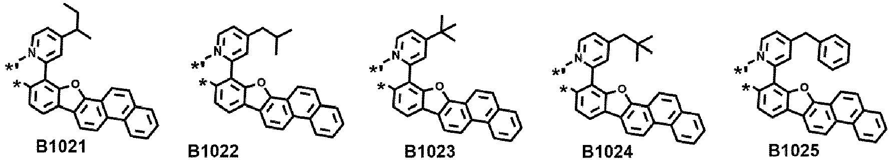 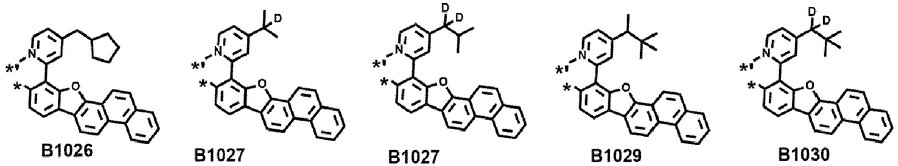 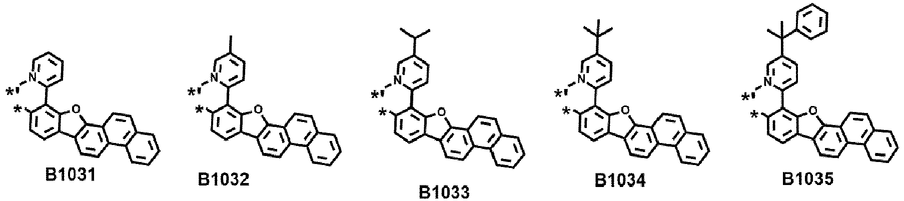 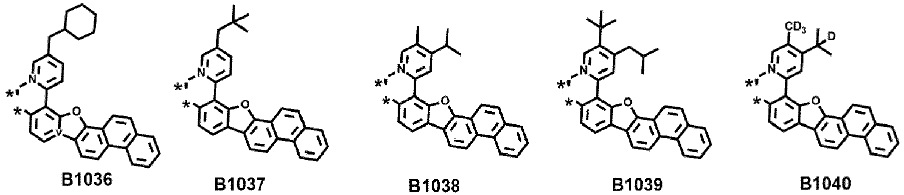 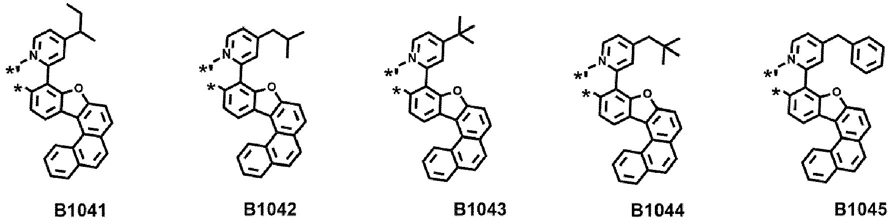 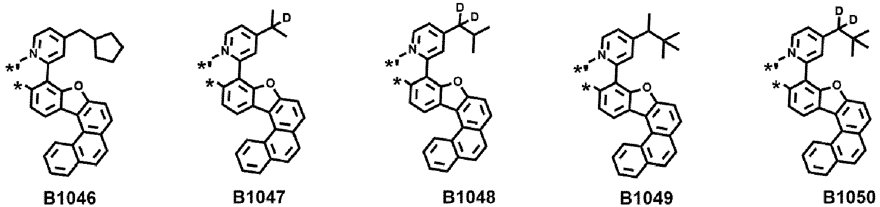 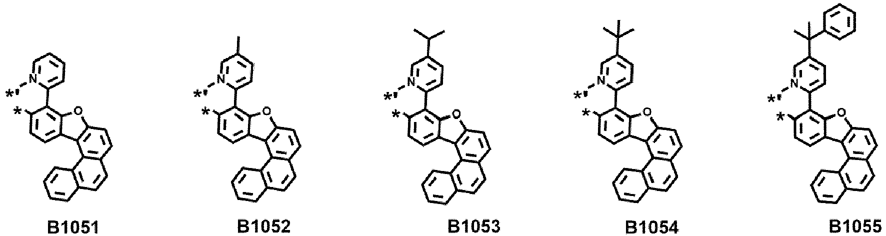 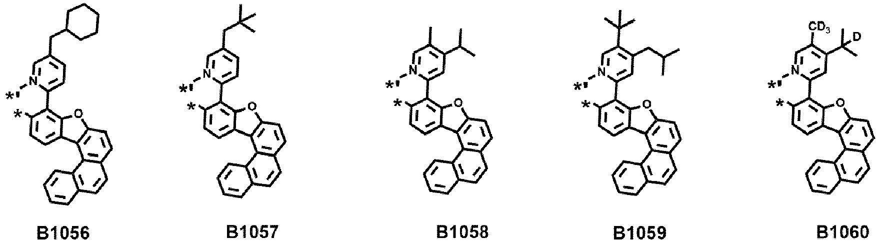 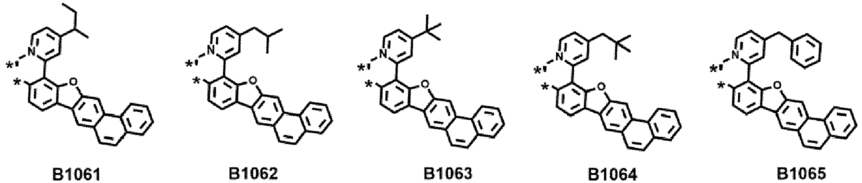 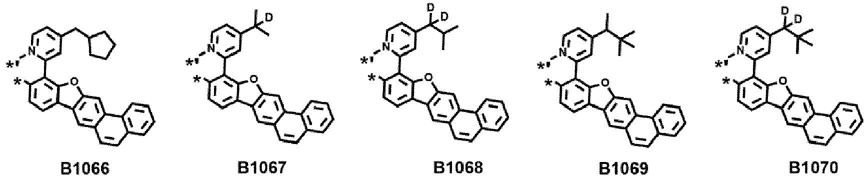 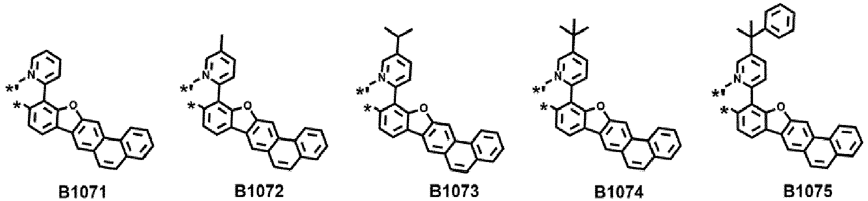 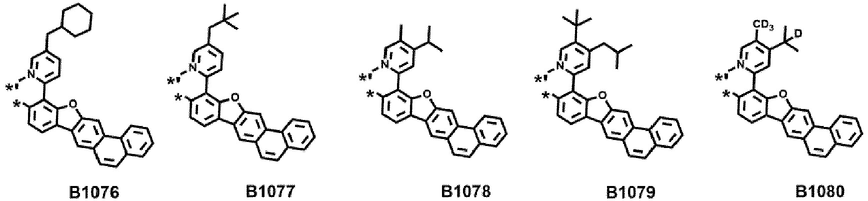 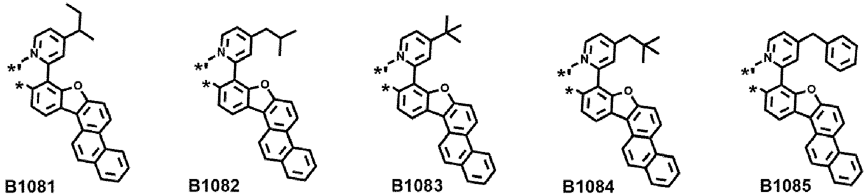 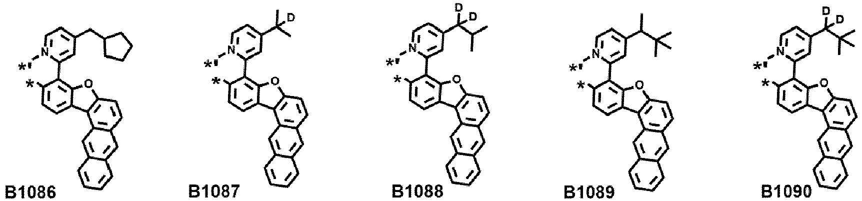 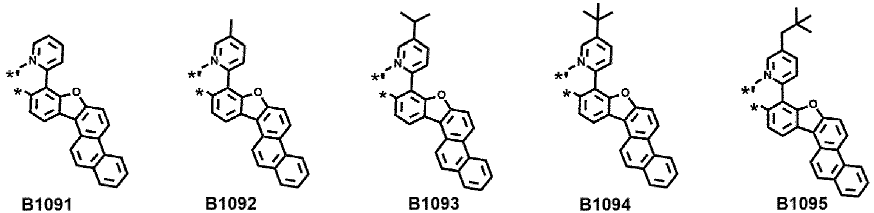 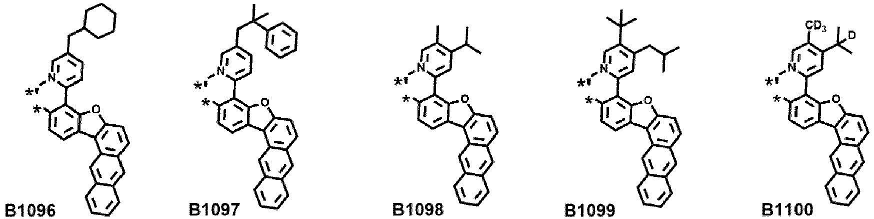 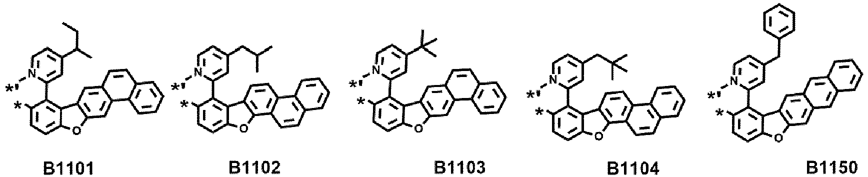 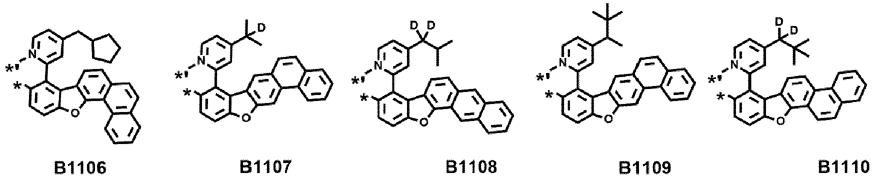 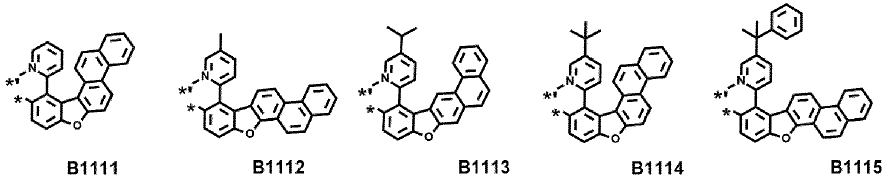 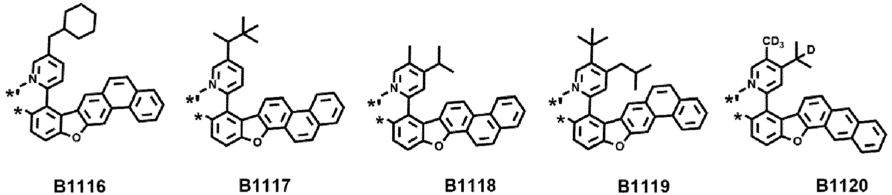 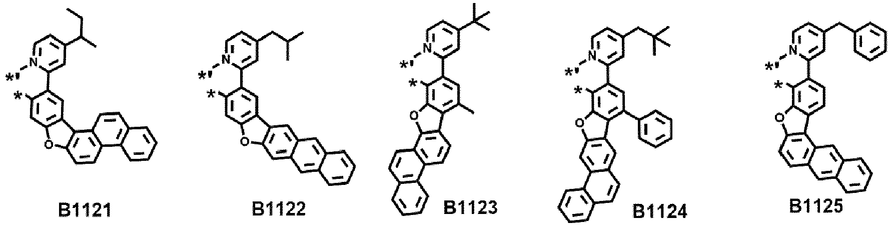 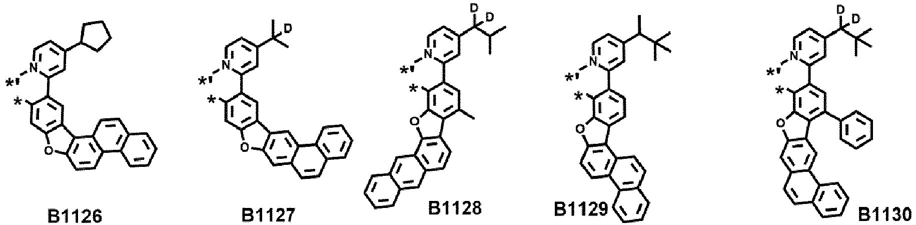 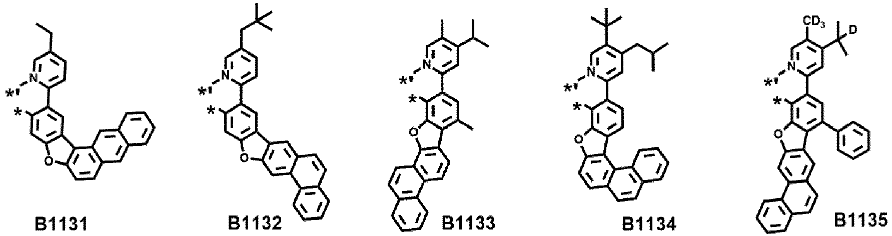 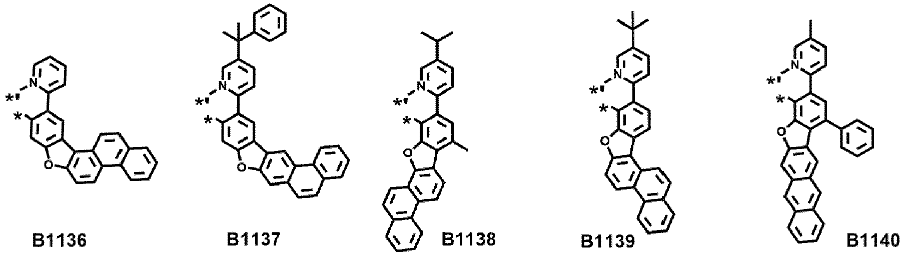 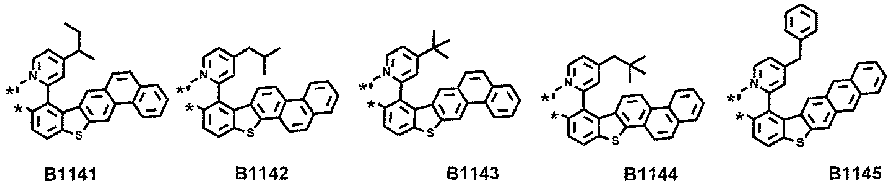 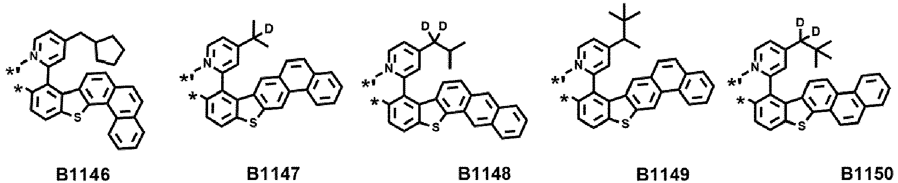 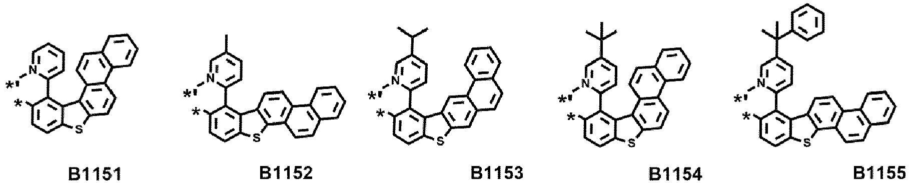 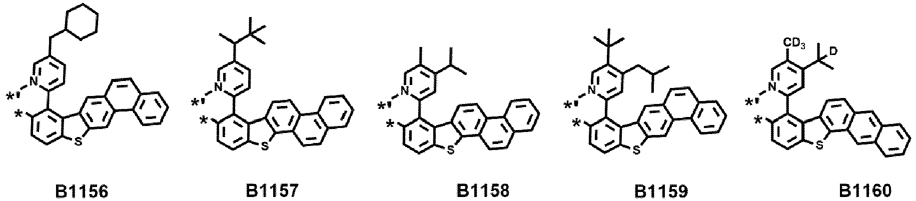 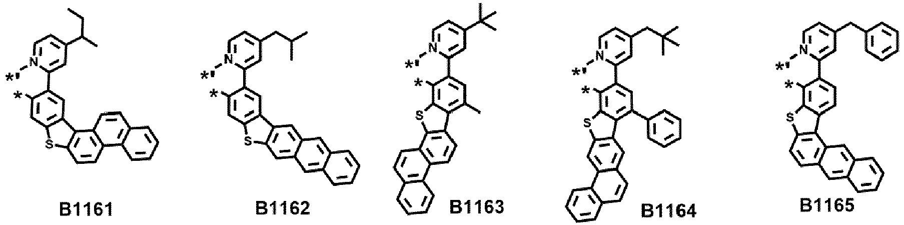 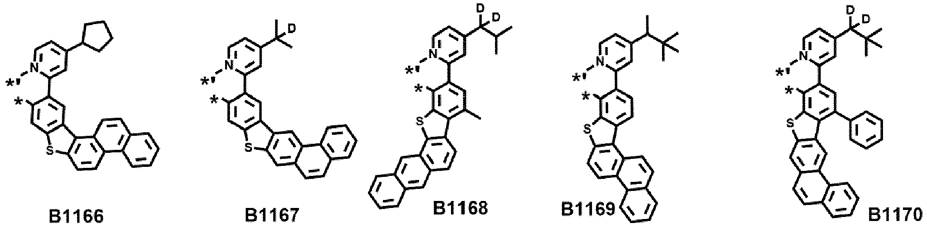 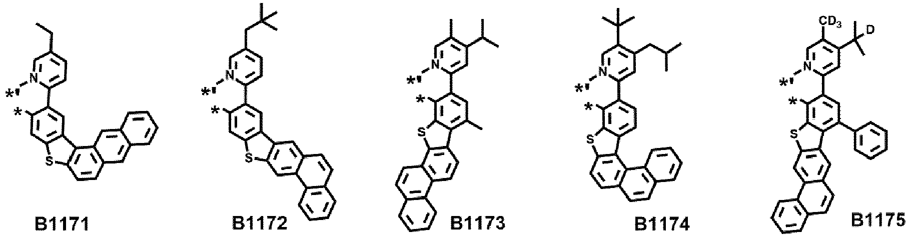 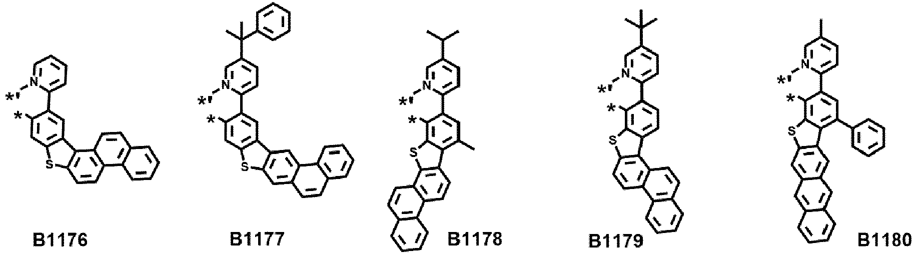 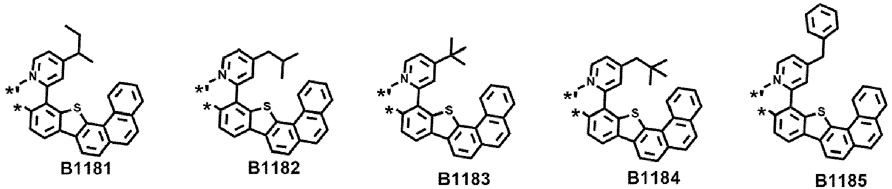 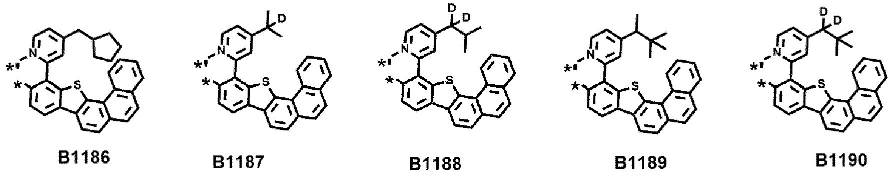 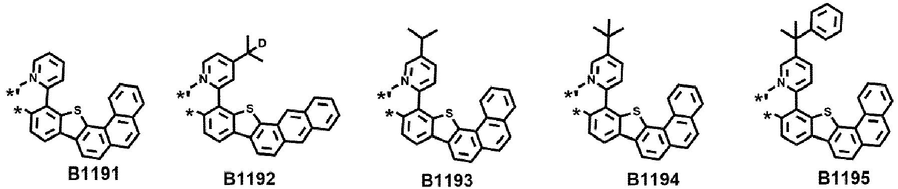 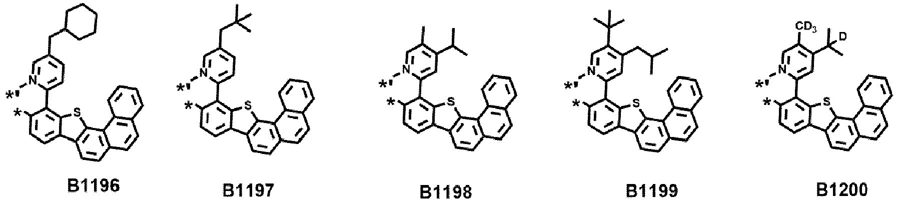 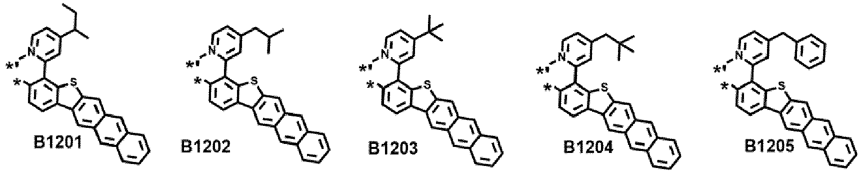 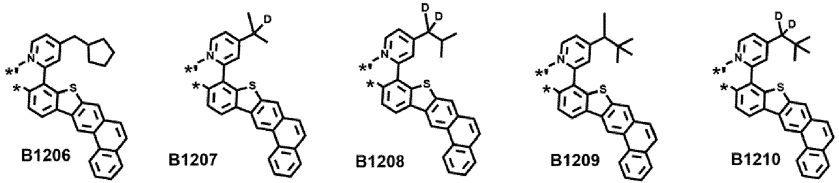 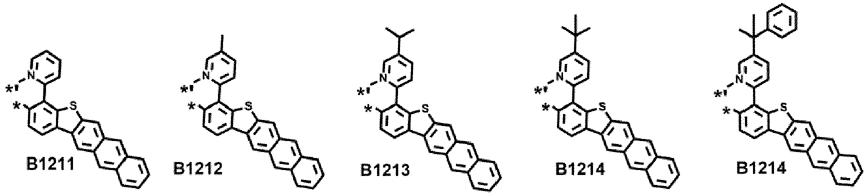 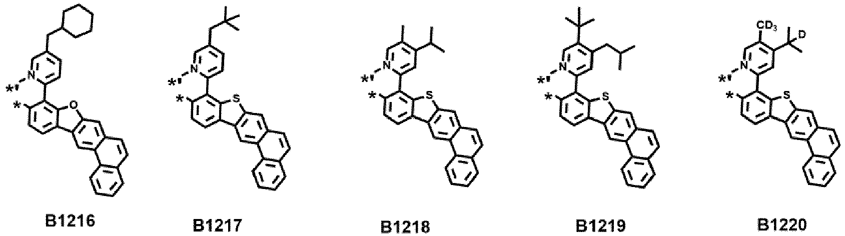 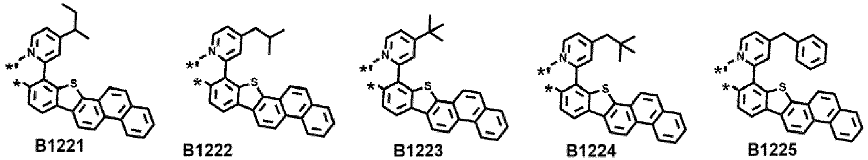 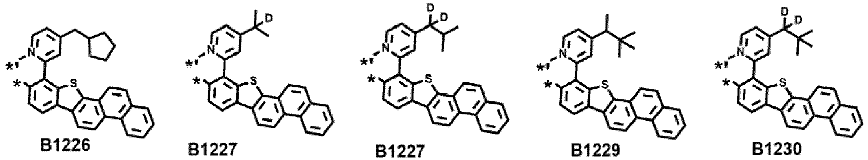 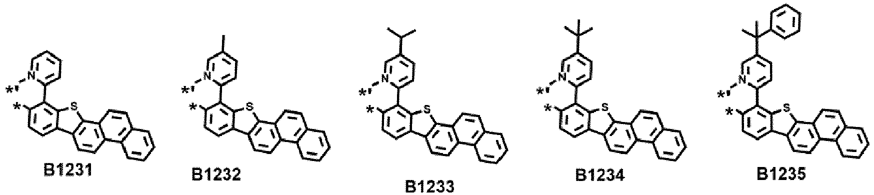 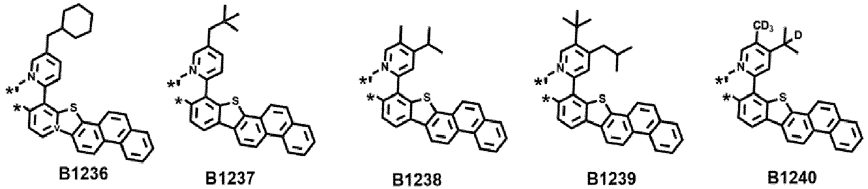 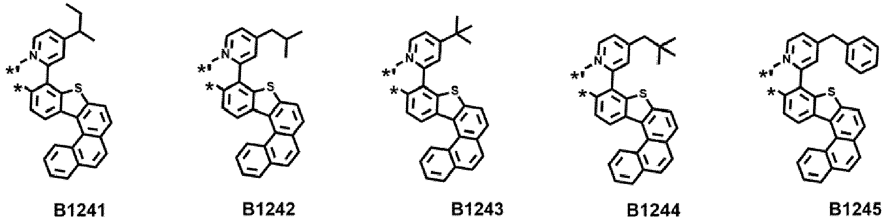 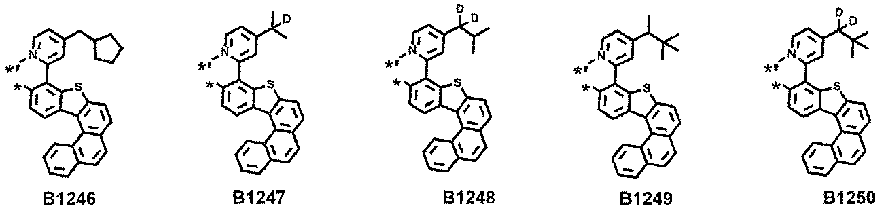 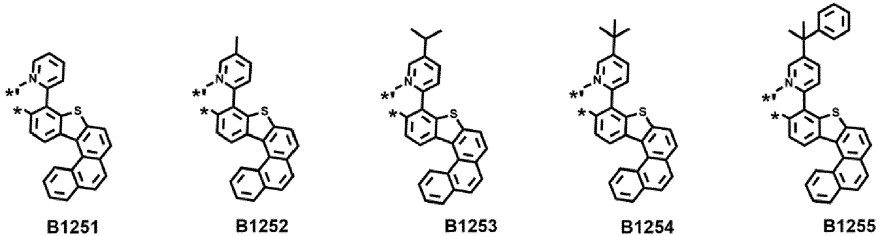 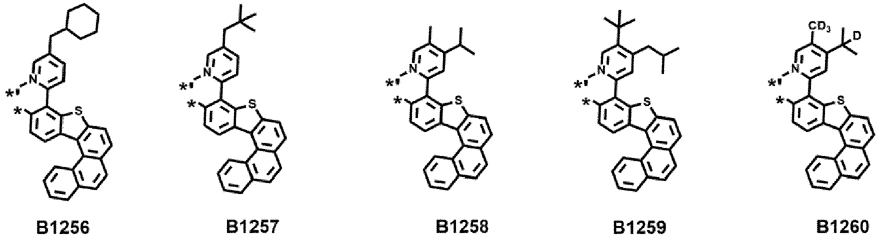 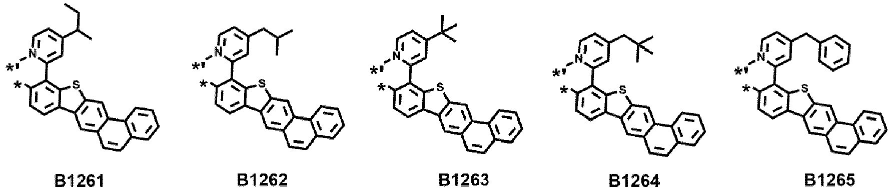 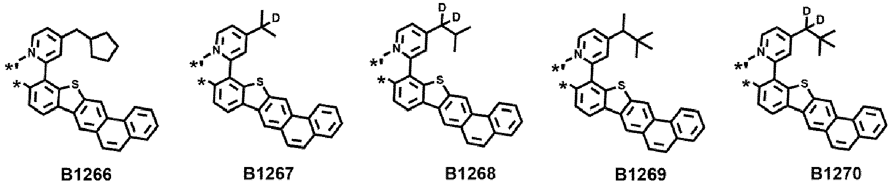 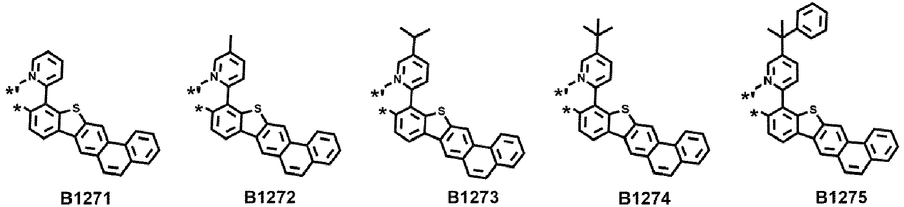 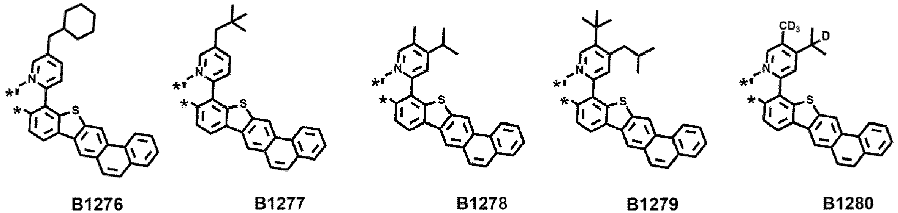 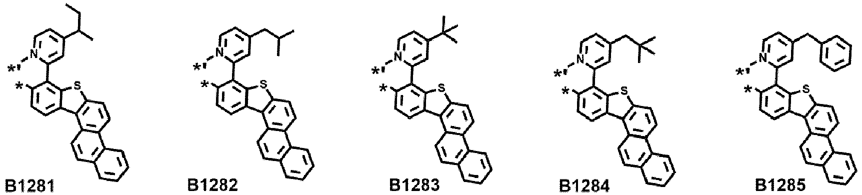 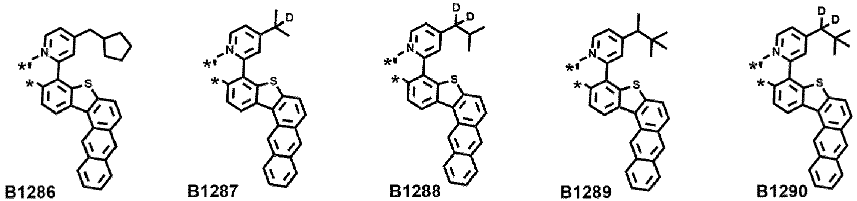 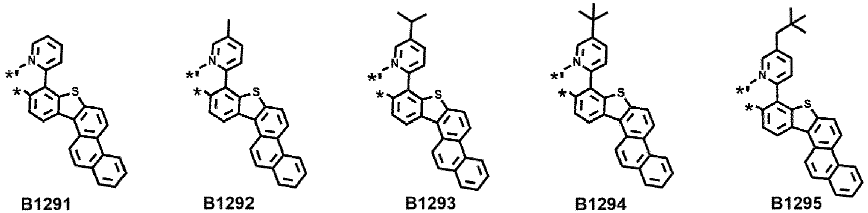 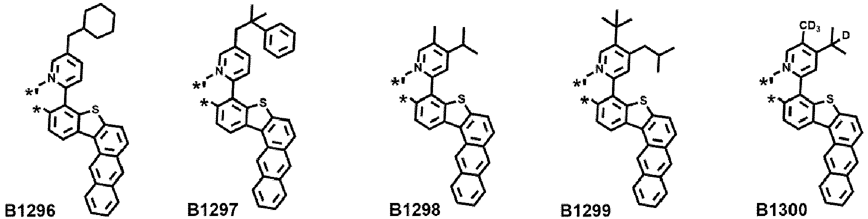 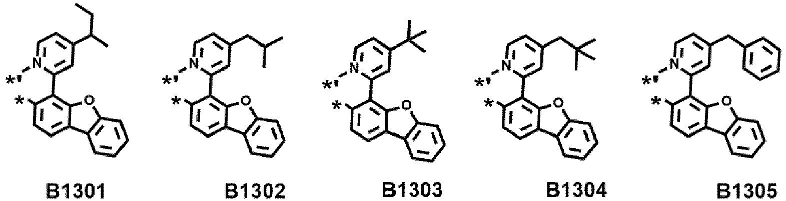 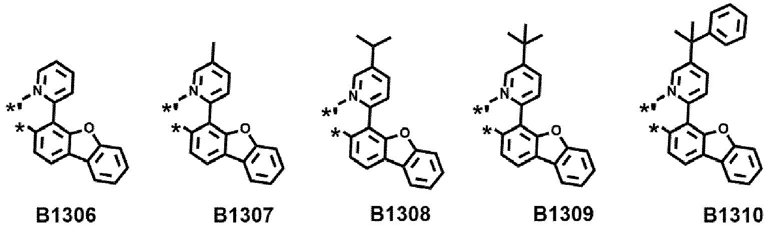 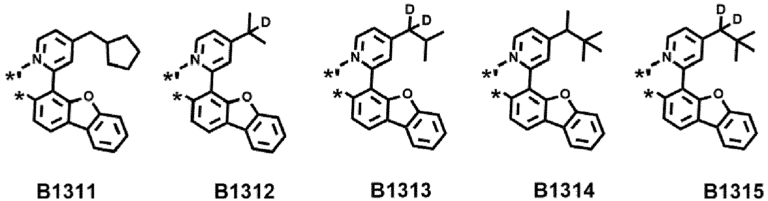 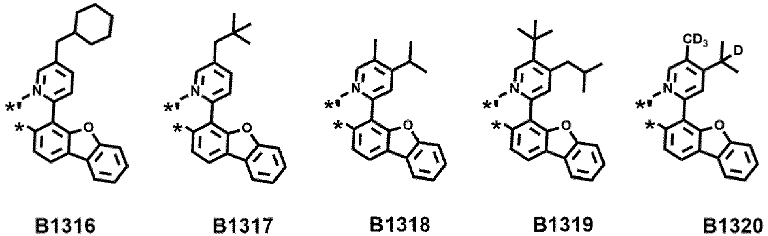 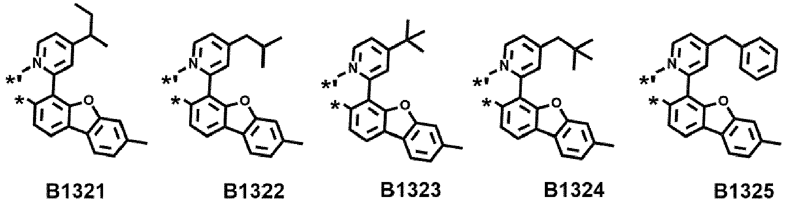 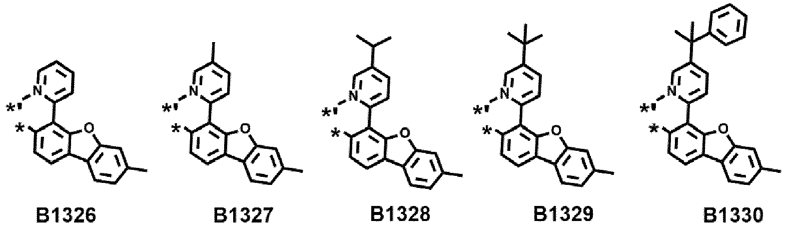 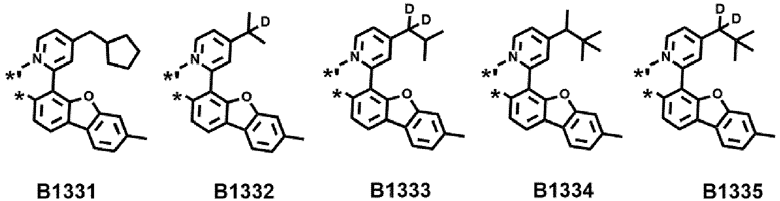 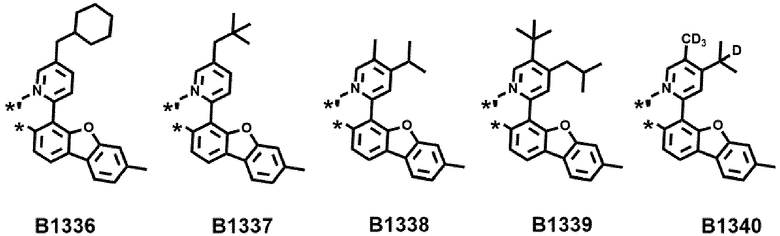 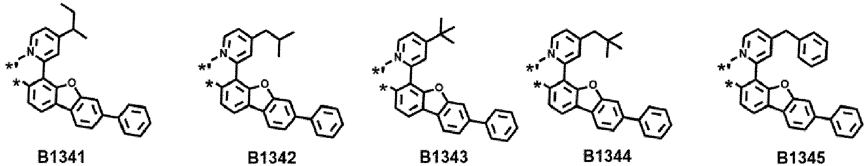 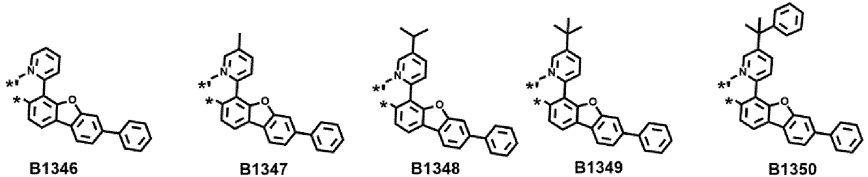 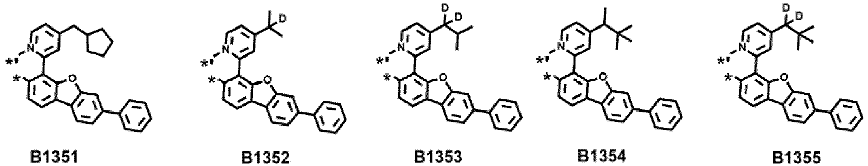 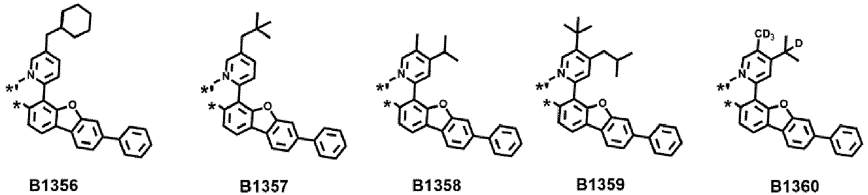 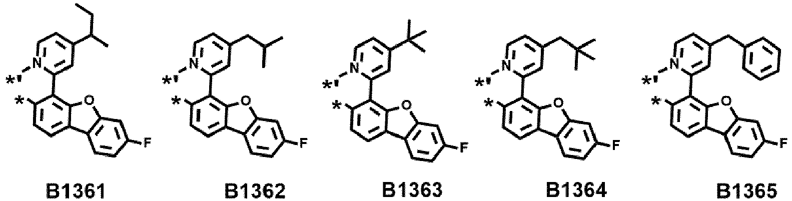 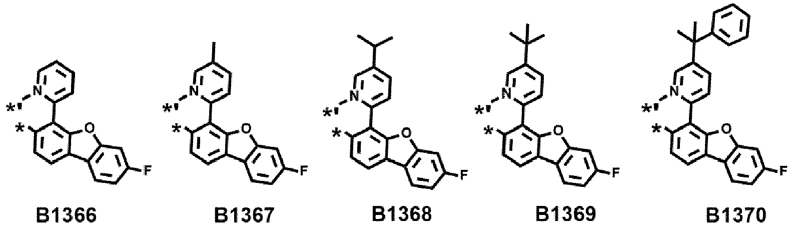 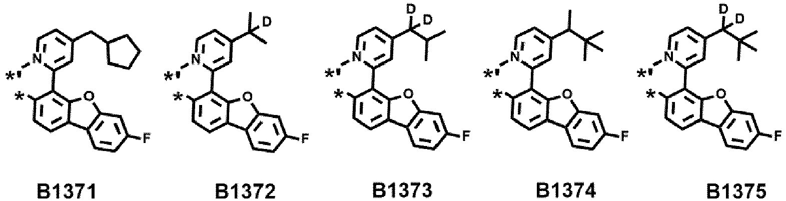 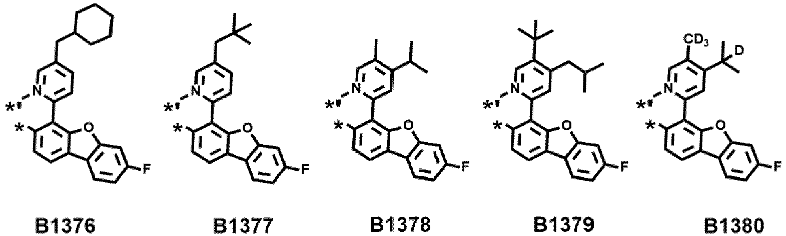 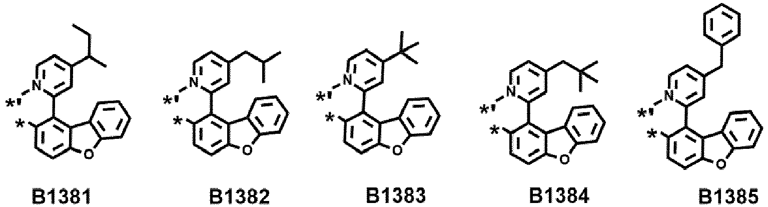 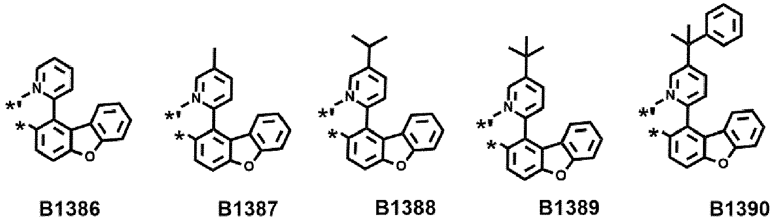 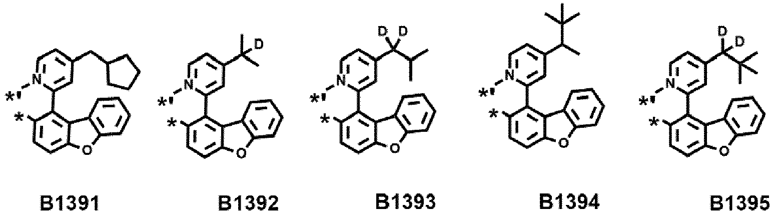 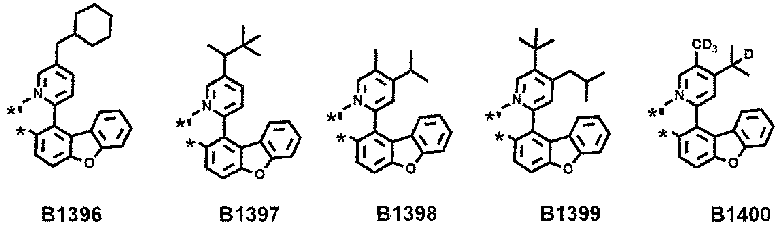 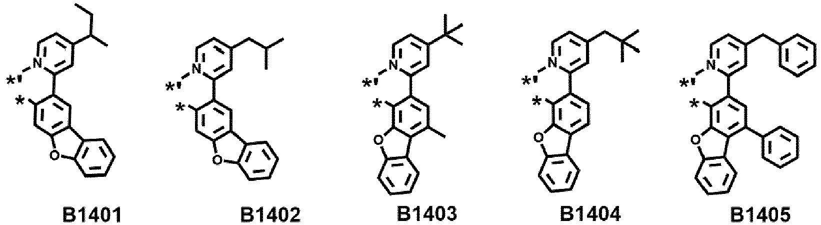 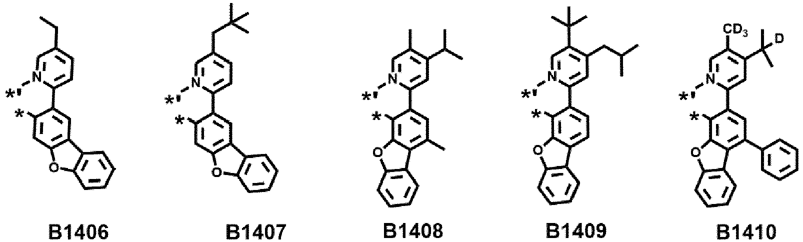 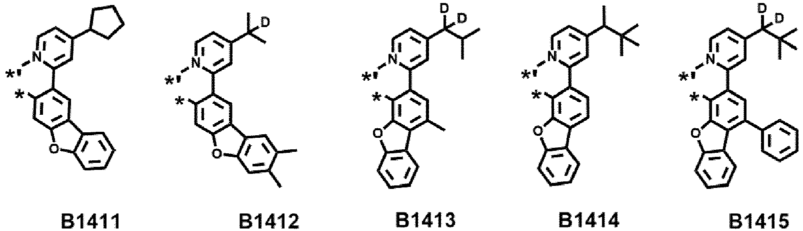 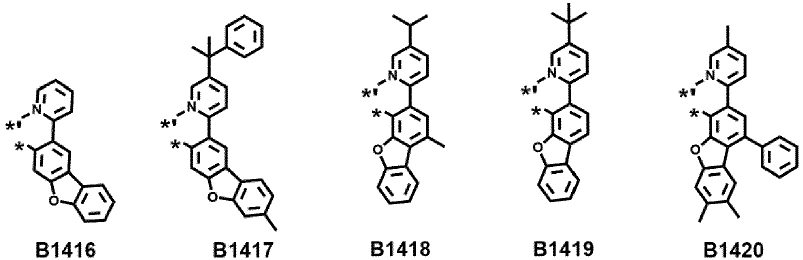 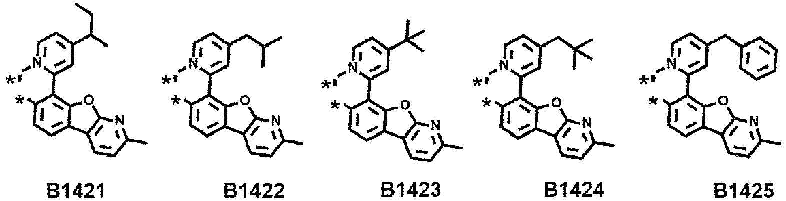 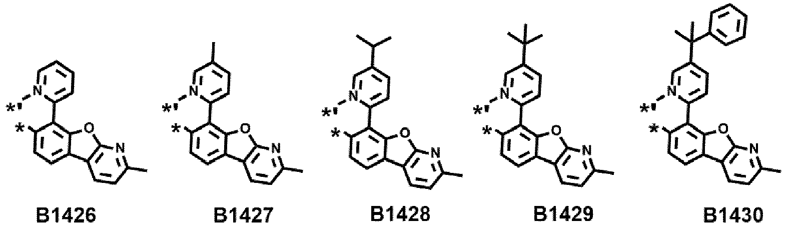 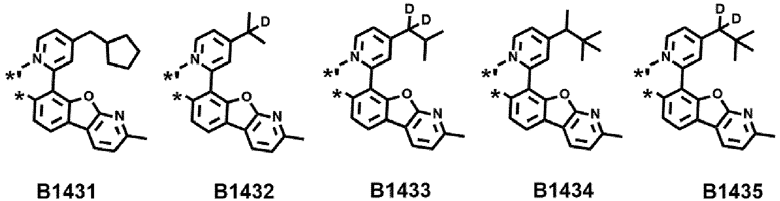 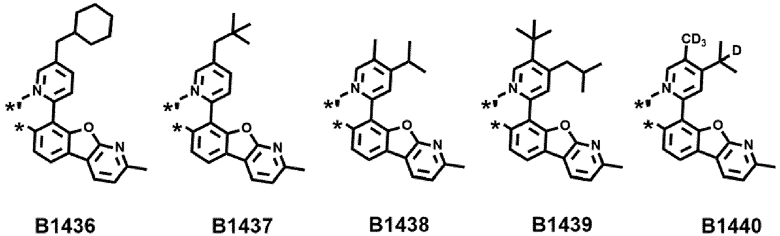 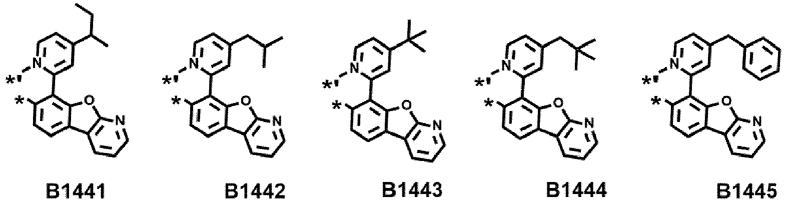 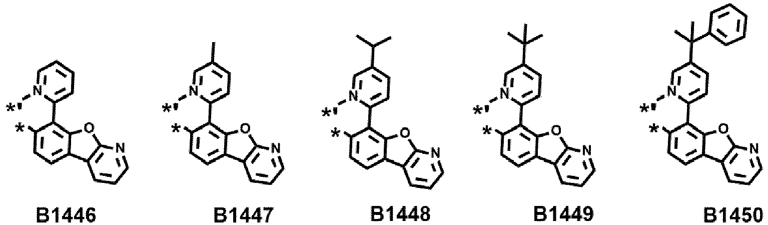 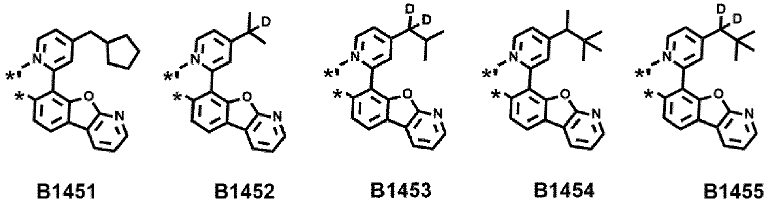 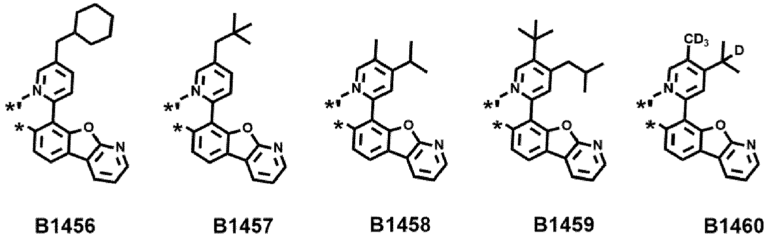 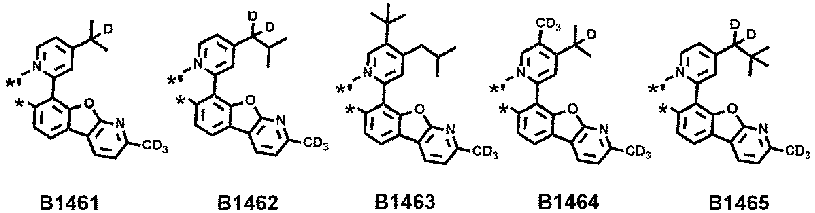 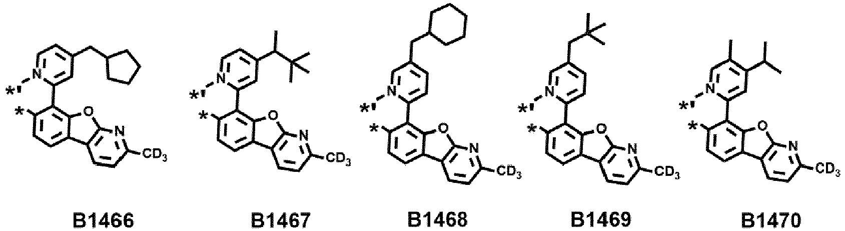 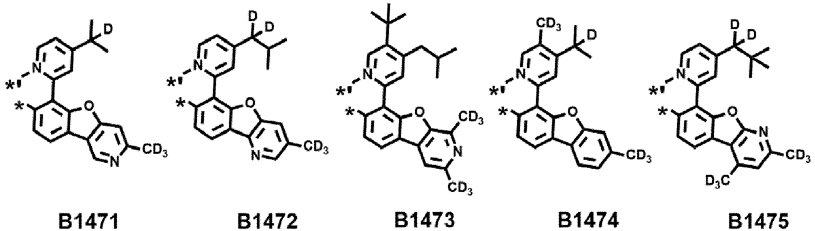 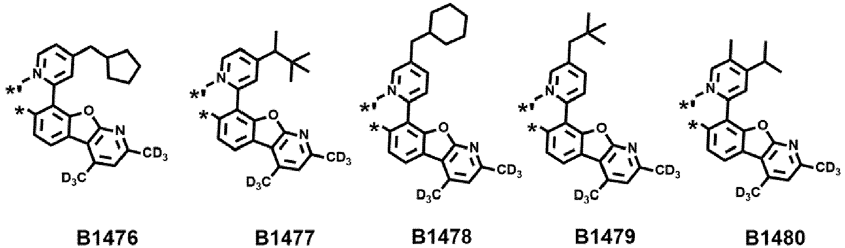 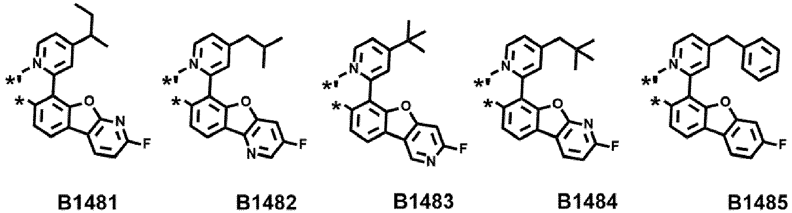 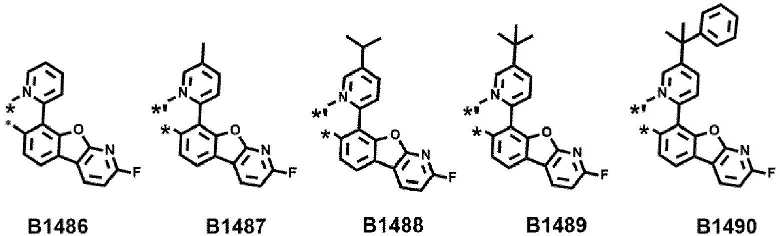 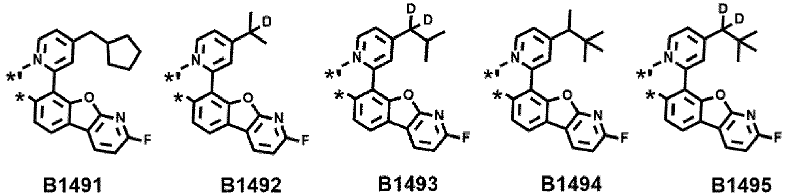 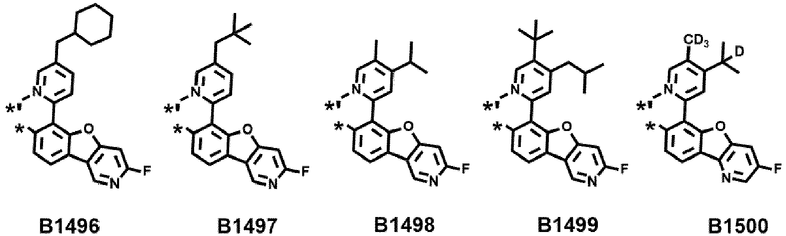 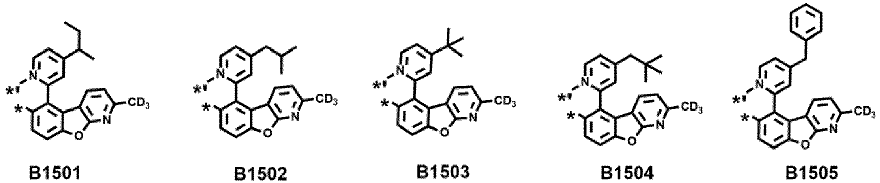 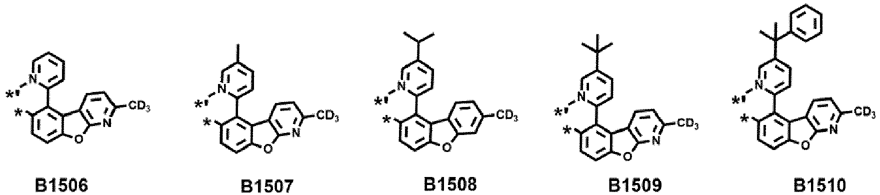 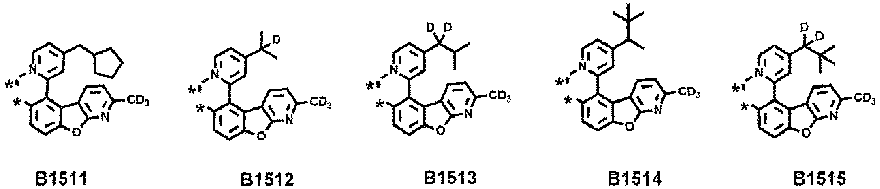 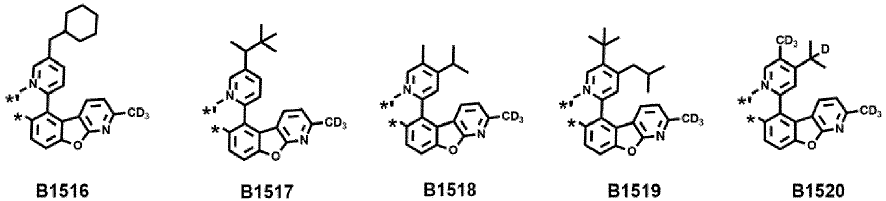 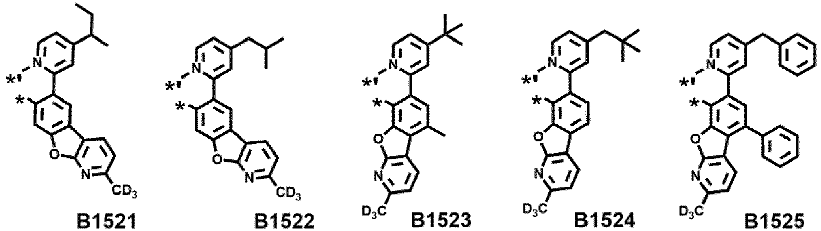 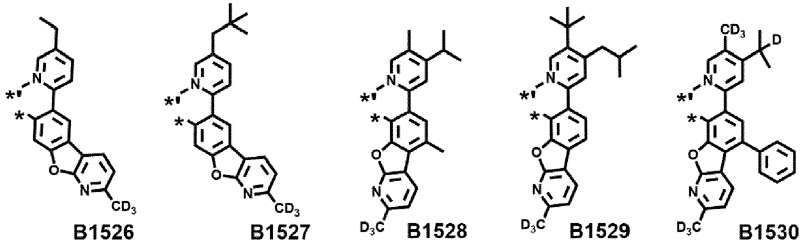 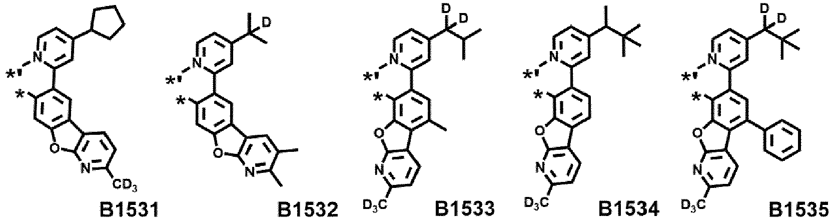 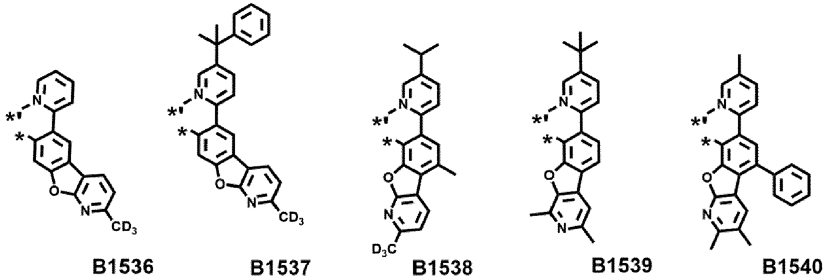 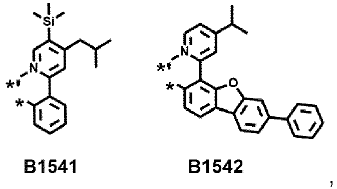 wherein * and *' each indicate a binding site to iridium.

In one or more embodiments, L₁₂ and L₁₃ in Formula 1 and a ligand represented by Formula 1-2 may each independently be selected from B1 to B780.

In one or more embodiments, L₂₂ and L₂₃ in Formula 2 and a ligand represented by Formula 2-2 may each independently be selected from B781 to B1542.

In one or more embodiments, the first compound and the second compound may each be one of compounds described in Tables 1 to 11 below.

**Table 1**

| [Group 1] Ir(L₁)₂(L₂) / [Group 2] Ir(L₁)(L₂)₂ | | | | | | | | |
|---|---|---|---|---|---|---|---|---|
| Compound | L₁ | L₂ | Compound | L₁ | L₂ | Compound | L₁ | L₂ |
| x-1 | Ax | B1 | x-51 | Ax | B51 | x-101 | Ax | B101 |
| x-2 | Ax | B2 | x-52 | Ax | B52 | x-102 | Ax | B102 |
| x-3 | Ax | B3 | x-53 | Ax | B53 | x-103 | Ax | B103 |
| x-4 | Ax | B4 | x-54 | Ax | B54 | x-104 | Ax | B104 |
| x-5 | Ax | B5 | x-55 | Ax | B55 | x-105 | Ax | B105 |
| x-6 | Ax | B6 | x-56 | Ax | B56 | x-106 | Ax | B106 |
| x-7 | Ax | B7 | x-57 | Ax | B57 | x-107 | Ax | B107 |
| x-8 | Ax | B8 | x-58 | Ax | B58 | x-108 | Ax | B108 |
| x-9 | Ax | B9 | x-59 | Ax | B59 | x-109 | Ax | B109 |
| x-10 | Ax | B10 | x-60 | Ax | B60 | x-110 | Ax | B110 |
| x-11 | Ax | B11 | x-61 | Ax | B61 | x-111 | Ax | B111 |
| x-12 | Ax | B12 | x-62 | Ax | B62 | x-112 | Ax | B112 |
| x-13 | Ax | B13 | x-63 | Ax | B63 | x-113 | Ax | B113 |
| x-14 | Ax | B14 | x-64 | Ax | B64 | x-114 | Ax | B114 |
| x-15 | Ax | B15 | x-65 | Ax | B65 | x-115 | Ax | B115 |
| x-16 | Ax | B16 | x-66 | Ax | B66 | x-116 | Ax | B116 |
| x-17 | Ax | B17 | x-67 | Ax | B67 | x-117 | Ax | B117 |
| x-18 | Ax | B18 | x-68 | Ax | B68 | x-118 | Ax | B118 |
| x-19 | Ax | B19 | x-69 | Ax | B69 | x-119 | Ax | B119 |
| x-20 | Ax | B20 | x-70 | Ax | B70 | x-120 | Ax | B120 |
| x-21 | Ax | B21 | x-71 | Ax | B71 | x-121 | Ax | B121 |
| x-22 | Ax | B22 | x-72 | Ax | B72 | x-122 | Ax | B122 |
| x-23 | Ax | B23 | x-73 | Ax | B73 | x-123 | Ax | B123 |
| x-24 | Ax | B24 | x-74 | Ax | B74 | x-124 | Ax | B124 |
| x-25 | Ax | B25 | x-75 | Ax | B75 | x-125 | Ax | B125 |
| x-26 | Ax | B26 | x-76 | Ax | B76 | x-126 | Ax | B126 |
| x-27 | Ax | B27 | x-77 | Ax | B77 | x-127 | Ax | B127 |
| x-28 | Ax | B28 | x-78 | Ax | B78 | x-128 | Ax | B128 |
| x-29 | Ax | B29 | x-79 | Ax | B79 | x-129 | Ax | B129 |
| x-30 | Ax | B30 | x-80 | Ax | B80 | x-130 | Ax | B130 |
| x-31 | Ax | B31 | x-81 | Ax | B81 | x-131 | Ax | B131 |
| x-32 | Ax | B32 | x-82 | Ax | B82 | x-132 | Ax | B132 |
| x-33 | Ax | B33 | x-83 | Ax | B83 | x-133 | Ax | B133 |
| x-34 | Ax | B34 | x-84 | Ax | B84 | x-134 | Ax | B134 |
| x-35 | Ax | B35 | x-85 | Ax | B85 | x-135 | Ax | B135 |
| x-36 | Ax | B36 | x-86 | Ax | B86 | x-136 | Ax | B136 |
| x-37 | Ax | B37 | x-87 | Ax | B87 | x-137 | Ax | B137 |
| x-38 | Ax | B38 | x-88 | Ax | B88 | x-138 | Ax | B138 |
| x-39 | Ax | B39 | x-89 | Ax | B89 | x-139 | Ax | B139 |
| x-40 | Ax | B40 | x-90 | Ax | B90 | x-140 | Ax | B140 |
| x-41 | Ax | B41 | x-91 | Ax | B91 | x-141 | Ax | B141 |
| x-42 | Ax | B42 | x-92 | Ax | B92 | x-142 | Ax | B142 |
| x-43 | Ax | B43 | x-93 | Ax | B93 | x-143 | Ax | B143 |
| x-44 | Ax | B44 | x-94 | Ax | B94 | x-144 | Ax | B144 |
| x-45 | Ax | B45 | x-95 | Ax | B95 | x-145 | Ax | B145 |
| x-46 | Ax | B46 | x-96 | Ax | B96 | x-146 | Ax | B146 |
| x-47 | Ax | B47 | x-97 | Ax | B97 | x-147 | Ax | B147 |
| x-48 | Ax | B48 | x-98 | Ax | B98 | x-148 | Ax | B148 |
| x-49 | Ax | B49 | x-99 | Ax | B99 | x-149 | Ax | B149 |
| x-50 | Ax | B50 | x-100 | Ax | B100 | x-150 | Ax | B150 |

**Table 2**

| [Group 1] Ir(L₁)₂(L₂) / [Group 2] Ir(L₁)(L₂)₂ | | | | | | | | |
|---|---|---|---|---|---|---|---|---|
| Compound | L₁ | L₂ | Compound | L₁ | L₂ | Compound | L₁ | L₂ |
| x-151 | Ax | B151 | x-201 | Ax | B201 | x-251 | Ax | B251 |
| x-152 | Ax | B152 | x-202 | Ax | B202 | x-252 | Ax | B252 |
| x-153 | Ax | B153 | x-203 | Ax | B203 | x-253 | Ax | B253 |
| x-154 | Ax | B154 | x-204 | Ax | B204 | x-254 | Ax | B254 |
| x-155 | Ax | B155 | x-205 | Ax | B205 | x-255 | Ax | B255 |
| x-156 | Ax | B156 | x-206 | Ax | B206 | x-256 | Ax | B256 |
| x-157 | Ax | B157 | x-207 | Ax | B207 | x-257 | Ax | B257 |
| x-158 | Ax | B158 | x-208 | Ax | B208 | x-258 | Ax | B258 |
| x-159 | Ax | B159 | x-209 | Ax | B209 | x-259 | Ax | B259 |
| x-160 | Ax | B160 | x-210 | Ax | B210 | x-260 | Ax | B260 |
| x-161 | Ax | B161 | x-211 | Ax | B211 | x-261 | Ax | B261 |
| x-162 | Ax | B162 | x-212 | Ax | B212 | x-262 | Ax | B262 |
| x-163 | Ax | B163 | x-213 | Ax | B213 | x-263 | Ax | B263 |
| x-164 | Ax | B164 | x-214 | Ax | B214 | x-264 | Ax | B264 |
| x-165 | Ax | B165 | x-215 | Ax | B215 | x-265 | Ax | B265 |
| x-166 | Ax | B166 | x-216 | Ax | B216 | x-266 | Ax | B266 |
| x-167 | Ax | B167 | x-217 | Ax | B217 | x-267 | Ax | B267 |
| x-168 | Ax | B168 | x-218 | Ax | B218 | x-268 | Ax | B268 |
| x-169 | Ax | B169 | x-219 | Ax | B219 | x-269 | Ax | B269 |
| x-170 | Ax | B170 | x-220 | Ax | B220 | x-270 | Ax | B270 |
| x-171 | Ax | B171 | x-221 | Ax | B221 | x-271 | Ax | B271 |
| x-172 | Ax | B172 | x-222 | Ax | B222 | x-272 | Ax | B272 |
| x-173 | Ax | B173 | x-223 | Ax | B223 | x-273 | Ax | B273 |
| x-174 | Ax | B174 | x-224 | Ax | B224 | x-274 | Ax | B274 |
| x-175 | Ax | B175 | x-225 | Ax | B225 | x-275 | Ax | B275 |
| x-176 | Ax | B176 | x-226 | Ax | B226 | x-276 | Ax | B276 |
| x-177 | Ax | B177 | x-227 | Ax | B227 | x-277 | Ax | B277 |
| x-178 | Ax | B178 | x-228 | Ax | B228 | x-278 | Ax | B278 |
| x-179 | Ax | B179 | x-229 | Ax | B229 | x-279 | Ax | B279 |
| x-180 | Ax | B180 | x-230 | Ax | B230 | x-280 | Ax | B280 |
| x-181 | Ax | B181 | x-231 | Ax | B231 | x-281 | Ax | B281 |
| x-182 | Ax | B182 | x-232 | Ax | B232 | x-282 | Ax | B282 |
| x-183 | Ax | B183 | x-233 | Ax | B233 | x-283 | Ax | B283 |
| x-184 | Ax | B184 | x-234 | Ax | B234 | x-284 | Ax | B284 |
| x-185 | Ax | B185 | x-235 | Ax | B235 | x-285 | Ax | B285 |
| x-186 | Ax | B186 | x-236 | Ax | B236 | x-286 | Ax | B286 |
| x-187 | Ax | B187 | x-237 | Ax | B237 | x-287 | Ax | B287 |
| x-188 | Ax | B188 | x-238 | Ax | B238 | x-288 | Ax | B288 |
| x-189 | Ax | B189 | x-239 | Ax | B239 | x-289 | Ax | B289 |
| x-190 | Ax | B190 | x-240 | Ax | B240 | x-290 | Ax | B290 |
| x-191 | Ax | B191 | x-241 | Ax | B241 | x-291 | Ax | B291 |
| x-192 | Ax | B192 | x-242 | Ax | B242 | x-292 | Ax | B292 |
| x-193 | Ax | B193 | x-243 | Ax | B243 | x-293 | Ax | B293 |
| x-194 | Ax | B194 | x-244 | Ax | B244 | x-294 | Ax | B294 |
| x-195 | Ax | B195 | x-245 | Ax | B245 | x-295 | Ax | B295 |
| x-196 | Ax | B196 | x-246 | Ax | B246 | x-296 | Ax | B296 |
| x-197 | Ax | B197 | x-247 | Ax | B247 | x-297 | Ax | B297 |
| x-198 | Ax | B198 | x-248 | Ax | B248 | x-298 | Ax | B298 |
| x-199 | Ax | B199 | x-249 | Ax | B249 | x-299 | Ax | B299 |
| x-200 | Ax | B200 | x-250 | Ax | B250 | x-300 | Ax | B300 |

**Table 3**

| [Group 1] Ir(L₁)₂(L₂) / [Group 2] Ir(L₁)(L₂)₂ | | | | | | | | |
|---|---|---|---|---|---|---|---|---|
| Compound | L₁ | L₂ | Compound | L₁ | L₂ | Compound | L₁ | L₂ |
| x-301 | Ax | B301 | x-351 | Ax | B351 | x-401 | Ax | B401 |
| x-302 | Ax | B302 | x-352 | Ax | B352 | x-402 | Ax | B402 |
| x-303 | Ax | B303 | x-353 | Ax | B353 | x-403 | Ax | B403 |
| x-304 | Ax | B304 | x-354 | Ax | B354 | x-404 | Ax | B404 |
| x-305 | Ax | B305 | x-355 | Ax | B355 | x-405 | Ax | B405 |
| x-306 | Ax | B306 | x-356 | Ax | B356 | x-406 | Ax | B406 |
| x-307 | Ax | B307 | x-357 | Ax | B357 | x-407 | Ax | B407 |
| x-308 | Ax | B308 | x-358 | Ax | B358 | x-408 | Ax | B408 |
| x-309 | Ax | B309 | x-359 | Ax | B359 | x-409 | Ax | B409 |
| x-310 | Ax | B310 | x-360 | Ax | B360 | x-410 | Ax | B410 |
| x-311 | Ax | B311 | x-361 | Ax | B361 | x-411 | Ax | B411 |
| x-312 | Ax | B312 | x-362 | Ax | B362 | x-412 | Ax | B412 |
| x-313 | Ax | B313 | x-363 | Ax | B363 | x-413 | Ax | B413 |
| x-314 | Ax | B314 | x-364 | Ax | B364 | x-414 | Ax | B414 |
| x-315 | Ax | B315 | x-365 | Ax | B365 | x-415 | Ax | B415 |
| x-316 | Ax | B316 | x-366 | Ax | B366 | x-416 | Ax | B416 |
| x-317 | Ax | B317 | x-367 | Ax | B367 | x-417 | Ax | B417 |
| x-318 | Ax | B318 | x-368 | Ax | B368 | x-418 | Ax | B418 |
| x-319 | Ax | B319 | x-369 | Ax | B369 | x-419 | Ax | B419 |
| x-320 | Ax | B320 | x-370 | Ax | B370 | x-420 | Ax | B420 |
| x-321 | Ax | B321 | x-371 | Ax | B371 | x-421 | Ax | B421 |
| x-322 | Ax | B322 | x-372 | Ax | B372 | x-422 | Ax | B422 |
| x-323 | Ax | B323 | x-373 | Ax | B373 | x-423 | Ax | B423 |
| x-324 | Ax | B324 | x-374 | Ax | B374 | x-424 | Ax | B424 |
| x-325 | Ax | B325 | x-375 | Ax | B375 | x-425 | Ax | B425 |
| x-326 | Ax | B326 | x-376 | Ax | B376 | x-426 | Ax | B426 |
| x-327 | Ax | B327 | x-377 | Ax | B377 | x-427 | Ax | B427 |
| x-328 | Ax | B328 | x-378 | Ax | B378 | x-428 | Ax | B428 |
| x-329 | Ax | B329 | x-379 | Ax | B379 | x-429 | Ax | B429 |
| x-330 | Ax | B330 | x-380 | Ax | B380 | x-430 | Ax | B430 |
| x-331 | Ax | B331 | x-381 | Ax | B381 | x-431 | Ax | B431 |
| x-332 | Ax | B332 | x-382 | Ax | B382 | x-432 | Ax | B432 |
| x-333 | Ax | B333 | x-383 | Ax | B383 | x-433 | Ax | B433 |
| x-334 | Ax | B334 | x-384 | Ax | B384 | x-434 | Ax | B434 |
| x-335 | Ax | B335 | x-385 | Ax | B385 | x-435 | Ax | B435 |
| x-336 | Ax | B336 | x-386 | Ax | B386 | x-436 | Ax | B436 |
| x-337 | Ax | B337 | x-387 | Ax | B387 | x-437 | Ax | B437 |
| x-338 | Ax | B338 | x-388 | Ax | B388 | x-438 | Ax | B438 |
| x-339 | Ax | B339 | x-389 | Ax | B389 | x-439 | Ax | B439 |
| x-340 | Ax | B340 | x-390 | Ax | B390 | x-440 | Ax | B440 |
| x-341 | Ax | B341 | x-391 | Ax | B391 | x-441 | Ax | B441 |
| x-342 | Ax | B342 | x-392 | Ax | B392 | x-442 | Ax | B442 |
| x-343 | Ax | B343 | x-393 | Ax | B393 | x-443 | Ax | B443 |
| x-344 | Ax | B344 | x-394 | Ax | B394 | x-444 | Ax | B444 |
| x-345 | Ax | B345 | x-395 | Ax | B395 | x-445 | Ax | B445 |
| x-346 | Ax | B346 | x-396 | Ax | B396 | x-446 | Ax | B446 |
| x-347 | Ax | B347 | x-397 | Ax | B397 | x-447 | Ax | B447 |
| x-348 | Ax | B348 | x-398 | Ax | B398 | x-448 | Ax | B448 |
| x-349 | Ax | B349 | x-399 | Ax | B399 | x-449 | Ax | B449 |
| x-350 | Ax | B350 | x-400 | Ax | B400 | x-450 | Ax | B450 |

**Table 4**

| [Group 1] Ir(L₁)₂(L₂) / [Group 2] Ir(L₁)(L₂)₂ | | | | | | | | |
|---|---|---|---|---|---|---|---|---|
| Compound | L₁ | L₂ | Compound | L₁ | L₂ | Compound | L₁ | L₂ |
| x-451 | Ax | B451 | x-501 | Ax | B501 | x-551 | Ax | B551 |
| x-452 | Ax | B452 | x-502 | Ax | B502 | x-552 | Ax | B552 |
| x-453 | Ax | B453 | x-503 | Ax | B503 | x-553 | Ax | B553 |
| x-454 | Ax | B454 | x-504 | Ax | B504 | x-554 | Ax | B554 |
| x-455 | Ax | B455 | x-505 | Ax | B505 | x-555 | Ax | B555 |
| x-456 | Ax | B456 | x-506 | Ax | B506 | x-556 | Ax | B556 |
| x-457 | Ax | B457 | x-507 | Ax | B507 | x-557 | Ax | B557 |
| x-458 | Ax | B458 | x-508 | Ax | B508 | x-558 | Ax | B558 |
| x-459 | Ax | B459 | x-509 | Ax | B509 | x-559 | Ax | B559 |
| x-460 | Ax | B460 | x-510 | Ax | B510 | x-560 | Ax | B560 |
| x-461 | Ax | B461 | x-511 | Ax | B511 | x-561 | Ax | B561 |
| x-462 | Ax | B462 | x-512 | Ax | B512 | x-562 | Ax | B562 |
| x-463 | Ax | B463 | x-513 | Ax | B513 | x-563 | Ax | B563 |
| x-464 | Ax | B464 | x-514 | Ax | B514 | x-564 | Ax | B564 |
| x-465 | Ax | B465 | x-515 | Ax | B515 | x-565 | Ax | B565 |
| x-466 | Ax | B466 | x-516 | Ax | B516 | x-566 | Ax | B566 |
| x-467 | Ax | B467 | x-517 | Ax | B517 | x-567 | Ax | B567 |
| x-468 | Ax | B468 | x-518 | Ax | B518 | x-568 | Ax | B568 |
| x-469 | Ax | B469 | x-519 | Ax | B519 | x-569 | Ax | B569 |
| x-470 | Ax | B470 | x-520 | Ax | B520 | x-570 | Ax | B570 |
| x-471 | Ax | B471 | x-521 | Ax | B521 | x-571 | Ax | B571 |
| x-472 | Ax | B472 | x-522 | Ax | B522 | x-572 | Ax | B572 |
| x-473 | Ax | B473 | x-523 | Ax | B523 | x-573 | Ax | B573 |
| x-474 | Ax | B474 | x-524 | Ax | B524 | x-574 | Ax | B574 |
| x-475 | Ax | B475 | x-525 | Ax | B525 | x-575 | Ax | B575 |
| x-476 | Ax | B476 | x-526 | Ax | B526 | x-576 | Ax | B576 |
| x-477 | Ax | B477 | x-527 | Ax | B527 | x-577 | Ax | B577 |
| x-478 | Ax | B478 | x-528 | Ax | B528 | x-578 | Ax | B578 |
| x-479 | Ax | B479 | x-529 | Ax | B529 | x-579 | Ax | B579 |
| x-480 | Ax | B480 | x-530 | Ax | B530 | x-580 | Ax | B580 |
| x-481 | Ax | B481 | x-531 | Ax | B531 | x-581 | Ax | B581 |
| x-482 | Ax | B482 | x-532 | Ax | B532 | x-582 | Ax | B582 |
| x-483 | Ax | B483 | x-533 | Ax | B533 | x-583 | Ax | B583 |
| x-484 | Ax | B484 | x-534 | Ax | B534 | x-584 | Ax | B584 |
| x-485 | Ax | B485 | x-535 | Ax | B535 | x-585 | Ax | B585 |
| x-486 | Ax | B486 | x-536 | Ax | B536 | x-586 | Ax | B586 |
| x-487 | Ax | B487 | x-537 | Ax | B537 | x-587 | Ax | B587 |
| x-488 | Ax | B488 | x-538 | Ax | B538 | x-588 | Ax | B588 |
| x-489 | Ax | B489 | x-539 | Ax | B539 | x-589 | Ax | B589 |
| x-490 | Ax | B490 | x-540 | Ax | B540 | x-590 | Ax | B590 |
| x-491 | Ax | B491 | x-541 | Ax | B541 | x-591 | Ax | B591 |
| x-492 | Ax | B492 | x-542 | Ax | B542 | x-592 | Ax | B592 |
| x-493 | Ax | B493 | x-543 | Ax | B543 | x-593 | Ax | B593 |
| x-494 | Ax | B494 | x-544 | Ax | B544 | x-594 | Ax | B594 |
| x-495 | Ax | B495 | x-545 | Ax | B545 | x-595 | Ax | B595 |
| x-496 | Ax | B496 | x-546 | Ax | B546 | x-596 | Ax | B596 |
| x-497 | Ax | B497 | x-547 | Ax | B547 | x-597 | Ax | B597 |
| x-498 | Ax | B498 | x-548 | Ax | B548 | x-598 | Ax | B598 |
| x-499 | Ax | B499 | x-549 | Ax | B549 | x-599 | Ax | B599 |
| x-500 | Ax | B500 | x-550 | Ax | B550 | x-600 | Ax | B600 |

**Table 5**

| [Group 1] Ir(L₁)₂(L₂) / [Group 2] Ir(L₁)(L₂)₂ | | | | | | | | |
|---|---|---|---|---|---|---|---|---|
| Compound | L₁ | L₂ | Compound | L₁ | L₂ | Compound | L₁ | L₂ |
| x-601 | Ax | B601 | x-651 | Ax | B651 | x-701 | Ax | B701 |
| x-602 | Ax | B602 | x-652 | Ax | B652 | x-702 | Ax | B702 |
| x-603 | Ax | B603 | x-653 | Ax | B653 | x-703 | Ax | B703 |
| x-604 | Ax | B604 | x-654 | Ax | B654 | x-704 | Ax | B704 |
| x-605 | Ax | B605 | x-655 | Ax | B655 | x-705 | Ax | B705 |
| x-606 | Ax | B606 | x-656 | Ax | B656 | x-706 | Ax | B706 |
| x-607 | Ax | B607 | x-657 | Ax | B657 | x-707 | Ax | B707 |
| x-608 | Ax | B608 | x-658 | Ax | B658 | x-708 | Ax | B708 |
| x-609 | Ax | B609 | x-659 | Ax | B659 | x-709 | Ax | B709 |
| x-610 | Ax | B610 | x-660 | Ax | B660 | x-710 | Ax | B710 |
| x-611 | Ax | B611 | x-661 | Ax | B661 | x-711 | Ax | B711 |
| x-612 | Ax | B612 | x-662 | Ax | B662 | x-712 | Ax | B712 |
| x-613 | Ax | B613 | x-663 | Ax | B663 | x-713 | Ax | B713 |
| x-614 | Ax | B614 | x-664 | Ax | B664 | x-714 | Ax | B714 |
| x-615 | Ax | B615 | x-665 | Ax | B665 | x-715 | Ax | B715 |
| x-616 | Ax | B616 | x-666 | Ax | B666 | x-716 | Ax | B716 |
| x-617 | Ax | B617 | x-667 | Ax | B667 | x-717 | Ax | B717 |
| x-618 | Ax | B618 | x-668 | Ax | B668 | x-718 | Ax | B718 |
| x-619 | Ax | B619 | x-669 | Ax | B669 | x-719 | Ax | B719 |
| x-620 | Ax | B620 | x-670 | Ax | B670 | x-720 | Ax | B720 |
| x-621 | Ax | B621 | x-671 | Ax | B671 | x-721 | Ax | B721 |
| x-622 | Ax | B622 | x-672 | Ax | B672 | x-722 | Ax | B722 |
| x-623 | Ax | B623 | x-673 | Ax | B673 | x-723 | Ax | B723 |
| x-624 | Ax | B624 | x-674 | Ax | B674 | x-724 | Ax | B724 |
| x-625 | Ax | B625 | x-675 | Ax | B675 | x-725 | Ax | B725 |
| x-626 | Ax | B626 | x-676 | Ax | B676 | x-726 | Ax | B726 |
| x-627 | Ax | B627 | x-677 | Ax | B677 | x-727 | Ax | B727 |
| x-628 | Ax | B628 | x-678 | Ax | B678 | x-728 | Ax | B728 |
| x-629 | Ax | B629 | x-679 | Ax | B679 | x-729 | Ax | B729 |
| x-630 | Ax | B630 | x-680 | Ax | B680 | x-730 | Ax | B730 |
| x-631 | Ax | B631 | x-681 | Ax | B681 | x-731 | Ax | B731 |
| x-632 | Ax | B632 | x-682 | Ax | B682 | x-732 | Ax | B732 |
| x-633 | Ax | B633 | x-683 | Ax | B683 | x-733 | Ax | B733 |
| x-634 | Ax | B634 | x-684 | Ax | B684 | x-734 | Ax | B734 |
| x-635 | Ax | B635 | x-685 | Ax | B685 | x-735 | Ax | B735 |
| x-636 | Ax | B636 | x-686 | Ax | B686 | x-736 | Ax | B736 |
| x-637 | Ax | B637 | x-687 | Ax | B687 | x-737 | Ax | B737 |
| x-638 | Ax | B638 | x-688 | Ax | B688 | x-738 | Ax | B738 |
| x-639 | Ax | B639 | x-689 | Ax | B689 | x-739 | Ax | B739 |
| x-640 | Ax | B640 | x-690 | Ax | B690 | x-740 | Ax | B740 |
| x-641 | Ax | B641 | x-691 | Ax | B691 | x-741 | Ax | B741 |
| x-642 | Ax | B642 | x-692 | Ax | B692 | x-742 | Ax | B742 |
| x-643 | Ax | B643 | x-693 | Ax | B693 | x-743 | Ax | B743 |
| x-644 | Ax | B644 | x-694 | Ax | B694 | x-744 | Ax | B744 |
| x-645 | Ax | B645 | x-695 | Ax | B695 | x-745 | Ax | B745 |
| x-646 | Ax | B646 | x-696 | Ax | B696 | x-746 | Ax | B746 |
| x-647 | Ax | B647 | x-697 | Ax | B697 | x-747 | Ax | B747 |
| x-648 | Ax | B648 | x-698 | Ax | B698 | x-748 | Ax | B748 |
| x-649 | Ax | B649 | x-699 | Ax | B699 | x-749 | Ax | B749 |
| x-650 | Ax | B650 | x-700 | Ax | B700 | x-750 | Ax | B750 |

**Table 6**

| [Group 1] Ir(L₁)₂(L₂) / [Group 2] Ir(L₁)(L₂)₂ | | | | | | | | |
|---|---|---|---|---|---|---|---|---|
| Compound | L₁ | L₂ | Compound | L₁ | L₂ | Compound | L₁ | L₂ |
| x-751 | Ax | B751 | x-801 | Ax | B801 | x-851 | Ax | B851 |
| x-752 | Ax | B752 | x-802 | Ax | B802 | x-852 | Ax | B852 |
| x-753 | Ax | B753 | x-803 | Ax | B803 | x-853 | Ax | B853 |
| x-754 | Ax | B754 | x-804 | Ax | B804 | x-854 | Ax | B854 |
| x-755 | Ax | B755 | x-805 | Ax | B805 | x-855 | Ax | B855 |
| x-756 | Ax | B756 | x-806 | Ax | B806 | x-856 | Ax | B856 |
| x-757 | Ax | B757 | x-807 | Ax | B807 | x-857 | Ax | B857 |
| x-758 | Ax | B758 | x-808 | Ax | B808 | x-858 | Ax | B858 |
| x-759 | Ax | B759 | x-809 | Ax | B809 | x-859 | Ax | B859 |
| x-760 | Ax | B760 | x-810 | Ax | B810 | x-860 | Ax | B860 |
| x-761 | Ax | B761 | x-811 | Ax | B811 | x-861 | Ax | B861 |
| x-762 | Ax | B762 | x-812 | Ax | B812 | x-862 | Ax | B862 |
| x-763 | Ax | B763 | x-813 | Ax | B813 | x-863 | Ax | B863 |
| x-764 | Ax | B764 | x-814 | Ax | B814 | x-864 | Ax | B864 |
| x-765 | Ax | B765 | x-815 | Ax | B815 | x-865 | Ax | B865 |
| x-766 | Ax | B766 | x-816 | Ax | B816 | x-866 | Ax | B866 |
| x-767 | Ax | B767 | x-817 | Ax | B817 | x-867 | Ax | B867 |
| x-768 | Ax | B768 | x-818 | Ax | B818 | x-868 | Ax | B868 |
| x-769 | Ax | B769 | x-819 | Ax | B819 | x-869 | Ax | B869 |
| x-770 | Ax | B770 | x-820 | Ax | B820 | x-870 | Ax | B870 |
| x-771 | Ax | B771 | x-821 | Ax | B821 | x-871 | Ax | B871 |
| x-772 | Ax | B772 | x-822 | Ax | B822 | x-872 | Ax | B872 |
| x-773 | Ax | B773 | x-823 | Ax | B823 | x-873 | Ax | B873 |
| x-774 | Ax | B774 | x-824 | Ax | B824 | x-874 | Ax | B874 |
| x-775 | Ax | B775 | x-825 | Ax | B825 | x-875 | Ax | B875 |
| x-776 | Ax | B776 | x-826 | Ax | B826 | x-876 | Ax | B876 |
| x-777 | Ax | B777 | x-827 | Ax | B827 | x-877 | Ax | B877 |
| x-778 | Ax | B778 | x-828 | Ax | B828 | x-878 | Ax | B878 |
| x-779 | Ax | B779 | x-829 | Ax | B829 | x-879 | Ax | B879 |
| x-780 | Ax | B780 | x-830 | Ax | B830 | x-880 | Ax | B880 |
| x-781 | Ax | B781 | x-831 | Ax | B831 | x-881 | Ax | B881 |
| x-782 | Ax | B782 | x-832 | Ax | B832 | x-882 | Ax | B882 |
| x-783 | Ax | B783 | x-833 | Ax | B833 | x-883 | Ax | B883 |
| x-784 | Ax | B784 | x-834 | Ax | B834 | x-884 | Ax | B884 |
| x-785 | Ax | B785 | x-835 | Ax | B835 | x-885 | Ax | B885 |
| x-786 | Ax | B786 | x-836 | Ax | B836 | x-886 | Ax | B886 |
| x-787 | Ax | B787 | x-837 | Ax | B837 | x-887 | Ax | B887 |
| x-788 | Ax | B788 | x-838 | Ax | B838 | x-888 | Ax | B888 |
| x-789 | Ax | B789 | x-839 | Ax | B839 | x-889 | Ax | B889 |
| x-790 | Ax | B790 | x-840 | Ax | B840 | x-890 | Ax | B890 |
| x-791 | Ax | B791 | x-841 | Ax | B841 | x-891 | Ax | B891 |
| x-792 | Ax | B792 | x-842 | Ax | B842 | x-892 | Ax | B892 |
| x-793 | Ax | B793 | x-843 | Ax | B843 | x-893 | Ax | B893 |
| x-794 | Ax | B794 | x-844 | Ax | B844 | x-894 | Ax | B894 |
| x-795 | Ax | B795 | x-845 | Ax | B845 | x-895 | Ax | B895 |
| x-796 | Ax | B796 | x-846 | Ax | B846 | x-896 | Ax | B896 |
| x-797 | Ax | B797 | x-847 | Ax | B847 | x-897 | Ax | B897 |
| x-798 | Ax | B798 | x-848 | Ax | B848 | x-898 | Ax | B898 |
| x-799 | Ax | B799 | x-849 | Ax | B849 | x-899 | Ax | B899 |
| x-800 | Ax | B800 | x-850 | Ax | B850 | x-900 | Ax | B900 |

**Table 7**

| [Group 1] Ir(L₁)₂(L₂) / [Group 2] Ir(L₁)(L₂)₂ | | | | | | | | |
|---|---|---|---|---|---|---|---|---|
| Compound | L₁ | L₂ | Compound | L₁ | L₂ | Compound | L₁ | L₂ |
| x-901 | Ax | B901 | x-951 | Ax | B951 | x-1001 | Ax | B1001 |
| x-902 | Ax | B902 | x-952 | Ax | B952 | x-1002 | Ax | B1002 |
| x-903 | Ax | B903 | x-953 | Ax | B953 | x-1003 | Ax | B1003 |
| x-904 | Ax | B904 | x-954 | Ax | B954 | x-1004 | Ax | B1004 |
| x-905 | Ax | B905 | x-955 | Ax | B955 | x-1005 | Ax | B1005 |
| x-906 | Ax | B906 | x-956 | Ax | B956 | x-1006 | Ax | B1006 |
| x-907 | Ax | B907 | x-957 | Ax | B957 | x-1007 | Ax | B1007 |
| x-908 | Ax | B908 | x-958 | Ax | B958 | x-1008 | Ax | B1008 |
| x-909 | Ax | B909 | x-959 | Ax | B959 | x-1009 | Ax | B1009 |
| x-910 | Ax | B910 | x-960 | Ax | B960 | x-1010 | Ax | B1010 |
| x-911 | Ax | B911 | x-961 | Ax | B961 | x-1011 | Ax | B1011 |
| x-912 | Ax | B912 | x-962 | Ax | B962 | x-1012 | Ax | B1012 |
| x-913 | Ax | B913 | x-963 | Ax | B963 | x-1013 | Ax | B1013 |
| x-914 | Ax | B914 | x-964 | Ax | B964 | x-1014 | Ax | B1014 |
| x-915 | Ax | B915 | x-965 | Ax | B965 | x-1015 | Ax | B1015 |
| x-916 | Ax | B916 | x-966 | Ax | B966 | x-1016 | Ax | B1016 |
| x-917 | Ax | B917 | x-967 | Ax | B967 | x-1017 | Ax | B1017 |
| x-918 | Ax | B918 | x-968 | Ax | B968 | x-1018 | Ax | B1018 |
| x-919 | Ax | B919 | x-969 | Ax | B969 | x-1019 | Ax | B1019 |
| x-920 | Ax | B920 | x-970 | Ax | B970 | x-1020 | Ax | B1020 |
| x-921 | Ax | B921 | x-971 | Ax | B971 | x-1021 | Ax | B1021 |
| x-922 | Ax | B922 | x-972 | Ax | B972 | x-1022 | Ax | B1022 |
| x-923 | Ax | B923 | x-973 | Ax | B973 | x-1023 | Ax | B1023 |
| x-924 | Ax | B924 | x-974 | Ax | B974 | x-1024 | Ax | B1024 |
| x-925 | Ax | B925 | x-975 | Ax | B975 | x-1025 | Ax | B1025 |
| x-926 | Ax | B926 | x-976 | Ax | B976 | x-1026 | Ax | B1026 |
| x-927 | Ax | B927 | x-977 | Ax | B977 | x-1027 | Ax | B1027 |
| x-928 | Ax | B928 | x-978 | Ax | B978 | x-1028 | Ax | B1028 |
| x-929 | Ax | B929 | x-979 | Ax | B979 | x-1029 | Ax | B1029 |
| x-930 | Ax | B930 | x-980 | Ax | B980 | x-1030 | Ax | B1030 |
| x-931 | Ax | B931 | x-981 | Ax | B981 | x-1031 | Ax | B1031 |
| x-932 | Ax | B932 | x-982 | Ax | B982 | x-1032 | Ax | B1032 |
| x-933 | Ax | B933 | x-983 | Ax | B983 | x-1033 | Ax | B1033 |
| x-934 | Ax | B934 | x-984 | Ax | B984 | x-1034 | Ax | B1034 |
| x-935 | Ax | B935 | x-985 | Ax | B985 | x-1035 | Ax | B1035 |
| x-936 | Ax | B936 | x-986 | Ax | B986 | x-1036 | Ax | B1036 |
| x-937 | Ax | B937 | x-987 | Ax | B987 | x-1037 | Ax | B1037 |
| x-938 | Ax | B938 | x-988 | Ax | B988 | x-1038 | Ax | B1038 |
| x-939 | Ax | B939 | x-989 | Ax | B989 | x-1039 | Ax | B1039 |
| x-940 | Ax | B940 | x-990 | Ax | B990 | x-1040 | Ax | B1040 |
| x-941 | Ax | B941 | x-991 | Ax | B991 | x-1041 | Ax | B1041 |
| x-942 | Ax | B942 | x-992 | Ax | B992 | x-1042 | Ax | B1042 |
| x-943 | Ax | B943 | x-993 | Ax | B993 | x-1043 | Ax | B1043 |
| x-944 | Ax | B944 | x-994 | Ax | B994 | x-1044 | Ax | B1044 |
| x-945 | Ax | B945 | x-995 | Ax | B995 | x-1045 | Ax | B1045 |
| x-946 | Ax | B946 | x-996 | Ax | B996 | x-1046 | Ax | B1046 |
| x-947 | Ax | B947 | x-997 | Ax | B997 | x-1047 | Ax | B1047 |
| x-948 | Ax | B948 | x-998 | Ax | B998 | x-1048 | Ax | B1048 |
| x-949 | Ax | B949 | x-999 | Ax | B999 | x-1049 | Ax | B1049 |
| x-950 | Ax | B950 | x-1000 | Ax | B1000 | x-1050 | Ax | B1050 |

**Table 8**

| [Group 1] Ir(L₁)₂(L₂) / [Group 2] Ir(L₁)(L₂)₂ | | | | | | | | |
|---|---|---|---|---|---|---|---|---|
| Compound | L₁ | L₂ | Compound | L₁ | L₂ | Compound | L₁ | L₂ |
| x-1051 | Ax | B1051 | x-1101 | Ax | B1101 | x-1151 | Ax | B1151 |
| x-1052 | Ax | B1052 | x-1102 | Ax | B1102 | x-1152 | Ax | B1152 |
| x-1053 | Ax | B1053 | x-1103 | Ax | B1103 | x-1153 | Ax | B1153 |
| x-1054 | Ax | B1054 | x-1104 | Ax | B1104 | x-1154 | Ax | B1154 |
| x-1 055 | Ax | B1055 | x-1105 | Ax | B1105 | x-1155 | Ax | B1155 |
| x-1056 | Ax | B1056 | x-1106 | Ax | B1106 | x-1156 | Ax | B1156 |
| x-1057 | Ax | B1057 | x-1107 | Ax | B1107 | x-1157 | Ax | B1157 |
| x-1058 | Ax | B1058 | x-1108 | Ax | B1108 | x-1158 | Ax | B1158 |
| x-1059 | Ax | B1059 | x-1109 | Ax | B1109 | x-1159 | Ax | B1159 |
| x-1060 | Ax | B1060 | x-1110 | Ax | B1110 | x-1160 | Ax | B1160 |
| x-1061 | Ax | B1061 | x-1111 | Ax | B1111 | x-1161 | Ax | B1161 |
| x-1062 | Ax | B1062 | x-1112 | Ax | B1112 | x-1162 | Ax | B1162 |
| x-1063 | Ax | B1063 | x-1113 | Ax | B1113 | x-1163 | Ax | B1163 |
| x-1064 | Ax | B1064 | x-1114 | Ax | B1114 | x-1164 | Ax | B1164 |
| x-1065 | Ax | B1065 | x-1115 | Ax | B1115 | x-1165 | Ax | B1165 |
| x-1066 | Ax | B1066 | x-1116 | Ax | B1116 | x-1166 | Ax | B1166 |
| x-1067 | Ax | B1067 | x-1117 | Ax | B1117 | x-1167 | Ax | B1167 |
| x-1068 | Ax | B1068 | x-1118 | Ax | B1118 | x-1168 | Ax | B1168 |
| x-1069 | Ax | B1069 | x-1119 | Ax | B1119 | x-1169 | Ax | B1169 |
| x-1070 | Ax | B1070 | x-1120 | Ax | B1120 | x-1170 | Ax | B1170 |
| x-1071 | Ax | B1071 | x-1121 | Ax | B1121 | x-1171 | Ax | B1171 |
| x-1072 | Ax | B1072 | x-1122 | Ax | B1122 | x-1172 | Ax | B1172 |
| x-1073 | Ax | B1073 | x-1123 | Ax | B1123 | x-1173 | Ax | B1173 |
| x-1074 | Ax | B1074 | x-1124 | Ax | B1124 | x-1174 | Ax | B1174 |
| x-1075 | Ax | B1075 | x-1125 | Ax | B1125 | x-1175 | Ax | B1175 |
| x-1076 | Ax | B1076 | x-1126 | Ax | B1126 | x-1776 | Ax | B1176 |
| x-1077 | Ax | B1077 | x-1127 | Ax | B1127 | x-1177 | Ax | B1177 |
| x-1078 | Ax | B1078 | x-1128 | Ax | B1128 | x-1178 | Ax | B1178 |
| x-1079 | Ax | B1079 | x-1129 | Ax | B1129 | x-1179 | Ax | B1179 |
| x-1080 | Ax | B1080 | x-1130 | Ax | B1130 | x-1180 | Ax | B1180 |
| x-1081 | Ax | B1081 | x-1131 | Ax | B1131 | x-1181 | Ax | B1181 |
| x-1082 | Ax | B1082 | x-1132 | Ax | B1132 | x-1182 | Ax | B1182 |
| x-1083 | Ax | B1083 | x-1133 | Ax | B1133 | x-1183 | Ax | B1183 |
| x-1084 | Ax | B1084 | x-1134 | Ax | B1134 | x-1184 | Ax | B1184 |
| x-1085 | Ax | B1085 | x-1135 | Ax | B1135 | x-1185 | Ax | B1185 |
| x-1086 | Ax | B1086 | x-1136 | Ax | B1136 | x-1186 | Ax | B1186 |
| x-1087 | Ax | B1087 | x-1137 | Ax | B1137 | x-1187 | Ax | B1187 |
| x-1088 | Ax | B1088 | x-1138 | Ax | B1138 | x-1188 | Ax | B1188 |
| x-1089 | Ax | B1089 | x-1139 | Ax | B1139 | x-1189 | Ax | B1189 |
| x-1090 | Ax | B1090 | x-1140 | Ax | B1140 | x-1190 | Ax | B1190 |
| x-1091 | Ax | B1091 | x-1141 | Ax | B1141 | x-1191 | Ax | B1191 |
| x-1092 | Ax | B1092 | x-1142 | Ax | B1142 | x-1192 | Ax | B1192 |
| x-1093 | Ax | B1093 | x-1143 | Ax | B1143 | x-1193 | Ax | B1193 |
| x-1094 | Ax | B1094 | x-1144 | Ax | B1144 | x-1194 | Ax | B1194 |
| x-1095 | Ax | B1095 | x-1145 | Ax | B1145 | x-1195 | Ax | B1195 |
| x-1096 | Ax | B1096 | x-1146 | Ax | B1146 | x-1196 | Ax | B1196 |
| x-1097 | Ax | B1097 | x-1147 | Ax | B1147 | x-1197 | Ax | B1197 |
| x-1098 | Ax | B1098 | x-1148 | Ax | B1148 | x-1198 | Ax | B1198 |
| x-1099 | Ax | B1099 | x-1149 | Ax | B1149 | x-1199 | Ax | B1199 |
| x-1100 | Ax | B1100 | x-1150 | Ax | B1150 | x-1200 | Ax | B1200 |

**Table 9**

| [Group 1] Ir(L₁)₂(L₂) / [Group 2] Ir(L₁)(L₂)₂ | | | | | | | | |
|---|---|---|---|---|---|---|---|---|
| Compound | L₁ | L₂ | Compound | L₁ | L₂ | Compound | L₁ | L₂ |
| x-1201 | Ax | B1201 | x-1251 | Ax | B1251 | x-1301 | Ax | B1301 |
| x-1202 | Ax | B1202 | x-1252 | Ax | B1252 | x-1302 | Ax | B1302 |
| x-1203 | Ax | B1203 | x-1253 | Ax | B1253 | x-1303 | Ax | B1303 |
| x-1204 | Ax | B1204 | x-1254 | Ax | B1254 | x-1304 | Ax | B1304 |
| x-1205 | Ax | B1205 | x-1255 | Ax | B1255 | x-1305 | Ax | B1305 |
| x-1206 | Ax | B1206 | x-1256 | Ax | B1256 | x-1306 | Ax | B1306 |
| x-1207 | Ax | B1207 | x-1257 | Ax | B1257 | x-1307 | Ax | B1307 |
| x-1208 | Ax | B1208 | x-1258 | Ax | B1258 | x-1308 | Ax | B1308 |
| x-1209 | Ax | B1209 | x-1259 | Ax | B1259 | x-1309 | Ax | B1309 |
| x-1210 | Ax | B1210 | x-1260 | Ax | B1260 | x-1310 | Ax | B1310 |
| x-1211 | Ax | B1211 | x-1261 | Ax | B1261 | x-1311 | Ax | B1311 |
| x-1212 | Ax | B1212 | x-1262 | Ax | B1262 | x-1312 | Ax | B1312 |
| x-1213 | Ax | B1213 | x-1263 | Ax | B1263 | x-1313 | Ax | B1313 |
| x-1214 | Ax | B1214 | x-1264 | Ax | B1264 | x-1314 | Ax | B1314 |
| x-1215 | Ax | B1215 | x-1265 | Ax | B1265 | x-1315 | Ax | B1315 |
| x-1216 | Ax | B1216 | x-1266 | Ax | B1266 | x-1316 | Ax | B1316 |
| x-1217 | Ax | B1217 | x-1267 | Ax | B1267 | x-1317 | Ax | B1317 |
| x-1218 | Ax | B1218 | x-1268 | Ax | B1268 | x-1318 | Ax | B1318 |
| x-1219 | Ax | B1219 | x-1269 | Ax | B1269 | x-1319 | Ax | B1319 |
| x-1220 | Ax | B1220 | x-1270 | Ax | B1270 | x-1320 | Ax | B1320 |
| x-1221 | Ax | B1221 | x-1271 | Ax | B1271 | x-1321 | Ax | B1321 |
| x-1222 | Ax | B1222 | x-1272 | Ax | B1272 | x-1322 | Ax | B1322 |
| x-1223 | Ax | B1223 | x-1273 | Ax | B1273 | x-1323 | Ax | B1323 |
| x-1224 | Ax | B1224 | x-1274 | Ax | B1274 | x-1324 | Ax | B1324 |
| x-1225 | Ax | B1225 | x-1275 | Ax | B1275 | x-1325 | Ax | B1325 |
| x-1226 | Ax | B1226 | x-1276 | Ax | B1276 | x-1326 | Ax | B1326 |
| x-1227 | Ax | B1227 | x-1277 | Ax | B1277 | x-1327 | Ax | B1327 |
| x-1228 | Ax | B1228 | x-1278 | Ax | B1278 | x-1328 | Ax | B1328 |
| x-1229 | Ax | B1229 | x-1279 | Ax | B1279 | x-1329 | Ax | B1329 |
| x-1230 | Ax | B1230 | x-1280 | Ax | B1280 | x-1330 | Ax | B1330 |
| x-1231 | Ax | B1231 | x-1281 | Ax | B1281 | x-1331 | Ax | B1331 |
| x-1232 | Ax | B1232 | x-1282 | Ax | B1282 | x-1332 | Ax | B1332 |
| x-1233 | Ax | B1233 | x-1283 | Ax | B1283 | x-1333 | Ax | B1333 |
| x-1234 | Ax | B1234 | x-1284 | Ax | B1284 | x-1334 | Ax | B1334 |
| x-1235 | Ax | B1235 | x-1285 | Ax | B1285 | x-1335 | Ax | B1335 |
| x-1236 | Ax | B1236 | x-1286 | Ax | B1286 | x-1336 | Ax | B1336 |
| x-1237 | Ax | B1237 | x-1287 | Ax | B1287 | x-1337 | Ax | B1337 |
| x-1238 | Ax | B1238 | x-1288 | Ax | B1288 | x-1338 | Ax | B1338 |
| x-1239 | Ax | B1239 | x-1289 | Ax | B1289 | x-1339 | Ax | B1339 |
| x-1240 | Ax | B1240 | x-1290 | Ax | B1290 | x-1340 | Ax | B1340 |
| x-1241 | Ax | B1241 | x-1291 | Ax | B1291 | x-1341 | Ax | B1341 |
| x-1242 | Ax | B1242 | x-1292 | Ax | B1292 | x-1342 | Ax | B1342 |
| x-1243 | Ax | B1243 | x-1293 | Ax | B1293 | x-1343 | Ax | B1343 |
| x-1244 | Ax | B1244 | x-1294 | Ax | B1294 | x-1344 | Ax | B1344 |
| x-1245 | Ax | B1245 | x-1295 | Ax | B1295 | x-1345 | Ax | B1345 |
| x-1246 | Ax | B1246 | x-1296 | Ax | B1296 | x-1346 | Ax | B1346 |
| x-1247 | Ax | B1247 | x-1297 | Ax | B1297 | x-1347 | Ax | B1347 |
| x-1248 | Ax | B1248 | x-1298 | Ax | B1298 | x-1348 | Ax | B1348 |
| x-1249 | Ax | B1249 | x-1299 | Ax | B1299 | x-1349 | Ax | B1349 |
| x-1250 | Ax | B1250 | x-1300 | Ax | B1300 | x-1350 | Ax | B1350 |

**Table 10**

| [Group 1] Ir(L₁)₂(L₂) / [Group 2] Ir(L₁)(L₂)₂ | | | | | | | | |
|---|---|---|---|---|---|---|---|---|
| Compound | L₁ | L₂ | Compound | L₁ | L₂ | Compound | L₁ | L₂ |
| x-1351 | Ax | B1351 | x-1401 | Ax | B1401 | x-1451 | Ax | B1451 |
| x-1352 | Ax | B1352 | x-1402 | Ax | B1402 | x-1452 | Ax | B1452 |
| x-1353 | Ax | B1353 | x-1403 | Ax | B1403 | x-1453 | Ax | B1453 |
| x-1354 | Ax | B1354 | x-1404 | Ax | B1404 | x-1454 | Ax | B1454 |
| x-1355 | Ax | B1355 | x-1405 | Ax | B1405 | x-1455 | Ax | B1455 |
| x-1356 | Ax | B1356 | x-1406 | Ax | B1406 | x-1456 | Ax | B1456 |
| x-1357 | Ax | B1357 | x-1407 | Ax | B1407 | x-1457 | Ax | B1457 |
| x-1358 | Ax | B1358 | x-1408 | Ax | B1408 | x-1458 | Ax | B1458 |
| x-1359 | Ax | B1359 | x-1409 | Ax | B1409 | x-1459 | Ax | B1459 |
| x-1360 | Ax | B1360 | x-1410 | Ax | B1410 | x-1460 | Ax | B1460 |
| x-1361 | Ax | B1361 | x-1411 | Ax | B1411 | x-1461 | Ax | B1461 |
| x-1362 | Ax | B1362 | x-1412 | Ax | B1412 | x-1462 | Ax | B1462 |
| x-1363 | Ax | B1363 | x-1413 | Ax | B1413 | x-1463 | Ax | B1463 |
| x-1364 | Ax | B1364 | x-1414 | Ax | B1414 | x-1464 | Ax | B1464 |
| x-1365 | Ax | B1365 | x-1415 | Ax | B1415 | x-1465 | Ax | B1465 |
| x-1366 | Ax | B1366 | x-1416 | Ax | B1416 | x-1466 | Ax | B1466 |
| x-1367 | Ax | B1367 | x-1417 | Ax | B1417 | x-1467 | Ax | B1467 |
| x-1368 | Ax | B1368 | x-1418 | Ax | B1418 | x-1468 | Ax | B1468 |
| x-1369 | Ax | B1369 | x-1419 | Ax | B1419 | x-1469 | Ax | B1469 |
| x-1370 | Ax | B1370 | x-1420 | Ax | B1420 | x-1470 | Ax | B1470 |
| x-1371 | Ax | B1371 | x-1421 | Ax | B1421 | x-1471 | Ax | B1471 |
| x-1372 | Ax | B1372 | x-1422 | Ax | B1422 | x-1472 | Ax | B1472 |
| x-1373 | Ax | B1373 | x-1423 | Ax | B1423 | x-1473 | Ax | B1473 |
| x-1374 | Ax | B1374 | x-1424 | Ax | B1424 | x-1474 | Ax | B1474 |
| x-1375 | Ax | B1375 | x-1425 | Ax | B1425 | x-1475 | Ax | B1475 |
| x-1376 | Ax | B1376 | x-1426 | Ax | B1426 | x-1476 | Ax | B1476 |
| x-1377 | Ax | B1377 | x-1427 | Ax | B1427 | x-1477 | Ax | B1477 |
| x-1378 | Ax | B1378 | x-1428 | Ax | B1428 | x-1478 | Ax | B1478 |
| x-1379 | Ax | B1379 | x-1429 | Ax | B1429 | x-1479 | Ax | B1479 |
| x-1380 | Ax | B1380 | x-1430 | Ax | B1430 | x-1480 | Ax | B1480 |
| x-1381 | Ax | B1381 | x-1431 | Ax | B1431 | x-1481 | Ax | B1481 |
| x-1382 | Ax | B1382 | x-1432 | Ax | B1432 | x-1482 | Ax | B1482 |
| x-1383 | Ax | B1383 | x-1433 | Ax | B1433 | x-1483 | Ax | B1483 |
| x-1384 | Ax | B1384 | x-1434 | Ax | B1434 | x-1484 | Ax | B1484 |
| x-1385 | Ax | B1385 | x-1435 | Ax | B1435 | x-1485 | Ax | B1485 |
| x-1386 | Ax | B1386 | x-1436 | Ax | B1436 | x-1486 | Ax | B1486 |
| x-1387 | Ax | B1387 | x-1437 | Ax | B1437 | x-1487 | Ax | B1487 |
| x-1388 | Ax | B1388 | x-1438 | Ax | B1438 | x-1488 | Ax | B1488 |
| x-1389 | Ax | B1389 | x-1439 | Ax | B1439 | x-1489 | Ax | B1489 |
| x-1390 | Ax | B1390 | x-1440 | Ax | B1440 | x-1490 | Ax | B1490 |
| x-1391 | Ax | B1391 | x-1441 | Ax | B1441 | x-1491 | Ax | B1491 |
| x-1392 | Ax | B1392 | x-1442 | Ax | B1442 | x-1492 | Ax | B1492 |
| x-1393 | Ax | B1393 | x-1443 | Ax | B1443 | x-1493 | Ax | B1493 |
| x-1394 | Ax | B1394 | x-1444 | Ax | B1444 | x-1494 | Ax | B1494 |
| x-1395 | Ax | B1395 | x-1445 | Ax | B1445 | x-1495 | Ax | B1495 |
| x-1396 | Ax | B1396 | x-1446 | Ax | B1446 | x-1496 | Ax | B1496 |
| x-1397 | Ax | B1397 | x-1447 | Ax | B1447 | x-1497 | Ax | B1497 |
| x-1398 | Ax | B1398 | x-1448 | Ax | B1448 | x-1498 | Ax | B1498 |
| x-1399 | Ax | B1399 | x-1449 | Ax | B1449 | x-1499 | Ax | B1499 |
| x-1400 | Ax | B1400 | x-1450 | Ax | B1450 | x-1500 | Ax | B1500 |

**Table 11**

| Group 1] Ir(L₁)₂(L₂) / [Group 2] Ir(L₁)(L₂)₂ | | |
|---|---|---|
| Compound | L₁ | L₂ |
| x-1501 | Ax | B1501 |
| x-1502 | Ax | B1502 |
| x-1503 | Ax | B1503 |
| x-1504 | Ax | B1504 |
| x-1505 | Ax | B1505 |
| x-1506 | Ax | B1506 |
| x-1507 | Ax | B1507 |
| x-1508 | Ax | B1508 |
| x-1509 | Ax | B1509 |
| x-1510 | Ax | B1510 |
| x-1511 | Ax | B1511 |
| x-1512 | Ax | B1512 |
| x-1513 | Ax | B1513 |
| x-1514 | Ax | B1514 |
| x-1515 | Ax | B1515 |
| x-1516 | Ax | B1516 |
| x-1517 | Ax | B1517 |
| x-1518 | Ax | B1518 |
| x-1519 | Ax | B1519 |
| x-1520 | Ax | B1520 |
| x-1521 | Ax | B1521 |
| x-1522 | Ax | B1522 |
| x-1523 | Ax | B1523 |
| x-1524 | Ax | B1524 |
| x-1525 | Ax | B1525 |
| x-1526 | Ax | B1526 |
| x-1527 | Ax | B1527 |
| x-1528 | Ax | B1528 |
| x-1529 | Ax | B1529 |
| x-1530 | Ax | B1530 |
| x-1531 | Ax | B1531 |
| x-1532 | Ax | B1532 |
| x-1533 | Ax | B1533 |
| x-1534 | Ax | B1534 |
| x-1535 | Ax | B1535 |
| x-1536 | Ax | B1536 |
| x-1537 | Ax | B1537 |
| x-1538 | Ax | B1538 |
| x-1539 | Ax | B1539 |
| x-1540 | Ax | B1540 |
| x-1541 | Ax | B1541 |
| x-1542 | Ax | B1542 |

Among the compounds in Tables 1 to 11, a compound of Group 1 is represented by Ir(L₁)₂(L₂), and L₁ and L₂ among compounds represented by Ir(L₁)₂(L₂) of Group 1 are as described in Tables 1 to 11.

Among the compounds in Tables 1 to 11, a compound of Group 2 is represented by Ir(L₁)(L₂)₂, and L₁ and L₂ among compounds represented by Ir(L₁)(L₂)₂ of Group 2 are as described in Tables 1 to 11.

x in Tables 1 to 11 is an integer from 1 to 380. Ax, i.e., A1 to A380, is as described above.

For example, in Tables 1 to 11,
1) Compound 93-10 (i.e., x = 93) of Group 1 is a compound represented by Ir(L₁)₂(L₂) in which L₁ is A93 and L₂ is B10, and may be represented by Compound 1 below,
2) Compound 298-58 (i.e., x = 298) of Group 1 is a compound represented by Ir(L₁)₂(L₂) in which L₁ is A298 and L₂ is B58, and may be represented by Compound 2 below,
3) Compound 260-373 (i.e., x = 260) of Group 1 is a compound represented by Ir(L₁)₂(L₂) in which L₁ is A260 and L₂ is B373, and may be represented by Compound 3 below,
4) Compound 198-1465 (i.e., x = 198) of Group 1 is a compound represented by Ir(L₁)₂(L₂) in which L₁ is A198 and L₂ is B1465, and may be represented by Compound 4,
5) Compound 1-1541 (i.e., x = 1) of Group 1 is a compound represented by Ir(L₁)₂(L₂) in which L₁ is A1 and L₂ is B1541, and may be represented Compound 5,
6) Compound 260-1542 (i.e., x = 260) of Group 1 is a compound represented by Ir(L₁)₂(L₂) in which L₁ is A260 and L₂ is B1542, and may be represented by Compound 6,
7) Compound 201-1070 (i.e., x = 201) of Group 1 is a compound represented by Ir(L₁)₂(L₂) in which L₁ is A201 and L₂ is B1070, and may be represented by Compound 7,
8) Compound 202-721 (i.e., x = 202) of Group 1 is a compound represented by Ir(L₁)₂(L₂) in which L₁ is A202 and L₂ is B721, and may be represented by Compound 8, and
9) Compound 93-10 (i.e., x = 93) of Group 2 is a compound represented by Ir(L₁)(L₂)₂ in which L₁ is A93 and L₂ is B10, and may be represented by Compound 9:

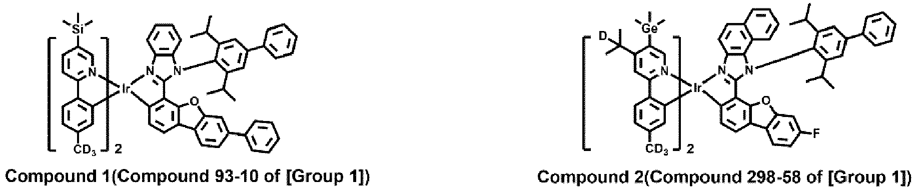

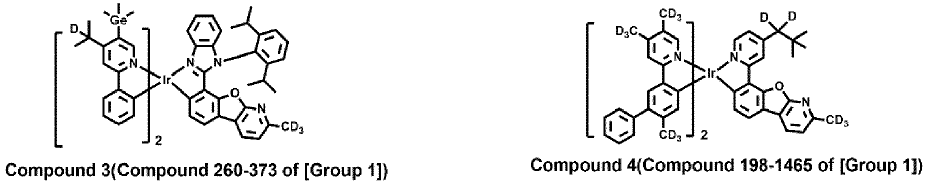

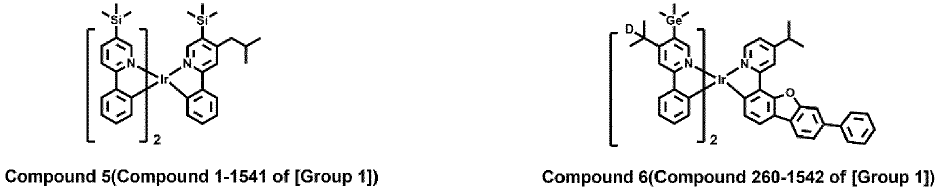

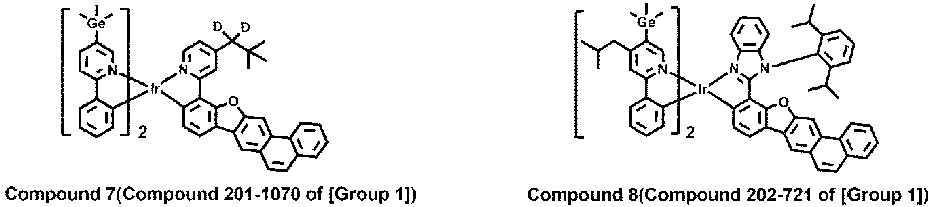

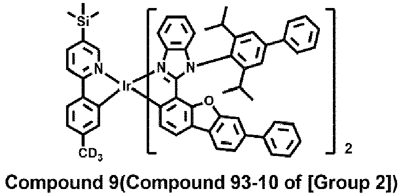

The remaining compounds in Tables 1 to 11 may also be recognized in the same manner as described above.

A composition including the first compound represented by Formula 1 and the second compound represented by Formula 2 as described above may emit light (for example, light having an emission peak wavelength in a range of about 480 nm to about 580 nm, or about 510 nm to about 570 nm, such as green light, yellow-green light, or yellow light) having excellent luminescence efficiency and excellent lifespan. Thus, a layer including the composition, a light-emitting device including the composition, and an electronic apparatus including the light-emitting device may be provided.

According to another aspect, a layer including the composition including the first compound and the second compound as described above may be provided.

In one or more embodiments, the layer may emit light having an emission peak wavelength in a range of about 480 nm to about 580 nm, for example, about 510 nm to about 570 nm.

In one or more embodiments, the layer may emit green light, yellow-green light, or yellow light.

In one or more embodiments, the layer may emit light having an emission peak wavelength in a range of about 510 nm to about 540 nm.

In one or more embodiments, the layer may emit light having an emission peak wavelength in a range of about 540 nm to about 570 nm.

A weight ratio of the first compound to the second compound included in the layer may be about 90:10 to about 10:90, about 80:20 to about 20:80, about 70:30 to about 30:70, or about 60:40 to about 40:60.

In one or more embodiments, a weight ratio of the first compound to second compound may be about 50:50, that is, about 1:1.

The layer may be formed i) by a co-deposition of the first compound and the second compound, or ii) by using a first mixture including the first compound and the second compound.

In one or more embodiments, the layer may include a host and a dopant, the host may not include a transition metal, and the dopant may include the composition including the first compound and the second compound. The layer may be formed i) by a co-deposition of the host and the dopant, or ii) by using a second mixture including the host and the dopant.

A weight of the host in the layer may be greater than a weight of the dopant.

In one or more embodiments, a weight ratio of the host to the dopant in the layer may be about 99:1 to about 55:45, or about 97:3 to about 60:40, or about 95:5 to about 70:30.

The host in the layer may include a hole transport compound, an electron transport compound, a bipolar compound, or a combination thereof.

According to another aspect, provided is a light-emitting device including: a first electrode; a second electrode; and an organic layer located between the first electrode and the second electrode and including an emission layer, wherein the organic layer includes the composition including the first compound and the second compound as described above.

The light-emitting device includes the composition including the first compound and the second compound as described above, and thus, may have excellent driving voltage, excellent external quantum efficiency, and excellent lifespan characteristics. Also, the light-emitting device may have an excellent side luminance ratio.

In one or more embodiments, the emission layer in the organic layer of the light-emitting device may include the composition including the first compound and the second compound.

In one or more embodiments, the emission layer may include a host and a dopant, the host may not include a transition metal, and the dopant may include the composition.

The host in the emission layer may include a hole transport compound, an electron transport compound, a bipolar compound, or a combination thereof.

In one or more embodiments, the host may include a hole transport compound and an electron transport compound, and the hole transport compound and the electron transport compound may be different from each other.

The emission layer may be formed by a co-deposition of the host and the dopant, or may be formed by using a second mixture including the host and the dopant.

The emission layer may emit third light having a third spectrum, and λP(EML) is an emission peak wavelength (in nm) of the third spectrum. In one or more embodiments, the λP(EML) may be evaluated from electroluminescence spectrum of the light-emitting device.

Fourth light having a fourth spectrum may be extracted to the outside of the light-emitting device (i.e., the organic light-emitting device) through the first electrode and/or the second electrode of the light-emitting device, and λP(OLED) is an emission peak wavelength (nm) of the fourth spectrum. In one or more embodiments, the λP(OLED) may be evaluated from electroluminescence spectrum of the light-emitting device.

In one or more embodiments, the λP(EML) and the λP(OLED) may each independently be about 480 nm to about 580 nm, for example, about 510 nm to about 570 nm.

In one or more embodiments, the λP(EML) and the λP(OLED) may each independently be about 510 nm to about 540 nm.

In one or more embodiments, the λP(EML) and the λP(OLED) may each independently be about 540 nm to about 570 nm.

In one or more embodiments, the third light and the fourth light may each be green light, yellow-green light, or yellow light.

In one or more embodiments, the third light and the fourth light may not be white light.

In one or more embodiments, the third spectrum may include i) a main emission peak having the λP(EML), and may not include ii) an additional emission peak having an emission peak wavelength of (λP(EML) + about 50 nm) or greater or (λP(EML) - about 50 nm) or less.

In one or more embodiments, the third spectrum may include i) a main emission peak having the λP(EML), and may not include ii) an additional emission peak having an emission peak wavelength of red light and/or blue light region.

In one or more embodiments, the fourth spectrum may include i) a main emission peak having the λP(OLED), and may not include ii) an additional emission peak having an emission peak wavelength of (λP(OLED) + about 50 nm) or greater or (λP(OLED) - about 50 nm) or less.

In one or more embodiments, the fourth spectrum may include i) a main emission peak having the λP(OLED), and may not include ii) an additional emission peak having an emission peak wavelength of red light and/or blue light region.

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one or more embodiments, in the light-emitting device, the first electrode may be an anode, and the second electrode may be a cathode, the organic layer may further include a hole transport region located between the first electrode and the emission layer and an electron transport region located between the emission layer and the second electrode, the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" as used herein refers to a single layer and/or a plurality of layers between the first electrode and the second electrode of the light-emitting device. The "organic layer" may include, in addition to an organic compound, an organometallic complex including metal.

The FIGURE is a schematic cross-sectional view of a light-emitting device 10 according to one or more embodiments described herein. Hereinafter, the structure and manufacturing method of the light-emitting device 10 according to one or more embodiments will be described with reference to FIGURE. The light-emitting device 10 has a structure in which a first electrode 11, an organic layer 15, and a second electrode 19 are sequentially stacked.

A substrate may be additionally located under the first electrode 11 or above the second electrode 19. For use as the substrate, any substrate that is used in light-emitting devices of the related art may be used, and the substrate may be a glass substrate or a transparent plastic substrate, each having excellent mechanical strength, thermal stability, transparency, surface smoothness, ease of handling, and water resistance.

The first electrode 11 may be formed by depositing or sputtering a material for forming the first electrode 11 on the substrate. The first electrode 11 may be an anode. The material for forming the first electrode 11 may include materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO.

The organic layer 15 is located on the first electrode 11.

The organic layer 15 may include a hole transport region, an emission layer, and an electron transport region.

The hole transport region may be between the first electrode 11 and the emission layer.

The hole transport region may include a hole injection layer, a hole transport layer, an electron blocking layer, a buffer layer, or a combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, wherein, for each structure, each layer is sequentially stacked in this stated order from the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (L-B) deposition.

When a hole injection layer is formed by vacuum deposition, the deposition conditions may vary depending on a material that is used to form the hole injection layer, and the structure and thermal characteristics of the hole injection layer. For example, the deposition conditions may include a deposition temperature of about 100°C to about 500°C, a vacuum pressure of about 1.33 × 10⁻⁶ pascals to about 0.133 pascals (10⁻⁸ torr to about 10⁻³ torr), and a deposition rate of about 0.01 angstroms per second (Å/sec) to about 100 Å/sec.

When the hole injection layer is formed using spin coating, coating conditions may vary according to the material used to form the hole injection layer, and the structure and thermal properties of the hole injection layer. For example, a coating speed may be from about 2,000 revolutions per minute (rpm) to about 5,000 rpm, and a temperature at which a heat treatment is performed to remove a solvent after coating may be from about 80°C to about 200°C.

The conditions for forming the hole transport layer and the electron blocking layer may be similar to or the same as the conditions for forming the hole injection layer.

The hole transport region may include 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(naphthalen-1-yl)-N,N'-diphenyl-benzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, a compound represented by Formula 202 below, or a combination thereof:

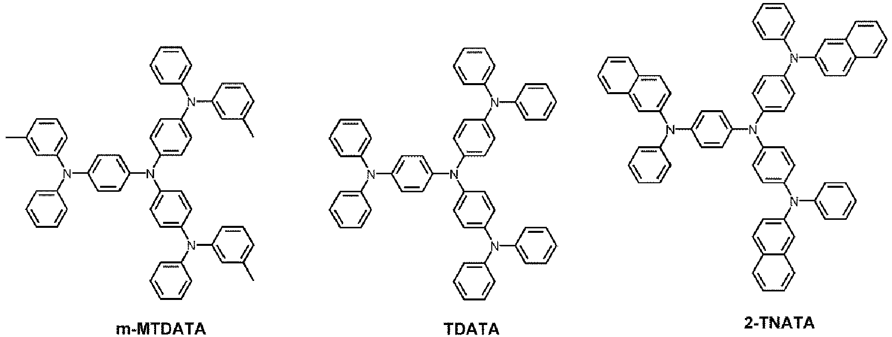

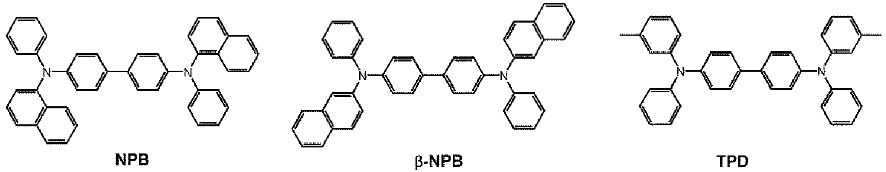

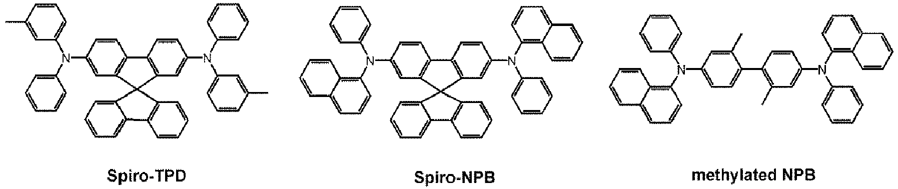

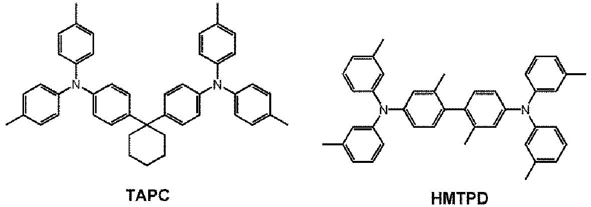

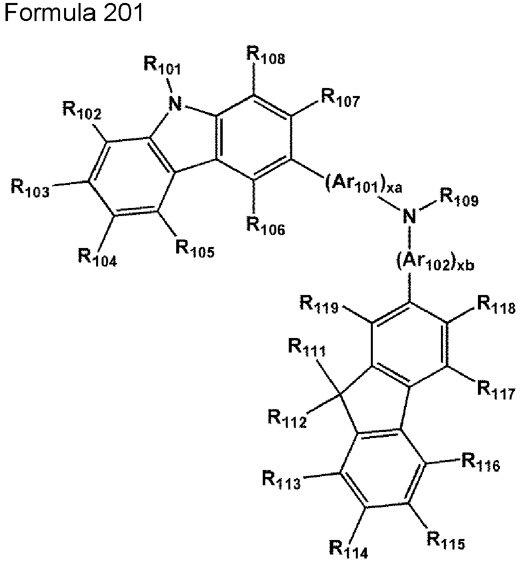

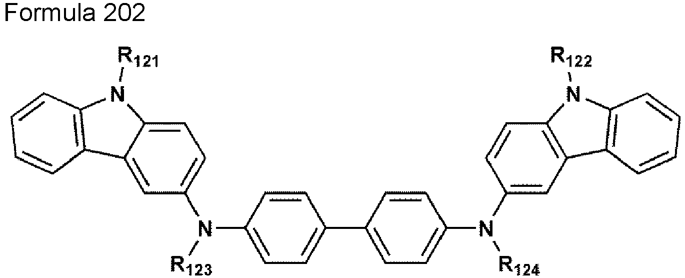

In Formula 201, Ar₁₀₁ and Ar₁₀₂ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with at least one of deuterium, -F, -Cl, -Br, -I, a hydroxyl group, a cyano group, a nitro group, an amino group, a C₁-C₆₀ alkyl group, a C₂-C₆₀ alkenyl group, a C₂-C₆₀ alkynyl group, a C₁-C₆₀ alkoxy group, a C₁-C₁₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or 0, 1, or 2. For example, xa may be 1 and xb may be 0.

R₁₀₁ to R₁₀₈, R₁₁₁ to R₁₁₉ and R₁₂₁ to R₁₂₄ in Formulae 201 and 202 may each independently be:
hydrogen, deuterium, -F, -Cl, -Br, -I, a hydroxyl group, a cyano group, a nitro group, an amino group, a C₁-C₁₀ alkyl group (for example, a methyl group, an ethyl group, a propyl group, a butyl group, a pentyl group, a hexyl group), a C₁-C₁₀ alkoxy group(for example, a methoxy group, an ethoxy group, a propoxy group, a butoxy group, a pentoxy group), or a C₁-C₁₀ alkylthio group;
a C₁-C₁₀ alkyl group, a C₁-C₁₀ alkoxy group, or a C₁-C₁₀ alkylthio group, each unsubstituted or substituted with at least one of deuterium, -F, -Cl, -Br, -I, a hydroxyl group, a cyano group, a nitro group, an amino group, or a combination thereof; or
a phenyl group, a naphthyl group, an anthracenyl group, a fluorenyl group, or a pyrenyl group, each unsubstituted or substituted with at least one of deuterium, -F, -Cl, -Br, -I, a hydroxyl group, a cyano group, a nitro group, an amino group, a C₁-C₁₀ alkyl group, a C₁-C₁₀ alkoxy group, a C₁-C₁₀ alkylthio group, or a combination thereof.

In Formula 201, R₁₀₉ may be a phenyl group, a naphthyl group, an anthracenyl group, or a pyridinyl group, each unsubstituted or substituted with at least one of deuterium, -F, -Cl, -Br, -I, a hydroxyl group, a cyano group, a nitro group, an amino group, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

In one embodiment, the compound represented by Formula 201 may be represented by Formula 201A: 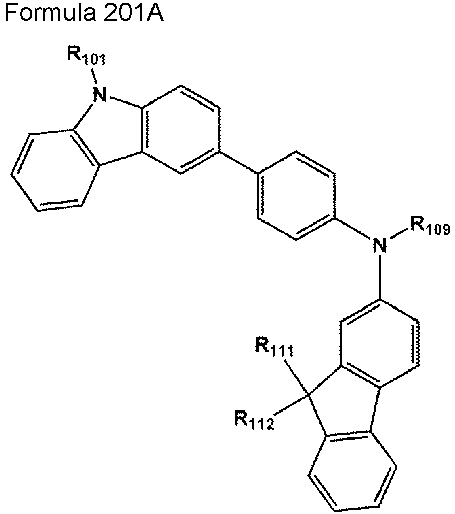 wherein R₁₀₁, R₁₁₁, R₁₁₂, and R₁₀₉ in Formula 201A are respectively as described above.

In one or more embodiments, the hole transport region may include one of Compounds HT1 to HT20 or a combination thereof:

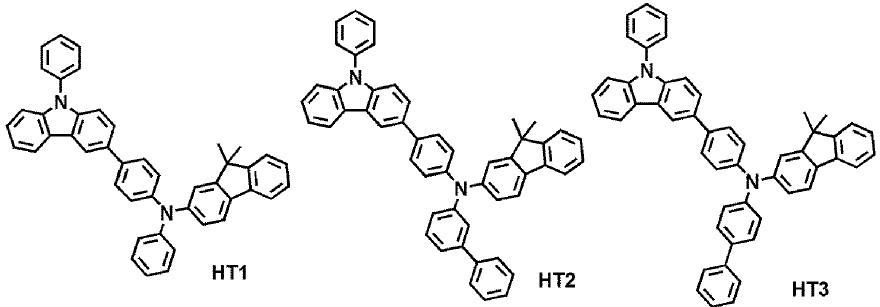

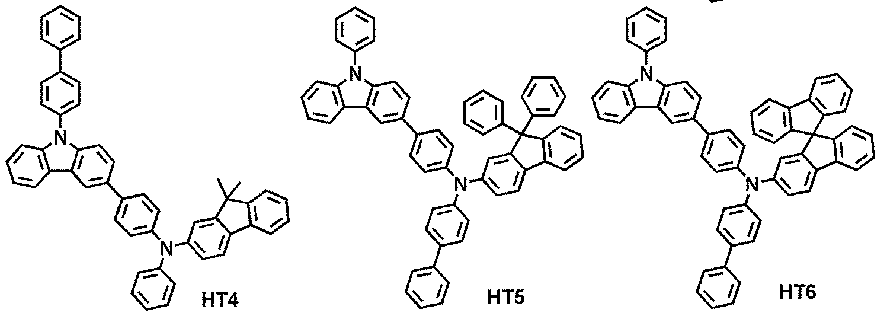

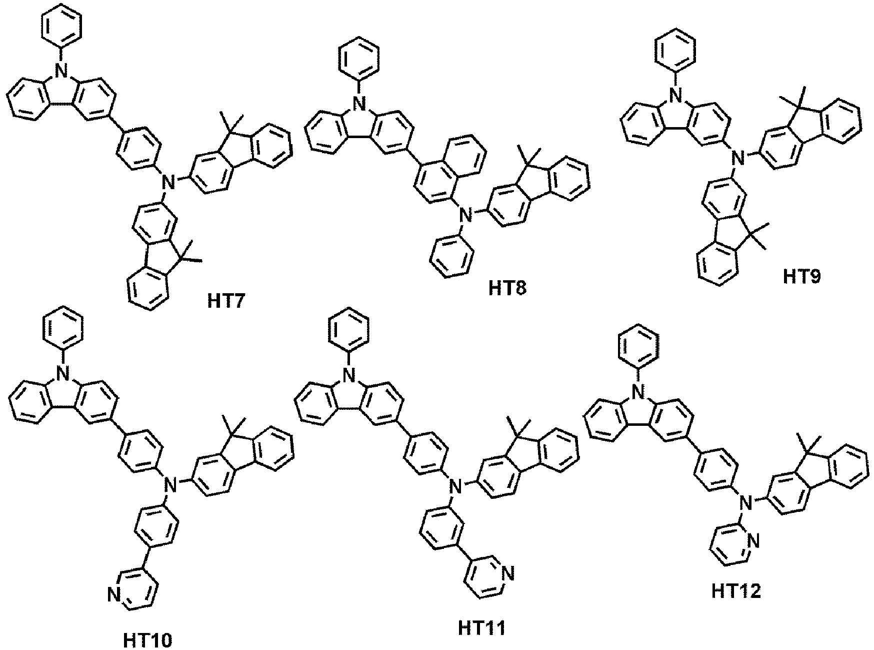

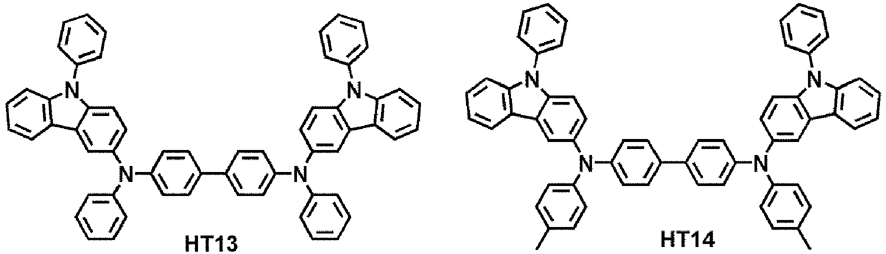

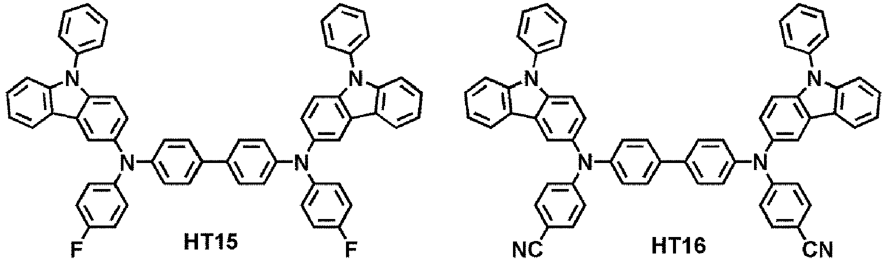

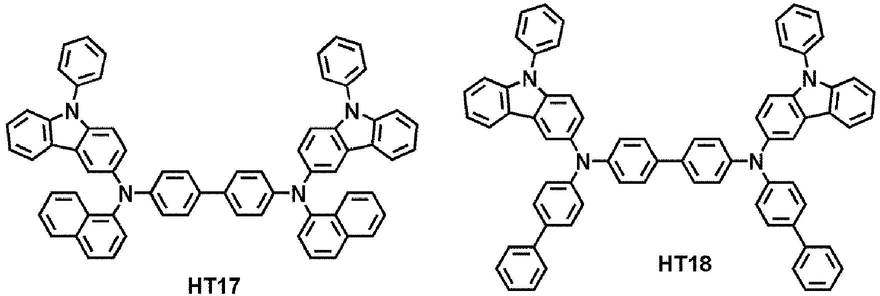

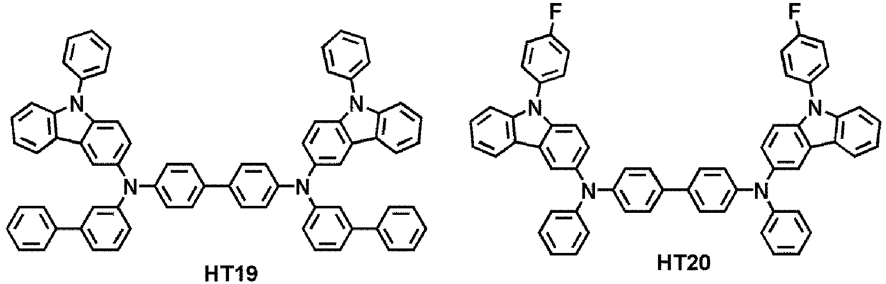

A thickness of the hole transport region may be in the range of about 100 angstroms (Å) to about 10,000 Å, for example, about 100 Å to about 1,000 Å. When the hole transport region includes a hole injection layer, a hole transport layer, an electron blocking layer, or a combination thereof, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-type dopant. The p-type dopant may be a quinone derivative, a metal oxide, a cyano group-containing compound, or a combination thereof. For example, the p-type dopant may be: a quinone derivative such as tetracyanoquinonedimethane (TCNQ), 2,3,5,6-tetrafluoro-tetracyano-1,4-benzoquinonedimethane (F4-TCNQ), or F6-TCNNQ; metal oxide, such as tungsten oxide and molybdenum oxide; a cyano group-containing compound, such as Compound HT-D1; or a combination thereof.

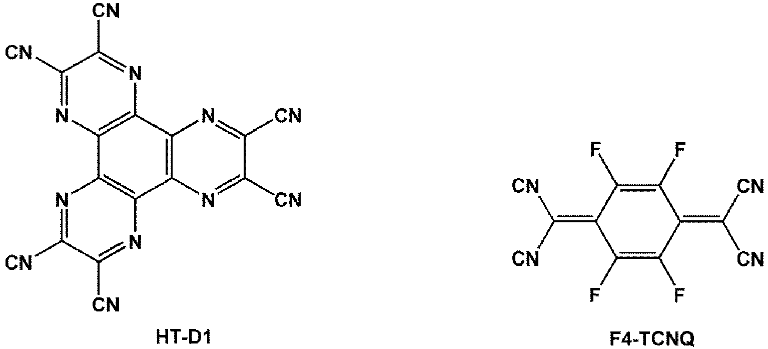

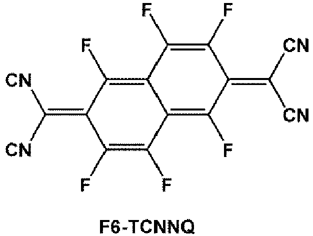

The hole transport region may further include a buffer layer.

Also, the buffer layer may compensate for an optical resonance distance according to a wavelength of light emitted from the emission layer, and thus, luminescence efficiency of a light-emitting device may be improved.

Meanwhile, when the hole transport region includes an electron blocking layer, a material for forming the electron blocking layer may include a material that is used in the hole transport region as described above, a host material described below, or a combination thereof. For example, when the hole transport region includes an electron blocking layer, mCP, Compound H-H1, or a combination thereof may be used as the material for forming the electron blocking layer.

Then, an emission layer may be formed on the hole transport region by vacuum deposition, spin coating, casting, L-B deposition, or the like. When the emission layer is formed by vacuum deposition or spin coating, the deposition or coating conditions may be similar to those applied in forming the hole injection layer although the deposition or coating conditions may vary according to a material that is used to form the emission layer.

The emission layer may include the composition including the first compound represented by Formula 1 and the second compound represented by Formula 2 as described herein. In one or more embodiments, the emission layer may include a layer including the composition including the first compound represented by Formula 1 and the second compound represented by Formula 2 as described herein.

In one or more embodiments, the emission layer may include a host and a dopant, the host may not include a transition metal, and the dopant may include the composition including the first compound represented by Formula 1 and the second compound represented by Formula 2 as described herein.

The host may include 1,3,5-tri(1-phenyl-1H-benzo[d]imidazol-2-yl)benzene (TPBi), 3-tert-butyl-9,10-di(naphth-2-yl)anthracene (TBADN), 9,10-di(naphthalene-2-yl)anthracene (ADN, also referred to as "DNA"), 4,4'-bis(N-carbazolyl)-1,1'-biphenyl (CBP), 4,4'-bis(9-carbazolyl)-2,2'-dimethyl-biphenyl (CDBP), TCP, mCP, Compound H50, Compound H51, Compound H52, Compound H-H1, Compound H-H2, or a combination thereof:

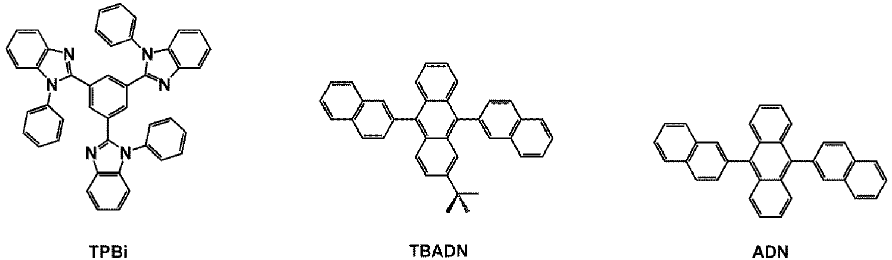

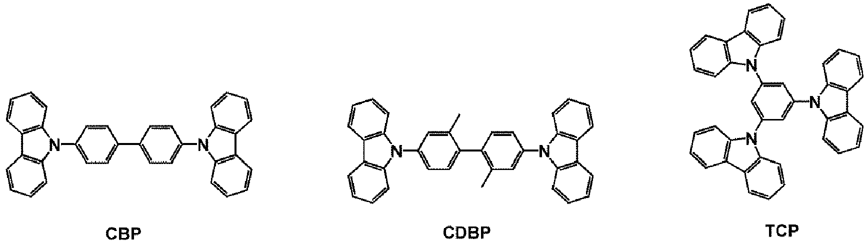

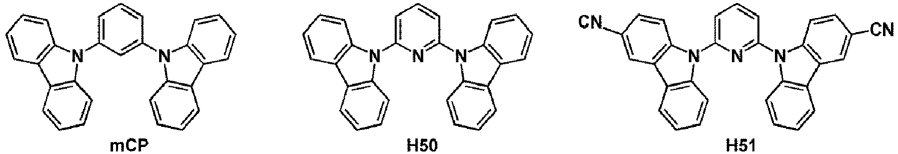

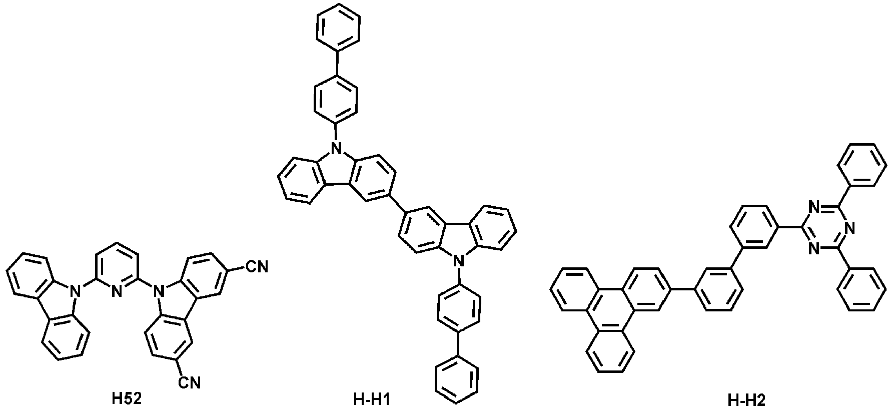

When the light-emitting device is a full-color light-emitting device, the emission layer may be patterned into a red emission layer, a green emission layer, and/or a blue emission layer.

A thickness of the emission layer may be in a range of about 100 Å to about 1,000 Å, for example, about 200 Å to about 600 Å. When the thickness of the emission layer is within the range, excellent light-emission characteristics may be obtained without a substantial increase in driving voltage.

An electron transport region may be located on the emission layer.

The electron transport region may include a hole blocking layer, an electron transport layer, an electron injection layer, or a combination thereof.

For example, the electron transport region may have a hole blocking layer/electron transport layer/electron injection layer structure or an electron transport layer/electron injection layer structure. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, 2,9-dimethyl-4,7-diphenyl-1,10-phenanthroline (BCP), 4,7-diphenyl-1,10-phenanthroline (Bphen), bis(2-methyl-8-quinolinolato-N1,O8)-(1,1'-biphenyl-4-olato)aluminum (Balq), or a combination thereof:

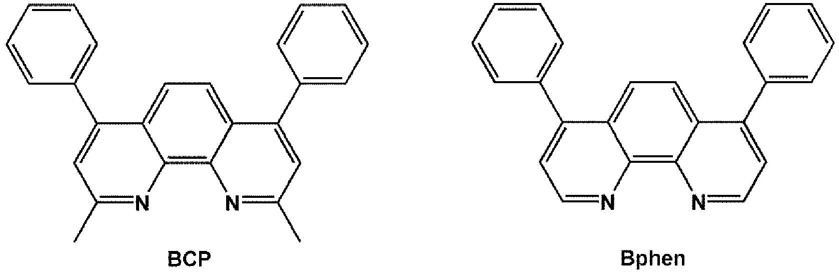

A thickness of the hole blocking layer may be in a range of about 20 Å to about 1,000 Å, for example, about 30 Å to about 600 Å. When the thickness of the hole blocking layer is within these ranges, excellent hole blocking characteristics may be obtained without a substantial increase in driving voltage.

The electron transport layer may include BCP, Bphen, TPBi, tris(8-hydroxyquinolinato)aluminum (Alq₃), Balq, 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof:

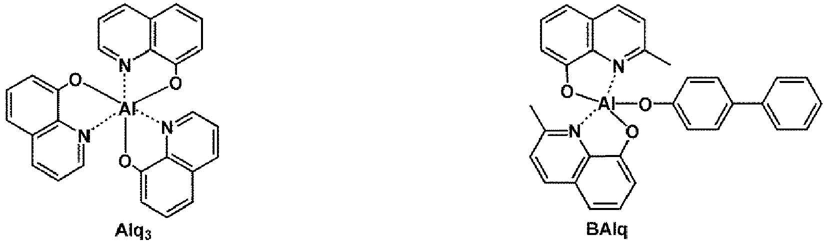

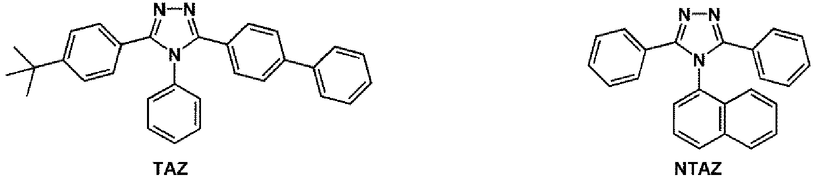

In one or more embodiments, the electron transport layer may include one or more of Compounds ET1 to ET25, or a combination thereof:

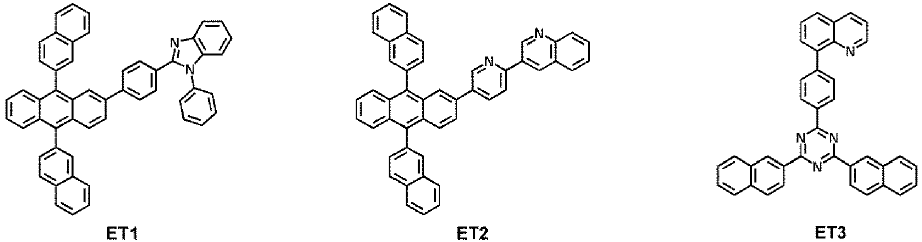

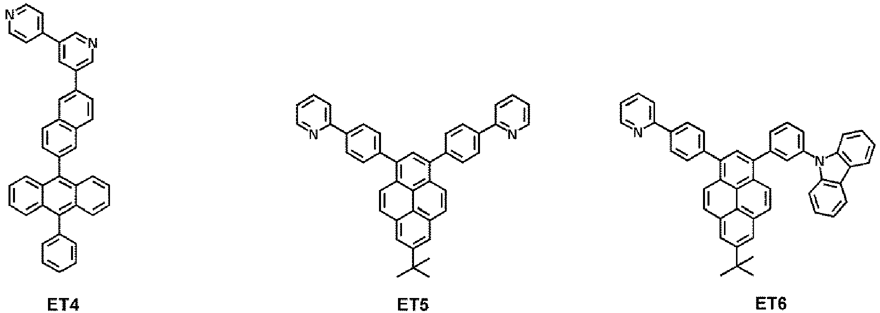

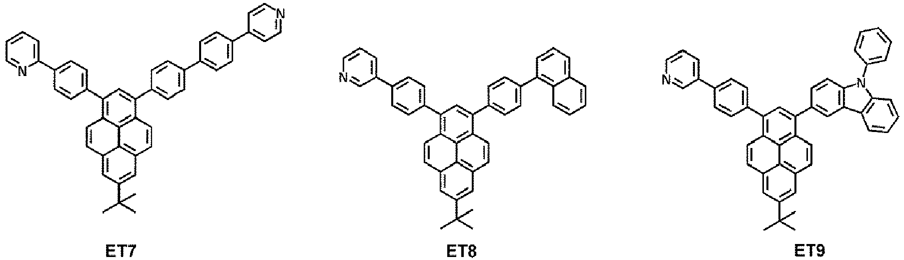

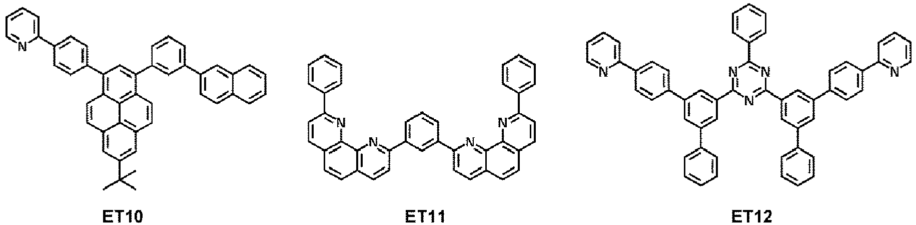

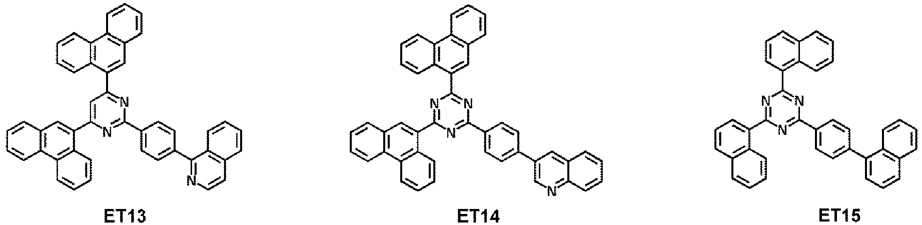

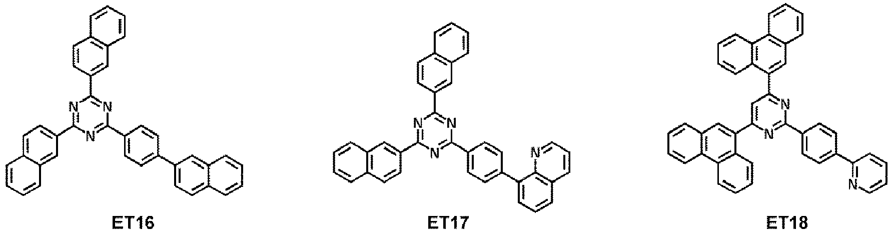

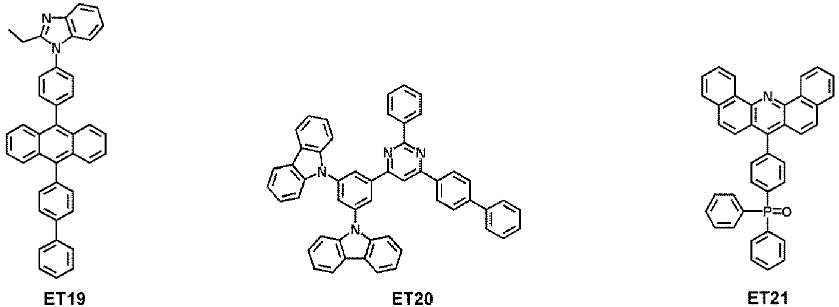

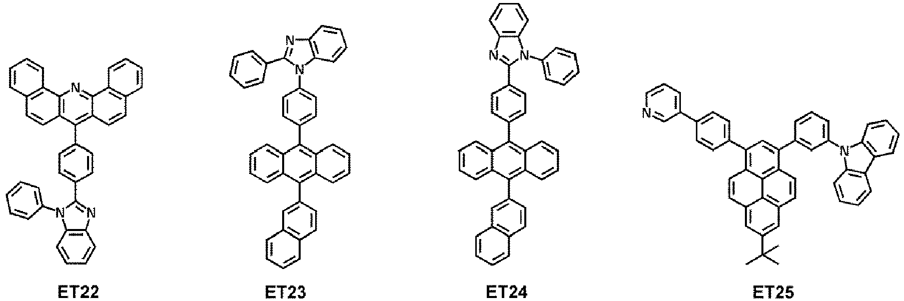

A thickness of the electron transport layer may be in the range of about 100 Å to about 1,000 Å, for example, about 150 Å to about 500 Å. When the thickness of the electron transport layer is within the range described above, the electron transport layer may have satisfactory electron transporting characteristics without a substantial increase in driving voltage.

The electron transport layer may include a metal-containing material in addition to the material as described above.

The metal-containing material may include a Li complex. The Li complex may include, for example, Compound ET-D1 or ET-D2:

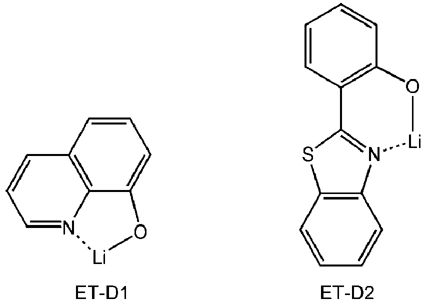

Also, the electron transport region may include an electron injection layer that promotes the flow of electrons from the second electrode 19 thereinto.

The electron injection layer may include LiF, NaCl, CsF, Li₂O, BaO, Compound ET-D1, Compound ET-D2, or a combination thereof.

A thickness of the electron injection layer may be in a range of about 1 Å to about 100 Å, and, for example, about 3 Å to about 90 Å. When the thickness of the electron injection layer is within the range described above, satisfactory electron injection characteristics may be obtained without a substantial increase in driving voltage.

The second electrode 19 may be located on the organic layer 15. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), silver (Ag), aluminum-lithium (Al-Li), calcium (Ca), magnesium-indium (Mg-In), magnesium-silver (Mg-Ag), or the like may be used as the material for forming the second electrode 19. In one or more embodiments, to manufacture a top-emission type light-emitting device, a transmissive electrode formed using ITO or IZO may be used as the second electrode 19.

In one or more embodiments, the composition, a layer including the composition, and an emission layer in a light-emitting device including the composition may not include a compound of [Group A] and mCP (1,3-bis(N-carbazolyl)benzene):

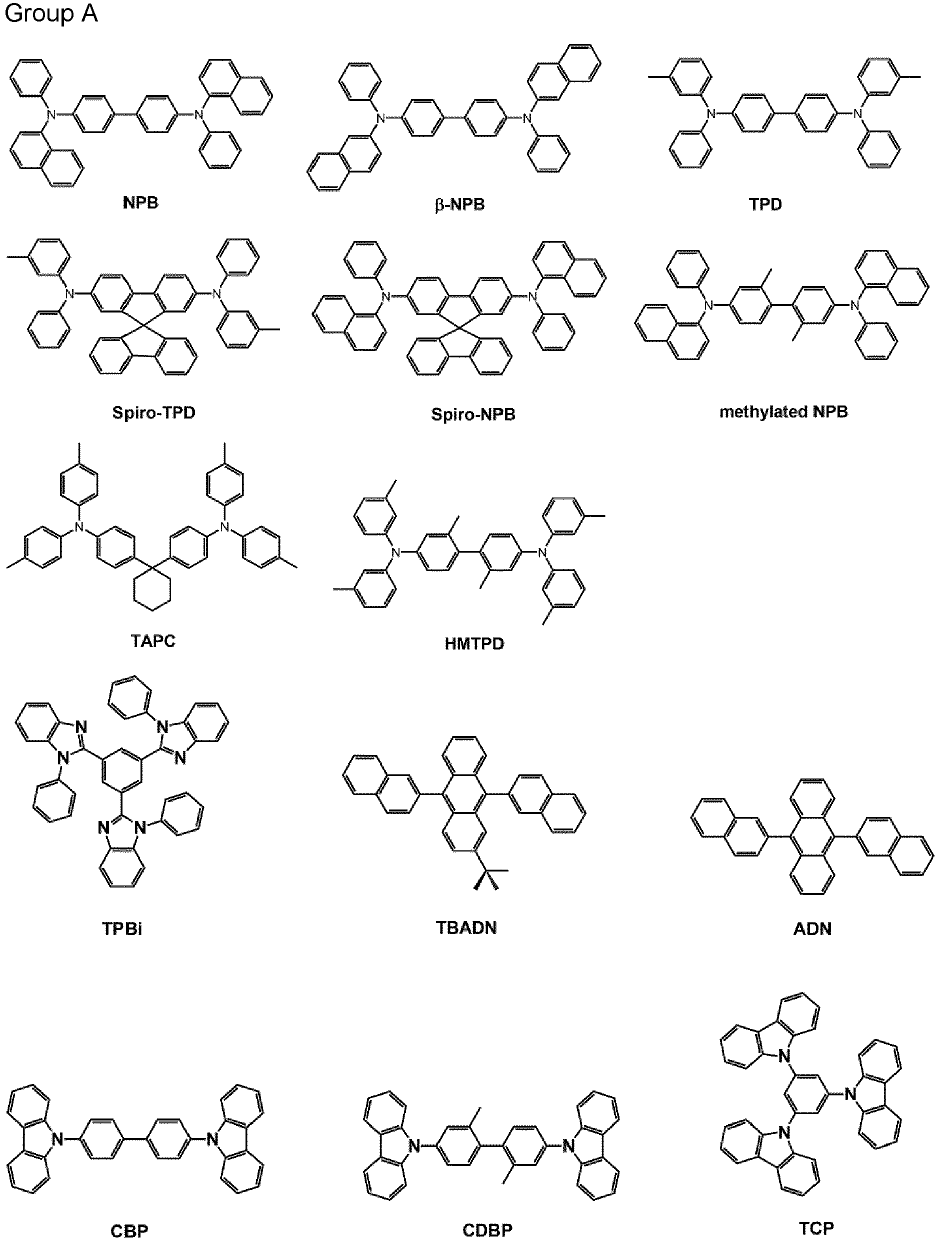

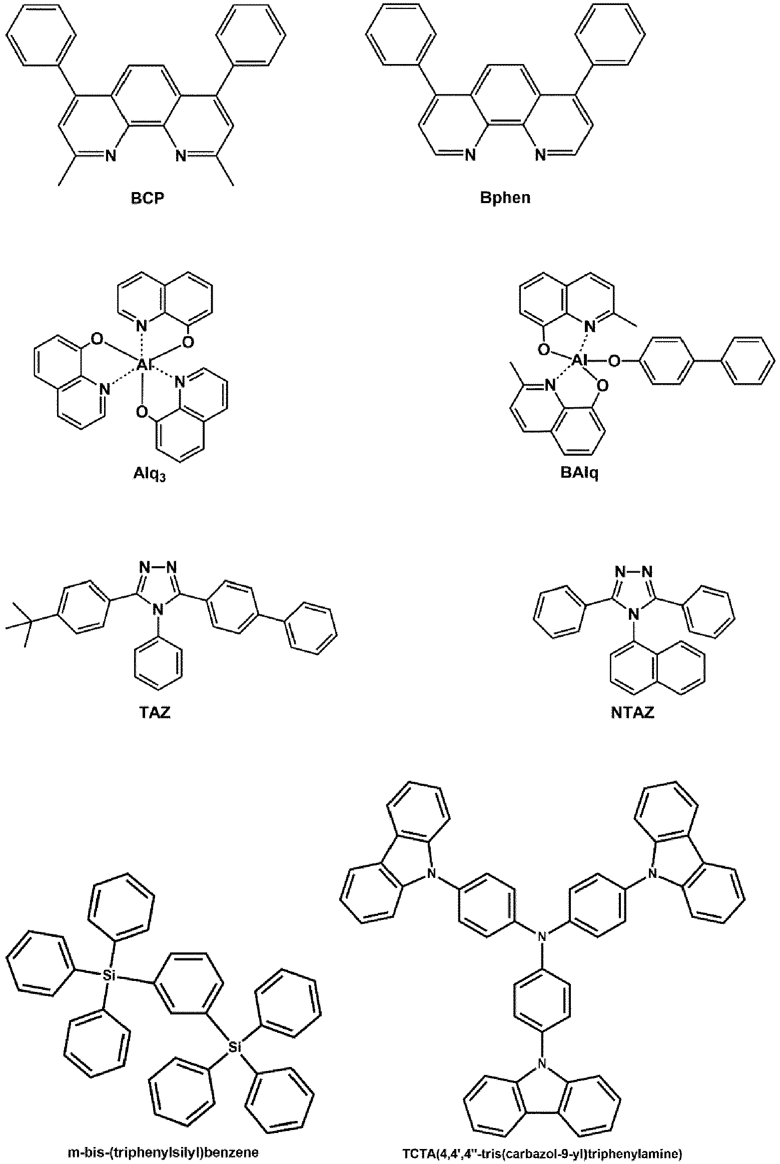

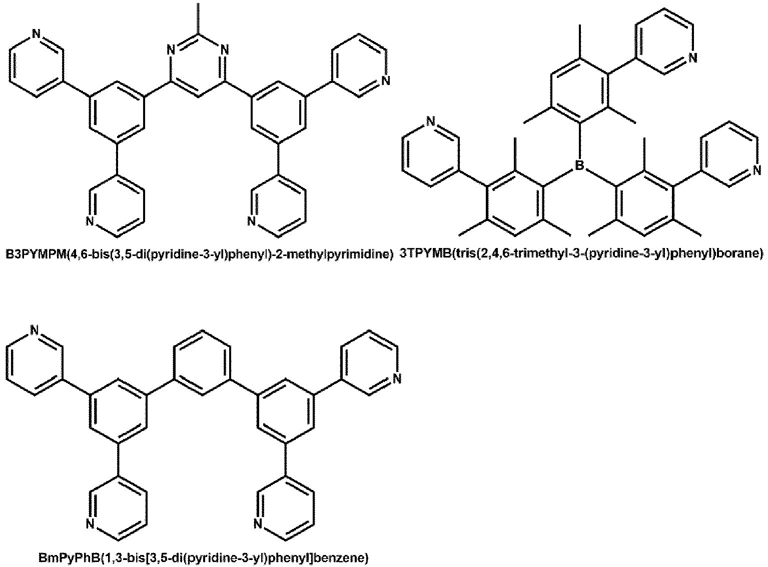

Hereinbefore, the light-emitting device has been described in connection with FIGURE, but embodiments are not limited thereto.

According to another aspect, the light-emitting device may be included in an electronic apparatus. Thus, an electronic apparatus including the light-emitting device is provided. The electronic apparatus may include, for example, a display, an illumination, a sensor, or the like.

The term "C₁-C₆₀ alkyl group" as used herein refers to a linear or branched saturated aliphatic hydrocarbons monovalent group having 1 to 60 carbon atoms, and the term "C₁-C₆₀ alkylene group" as used here refers to a divalent group having the same structure as the C₁-C₆₀ alkyl group.

Examples of the C₁-C₆₀ alkyl group, the C₁-C₂₀ alkyl group, and/or the C₁-C₁₀ alkyl group may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with at least one of a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched C₆ alkyl group, for example, a tert-butyl group that is substituted with two methyl groups.

The term "C₁-C₆₀ alkoxy group" as used herein refers to a monovalent group represented by -OA₁₀₁ (wherein A₁₀₁ is the C₁-C₆₀ alkyl group), and examples thereof may include a methoxy group, an ethoxy group, a propoxy group, a butoxy group, a pentoxy group, or the like.

The term "C₁-C₆₀ alkylthio group" as used herein refers to a monovalent group having the formula of -SA₁₀₁ (where A₁₀₁ is the C₁-C₆₀ alkyl group).

The term "C₂-C₆₀ alkenyl group" as used herein refers to a hydrocarbon group formed by substituting at least one carbon-carbon double bond in the middle or at the terminus of the C₂-C₆₀ alkyl group, and examples thereof include an ethenyl group, a propenyl group, a butenyl group, or the like. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and examples thereof include an ethynyl group, a propynyl group, or the like. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and the C₃-C₁₀ cycloalkylene group is a divalent group having the same structure as the C₃-C₁₀ cycloalkyl group.

Examples of the C₃-C₁₀ cycloalkyl group may include a cyclopropyl group, a cyclobutyl group, a cyclopentyl, cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, a bicyclo[2.2.2]octyl group, or the like.

The term "C₁-C₁₀ heterocycloalkyl group" as used herein refers to a monovalent saturated cyclic group that includes at least one hetero atom selected from N, O, P, Si, S, Se, Ge, and B as a ring-forming atom and 1 to 10 carbon atoms, and the term "C₁-C₁₀ heterocycloalkylene group" as used herein refers to a divalent group having the same structure as the C₁-C₁₀ heterocycloalkyl group.

Examples of the C₁-C₁₀ heterocycloalkyl group may include a silolanyl group, a silinanyl group, tetrahydrofuranyl group, a tetrahydro-2H-pyranyl group, a tetrahydrothiophenyl group, or the like.

The term "C₃-C₁₀ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, a cycloheptenyl group, or the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one hetero atom selected from N, O, P, Si, S, Se, Ge, and B as a ring-forming atom, 1 to 10 carbon atoms, and at least one carbon-carbon double bond in its ring. Examples of the C₁-C₁₀ heterocycloalkenyl group include a 2,3-dihydrofuranyl group, a 2,3-dihydrothiophenyl group, or the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, a chrysenyl group, or the like. When the C₆-C₆₀ aryl group and the C₆-C₆₀ arylene group each include two or more rings, the rings may be fused to each other.

The term "C₇-C₆₀ alkyl aryl group" as used herein refers to a C₆-C₆₀ aryl group substituted with at least one C₁-C₆₀ alkyl group. The term "C₇-C₆₀ aryl alkyl group" as used herein refers to a C₁-C₆₀ alkyl group substituted with at least one C₆-C₆₀ aryl group.

The term "C₁-C₆₀ heteroaryl group" as used herein refers to a monovalent group that includes at least one hetero atom selected from N, O, P, Si, S, Se, Ge, and B as a ring-forming atom and a cyclic aromatic system having 1 to 60 carbon atoms, and the term "C₁-C₆₀ heteroarylene group" as used herein refers to a divalent group that includes at least one hetero atom selected from N, O, P, Si, S, Se, Ge, and B as a ring-forming atom and a cyclic aromatic system having 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₆-C₆₀ heteroaryl group and the C₆-C₆₀ heteroarylene group each include two or more rings, the two or more rings may be fused to each other.

The term "C₂-C₆₀ alkyl heteroaryl group" as used herein refers to a C₁-C₆₀ heteroaryl group substituted with at least one C₁-C₆₀ alkyl group. The term "C₂-C₆₀ heteroaryl alkyl group" as used herein refers to a C₁-C₆₀ alkyl group substituted with at least one C₁-C₆₀ heteroaryl group.

The term "C₆-C₆₀ aryloxy group" as used herein indicates -OA₁₀₂ (wherein A₁₀₂ indicates the C₆-C₆₀ aryl group), the term "C₆-C₆₀ arylthio group" as used herein indicates -SA₁₀₃ (wherein A₁₀₃ indicates the C₆-C₆₀ aryl group), and the term "C₁-C₆₀ alkylthio group" as used herein indicates -SA₁₀₄ (wherein A₁₀₄ indicates the C₁-C₆₀ alkyl group). The term "C₁-C₆₀ heteroaryloxy group" as used herein indicates -OA_{102'} (wherein A_{102'} indicates the C₁-C₆₀ heteroaryl group), and the term "C₁-C₆₀ heteroarylthio group" as used herein indicates -SA_{103'} (wherein A_{103'} indicates the C₁-C₆₀ heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as a monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, including at least one hetero atom selected from N, O, P, Si, S, Se, Ge, and B, other than carbon atoms, as a ring-forming atom, and having no aromaticity in its entire molecular structure. Examples of the monovalent non-aromatic condensed heteropolycyclic group include a carbazolyl group or the like. The term "divalent non-aromatic condensed heteropolycyclic group" as used herein refers to a divalent group having the same structure as a monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group. Examples of the "C₅-C₃₀ carbocyclic group (unsubstituted or substituted with at least one R₁₀ₐ)" used herein are an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, or a fluorene group (each unsubstituted or substituted with at least one R₁₀ₐ).

The term "C₁-C₃₀ heterocyclic group" as used herein refers to a saturated or unsaturated cyclic group having, as a ring-forming atom, at least one heteroatom selected from N, O, P, Si, S, Se, Ge, and B other than 1 to 30 carbon atoms. The C₁-C₃₀ heterocyclic group may be a monocyclic group or a polycyclic group. The "C₁-C₃₀ heterocyclic group (unsubstituted or substituted with at least one R₁₀ₐ)" may be, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (each unsubstituted or substituted with at least one R₁₀ₐ).

In one or more embodiments, examples of the "C₅-C₃₀ carbocyclic group" and "C₁-C₃₀ heterocyclic group" as used herein include i) a first ring, ii) a second ring, iii) a condensed ring in which two or more first rings are condensed with each other, iv) a condensed ring in which two or more second rings are condensed with each other, or v) a condensed ring in which at least one first ring and at least one second ring are condensed with each other,
the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated C₁-C₆₀ alkyl group (or a fluorinated C₁-C₂₀ alkyl group or the like)", "fluorinated C₃-C₁₀ cycloalkyl group", "fluorinated C₁-C₁₀ heterocycloalkyl group," and "fluorinated phenyl group" as used herein respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one fluoro group (-F). For example, the term "fluorinated C₁ alkyl group (that is, a fluorinated methyl group)" includes -CF₃, -CF₂H, and -CFH₂. The "fluorinated C₁-C₆₀ alkyl group (or, a fluorinated C₁-C₂₀ alkyl group, or the like)", "the fluorinated C₃-C₁₀ cycloalkyl group", "the fluorinated C₁-C₁₀ heterocycloalkyl group", or "the fluorinated phenyl group" may be i) a fully fluorinated C₁-C₆₀ alkyl group (or, a fully fluorinated C₁-C₂₀ alkyl group, or the like), a fully fluorinated C₃-C₁₀ cycloalkyl group, a fully fluorinated C₁-C₁₀ heterocycloalkyl group, or a fully fluorinated phenyl group, wherein, in each group, all hydrogen included therein is substituted with a fluoro group, or ii) a partially fluorinated C₁-C₆₀ alkyl group (or, a partially fluorinated C₁-C₂₀ alkyl group, or the like), a partially fluorinated C₃-C₁₀ cycloalkyl group, a partially fluorinated C₁-C₁₀ heterocycloalkyl group, or partially fluorinated phenyl group, wherein, in each group, all hydrogen included therein is not substituted with a fluoro group.

The terms "deuterated C₁-C₆₀ alkyl group (or a deuterated C₁-C₂₀ alkyl group or the like)", "deuterated C₃-C₁₀ cycloalkyl group", "deuterated C₁-C₁₀ heterocycloalkyl group," and "deuterated phenyl group" as used herein respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. For example, the "deuterated C₁ alkyl group (that is, the deuterated methyl group)" may include -CD₃, -CD₂H, and -CDH₂, and examples of the "deuterated C₃-C₁₀ cycloalkyl group" are, for example, Formula 10-501 and the like. The "deuterated C₁-C₆₀ alkyl group (or, the deuterated C₁-C₂₀ alkyl group or the like)", "the deuterated C₃-C₁₀ cycloalkyl group", "the deuterated C₁-C₁₀ heterocycloalkyl group", or "the deuterated phenyl group" may be i) a fully deuterated C₁-C₆₀ alkyl group (or, a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogen included therein is substituted with at least one of deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, all hydrogen included therein is not substituted with deuterium.

The term "(C₁-C₂₀ alkyl) 'X' group" as used herein refers to a 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group, and the term "(C₁-C₂₀ alkyl)phenyl group" as used herein refers to a phenyl group substituted with at least one C₁-C₂₀ alkyl group. An example of a (C₁ alkyl)phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" as used herein respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, or a dibenzothiophene 5,5-dioxide group," in which, in each group, at least one carbon selected from ring-forming carbons is substituted with nitrogen.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group,;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), - P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), - P(=O)(Q₂₈)(Q₂₉), -P(Q₂₈)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
a combination thereof.

Q₁ to Q₉, Q₁₁ to Q₁₉, Q₂₁ to Q₂₉, and Q₃₁ to Q₃₉ herein may each independently be: hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, a C₁-C₆₀ alkyl group, a C₆-C₆₀ aryl group, or a combination thereof.

For example, Q₁ to Q₉, Q₁₁ to Q₁₉, Q₂₁ to Q₂₉, and Q₃₁ to Q₃₉ described herein may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₁₀ alkyl group, a phenyl group, or a combination thereof.

Hereinafter, a compound and a light-emitting device according to one or more example embodiments are described in further detail with reference to Synthesis Example and Examples. However, the light-emitting device is not limited thereto. The wording "B was used instead of A" used in describing Synthesis Examples means that an amount of A used was identical to an amount of B used, in terms of a molar equivalent.

### EXAMPLES

### Synthesis Example 1 (Synthesis of Compound 1)

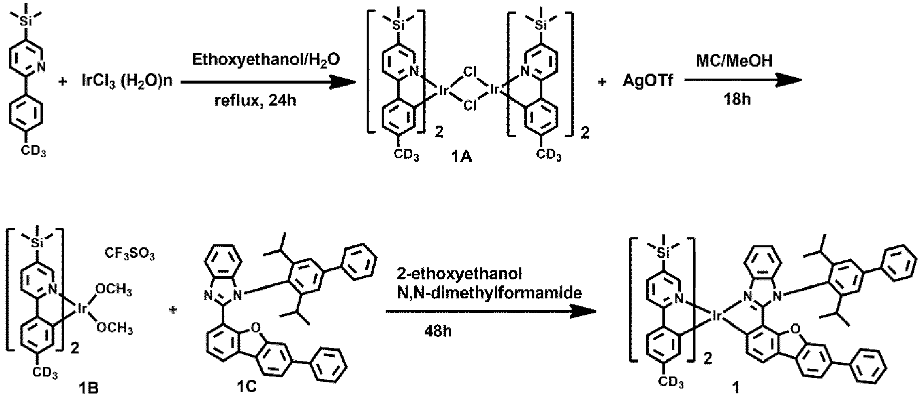

### Synthesis of Compound 1A

2-(4-(methyl-d3)phenyl)-5-(trimethylsilyl)pyridine (4.52 grams (g), 18.5 millimoles (mmol)) and iridium chloride hydrate (IrCl₃·(H₂O)ₙ, n=3) (2.96 g, 8.40 mmol) were mixed with 30 milliliters (mL) of 2-ethoxyethanol and 10 mL of deionized (DI) water and then stirred while heating at reflux for 24 hours, and then, the temperature was allowed to cool to room temperature. The resulting solid was separated by filtration, washed sufficiently with water, methanol, and hexanes, in this stated order, and then dried in a vacuum oven to obtain 5.22 g (yield of 87%) of Compound 1A.

### Synthesis of Compound 1B

Compound 1A (2.4 g, 1.68 mmol) and 60 mL of methylene chloride (MC) were mixed together, and then, silver trifluoromethanesulfonate (silver triflate, AgOTf) (0.86 g, 3.36 mmol) were mixed with 20 mL of methanol (MeOH) and then added thereto. Afterwards, the mixture was stirred for 18 hours at room temperature while light was blocked from the reaction contents with aluminum foil, and then the resulting product was filtered through diatomaceous earth to remove the resulting solid, and the filtrate was subjected to reduced pressure to obtain a resulting product (Compound 1B). Compound 1B was used in the next reaction without an additional purification process.

### Synthesis of Compound 1

Compound 1B (2.66 g, 2.98 mmol) and Compound 1C (1-(3,5-diisopropyl-[1,1'-biphenyl]-4-yl)-2-(7-phenyldibenzo[b,d]furan-4-yl)-1H-benzo[d]imidazole) (1.78 g, 2.98 mmol) were mixed with 30 mL of 2-ethoxyethanol and 30 mL of N,N-dimethylformamide and then stirred while heating at reflux for 48 hours, and then the temperature was allowed to cool to room temperature. The obtained mixture was subjected to a reduced pressure to obtain a solid, on which column chromatography (eluent: ethyl acetate (EA) and hexanes) was performed to obtain 1.13 g (yield of 30%) of Compound 1. The obtained compound was identified by high resolution mass spectrometry (HRMS) with matrix assisted laser desorption ionization (MALDI) and by high performance liquid chromatography (HPLC) analysis.

HRMS (MALDI) calcd for C₇₃H₆₅D₆IrN₄OSi₂: m/z 1274.5172 Found: 1274.5171.

### Synthesis Example 2 (Synthesis of Compound 2)

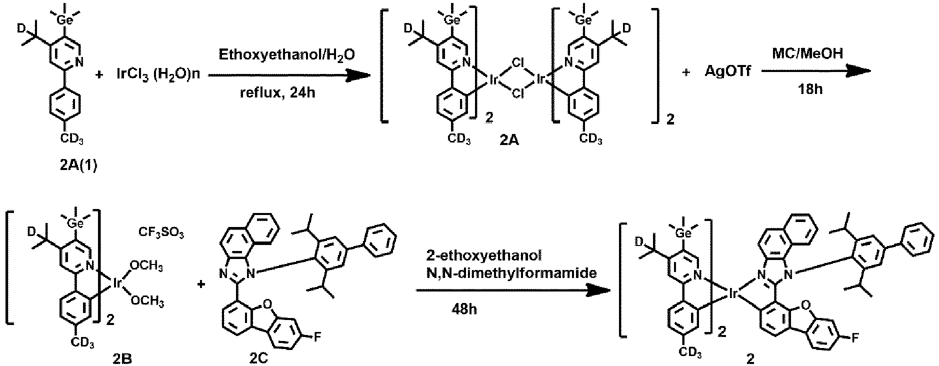

### Synthesis of Compound 2A

6.3 g (yield of 90 %) of Compound 2A was obtained in a similar manner as used to obtain Compound 1A of Synthesis Example 1, except that Compound 2A(1) (2-(4-methyl-d3)phenyl)-4-(propan-2-yl-2-d)-5-(trimethylgermyl)pyridine) was used instead of 2-(4-(methyl-d3)phenyl)-5-(trimethylsilyl)pyridine.

### Synthesis of Compound 2B

Compound 2B was obtained in a similar manner as used to obtain Compound 1B of Synthesis Example 1, except that Compound 2A was used instead of Compound 1A. The obtained Compound 2B was used in the next reaction without an additional purification process.

### Synthesis of Compound 2

1.61 g (yield of 40 %) of Compound 2 was obtained in a similar manner as used to obtain Compound 1 of Synthesis Example 1, except that Compound 2B was used instead of Compound 1B and Compound 2C (1-(3,5-diisopropyl-[1,1'-biphenyl]-4-yl)-2-(7-fluorodibenzo[b,d]furan-4-yl)-1H-naphtho[1,2-d]imidazole) was used instead of Compound 1C.

HRMS (MALDI) calcd for C₇₇H₇₂D₈FIrN₄OGe₂. m/z 1444.4871 Found: 1444.4870.

### Synthesis Example 3 (Synthesis of Compound 3)

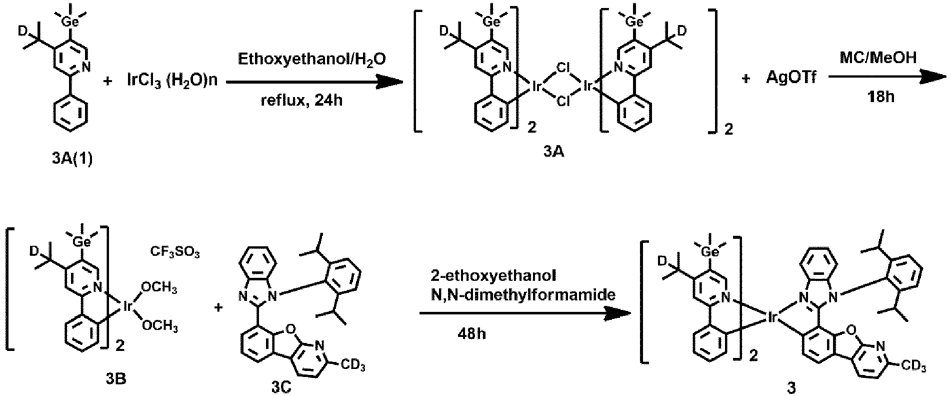

### Synthesis of Compound 3A

6.13 g (yield of 88 %) of Compound 3A was obtained in a similar manner as used to obtain Compound 1A of Synthesis Example 1, except that Compound 3A(1) (2-phenyl-4-(propan-2-yl-2-d)-5-(trimethylgermyl)pyridine) was used instead of 2-(4-(methyl-d3)phenyl)-5-(trimethylsilyl)pyridine.

### Synthesis of Compound 3B

Compound 3B was obtained in a similar manner as used to obtain Compound 1B of Synthesis Example 1, except that Compound 3A was used instead of Compound 1A. The obtained Compound 3B was used in the next reaction without an additional purification process.

### Synthesis of Compound 3

1.32 g (yield of 36 %) of Compound 3 was obtained in a similar manner as used to obtain Compound 1 of Synthesis Example 1, except that Compound 3B was used instead of Compound 1B and Compound 3C (8-(1-(2,6-diisopropylphenyl)-1H-benzo[d]imidazol-2-yl)-2-(methyl-d3)benzofuro[2,3-b]pyridine) was used instead of Compound 1C.

HRMS (MALDI) calcd for C₆₅H₆₇D₅Ge₂IrN₅O: m/z 1284.4104 Found: 1281.4106.

### Synthesis Example 4 (Synthesis of Compound 4)

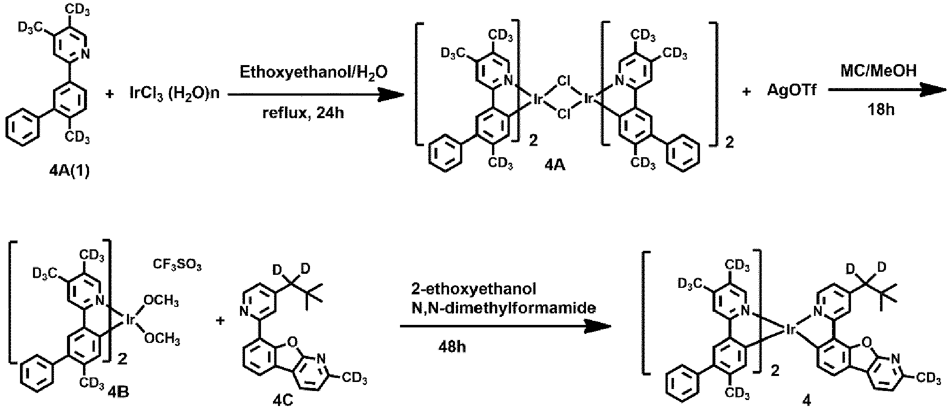

### Synthesis of Compound 4A

4.31 g (yield of 81 %) of Compound 4A was obtained in a similar manner as used to obtain Compound 1A of Synthesis Example 1, except that Compound 4A(1) (4,5-bis(methyl-d3)-2-(6-(methyl-d3)-[1,1'-biphenyl]-3-yl)pyridine) was used instead of 2-(4-(methyl-d3)phenyl)-5-(trimethylsilyl)pyridine.

### Synthesis of Compound 4B

Compound 4B was obtained in a similar manner as used to obtain Compound 1B of Synthesis Example 1, except that Compound 4A was used instead of Compound 1A. The obtained Compound 4B was used in the next reaction without an additional purification process.

### Synthesis of Compound 4

1.44 g (yield of 38 %) of Compound 4 was obtained in a similar manner as used to obtain Compound 1 of Synthesis Example 1, except that Compound 4B was used instead of Compound 1B and Compound 4C (8-(4-(2,2-dimethylpropyl-1,1-d2)pyridin-2-yl)-2-(methyl-d3)benzofuro[2,3-b]pyridine) was used instead of Compound 1C.

HRMS (MALDI) calcd for C₆₂H₃₄D₂₃IrN₄O: m/z 1089.5605 Found: 1089.5606.

### Synthesis Example 5 (Synthesis of Compound 5)

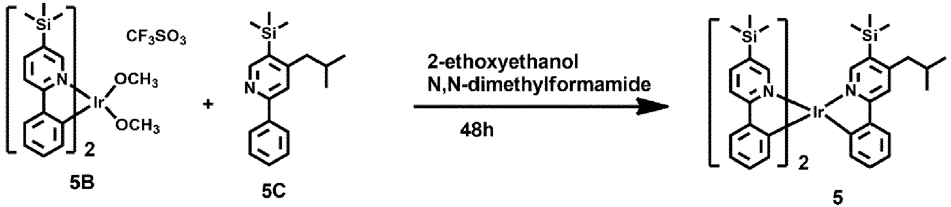

0.98 g (yield of 36 %) of Compound 5 was obtained in a similar manner as used to obtain Compound 1 of Synthesis Example 1, except that Compound 5B was used instead of Compound 1B and Compound 5C was used instead of Compound 1C.

HRMS (MALDI) calcd for C₄₆H₅₆IrN₃Si₃: m/z 927.3411 Found: 927.3412.

### Synthesis Example 6 (Synthesis of Compound 6)

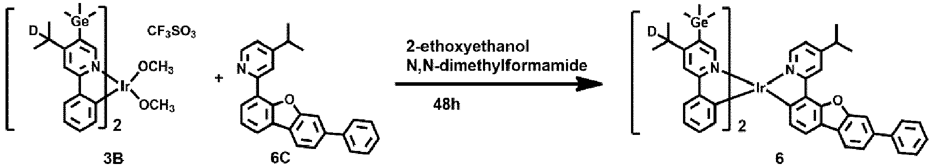

1.12 g (yield of 32 %) of Compound 6 was obtained in a similar manner as used to obtain Compound 1 of Synthesis Example 1, except that Compound 3B was used instead of Compound 1B and Compound 6C was used instead of Compound 1C.

HRMS (MALDI) calcd for C₆₉H₆₂D₂Ge₂IrN₃O: m/z 1185.3228 Found: 1185.3226.

### Synthesis Example 7 (Synthesis of Compound 7)

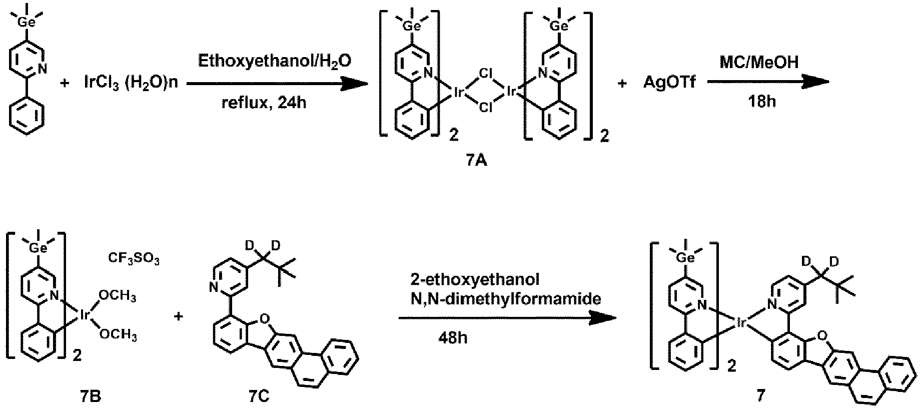

### Synthesis of Compound 7A

4.53 g (yield of 91 %) of Compound 7A was obtained in a similar manner as used to obtain Compound 1A of Synthesis Example 1, except that 2-phenyl-5-(trimethylgermyl)pyridine was used instead of 2-(4-(methyl-d3)phenyl)-5-(trimethylsilyl)pyridine.

### Synthesis of Compound 7B

Compound 7B was obtained in a similar manner as used to obtain Compound 1B of Synthesis Example 1, except that Compound 7A was used instead of Compound 1A. The obtained Compound 7B was used in the next reaction without an additional purification process.

### Synthesis of Compound 7

1.25 g (yield of 37 %) of Compound 7 was obtained in a similar manner as used to obtain Compound 1 of Synthesis Example 1, except that Compound 7B was used instead of Compound 1B and Compound 7C was used instead of Compound 1C.

HRMS (MALDI) calcd for C₅₈H₅₄D₂Ge₂IrN₃O: m/z 1153.2602 Found: 1153.2600.

### Synthesis Example 8: (Synthesis of Compound 8)

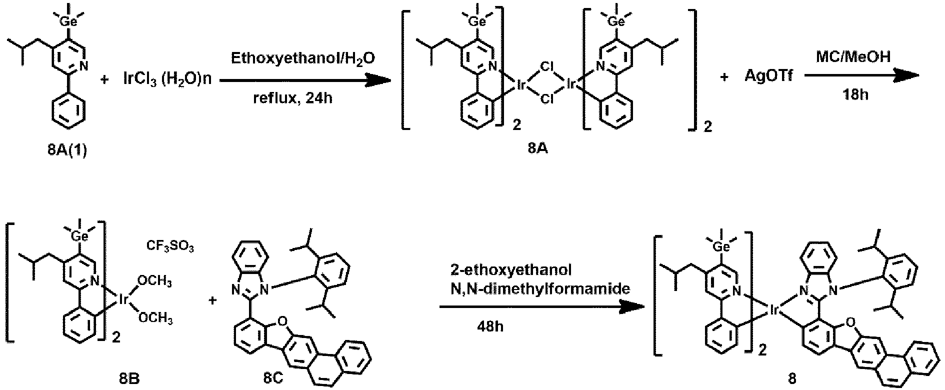

### Synthesis of Compound 8A

4.32 g (yield of 86 %) of Compound 8A was obtained in a similar manner as used to obtain Compound 1A of Synthesis Example 1, except that Compound 8A(1) was used instead of 2-(4-(methyl-d3)phenyl)-5-(trimethylsilyl)pyridine.

### Synthesis of Compound 8B

Compound 8B was obtained in a similar manner as used to obtain Compound 1B of Synthesis Example 1, except that Compound 8A was used instead of Compound 1A. The obtained Compound 8B was used in the next reaction without an additional purification process.

### Synthesis of Compound 8

1.49 g (yield of 36 %) of Compound 8 was obtained in a similar manner as used to obtain Compound 1 of Synthesis Example 1, except that Compound 8B was used instead of Compound 1B and Compound 8C was used instead of Compound 1C. HRMS (MALDI) calcd for C₇₅H₇₉Ge₂IrN₄O: m/z 1392.4307 Found: 1392.4305.

### Manufacture of OLED 1

As an anode, an ITO-patterned glass substrate was cut to a size of 50 millimeters (mm) × 50 mm × 0.5 mm, sonicated with isopropyl alcohol and DI water, each for 5 minutes, and then cleaned by irradiation of ultraviolet light and exposure of ozone for 30 minutes. The resultant ITO-patterned glass substrate was loaded onto a vacuum deposition apparatus.

HT3 and F6-TCNNQ were vacuum co-deposited on the anode at the weight ratio of 98:2 to form a hole injection layer having a thickness of 100 Å, and then, HT3 was vacuum-deposited on the hole injection layer to form a hole transport layer having a thickness of 1,350 Å. H-H1 was vacuum-deposited on the hole transport layer to form an electron blocking layer having a thickness of 300 Å.

Next, a host and a dopant were co-deposited on the electron blocking layer at a weight ratio described in Table 12 to form an emission layer having a thickness of 400 Å. H-H1 and H-H2 were used at a weight ratio of 5:5 as the host, and the first compound and second compound described in Table 12 were used at a weight ratio of 1:1 as the dopant.

Afterwards, ET3 and ET-D1 were co-deposited on the emission layer at a volume ratio of 50:50 to form an electron transport layer having a thickness of 350 Å, ET-D1 was vacuum-deposited on the electron transport layer to form an electron injection layer having a thickness of 10 Å, and AI was vacuum-deposited on the electron injection layer to form a cathode having a thickness of 1,000 Å, thereby completing the manufacture of OLED 1.

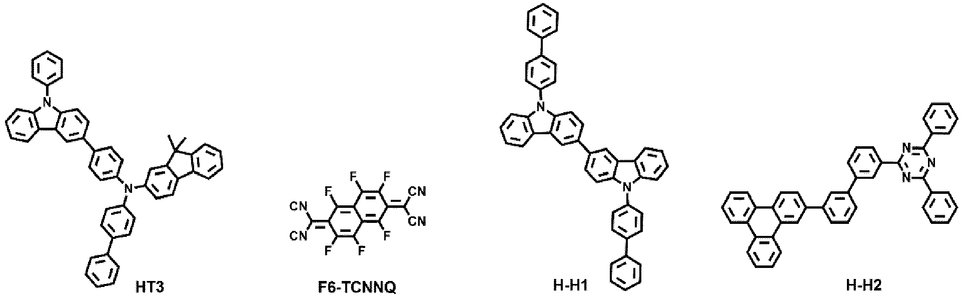

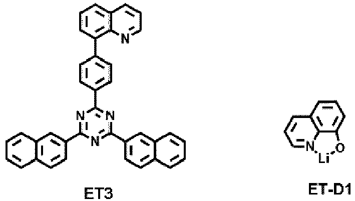

### Manufacture of OLEDs 2 to 6 and A to C

OLEDs 2 to 6 and A to C were manufactured in a similar manner as used to manufacture OLED 1, except that, in forming an emission layer, compounds described in Table 12 below were used as a dopant.

### Evaluation Example 1

A driving voltage (volts, V), emission peak wavelength λₘₐₓ, nm), maximum value of external quantum efficiency (Max EQE, relative % to OLED A), and lifespan (LT₉₇, relative % to OLED A) (hr) of each of OLEDs 1 to 6 and A to C were evaluated, and the results are shown in Tables 12 to 14. A current-voltage meter (Keithley 2400) and a luminance meter (Minolta Cs-1000A) were used as an apparatus for evaluation, the lifespan (LT₉₇) (at 16,000 candela per square meter (cd/m²) or nit) was obtained by measuring the amount of time (hour, hr) that elapsed until luminance was reduced to 97 % of the initial brightness (from the initial luminance, which is set as 100%), and the results are expressed as a relative value (%) to OLED A. Max EQE of Tables 12 to 14 was also expressed as a relative value (%) to OLED A.

**Table 12**

| | Dopant in emission layer | | Weight ratio of host to dopant in emission layer | Driving Voltage (V) | λₘₐₓ (nm) | Max EQE (Relative value, %) | LT₉₇ (Relative value, %) |
|---|---|---|---|---|---|---|---|
| | First compound | Second compound | | | | | |
| OLED 1 | 1 | 4 | 90:10 | 4.29 | 531 | 98 | 154 |
| OLED 3 | 1 | 6 | 90:10 | 4.12 | 531 | 98 | 142 |
| OLED 4 | 1 | 7 | 90:10 | 4.13 | 531 | 97 | 150 |
| OLED A | 1 | | 95:5 | 4.00 | 531 | 100 | 100 |
| OLED B | 4 | | 95:5 | 4.36 | 525 | 91 | 39 |
| OLED C | C-1 | C-2 | 90:10 | 5.4 | 516 | 42 | <10 |

**Table 13**

| | Dopant in emission layer | | Weight ratio of host to dopant in emission layer | Driving Voltage (V) | λₘₐₓ (nm) | Max EQE (Relative value, %) | LT₉₇ (Relative value, %) |
|---|---|---|---|---|---|---|---|
| | First compound | Second compound | | | | | |
| OLED 5 | 3 | 4 | 90:10 | 4.28 | 530 | 102 | 75 |
| OLED 6 | 8 | 4 | 90:10 | 4.30 | 530 | 102 | 140 |
| OLED B | 4 | | 95:5 | 4.36 | 525 | 91 | 39 |
| OLED C | C-1 | C-2 | 90: 0 | 5.4 | 516 | 42 | <10 |

**Table 14**

| | Dopant in emission layer | | Weight ratio of host to dopant in emission layer | Driving Voltage (V) | λₘₐₓ (nm) | Max EQE (Relative value, %) | LT₉₇ (Relative value, %) |
|---|---|---|---|---|---|---|---|
| | First compound | Second compound | | | | | |
| OLED 2 | 2 | 5 | 90:10 | 4.15 | 525 | 86 | 85 |
| OLED C | C-1 | C-2 | 90:10 | 5.4 | 516 | 42 | <10 |

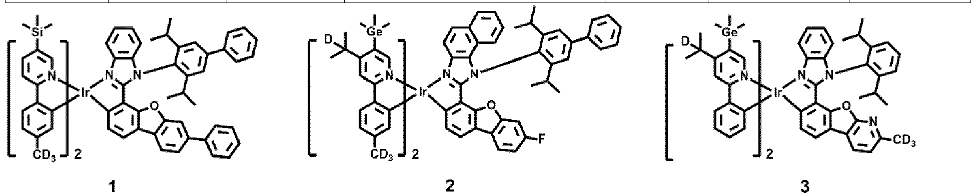

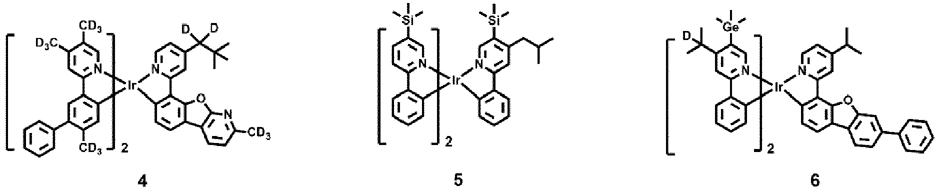

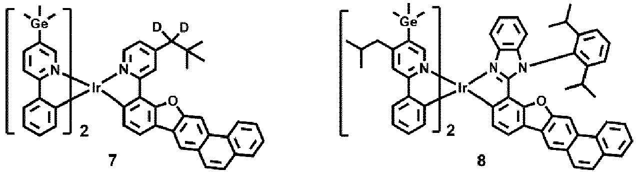

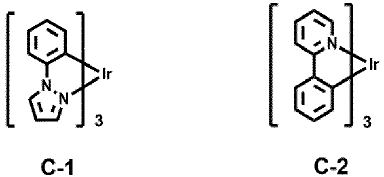

It was confirmed that 1) referring to Table 12, OLED 1 emits green light, and improved or equivalent external quantum efficiency and improved lifespan characteristics, compared to those of each of OLEDs A to C, 2) referring to Table 12, each of OLEDs 3 and 4 emit green light, and have improved driving voltage, improved external quantum efficiency, and improved lifespan characteristics compared to those of each of OLED C, 3) referring to Table 13, each of OLEDs 5 and 6 emit green light, and have improved driving voltage, improved external quantum efficiency, and improved lifespan characteristics compared to those of each of OLEDs B and C, and 3) referring to Table 14, OLED 2 emits green light, and has improved driving voltage, improved external quantum efficiency, and improved lifespan characteristics compared to those of OLED C.

An electronic device, for example, a light-emitting device, including the composition may have improved driving voltage, improved external quantum efficiency, and improved lifespan characteristics.

## Claims

1. A composition, comprising a first compound represented by Formula 1 and a second compound represented by Formula 2:
Formula 1 Ir(L₁₁)ₙ₁₁(L₁₂)ₙ₁₂(L₁₃)ₙ₁₃
Formula 2 Ir(L₂₁)ₙ₂₁(L₂₂)ₙ₂₂(L₂₃)ₙ₂₃
wherein, in Formulae 1 and 2,
L₁₁ is a ligand represented by Formula 1-1,
L₁₂ is a ligand represented by Formula 1-2,
L₁₃ is a ligand represented by Formula 1-1 or a ligand represented by Formula 1-2,
L₂₁ is a ligand represented by Formula 2-1,
L₂₂ is a ligand represented by Formula 2-2,
L₂₃ is a ligand represented by Formula 2-1 or a ligand represented by Formula 2-2: 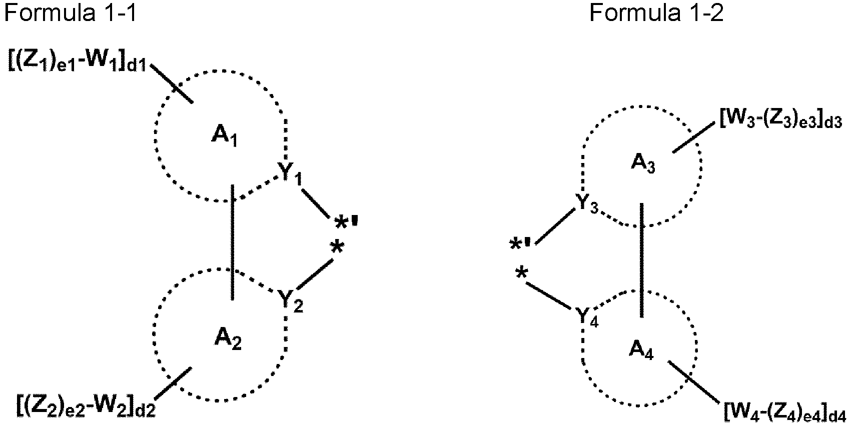 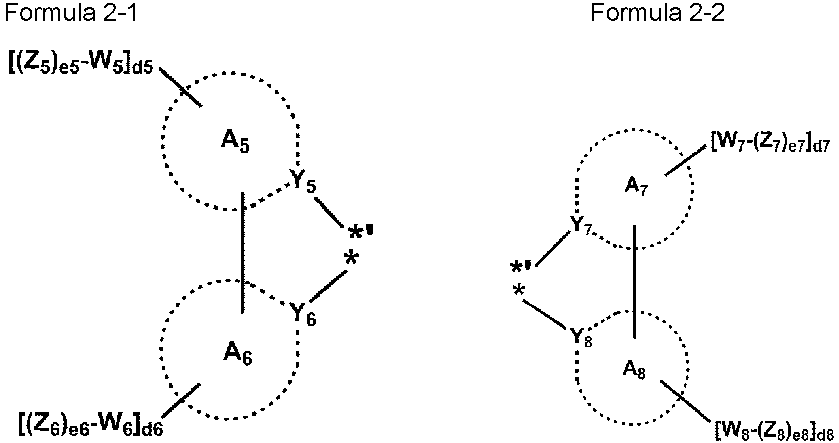
L₁₁, L₁₂, and L₁₃ are different from one another,
n11 and n12 are each independently 1 or 2,
n13 is 0 or 1,
a sum of n11, n12, and n13 is 3,
L₂₁, L₂₂, and L₂₃ are different from one another,
n21 and n22 are each independently 1 or 2,
n23 is 0 or 1,
a sum of n21, n22, and n23 is 3, and
L₁₁ and L₂₁ are different from each other, and
wherein, in Formulae 1-1, 1-2, 2-1, and 2-2,
Y₁, Y₃, Y₅, and Y₇ are N,
Y₂, Y₄, Y₆, and Y₈ are C,
ring A₁, ring A₃, ring A₅, and ring A₇ are each a C₁-C₃₀ heterocyclic group,
ring A₂, ring A₄, ring A₆, and ring A₈ are each independently a C₅-C₃₀ carbocyclic group or a C₁-C₃₀ heterocyclic group,
ring A₁ and ring A₃ are different from each other,
a Y₃-containing monocyclic group in ring A₃ is a 5-membered ring,
W₁ to W₈ are each independently a single bond, a C₁-C₂₀ alkylene group that is unsubstituted or substituted with at least one R₁₀ₐ, a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
Z₁ to Z₈ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), - Si(Q₃)(Q₄)(Q₅), -Ge(Q₃)(Q₄)(Q₆), -B(Q₆)(Q₇), -P(=O)(Q₈)(Q₉), or -P(Q₈)(Q₉),
e1 to e8 and d1 to d8 are each independently an integer from 0 to 20,
one or more of i) two or more of a plurality of Z₁(s), ii) two or more of a plurality of Z₂(s), iii) two or more of a plurality of Z₃(s), iv) two or more of a plurality of Z₄(s), v) two or more of a plurality of Z₅(s), vi) two or more of a plurality of Z₆(s), vii) two or more of a plurality of Z₇(s), and viii) two or more of a plurality of Z₈(s) are respectively optionally bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
R₁₀ₐ is as described in connection with Z₁,
* and *' in Formulae 1-1, 1-2, 2-1, and 2-2 each indicate a binding site to iridium in Formulae 1 and 2,
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₂-C₆₀ heteroarylthio group, the substituted monovalent non-aromatic condensed polycyclic group, and the substituted monovalent non-aromatic condensed heteropolycyclic group is:
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), - Ge(Q₁₃)(Q₁₄)(Q₁₅), -B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), -P(Q₂₈)(Q₂₉), or a combination thereof; or
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉);
and
Q₁ to Q₉, Q₁₁ to Q₁₉, Q₂₁ to Q₂₉, and Q₃₁ to Q₃₉ are each independently: hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, a C₁-C₆₀ alkyl group, a C₆-C₆₀ aryl group, a C₇-C₆₀ alkyl aryl group, a C₇-C₆₀ aryl alkyl group, or a combination thereof.

2. The composition of claim 1, wherein
n13 of Formula 1 is 0, and
n23 of Formula 2 is 0.

3. The composition of claims 1 or 2, wherein
ring A₁ and ring A₅ are each independently:
a pyridine group, a pyrimidine group, a pyridazine group, or a pyrazine group; or
a pyridine group, a pyrimidine group, a pyridazine group, or a pyrazine group, each condensed with at least one of a cyclohexane group, a norbornane group, a benzene group, or a combination thereof,
ring A₃ is:
an imidazole group, a benzimidazole group, a naphthoimidazole group, a phenanthrenoimidazole group, a pyridinoimidazole group, an oxazole group, a benzoxazole group, a naphthooxazole group, a phenanthrenooxazole group, a pyridinooxazole group, a thiazole group, a benzothiazole group, a naphthothiazole group, a phenanthrenothiazole group, or a pyridinothiazole group, and
ring A₇ is:
a pyridine group, a pyrimidine group, a pyridazine group, or a pyrazine group;
a pyridine group, a pyrimidine group, a pyridazine group, or a pyrazine group, each condensed with at least one of a cyclohexane group, a norbornane group, a benzene group, or a combination thereof; or
an imidazole group, a benzimidazole group, a naphthoimidazole group, a phenanthrenoimidazole group, a pyridinoimidazole group, an oxazole group, a benzoxazole group, a naphthooxazole group, a phenanthrenooxazole group, a pyridinooxazole group, a thiazole group, a benzothiazole group, a naphthothiazole group, a phenanthrenothiazole group, or a pyridinothiazole group.

4. The composition of any of claims 1-3, wherein ring A₂ and ring A₄ are different from each other; and/or
wherein ring A₆ and ring A₈ are different from each other.

5. The composition of any of claims 1-4, wherein
ring A₂ and ring A₆ are each independently:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with at least one of a cyclohexane group, a norbornane group, a benzene group, or a combination thereof, and
ring A₄ and ring A₈ are each independently:
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, an azadibenzosilole group, or a phenanthrobenzofuran group; or
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or an azadibenzosilole group, each condensed with at least one of a benzene group, a pyridine group, a pyrimidine group, a pyridazine group, a pyrazine group, a cyclohexane group, a norbornane group, a furan group, a thiophene group, a selenophene group, a pyrrole group, a cyclopentadiene group, a silole group, a pyrazole group, an imidazole group, an oxazole group, a thiazole group, an isoxazole group, an isothiazole group, or a combination thereof.

6. The composition of any of claims 1-5, wherein
e1 and d1 are each not 0,
one or more Zi(s) are each independently:
a C₁-C₂₀ alkyl group that is unsubstituted or substituted with at least one of deuterium, -F, a phenyl group, or a combination thereof;
-Si(Q₃)(Q₄)(Q₅); or
-Ge(Q₃)(Q₄)(Q₅).

7. The composition of any of claims 1-6, wherein
e5 and d5 are each not 0,
one or more Zs(s) are each independently:
a C₁-C₂₀ alkyl group that is unsubstituted or substituted with at least one of deuterium, -F, a phenyl group, or a combination thereof;
-Si(Q₃)(Q₄)(Q₅); or
-Ge(Q₃)(Q₄)(Q₅).

8. The composition of any of claims 1-7, wherein a group represented by 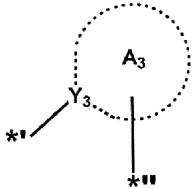 in Formula 1-2 is a group represented by one of Formulae NR29 to NR48, and a group represented by 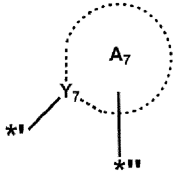 in Formula 2-2 is a group represented by one of Formulae NR1 to NR48: 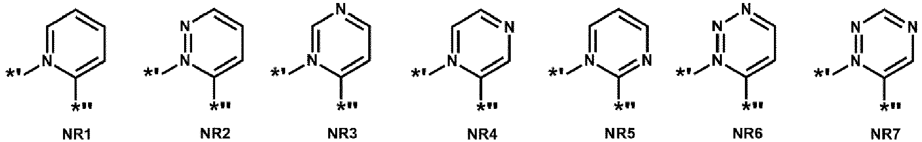 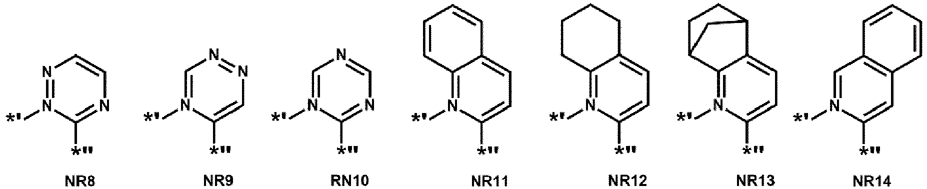 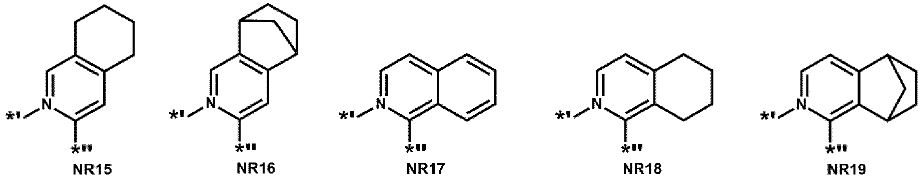 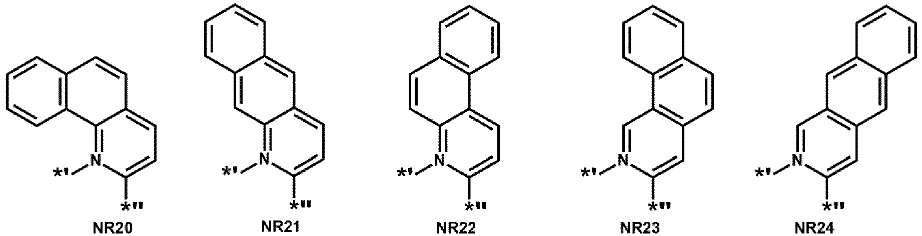 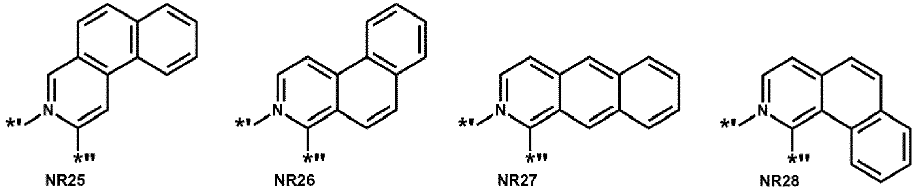 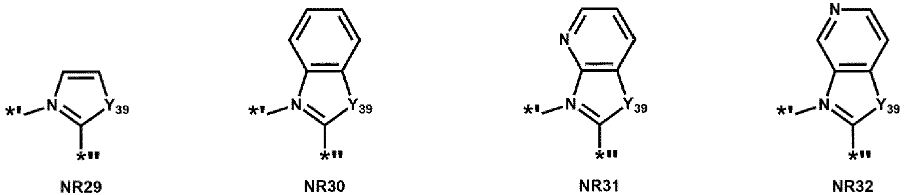 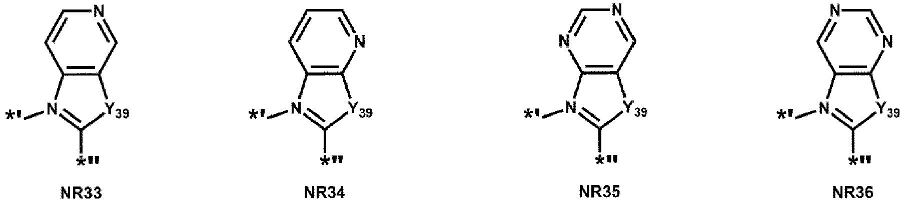 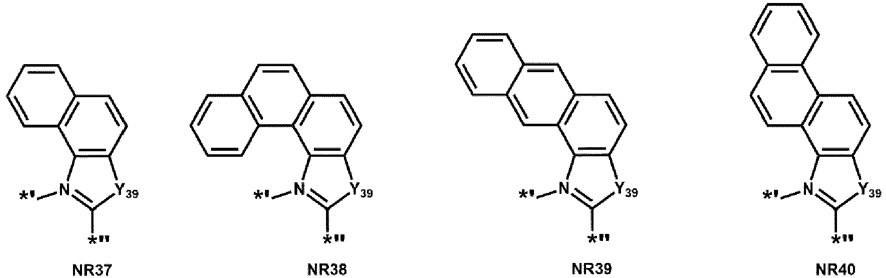 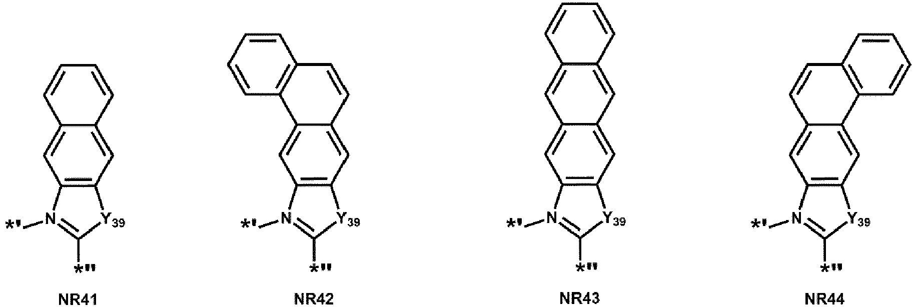 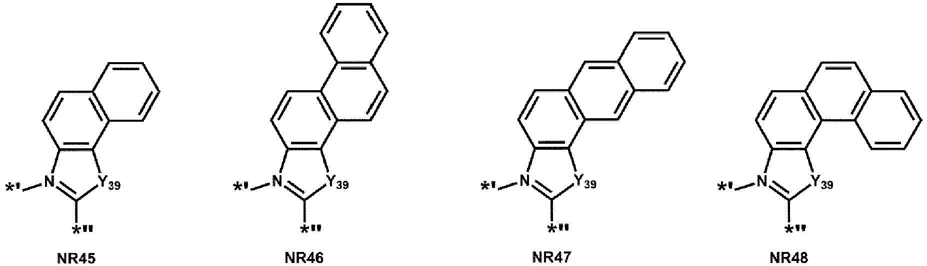
wherein, in Formulae NR1 to NR48,
Y₃₉ is O, S, Se, N-[W₃-(Z₃)ₑ₃], N-[W₇-(Z₇)ₑ₇], C(Z₃₉ₐ)(Z_{39b}), C(Z₇₉ₐ)(Z_{79b}), Si(Z₃₉ₐ)(Z_{39b}), or Si(Z₇₉ₐ)(Z_{79b}),
W₃, W₇, Z₃, Z₇, e3, and e7 are respectively as described in claim 1, Z₃₉ₐ and Z_{39b} are respectively as described in connection with Z₃ in claim 1, and Z₇₉ₐ and Z_{79b} are respectively as described in connection with Z₇ in claim 1,
*' indicates a binding site to iridium in Formula 1 or 2, and
*" indicates a binding site to ring A₄ or ring A₈;
preferably wherein a group represented by 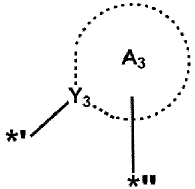 in Formula 1-2 is a group represented by one of Formulae NR30 to NR48.

9. The composition of any of claims 1-8, wherein a group represented by 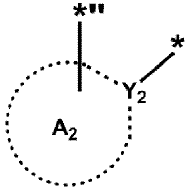 in Formula 1-1,
a group represented by 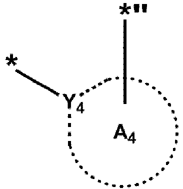 in Formula 1-2,
a group represented by 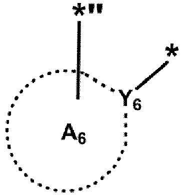 in Formula 2-1, and
a group represented by 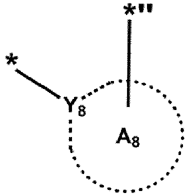 in Formula 2-2 are each independently a group represented by one of Formulae CR1 to CR29: 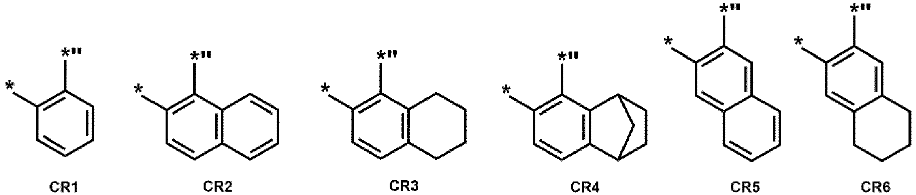 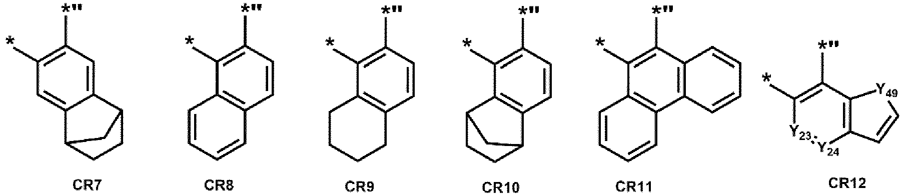 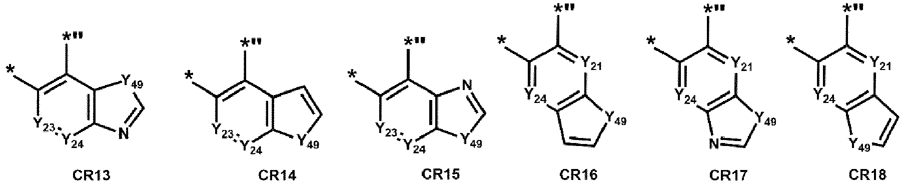 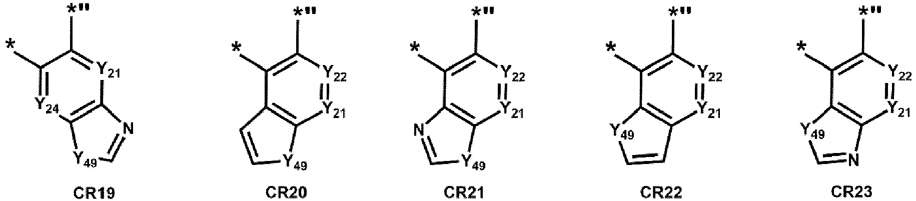 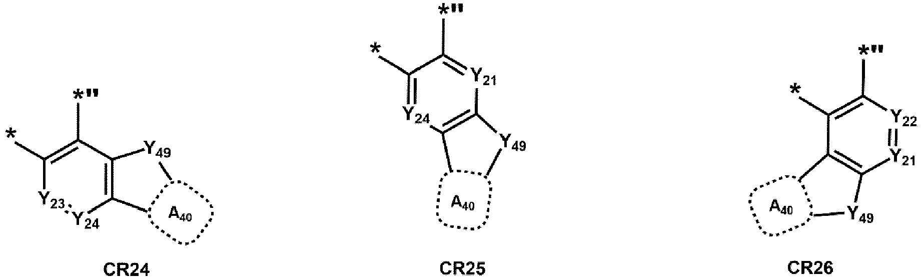 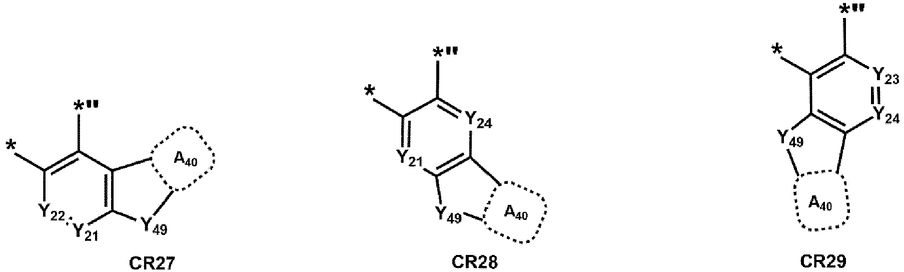
wherein, in Formulae CR1 to CR29,
Y₄₉ is O, S, Se, N-[W₂-(Z₂)ₑ₂], N-[W₄-(Z₄)ₑ₄], N-[W₆-(Z₆)ₑ₆], N-[W₈-(Z₈)ₑ₈], C(Z₂₉ₐ)(Z_{29b}), C(Z₄₉ₐ)(Z_{49b}), C(Z₆₉ₐ)(Z_{69b}), C(Z₈₉ₐ)(Z_{89b}), Si(Z₂₉ₐ)(Z_{29b}), Si(Z₄₉ₐ)(Z_{49b}), Si(Z₆₉ₐ)(Z_{69b}), or Si(Z₈₉ₐ)(Z_{89b}),
W₂, W₄, W₆, W₈, Z₂, Z₄, Z₆, Z₈, e2, e4, e6, and e8 are respectively as described in claim 3, Z₂₉ₐ and Z_{29b} are respectively as described in connection with Z₂ in claim 1, Z₄₉ₐ and Z_{49b} are respectively as described in connection with Z₄ in claim 1, Z₆₉ₐ and Z_{69b} are respectively as described in connection with Z₆ in claim 1, and Z₈₉ₐ and Z_{89b} are respectively as described in connection with Z₈ in claim 1,
Y₂₁ to Y₂₄ are each independently N or C,
ring A₄₀ is a C₅-C₃₀ carbocyclic group or a C₁-C₃₀ heterocyclic group,
* indicates a binding site to iridium in Formulae 1 and 2, and
*" indicates a binding site to ring A₁, ring A₃, ring A₅, and ring A₇.

10. The composition of any of claims 1-9, wherein
the first compound emits a first light comprising a first spectrum, and λP(1) is an emission peak wavelength in nanometers of the first spectrum, and
the second compound emits a second light comprising a second spectrum, and λP(2) is an emission peak wavelength in nanometers of the second spectrum,
wherein
λP(1) and λP(2) are each 480 nanometers to 580 nanometers; and/or
an absolute value of a difference between λP(1) and λP(2) is 0 nanometers to 30 nanometers.

11. A layer, comprising the composition of any of claims 1-10.

12. A light-emitting device, comprising:
a first electrode;
a second electrode; and
an organic layer located between the first electrode and the second electrode,
wherein the organic layer comprises an emission layer, and
wherein the organic layer comprises the composition of any of claims 1-10;
preferably wherein the emission layer comprises the composition.

13. An electronic apparatus, comprising the light-emitting device of claim 12.

## Patentansprüche

1. Zusammensetzung, umfassend eine erste Verbindung dargestellt durch Formel 1 und eine zweite Verbindung dargestellt durch Formel 2:
Formel 1 Ir(L₁₁)ₙ₁₁(L₁₂)ₙ₁₂(L₁₃)ₙ₁₃
Formel 2 Ir(L₂₁)ₙ₂₁(L₂₂)ₙ₂₂(L₂₃)ₙ₂₃
wobei in Formel 1 und 2
L₁₁ ein Ligand dargestellt durch Formel 1-1 ist,
L₁₂ ein Ligand dargestellt durch Formel 1-2 ist,
L₁₃ ein Ligand dargestellt durch Formel 1-1 oder ein Ligand dargestellt durch Formel 1-2 ist,
L₂₁ ein Ligand dargestellt durch Formel 2-1 ist,
L₂₂ ein Ligand dargestellt durch Formel 2-2 ist,
L₂₃ ein Ligand dargestellt durch Formel 2-1 oder ein Ligand dargestellt durch Formel 2-2 ist: 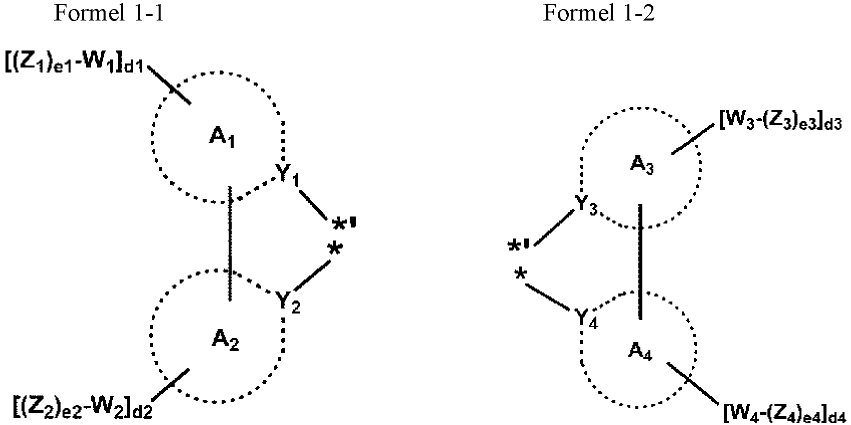 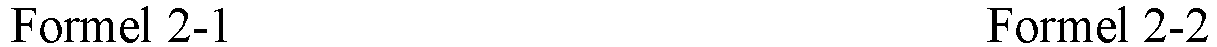 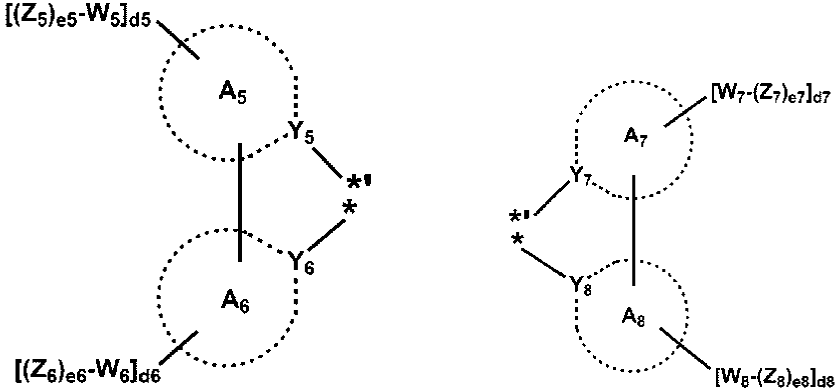
L₁₁, L₁₂ und L₁₃ voneinander verschieden sind,
n11 und n12 jeweils unabhängig 1 oder 2 sind,
n13 0 oder 1 ist,
eine Summe von n11, n12 und n13 3 ist,
L₂₁, L₂₂ und L₂₃ voneinander verschieden sind,
n21 und n22 jeweils unabhängig 1 oder 2 sind,
n23 0 oder 1 ist,
eine Summe von n21, n22 und n23 3 ist, und
L₁₁ und L₂₁ voneinander verschieden sind,
wobei in Formel 1-1, 1-2, 2-1 und 2-2
Y₁, Y₃, Y₅ und Y₇ N sind,
Y₂, Y₄, Y₆ und Y₈ C sind,
Ring A₁, Ring A₃, Ring A₅ und Ring A₇ jeweils eine heterocyclische C₁-C₃₀-Gruppe sind,
Ring A₂, Ring A₄, Ring A₆ und Ring A₈ jeweils unabhängig eine carbocyclische C₅-C₃₀-Gruppe oder eine heterocyclische C₁-C₃₀-Gruppe sind,
Ring A₁ und Ring A₃ voneinander verschieden sind,
eine Y₃-haltige monocyclische Gruppe in Ring A₃ ein 5-gliedriger Ring ist,
W₁ bis W₈ jeweils unabhängig eine Einfachbindung, eine C₁-C₂₀-Alkylengruppe, die unsubstituiert oder mit zumindest einem R₁₀ₐ substituiert ist, eine carbocyclische C₅-C₃₀-Gruppe, die unsubstituiert oder mit zumindest einem R₁₀ₐ substituiert ist, oder eine heterocyclische C₁-C₃₀-Gruppe, die unsubstituiert oder mit zumindest einem R₁₀ₐ substituiert ist, ist,
Z₁ bis Z₈ jeweils unabhängig Wasserstoff, Deuterium, -F, -Cl, -Br, -I, -SF₅, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte einwertige nichtaromatische kondensierte polycyclische Gruppe, eine substituierte oder unsubstituierte einwertige nichtaromatische kondensierte heteropolycyclische Gruppe, -N(Q₁)(Q₂), - Si(Q₃)(Q₄)(Q₅), - Ge(Q₃)(Q₄)(Q₅), -B(Q₆)(Q₇), -P(=O)(Q₈)(Q₉) oder -P(Q₈)(Q₉) sind,
e1 bis e8 und d1 bis d8 jeweils unabhängig eine ganze Zahl von 0 bis 20 sind,
eines oder mehrere von i) zwei oder mehr aus einer Vielzahl von Z₁(s), ii) zwei oder mehr aus einer Vielzahl von Z₂(s), iii) zwei oder mehr aus einer Vielzahl von Z₃(s), iv) zwei oder mehr aus einer Vielzahl von Z₄(s), v) zwei oder mehr aus einer Vielzahl von Z₅(s), vi) zwei oder mehr aus einer Vielzahl von Z₆(_{S}), vii) zwei oder mehr aus einer Vielzahl von Z₇(s), und viii) zwei oder mehr aus einer Vielzahl von Z₈(s) jeweils optional aneinander gebunden sind, um eine carbocyclische C₅-C₃₀-Gruppe, die unsubstituiert oder mit zumindest einem R₁₀ₐ substituiert ist, oder eine heterocyclische C₁-C₃₀-Gruppe, die unsubstituiert oder mit zumindest einem R₁₀ₐ substituiert ist, zu bilden,
R₁₀ₐ wie in Verbindung mit Z₁ beschrieben ist,
* und *' in Formel 1-1, 1-2, 2-1 und 2-2 jeweils eine Bindungsstelle zu Iridium in Formel 1 und 2 angeben,
zumindest ein Substituent der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₁-C₆₀-Alkylthiogruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₇-C₆₀-Alkylarylgruppe, der substituierten C₇-C₆₀-Arylalkylgruppe, der substituierten C₆-C₆₀-Aryloxygruppe, der substituierten C₆-C₆₀-Arylthiogruppe, der substituierten C₁-C₆₀-Heteroarylgruppe, der substituierten C₂-C₆₀-Alkylheteroarylgruppe, der substituierten C₂-C₆₀-Heteroarylalkylgruppe, der substituierten C₁-C₆₀-Heteroaryloxygruppe, der substituierten C₂-C₆₀-Heteroarylthiogruppe, der substituierten einwertigen nichtaromatischen kondensierten polycyclischen Gruppe und der substituierten einwertigen nichtaromatischen kondensierten heteropolycyclischen Gruppe wie folgt ist:
Deuterium, -F, -Cl, -Br, -I, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe,
eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe, jeweils substituiert mit zumindest einem von Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₁-C₆₀-Heteroaryloxygruppe, einer C₁-C₆₀-Heteroarylthiogruppe, einer einwertigen nichtaromatischen kondensierten polycyclischen Gruppe, einer einwertigen nichtaromatischen kondensierten heteropolycyclischen Gruppe, - N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), - P(Q₁₈)(Q₁₉) oder einer Kombination davon;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₁-C₆₀-Heteroaryloxygruppe, eine C₁-C₆₀-Heteroarylthiogruppe, eine einwertige nichtaromatische kondensierte polycyclische Gruppe oder eine einwertige nichtaromatische kondensierte heteropolycyclische Gruppe, jeweils unsubstituiert oder substituiert mit zumindest einem von Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₁-C₆₀-Alkylthiogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₇-C₆₀-Arylalkylgruppe, einer C₆- C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₂-C₆₀-Heteroarylalkylgruppe, einer C₁-C₆₀-Heteroaryloxygruppe, einer C₁- C₆₀-Heteroarylthiogruppe, einer einwertigen nichtaromatischen kondensierten polycyclischen Gruppe, einer einwertigen nichtaromatischen kondensierten heteropolycyclischen Gruppe, -N(Q₂₁)(Q₂₂), - Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), -P(Q₂₈)(Q₂₉) oder einer Kombination davon; oder
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), -P(=O)(Q₃₈)(Q₃₉) oder -P(Q₃₈)(Q₃₉);
und
Q₁ bis Q₉, Q₁₁ bis Q₁₉, Q₂₁ bis Q₂₉ und Q₃₁ bis Q₃₉ jeweils unabhängig Wasserstoff, Deuterium, -F, -Cl, -Br, -I, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon oder eine C₁-C₆₀-Alkylgruppe, eine C₂-C₆₀-Alkenylgruppe, eine C₂-C₆₀-Alkinylgruppe, eine C₁-C₆₀-Alkoxygruppe, eine C₁-C₆₀-Alkylthiogruppe, eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₇-C₆₀-Arylalkylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₂-C₆₀-Heteroarylalkylgruppe, eine C₁-C₆₀-Heteroaryloxygruppe, eine C₁-C₆₀-Heteroarylthiogruppe, eine einwertige nichtaromatische kondensierte polycyclische Gruppe oder eine einwertige nichtaromatische kondensierte heteropolycyclische Gruppe, jeweils unsubstituiert oder substituiert mit zumindest einem von Deuterium, einer C₁-C₆₀-Alkylgruppe, einer C₆-C₆₀-Arylgruppe, einer C₇-C₆₀-Alkylarylgruppe, einer C₇-C₆₀-Arylalkylgruppe oder einer Kombination davon sind.

2. Zusammensetzung nach Anspruch 1, wobei
n13 der Formel 1 0 ist, und
n23 der Formel 2 0 ist.

3. Zusammensetzung nach Anspruch 1 oder 2, wobei
Ring A₁ und Ring A₅ jeweils unabhängig wie folgt sind:
eine Pyridingruppe, eine Pyrimidingruppe, eine Pyridazingruppe oder eine Pyrazingruppe; oder
eine Pyridingruppe, eine Pyrimidingruppe, eine Pyridazingruppe oder eine Pyrazingruppe, jeweils kondensiert mit zumindest einem von einer Cyclohexangruppe, einer Norbornangruppe, einer Benzolgruppe oder einer Kombination davon,
Ring A₃ wie folgt ist:
eine Imidazolgruppe, eine Benzimidazolgruppe, eine Naphthoimidazolgruppe, eine Phenanthrenoimidazolgruppe, eine Pyridinoimidazolgruppe, eine Oxazolgruppe, eine Benzoxazolgruppe, eine Naphthooxazolgruppe, eine Phenanthrenooxazolgruppe, eine Pyridinooxazolgruppe, eine Thiazolgruppe, eine Benzothiazolgruppe, eine Naphthothiazolgruppe, eine Phenanthrenothiazolgruppe oder eine Pyridinothiazolgruppe, und
Ring A₇ wie folgt ist:
eine Pyridingruppe, eine Pyrimidingruppe, eine Pyridazingruppe oder eine Pyrazingruppe; eine Pyridingruppe, eine Pyrimidingruppe, eine Pyridazingruppe oder eine Pyrazingruppe, jeweils kondensiert mit zumindest einem von einer Cyclohexangruppe, einer Norbornangruppe, einer Benzolgruppe oder einer Kombination davon; oder
eine Imidazolgruppe, eine Benzimidazolgruppe, eine Naphthoimidazolgruppe, eine Phenanthrenoimidazolgruppe, eine Pyridinoimidazolgruppe, eine Oxazolgruppe, eine Benzoxazolgruppe, eine Naphthooxazolgruppe, eine Phenanthrenooxazolgruppe, eine Pyridinooxazolgruppe, eine Thiazolgruppe, eine Benzothiazolgruppe, eine Naphthothiazolgruppe, eine Phenanthrenothiazolgruppe oder eine Pyridinothiazolgruppe.

4. Zusammensetzung nach einem der Ansprüche 1-3, wobei Ring A₂ und Ring A₄ voneinander verschieden sind; und/oder
wobei Ring A₆ und Ring A₈ voneinander verschieden sind.

5. Zusammensetzung nach einem der Ansprüche 1-4, wobei
Ring A₂ und Ring A₆ jeweils unabhängig wie folgt sind:
eine Benzolgruppe, eine Naphthalengruppe, eine Phenanthrengruppe, eine Dibenzofurangruppe, eine Dibenzothiophengruppe, eine Dibenzoselenophengruppe, eine Carbazolgruppe, eine Fluorengruppe oder eine Dibenzosilolgruppe; oder
eine Benzolgruppe, eine Naphthalengruppe, eine Phenanthrengruppe, eine Dibenzofurangruppe, eine Dibenzothiophengruppe, eine Dibenzoselenophengruppe, eine Carbazolgruppe, eine Fluorengruppe oder eine Dibenzosilolgruppe, jeweils kondensiert mit zumindest einem von einer Cyclohexangruppe, einer Norbornangruppe, einer Benzolgruppe oder einer Kombination davon, und
Ring A₄ und Ring A₈ jeweils unabhängig wie folgt sind:
eine Benzolgruppe, eine Naphthalengruppe, eine Phenanthrengruppe, eine Dibenzofurangruppe, eine Dibenzothiophengruppe, eine Dibenzoselenophengruppe, eine Carbazolgruppe, eine Fluorengruppe, eine Dibenzosilolgruppe, eine Azadibenzofurangruppe, eine Azadibenzothiophengruppe, eine Azadibenzoselenophengruppe, eine Azacarbazolgruppe, eine Azafluorengruppe, eine Azadibenzosilolgruppe oder eine Phenanthrobenzofurangruppe; oder
eine Benzolgruppe, eine Naphthalengruppe, eine Phenanthrengruppe, eine Dibenzofurangruppe, eine Dibenzothiophengruppe, eine Dibenzoselenophengruppe, eine Carbazolgruppe, eine Fluorengruppe, eine Dibenzosilolgruppe, eine Azadibenzofurangruppe, eine Azadibenzothiophengruppe, eine Azadibenzoselenophengruppe, eine Azacarbazolgruppe, eine Azafluorengruppe oder eine Azadibenzosilolgruppe, jeweils kondensiert mit zumindest einem von einer Benzolgruppe, einer Pyridingruppe, einer Pyrimidingruppe, einer Pyridazingruppe, einer Pyrazingruppe, einer Cyclohexangruppe, einer Norbornangruppe, einer Furangruppe, einer Thiophengruppe, einer Selenophengruppe, einer Pyrrolgruppe, einer Cyclopentadiengruppe, einer Silolgruppe, einer Pyrazolgruppe, einer Imidazolgruppe, einer Oxazolgruppe, einer Thiazolgruppe, einer Isoxazolgruppe, einer Isothiazolgruppe oder einer Kombination davon.

6. Zusammensetzung nach einem der Ansprüche 1-5, wobei
e1 und d1 jeweils nicht 0 sind,
ein oder mehrere Z₁(s) jeweils unabhängig wie folgt sind:
eine C₁-C₂₀-Alkylgruppe, die unsubstituiert oder mit zumindest einem von Deuterium, -F, einer Phenylgruppe oder einer Kombination davon substituiert ist;
-Si(Q₃)(Q₄)(Q₅); oder
-Ge(Q₃)(Q₄)(Q₅).

7. Zusammensetzung nach einem der Ansprüche 1-6, wobei
e5 und d5 jeweils nicht 0 sind,
ein oder mehrere Z₅(s) jeweils unabhängig wie folgt sind:
eine C₁-C₂₀-Alkylgruppe, die unsubstituiert oder mit zumindest einem von Deuterium, -F, einer Phenylgruppe oder einer Kombination davon substituiert ist;
-Si(Q₃)(Q₄)(Q₅); oder
-Ge(Q₃)(Q₄)(Q₅).

8. Zusammensetzung nach einem der Ansprüche 1-7, wobei eine Gruppe dargestellt durch 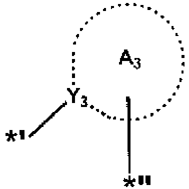 in Formel 1-2 eine Gruppe dargestellt durch eine der Formeln NR29 bis NR48 ist und eine Gruppe dargestellt durch 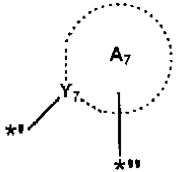 in Formel 2-2 eine Gruppe dargestellt durch eine der Formeln NR1 bis NR48 ist: 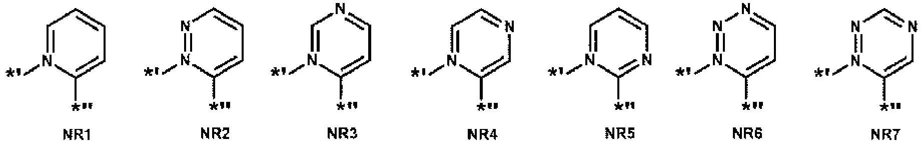 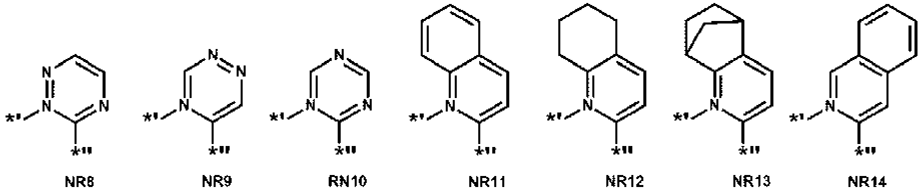 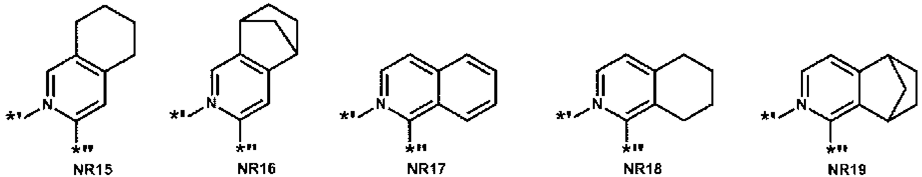 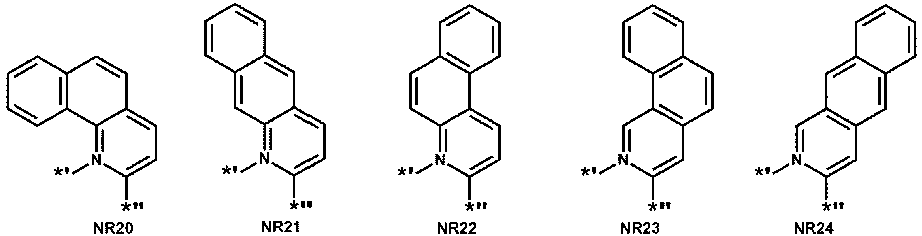 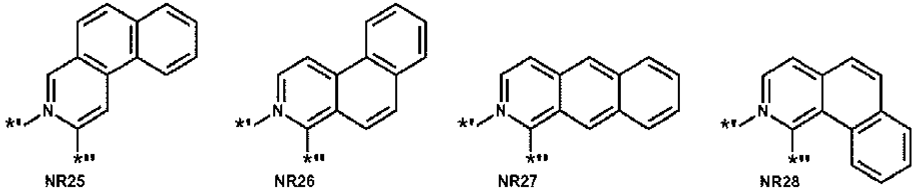 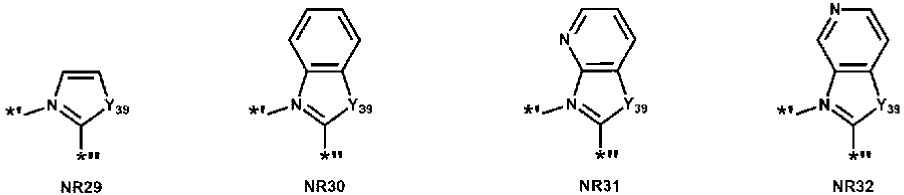 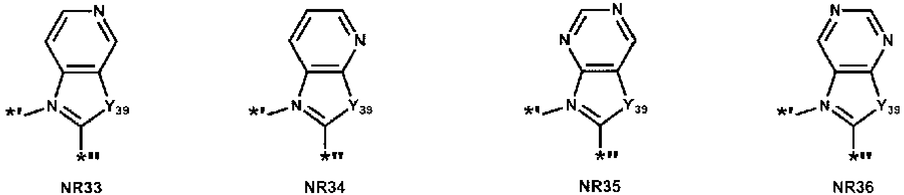 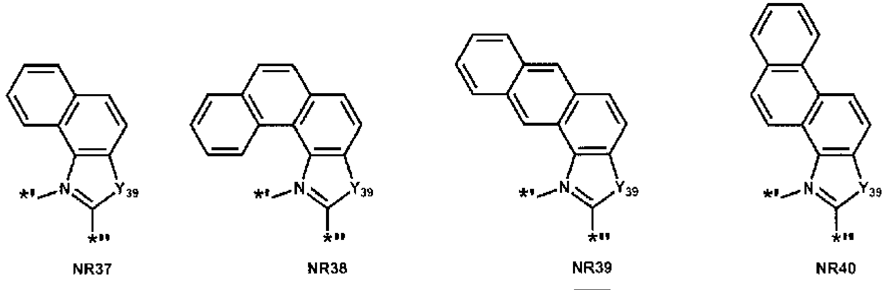 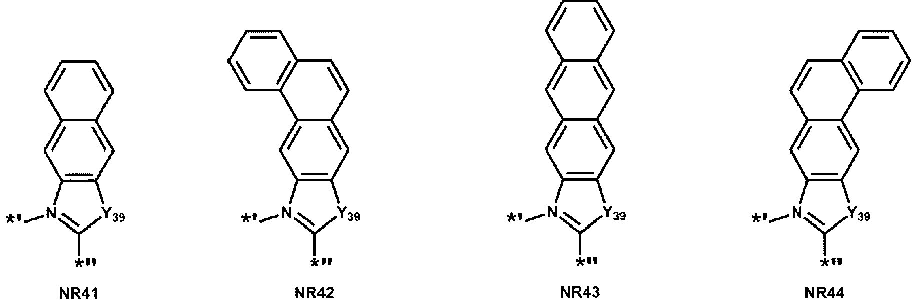 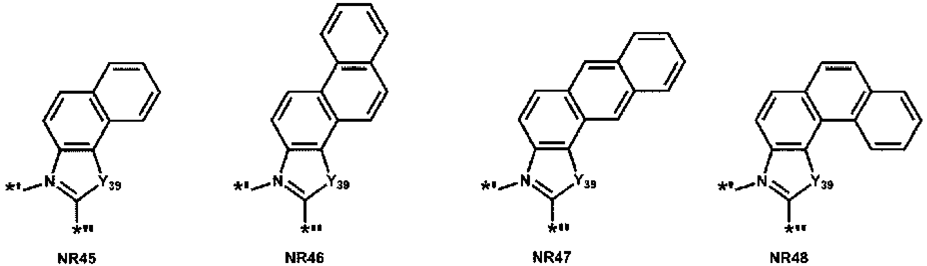
wobei in Formel NR1 bis NR48
Y₃₉ O, S, Se, N-[W₃-(Z₃)ₑ₃], N-[W₇-(Z₇)ₑ₇], C(Z₃₉ₐ)(Z_{39b}), C(Z₇₉ₐ)(Z_{79b}), Si(Z₃₉ₐ)(Z_{39b}) oder Si(Z₇₉ₐ)(Z_{79b}) ist,
W₃, W₇, Z₃, Z₇, e3 und e7 jeweils wie in Anspruch 1 beschrieben sind, Z₃₉ₐ und Z_{39b} jeweils wie in Verbindung mit Z₃ in Anspruch 1 beschrieben sind und Z₇₉ₐ und Z_{79b} jeweils wie in Verbindung mit Z₇ in Anspruch 1 beschrieben sind,
*' eine Bindungsstelle an Iridium in Formel 1 oder 2 angibt, und
*" eine Bindungsstelle an Ring A₄ oder Ring A₈ angibt;
wobei bevorzugt eine Gruppe dargestellt durch 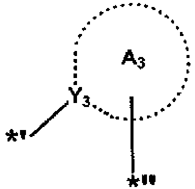
in Formel 1-2 eine Gruppe dargestellt durch eine der Formeln NR30 bis NR48 ist.

9. Zusammensetzung nach einem der Ansprüche 1-8, wobei eine Gruppe dargestellt durch 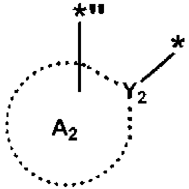 in Formel 1-1,
eine Gruppe dargestellt durch 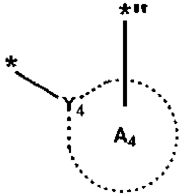 in Formel 1-2,
eine Gruppe dargestellt durch 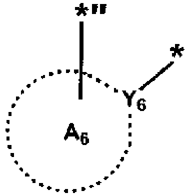 in Formel 2-1, und
eine Gruppe dargestellt durch 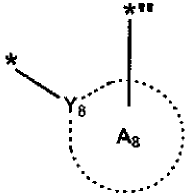
in Formel 2-2 jeweils unabhängig eine Gruppe dargestellt durch eine der Formeln CR1 bis CR29 sind: 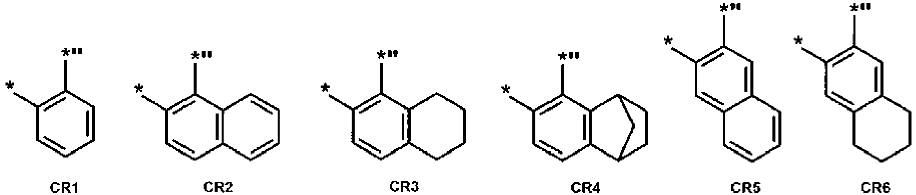 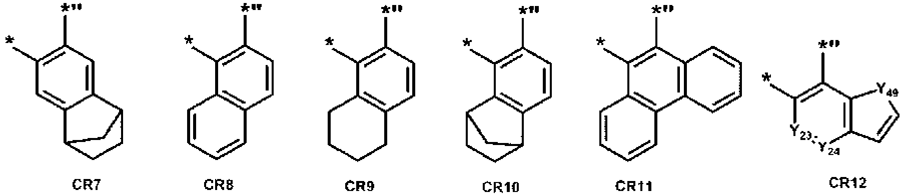 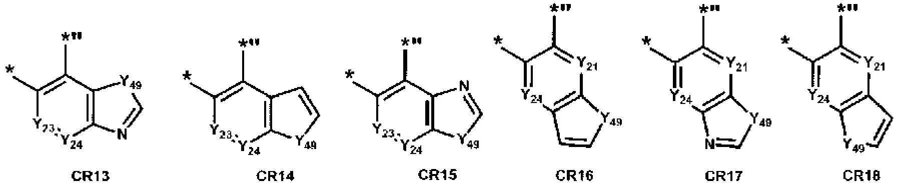 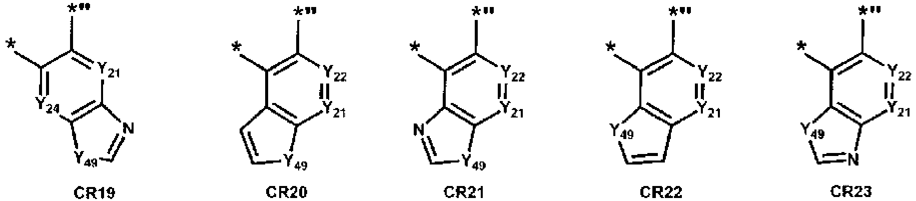 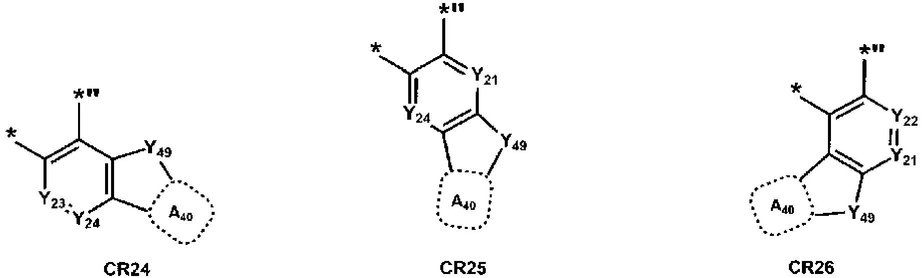 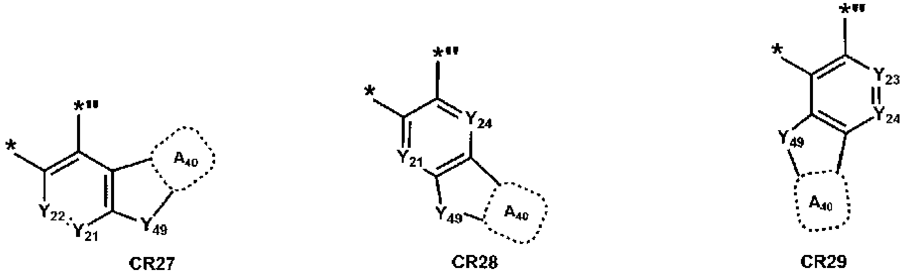
wobei in Formel CR1 bis CR29
Y₄₉ O, S, Se, N-[W₂-(Z₂)ₑ₂], N-[W₄-(Z₄)ₑ₄], N-[W₆-(Z₆)ₑ₆], N-[W₈-(Z₈)ₑ₈], C(Z₂₉ₐ)(Z_{29b}), C(Z₄₉ₐ)(Z_{49b}), C(Z₆₉ₐ)(Z_{69b}), C(Z₈₉ₐ)(Z_{89b}), Si(Z₂₉ₐ)(Z_{29b}), Si(Z₄₉ₐ)(Z_{49b}), Si(Z₆₉ₐ)(Z_{69b}) oder Si(Z₈₉ₐ)(Z_{89b}) ist,
W₂, W₄, W₆, W₈, Z₂, Z₄, Z₆, Z₈, e2, e4, e6 und e8 jeweils wie in Anspruch 3 beschrieben sind, Z₂₉ₐ und Z_{29b} jeweils wie in Verbindung mit Z₂ in Anspruch 1 beschrieben sind, Z₄₉ₐ und Z_{49b} jeweils wie in Verbindung mit Z₄ in Anspruch 1 beschrieben sind, Z₆₉ₐ und Z_{69b} jeweils wie in Verbindung mit Z₆ in Anspruch 1 beschrieben sind und Z₈₉ₐ und Z_{89b} jeweils wie in Verbindung mit Z₈ in Anspruch 1 beschrieben sind,
Y₂₁ bis Y₂₄ jeweils unabhängig N oder C sind,
Ring A₄₀ eine carbocyclische C₅-C₃₀-Gruppe oder eine heterocyclische C₁-C₃₀-Gruppe ist,
* eine Bindungsstelle an Iridium in Formel 1 und 2 angibt, und
*" eine Bindungsstelle an Ring A₁, Ring A₃, Ring A₅ und Ring A₇ angibt.

10. Zusammensetzung nach einem der Ansprüche 1-9, wobei
die erste Verbindung ein erstes Licht emittiert, das ein erstes Spektrum umfasst, und λP(1) eine Emissionsspitzenwellenlänge in Nanometern des ersten Spektrums ist, und
die zweite Verbindung ein zweites Licht emittiert, das ein zweites Spektrum umfasst, und λP(2) eine Emissionsspitzenwellenlänge in Nanometern des zweiten Spektrums ist, wobei
λP(1) und λP(2) jeweils 480 Nanometer bis 580 Nanometer sind; und/oder
ein Absolutwert einer Differenz zwischen λP(1) und λP(2) 0 Nanometer bis 30 Nanometer ist.

11. Schicht, umfassend die Zusammensetzung nach einem der Ansprüche 1-10.

12. Lichtemittierende Vorrichtung, umfassend
eine erste Elektrode;
eine zweite Elektrode; und
eine organische Schicht, die sich zwischen der ersten Elektrode und der zweiten Elektrode befindet,
wobei die organische Schicht eine Emissionsschicht umfasst, und
wobei die organische Schicht die Zusammensetzung nach einem der Ansprüche 1-10 umfasst;
wobei bevorzugt die Emissionsschicht die Zusammensetzung umfasst.

13. Elektronische Einrichtung, umfassend die lichtemittierende Vorrichtung nach Anspruch 12.

## Revendications

1. Composition, comprenant un premier composé représenté par la Formule 1 et un deuxième composé représenté par la Formule 2 :
Formule 1 Ir(L₁₁)ₙ₁₁(L₁₂)ₙ₁₂(L₁₃)ₙ₁₃
Formule 2 Ir(L₂₁)ₙ₂₁(L₂₂)ₙ₂₂(L₂₃)ₙ₂₃
où, dans les formules 1 et 2,
L₁₁ est un ligand représenté par la Formule 1-1,
L₁₂ est un ligand représenté par la Formule 1-2,
L₁₃ est un ligand représenté par la Formule 1-1 ou un ligand représenté par la Formule 1-2,
L₂₁ est un ligand représenté par la Formule 2-1,
L₂₂ est un ligand représenté par la Formule 2-2,
L₂₃ est un ligand représenté par la Formule 2-1 ou un ligand représenté par la Formule 2-2 : 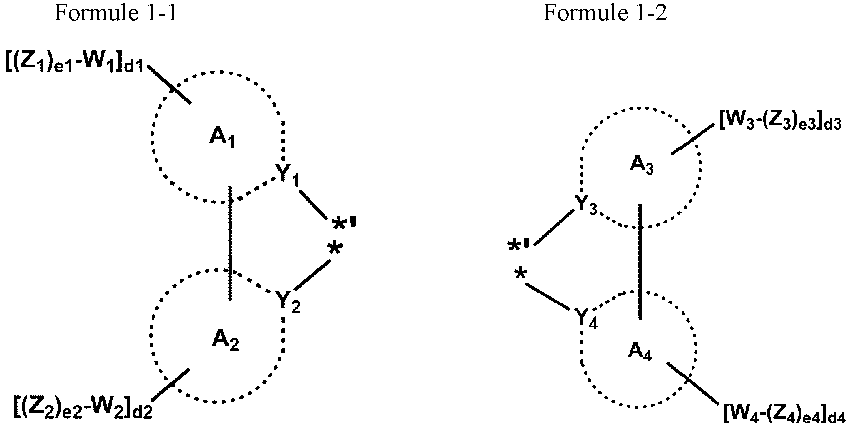 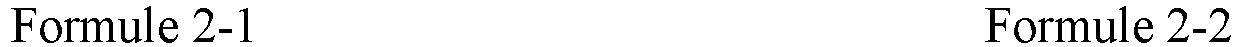 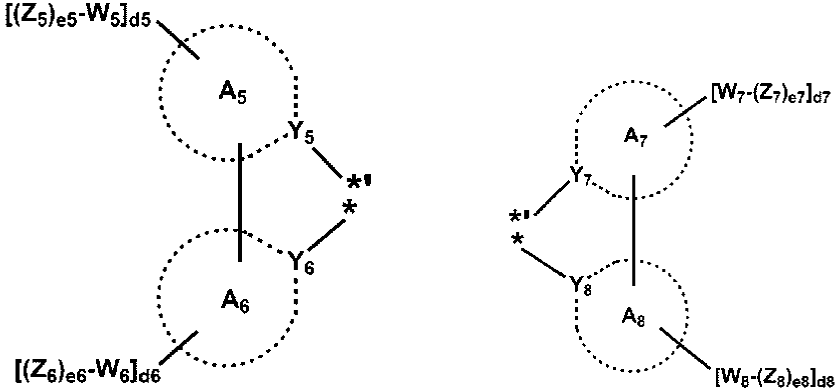
L₁₁, L₁₂, et L₁₃ sont différents les uns des autres,
n11 et n12 valent chacun indépendamment 1 ou 2,
n13 vaut 0 ou 1 ;
une somme de n11, n12 et n13 est égale à 3,
L₂₁, L₂₂, et L₂₃ sont différents les uns des autres,
n21 et n22 valent chacun indépendamment 1 ou 2,
n23 vaut 0 ou 1,
une somme de n21, n22 et n23 vaut 3, et
L₁₁ et L₂₁ sont différents l'un de l'autre, et
où, dans les formules 1-1, 1-2, 2-1 et 2-2,
Y₁, Y₃, Y₅, et Y₇ sont N,
Y₂, Y₄, Y₆, et Y₈ sont C,
le cycle A₁, le cycle A₃, le cycle A₅ et le cycle A₇ sont chacun un groupe hétérocyclique en C₁ à C₃₀,
le cycle A₂, le cycle A₄, le cycle A₆, et le cycle A₈ sont chacun indépendamment un groupe carbocyclique en C₅ à C₃₀ ou un groupe hétérocyclique en C₁ à C₃₀,
le cycle A₁ et le cycle A₃ sont différents l'un de l'autre,
un groupe monocyclique contenant Y₃ dans le cycle A₃ est un cycle à 5 chaînons,
W₁ à W₈ représentent chacun indépendamment une liaison simple, un groupe alkylène en C₁ à C₂₀ non substitué ou substitué par au moins un R₁₀ₐ, un groupe carbocyclique en C₅ à C₃₀ non substitué ou substitué par au moins un R₁₀ₐ, ou un groupe hétérocyclique en C₁ à C₃₀ non substitué ou substitué par au moins un R₁₀ₐ,
Z₁ à Z₈ sont chacun indépendamment hydrogène, deutérium, -F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe alkylthio en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe alkylaryle en C₇ à C₆₀ substitué ou non substitué, un groupe arylalkyle en C₇ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe alkylhétéroaryl en C₂ à C₆₀ substitué ou non substitué, un groupe hétéroarylalkyle en C₂ à C₆₀ substitué ou non substitué, un groupe hétéroaryloxy en C₁ à C₆₀ substitué ou non substitué, un groupe hétéroarylthio en C₁ à C₆₀ substitué ou non substitué, un groupe polycyclique condensé non-aromatique monovalent substitué ou non substitué, un groupe hétéropolycyclique condensé non-aromatique monovalent substitué ou non substitué, - N(Q₁)(Q₂), - Si(Q₃)(Q₄)(Q₅), -Ge(Q₃)(Q₄)(Q₅), -B(Q₆)(Q₇), -P(=O)(Q₈)(Q₉), ou -P(Q₈)(Q₉),
e1 à e8 et d1 à d8 sont chacun indépendamment un nombre entier de 0 à 20,
un ou plusieurs parmi i) deux ou plus d'une pluralité de Z₁, ii) deux ou plus d'une pluralité de Z₂, iii ) deux ou plus d'une pluralité de Z₃, iv) deux ou plus d'une pluralité de Z₄, v) deux ou plus d'une pluralité de Z₅, vi) deux ou plus d'une pluralité de Z₆, vii) deux ou plus d'une pluralité de Z₇, et viii) deux ou plus d'une pluralité de Z₈ sont respectivement facultativement liés les uns aux autres pour former un groupe carbocyclique en C₅ à C₃₀ qui est non substitué ou substitué par au moins un R₁₀ₐ ou un groupe hétérocyclique en C₁ à C₃₀ non substitué ou substitué par au moins un R₁₀ₐ,
R₁₀ₐ est le même que celui décrit en relation avec Z₁,
* et *' dans les formules 1-1, 1-2, 2-1 et 2-2 indiquent chacun un site de liaison à l'iridium dans les formules 1 et 2,
au moins un substituant du groupe alkyle en C₁ à C₆₀ substitué, du groupe alcényle en C₂ à C₆₀ substitué, du groupe alcynyle en C₂ à C₆₀ substitué, du groupe alkoxy en C₁ à C₆₀ substitué, du groupe alkylthio en C₁ à C₆₀ substitué, du groupe cycloalkyle en C₃ à C₁₀ substitué, du groupe hétérocycloalkyle en C₁ à C₁₀ substitué, du groupe cycloalcényle en C₃ à C₁₀ substitué, du groupe hétérocycloalcényle en C₁ à C₁₀ substitué, du groupe aryle en C₆ à C₆₀ substitué, du groupe alkylaryle en C₇ à C₆₀ substitué, du groupe arylalkyle en C₇ à C₆₀ substitué, du groupe aryloxy en C₆ à C₆₀ substitué, du groupe arylthio en C₆ à C₆₀ substitué, du groupe hététoaryle en C₁ à C₆₀ substitué, du groupe alkylhététoaryle en C₂ à C₆₀ substitué, du groupe hététoarylalkyle en C₂ à C₆₀ substitué, du groupe hétéroaryloxy en C₁ à C₆₀ substitué, du groupe hétéroarylthio en C₂ à C₆₀ substitué, du groupe polycyclique condensé non aromatique monovalent substitué et du groupe hétéropolycyclique condensé non aromatique monovalent substitué est :
deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀, un groupe alcényle en C₂ à C₆₀, un groupe alcynyle en C₂ à C₆₀, un groupe alcoxy en C₁ à C₆₀ ou un groupe alkylthio en C₁ à C₆₀ ;
un groupe alkyle en C₁ à C₆₀, un groupe alcényle en C₂ à C₆₀, un groupe alcynyle en C₂ à C₆₀, un groupe alcoxy en C₁ à C₆₀, ou un groupe alkylthio en C₁ à C₆₀, chacun substitué par au moins l'un choisi parmi le deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe alkylaryle en C₇ à C₆₀, un groupe aryloxy en C₆ à C₆₀, un groupe arylthio en C₆ à C₆₀, un groupe hétéroaryle en C₁ à C₆₀, , un groupe alkylhétéroaryle en C₂ à C₆₀, un groupe hétéroaryloxy en C₁ à C₆₀, un groupe hétéroarylthio en C₁ à C₆₀, un groupe polycyclique condensé non aromatique monovalent, un groupe hétéropolycyclique condensé non aromatique monovalent, -N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), - P(Q₁₈)(Q₁₉), ou une combinaison de ceux-ci ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe alkylaryle en C₇ à C₆₀, un groupe aryloxy en C₆ à C₆₀, un groupe arylthio en C₆ à C₆₀, un groupe hétéroaryle en C₁ à C₆₀, un groupe alkylhétéroaryle en C₂ à C₆₀, un groupe hétéroaryloxy en C₁ à C₆₀, un groupe hétéroarylthio en C₁ à C₆₀, un groupe polycyclique condensé non aromatique monovalent, ou un groupe hétéropolycyclique condensé non aromatique monovalent, chacun non-substitué ou substitué par au moins l'un choisi parmi le deutérium, -F, -Cl, -Br, -I, - CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀, un groupe alcényle en C₂ à C₆₀, un groupe alcynyle en C₂ à C₆₀, un groupe alcoxy en C₁ à C₆₀, un groupe alkylthio en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe alkylaryle en C₇ à C₆₀, un groupe arylalkyle en C₇ à C₆₀, un groupe aryloxy en C₆ à C₆₀, un groupe arylthio en C₆ à C₆₀, un groupe hétéroaryle en C₁ à C₆₀, un groupe alkylhétéroaryle en C₂ à C₆₀, un groupe hétéroarylalkyle en C₂ à C₆₀, un groupe hétéroaryloxy en C₁ à C₆₀, un groupe hétéroarylthio en C₁ à C₆₀, un groupe polycyclique condensé non aromatique monovalent, un groupe hétéropolycyclique condensé non aromatique monovalent, -N(Q₂₁)(Q₂₂), - Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), -P(Q₂₈)(Q₂₉), ou une combinaison de ceux-ci ; ou
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), -P(=O)(Q₃₈)(Q₃₉), ou -P(Q₃₈)(Q₃₉);
et
Q₁ à Q₉, Q₁₁ à Q₁₉, Q₂₁ à Q₂₉ et Q₃₁ à Q₃₉ sont chacun indépendamment : hydrogène, deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀, un groupe alcényle en C₂ à C₆₀, un groupe alcynyle en C₂ à C₆₀, un groupe alkoxy en C₁ à C₆₀, un groupe alkylthio en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe alkylaryle en C₇ à C₆₀, un groupe arylalkyle en C₇ à C₆₀, un groupe aryloxy en C₆ à C₆₀, un groupe arylthio en C₆ à C₆₀, un groupe hétéroaryle en C₁ à C₆₀, un groupe alkylhétéroaryle en C₂ à C₆₀, un groupe hétéroaryle alkyle en C₂ à C₆₀, un groupe hétéroaryloxy en C₁ à C₆₀, un groupe hétéroarylthio en C₁ à C₆₀, un groupe polycyclique condensé non aromatique monovalent, ou un groupe hétéropolycyclique condensé non aromatique monovalent, chacun substitué ou non substitué par au moins l'un parmi le deutérium, un groupe alkyle en C₁ à C₆₀, un groupe aryle en C₆ à C₆₀, un groupe alkylaryle en C₇ à C₆₀, un groupe arylalkyle en C₇ à C₆₀, ou une combinaison de ceux-ci.

2. Composition selon la revendication 1, dans laquelle
n13 de la Formule 1 vaut 0, et
n23 de la Formule 2 vaut 0.

3. Composition selon la revendication 1 ou 2, dans laquelle
le cycle A₁ et le cycle A₅ sont chacun indépendamment :
un groupe pyridine, un groupe pyrimidine, un groupe pyridazine ou un groupe pyrazine ; ou
un groupe pyridine, un groupe pyrimidine, un groupe pyridazine ou un groupe pyrazine, chacun condensé avec au moins l'un d'un groupe cyclohexane, un groupe norbornane, un groupe benzène ou une combinaison de ceux-ci,
le cycle A₃ est :
un groupe imidazole, un groupe benzimidazole, un groupe naphthoimidazole, un groupe phénanthrénoimidazole, un groupe pyridinoimidazole, un groupe oxazole, un groupe benzoxazole, un groupe naphthooxazole, un groupe phénanthrénooxazole, un groupe pyridinooxazole, un groupe thiazole, un groupe benzothiazole, un naphtothiazole un groupe phénanthrénothiazole ou un groupe pyridinothiazole, et
le cycle A₇ est :
un groupe pyridine, un groupe pyrimidine, un groupe pyridazine ou un groupe pyrazine ;
un groupe pyridine, un groupe pyrimidine, un groupe pyridazine ou un groupe pyrazine, chacun condensé avec au moins l'un d'un groupe cyclohexane, un groupe norbornane, un groupe benzène ou une combinaison de ceux-ci ; ou
un groupe imidazole, un groupe benzimidazole, un groupe naphthoimidazole, un groupe phénanthrénoimidazole, un groupe pyridinoimidazole, un groupe oxazole, un groupe benzoxazole, un groupe naphthooxazole, un groupe phénanthrénooxazole, un groupe pyridinooxazole, un groupe thiazole, un groupe benzothiazole, un naphtothiazole un groupe phénanthrénothiazole ou un groupe pyridinothiazole.

4. Composition selon l'une quelconque des revendications 1 à 3, dans laquelle le cycle A₂ et le cycle A₄ sont différents l'un de l'autre ; et/ou
dans laquelle le cycle A₆ et le cycle A₈ sont différents l'un de l'autre.

5. Composition selon l'une quelconque des revendications 1 à 4, dans laquelle
le cycle A₂ et le cycle A₆ sont chacun indépendamment :
un groupe benzène, un groupe naphtalène, un groupe phénanthrène, un groupe dibenzofurane, un groupe dibenzothiophène, un groupe dibenzosélénophène, un groupe carbazole, un groupe fluorène ou groupe dibenzosilole ; ou
un groupe benzène, un groupe naphtalène, un groupe phénanthrène, un groupe dibenzofurane, un groupe dibenzothiophène, un groupe dibenzoselénophène, un groupe carbazole, un groupe fluorène, un groupe dibenzosilole, chacun condensé avec au moins un groupe parmi un groupe cyclohexane, un groupe norbornane, un groupe benzène, ou une combinaison de ceux-ci, et
le cycle A₄ et le cycle A₈ sont chacun indépendamment :
un groupe benzène, un groupe naphtalène, un groupe phénanthrène, un groupe dibenzofurane, un groupe dibenzothiophène, un groupe dibenzoselénophène, un groupe carbazole, un groupe fluorène, un groupe dibenzosilole, un groupe azadibenzofurane, un groupe azadibenzothiophène, un groupe azadibenzosélenophène, un groupe azacarbazole, un groupe azafluorène, un groupe azadibenzosilole ou un groupe phénanthrobenzofurane ; ou
un groupe benzène, un groupe naphtalène, un groupe phénanthrène, un groupe dibenzofurane, un groupe dibenzothiophène, un groupe dibenzoselénophène, un groupe carbazole, un groupe fluorène, un groupe dibenzosilole, un groupe azadibenzofurane, un groupe azadibenzothiophène, un groupe azadibenzosélenophène, un groupe azacarbazole, un groupe azafluorène ou un groupe azadibenzosilole, chacun condensé avec au moins un groupe parmi un groupe benzène, un groupe pyridine, un groupe pyrimidine, un groupe pyridazine, un groupe pyrazine, un groupe cyclohexane, un groupe norbornane, un groupe furane, un groupe thiophène, un groupe sélénophène, un groupe pyrrole, un groupe cyclopentadiène, un groupe silole, un groupe pyrazole, un groupe imidazole, un groupe oxazole, un groupe thiazole, un groupe isoxazole, un groupe isothiazole, ou une combinaison de ceux-ci.

6. Composition selon l'une quelconque des revendications 1 à 5, dans laquelle
e1 et d1 ne valent chacun pas 0,
un ou plusieurs Z₁ sont chacun indépendamment :
un groupe alkyle en C₁ à C₂₀ qui est non substitué ou substitué par au moins l'un parmi le deutérium, -F, un groupe phényle ou une combinaison de ceux-ci ;
-Si(Q₃)(Q₄)(Q₅) ; ou
-Ge(Q₃)(Q₄)(Q₅).

7. Composition selon l'une quelconque des revendications 1 à 6, dans laquelle
e5 et d5 ne valent chacun pas 0,
un ou plusieurs Z₅ sont chacun indépendamment :
un groupe alkyle en C₁ à C₂₀ qui est non substitué ou substitué par au moins l'un parmi le deutérium, -F, un groupe phényle ou une combinaison de ceux-ci ;
-Si(Q₃)(Q₄)(Q₅) ; ou
-Ge(Q₃)(Q₄)(Q₅).

8. Composition selon l'une quelconque des revendications 1 à 7, dans laquelle un groupe représenté par 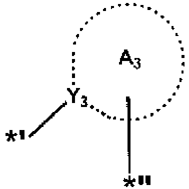
dans la Formule 1-2 est un groupe représenté par l'une des formules NR29 à NR48, et un groupe représenté par 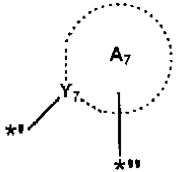
dans la Formule 2-2 est un groupe représenté par l'une des Formules NR1 à NR48 : 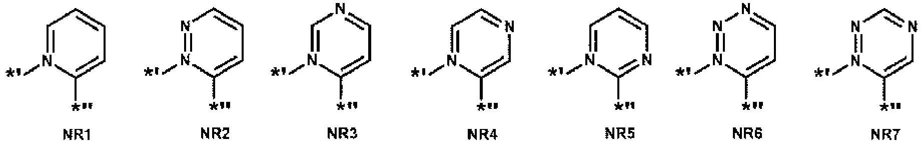 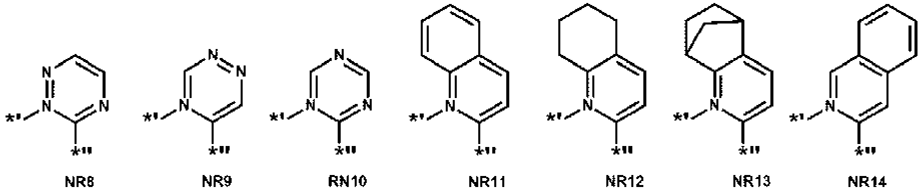 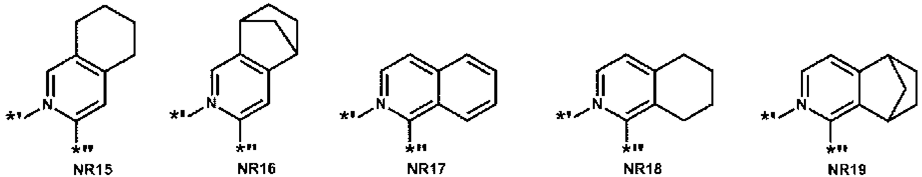 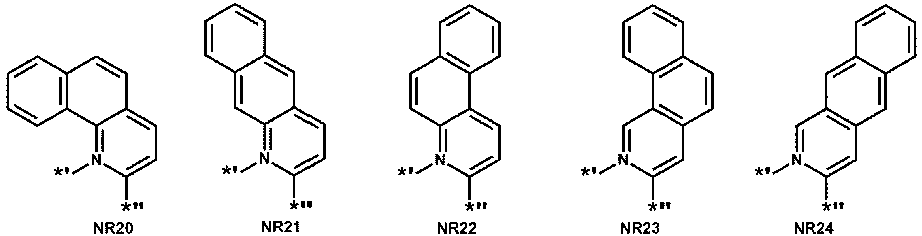 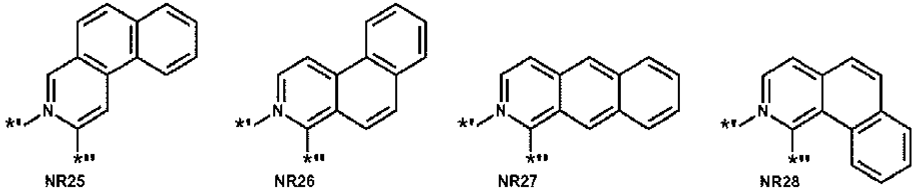 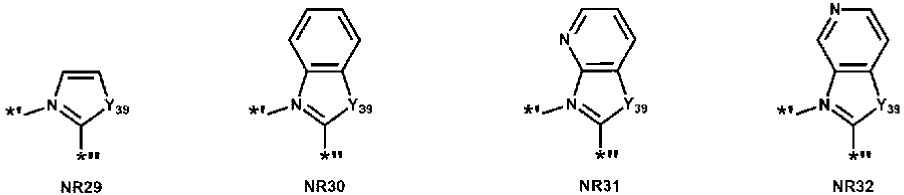 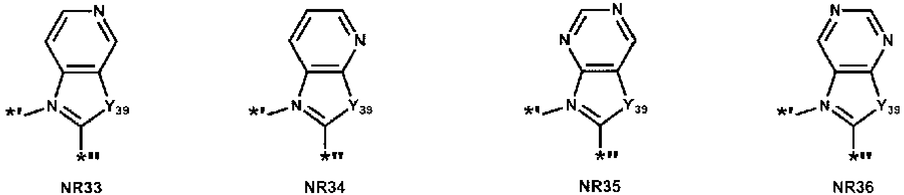 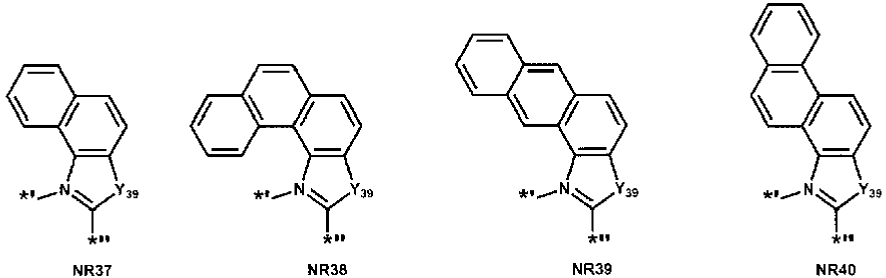 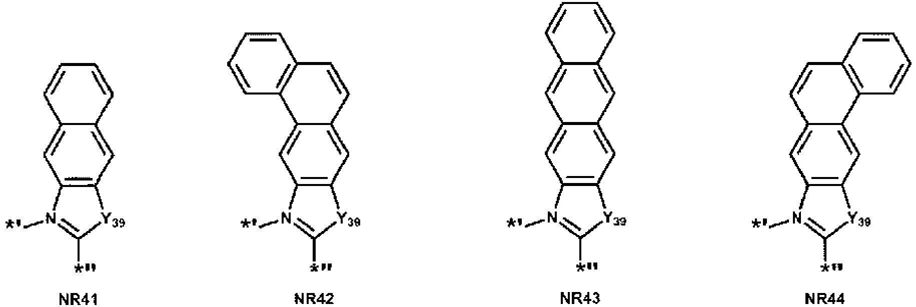 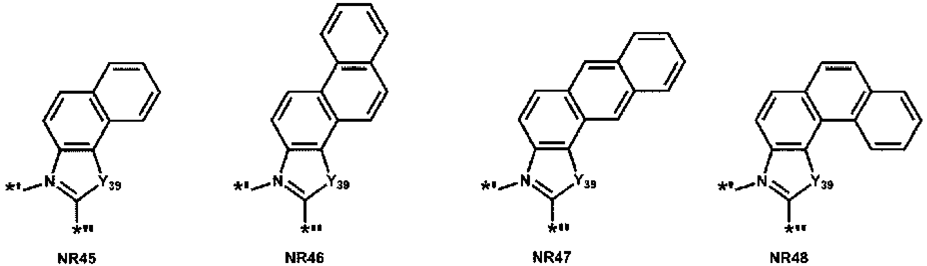
où, dans les formules NR1 à NR48,
Y₃₉ est O, S, Se, N-[W₃-(Z₃)ₑ₃], N-[W₇-(Z₇)ₑ₇], C(Z₃₉ₐ)(Z_{39b}), C(Z₇₉ₐ)(Z_{79b}), Si(Z₃₉ₐ)(Z_{39b}), ou Si(Z₇₉ₐ)(Z_{79b}),
W₃, W₇, Z₃, Z₇, e3 et e7 sont respectivement tels que décrits dans la revendication 1, Z₃₉ₐ et Z_{39b} sont respectivement tels que décrits en relation avec Z₃ dans la revendication 1, et Z₇₉ₐ et Z_{79b} sont respectivement tels que décrits en relation avec Z₇ dans la revendication 1,
*' indique un site de liaison à l'iridium dans la Formule 1 ou 2, et
*" indique un site de liaison au cycle A₄ ou au cycle A₈ ;
de préférence dans lequel un groupe représenté par 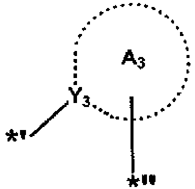
dans la Formule 1-2 est un groupe représenté par l'une des Formules NR30 à NR48.

9. Composition selon l'une quelconque des revendications 1 à 8, dans laquelle un groupe représenté par 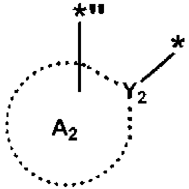 dans la Formule 1-1
un groupe représenté par 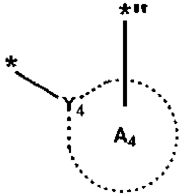 dans la Formule 1-2
un groupe représenté par 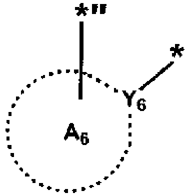 dans la Formule 2-1, et
un groupe représenté par 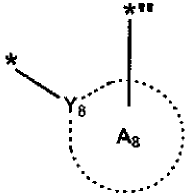 dans la formule 2-2 sont chacun indépendamment un groupe représenté par l'une des formules CR1 à CR29 : 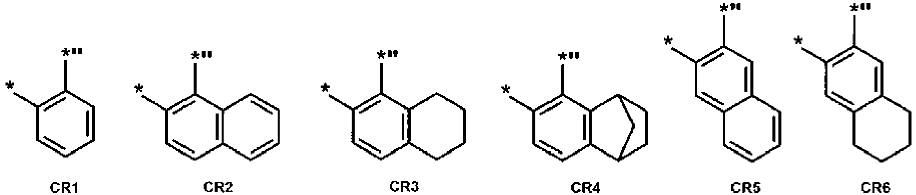 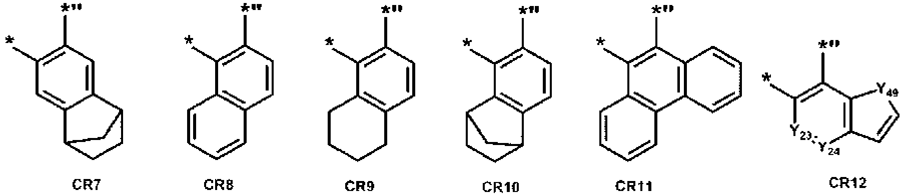 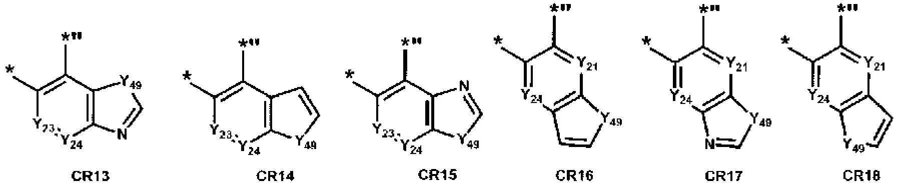 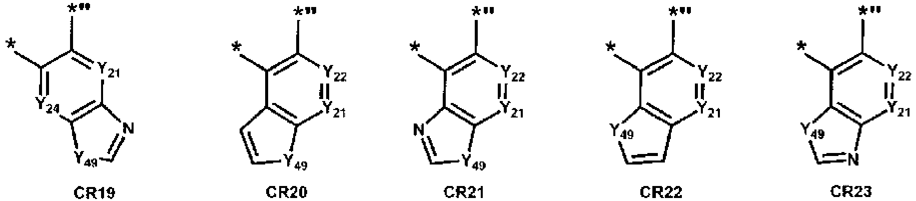 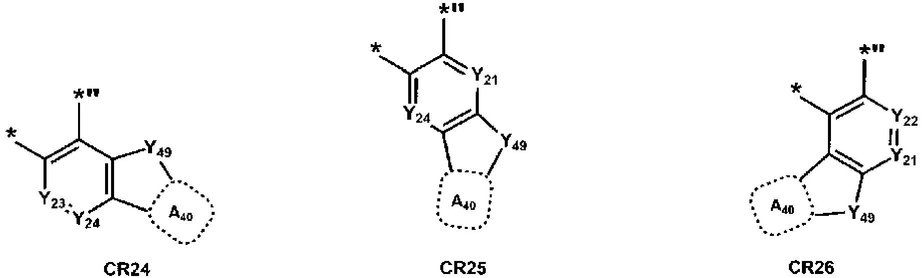 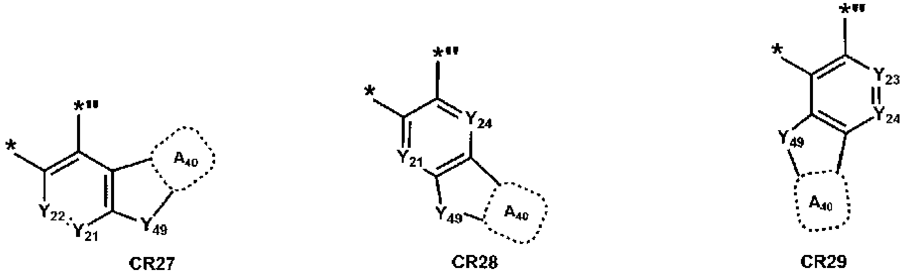
où, dans les formules CR1 à CR29,
Y₄₉ est O, S, Se, N-[W₂-(Z₂)ₑ₂], N-[W₄-(Z₄)ₑ₄], N-[W₆-(Z₆)ₑ₆], N-[W₈-(Z₈)ₑ₈], C(Z₂₉ₐ)(Z_{29b}), C(Z₄₉ₐ)(Z_{49b}), C(Z₆₉ₐ)(Z_{69b}), C(Z₈₉ₐ)(Z_{89b}), Si(Z₂₉ₐ)(Z_{29b}), Si(Z₄₉ₐ)(Z_{49b}), Si(Z₆₉ₐ)(Z_{69b}), ou Si(Z₈₉ₐ)(Z_{89b}),
W₂, W₄, W₆, W₈, Z₂, Z₄, Z₆, Z₈, e2, e4, e6, et e8 sont respectivement tels que décrits dans la revendication 3, Z₂₉ₐ et Z_{29b} sont respectivement tels que décrits en relation avec Z₂ dans la revendication 1, Z₄₉ₐ et Z_{49b} sont respectivement tels que décrits en relation avec Z₄ dans la revendication 1, Z₆₉ₐ et Z_{69b} sont respectivement tels que décrits en relation avec Z₆ dans la revendication 1, et Z₈₉ₐ et Z_{89b} sont respectivement tels que décrits en relation avec Z₈ dans la revendication 1,
Y₂₁ à Y₂₄ sont chacun indépendamment N ou C,
le cycle A₄₀ est un groupe carbocyclique en C₅ à C₃₀ ou un groupe hétérocyclique en C₁ à C₃₀,
* indique un site de liaison à l'iridium dans les formules 1 et 2, et
*" indique un site de liaison au cycle A₁, au cycle A₃, au cycle As et au cycle A₇.

10. Composition selon l'une quelconque des revendications 1 à 9, dans laquelle
le premier composé émet une première lumière comprenant un premier spectre, et λP(1) est une longueur d'onde de pic d'émission en nanomètres du premier spectre, et
le deuxième composé émet une deuxième lumière comprenant un deuxième spectre, et λP(2) est une longueur d'onde de pic d'émission en nanomètres du deuxième spectre,
dans laquelle
λP(1) et λP(2) mesurent chacun 480 nanomètres à 580 nanomètres ; et/ou
une valeur absolue d'une différence entre λP(1) et λP(2) est comprise entre 0 nanomètre et 30 nanomètres.

11. Couche comprenant la composition selon l'une quelconque des revendications 1 à 10.

12. Dispositif électroluminescent, comprenant
une première électrode ;
une seconde électrode ; et
une couche organique située entre la première électrode et la seconde électrode,
dans lequel la couche organique comprend une couche d'émission ; et
dans lequel la couche organique comprend la composition selon l'une quelconque des revendications 1 à 10 ;
de préférence, dans lequel la couche d'émission comprend la composition.

13. Appareil électronique, comprenant le dispositif électroluminescent selon la revendication 12.
